# EUROPEAN PATENT SPECIFICATION

(11) **EP 2 053 112 B1**
(45) Date of publication and mention of the grant of the patent: **24.08.2011**
(21) Application number: 08167460.8
(22) Date of filing: 23.10.2008
(51) Int. Cl.: C09K 11/06, H01L 51/50, H05B 33/14, C09B 57/10, C07F 15/00

(54) **Novel red electroluminescent compounds and organic electroluminescent device using the same**
Neuartige rote Elektrolumineszenz-Verbindungen und organische Elektrolumineszenzvorrichtung, die diese einsetzt
Nouveaux composés électroluminescents rouges et dispositif électroluminescent organique les utilisant

(30) Priority: 25.10.2007 KR 20070107557
(43) Date of publication of application: 29.04.2009
(73) Proprietor: Gracel Display Inc., Seoul 133-833 (KR)
(72) Inventor: Kim, Jin, Ho, Seoul (KR); Eum, Sung, Jin, 152-053 Seoul (KR); Cho, Young, Jun, 136-060 Seoul (KR); Kwon, Hyuck, Joo, 130-100 Seoul (KR); Kim, Bong, Ok, 135-090 Seoul (KR); Kim, Sung, Min, 157-886 Seoul-city (KR); Yoon, Seung, Soo, 135-884 Seoul (KR)
(74) Representative: Buckley, Guy Julian

(56) References cited:
- WO-A2-2008/109824
- US-A1- 2004 127 710
- PARK GUI YOUN ET AL: "Synthesis and photo physical study of iridium complex of new pentafluorophenyl-substituted ligands" THIN SOLID FILMS, ELSEVIER-SEQUOIA S.A. LAUSANNE, CH LNKD- DOI:10.1016/J.TSF.2007.08.030, vol. 516, no. 11, 1 January 2008 (2008-01-01), pages 3622-3626, XP002514162 ISSN: 0040-6090 [retrieved on 2007-08-16]

## Description

### FIELD OF THE INVENTION

The present invention relates to novel red phosphorescent compounds exhibiting high luminous efficiency and organic electroluminescent devices using the same.

### BACKGROUND OF THE INVENTION

The most important factor to determine luminous efficiency in an OLED (organic light-emitting diode) is the type of electroluminescent material. Though fluorescent materials has been widely used as an electroluminescent material up to the present, development of phosphorescent materials is one of the best methods to improve the luminous efficiency theoretically up to four(4) times, in view of electroluminescent mechanism.

Up to now, iridium (III) complexes are widely known as phosphorescent material, including (acac)Ir(btp)₂, Ir(ppy)₃ and Firpic, as the red, green and blue one, respectively. In particular, a lot of phosphorescent materials have been recently investigated in Japan and Europe and America.

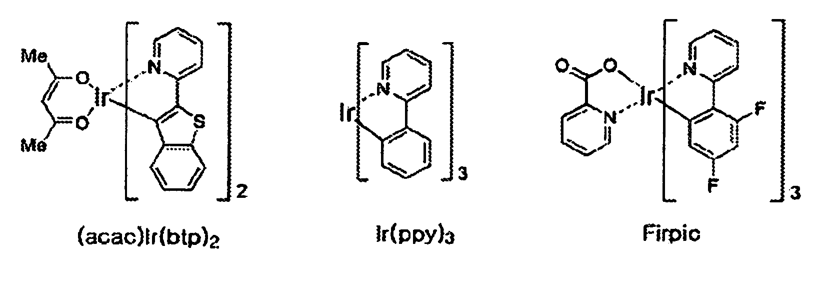

Among conventional red phosphorescent materials, several materials are reported to have good EL (electroluminescence) properties. However, very rare materials among them have reached the level of commercialization. As the best material, an iridium complex of 1-phenyl isoquinoline may be mentioned, which is known to have excellent EL property and to exhibit color purity of dark red with high luminous efficiency. [See A. Tsuboyama et al., J. Am. Chem. Soc. 2003, 125(42), 12971-12979.]

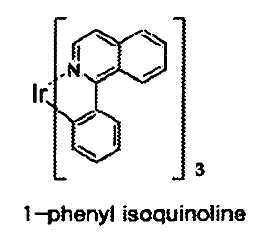

Moreover, the red materials, having no significant problem of life time, have tendency of easy commercialization if they have good color purity or luminous efficiency. Thus, the above-mentioned iridium complex is a material having very high possibility of commercialization due to its excellent color purity and luminous efficiency.

However, the iridium complex is still construed only as a material which is applicable to small displays, while higher levels of EL properties than those of known materials are practically required for an OLED panel of medium to large size.

As a result of intensive efforts of the present inventors to overcome the problems of conventional techniques as described above, they have researched for developing novel red phosphorescent compounds to realize an organic EL device having excellent luminous efficiency and surprisingly improved lifetime. Eventually, the inventors found that luminous efficiency and life property are improved when an iridium complex, which was synthesized by introducing a phenyl derivative at 6-position of quinoline to a primary ligand compound consisting of quinoline and benzene derivative, is applied as a dopant of an electroluminescent device, and completed the present invention. Thus, the object of the invention is to provide novel red phosphorescent compounds having the skeletal to give more excellent properties as compared to those of conventional red phosphorescent materials. Another object of the invention is to provide novel phosphorescent compounds which are applicable to OLED panels of medium to large size. A red luminescent iridium metal complex based on phenylquinoline and an organic electroluminescent device using the same is disclosed in US,A,2004,127,710.

### SUMMARY OF THE INVENTION

Thus, the present invention relates to novel red phosphorescent compounds and organic electroluminescent devices employing the same in an electroluminescent layer. Specifically, the red phosphorescent compounds according to the invention are characterized in that they are represented by Chemical Formula (I): 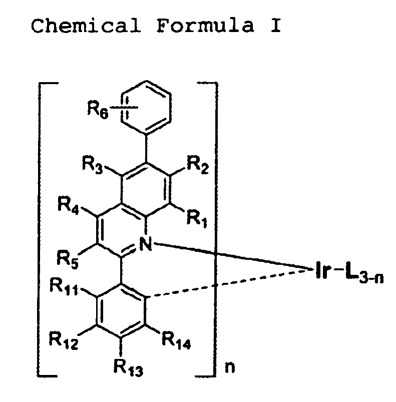 wherein, L is an organic ligand;
R₁ through R₅ independently represent hydrogen, (C₁-C₂₀)alkyl, (C₁-C₂₀)alkoxy, (C₃-C₁₂)cycloalkyl, halogen, tri(C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri(C₁-C₂₀)alkylsilyl, tri(C₆-C₂₀)arylsilyl, (C₁-C₂₀)alkoxy, (C₁-C₂₀)alkylcarbonyl, (C₆-C₂₀)arylcarbonyl, di(C₁-C₂₀)alkylamino, di(C₆-C₂₀)arylamino, phenyl, naphthyl, anthryl, fluorenyl, spirobifluorenyl or 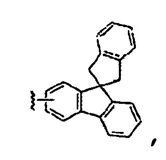 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂)alkylene or (C₃-C₁₂)alkenylene with or without a fused ring may be further substituted by one or more substituent(s) selected from (C₁-C₂₀)alkyl with or without halogen substituent(s), (C₁-C₂₀)alkoxy, halogen, tri(C₁-C₂₀)alkylsilyl, tri (C₆-C₂₀)arylsilyl, (C₁-C₂₀) alkylcarbonyl, (C₆-C₂₀)arylcarbonyl, di(C₁-C₂₀)alkylamino, di(C₆-C₂₀)arylamino and (C₆-C₂₀)aryl; and
n is an integer from 1 to 3.

### BRIEF DESCRIPTION OF THE DRAWINGS

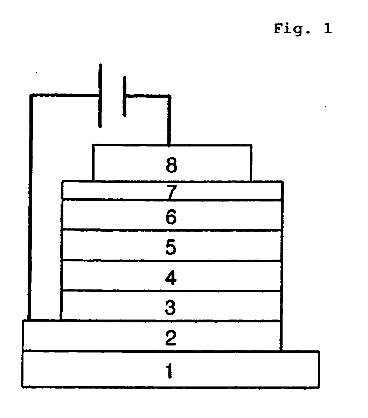

Fig. 1 is a cross-sectional view of an OLED.

### DETAILED DESCRIPTION OF THE INVENTION

Referring now to the drawings, Fig. 1 illustrates a cross-sectional view of an OLED of the present invention comprising Glass 1, Transparent electrode 2, Hole injection layer 3, Hole transport layer 4, Electroluminescent layer 5, Electron transport layer 6, Electron injection layer 7 and A1 cathode 8.

The naphthyl of Chemical Formula (I) may be 1-naphthyl and 2-naphthyl; the anthryl may be 1-anthryl, 2-anthryl and 9-anthryl; and the fluorenyl may be 1-fluorenyl, 2-fluorenyl, 3-fluorenyl, 4-fluorenyl and 9-fluorenyl.

The alicyclic ring, or the monocyclic or polycyclic aromatic ring formed from two of R₁₁ through R₁₄ in Chemical Formula (I) by linkage via (C₃-C₁₂)alkylene or (C₃-C₁₂)alkenylene with or without a fused ring is benzene, naphthalene, anthracene, fluorene, indene or phenanthrene. The compound within the square bracket ([]) serves as a primary ligand of iridium, and L serves as a subsidiary ligand. The organic phosphorescent compounds according to the present invention also include the complex with the ratio of primary ligand: subsidiary ligand = 2:1 (n=2) and the complex with the ratio of primary ligand: subsidiary ligand = 1:2 (n=1), as well as tris-chelated complexes without subsidiary ligand (L) (n=3).

R₁₁ through R₁₄ independently represent hydrogen, methyl, ethyl, n-propyl, i-propyl, n-butyl, i-bytyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, methylcarbonyl, ethylcarbonyl, t-butylcarbonyl, phenylcarbonyl, dimethylamino, diphenylamino, phenyl, naphthyl, anthryl, fluorenyl or 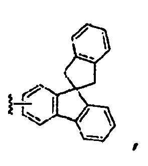 and the fluorenyl may be further substituted by methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, phenyl, naphthyl, anthryl, trimethylsilyl, tripropylsilyl, tri(t-butyl)silyl, t-butyldimethylsilyl or triphenylsilyl.

The organic phosphorescent compound according to the invention may be exemplified by the compounds represented by one of Chemical Formulas (II) to (VI): 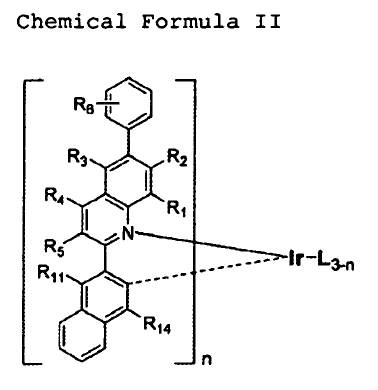 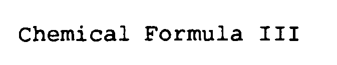 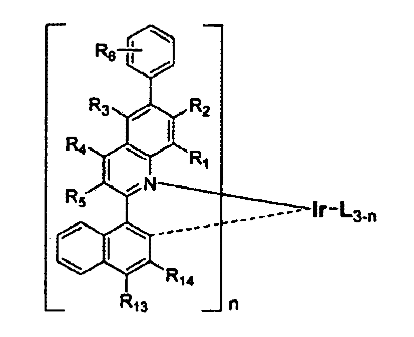 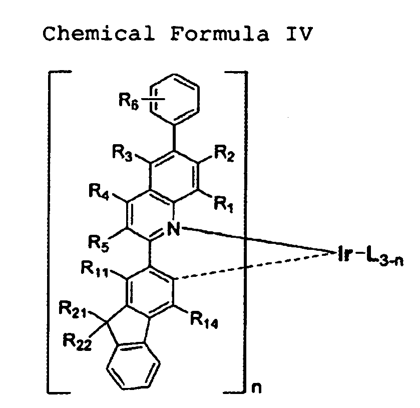 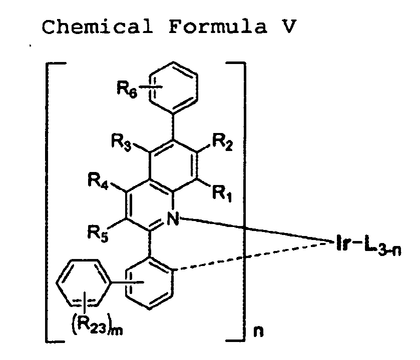 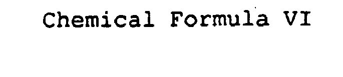 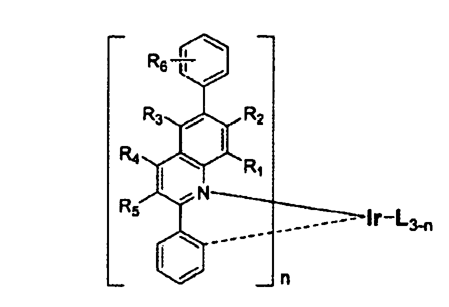 wherein, L, R₁, R₂, R₃, R₄, R₅, R₆, R₁₁, R₁₃, R₁₄ and n are defined as in Chemical Formula (I);
R₂₁ and R₂₂ independently represent hydrogen, (C₁-C₂₀)alkyl, (C₆-C₂₀)aryl, or R₂₁ and R₂₂ may be linked each other via (C₃-C₁₂)alkylene or (C₃-C₁₂)alkenylene with or without a fused ring to form an alicyclic ring, or a monocyclic or polycyclic aromatic ring;
R₂₃ represents (C₁-C₂₀)alkyl, halogen, cyano, tri(C₁-C₂₀)alkylsilyl, tri(C₆-C₂₀)arylsilyl, (C₁-C₂₀)alkoxy, (C₁-C₂₀)alkylcarbonyl, (C₆-C₂₀)arylcarbonyl, phenyl, di(C₁-C₂₀)alkylamino, di(C₆-C₂₀)arylamino, naphthyl, 9,9-di(C₁-C₂₀)alkylfluorenyl or 9,9-di(C₆-C₂₀)arylfluorenyl; and
m is an integer from 1 to 5.
R₁ through R₅ of Chemical Formula (I) independently represent hydrogen, methyl, ethyl, n-propyl, i-propyl, n-butyl, i-butyl, t-butyl, n-pentyl, i-pentyl, n-hexyl, n-heptyl, n-octyl, ethylhexyl, methoxy, ethoxy, butoxy, cyclopropyl, cyclohexyl, cycloheptyl, fluoro, trimethylsilyl, tripropylsilyl, tri(t-butyl)silyl, t-butyldimethylsilyl or triphenylsilyl; and R₆ represents hydrogen, methyl, ethyl, n-propyl, i-propyl, n-butyl, i-butyl, t-butyl, n-pentyl, n-hexyl, n-heptyl, n-octyl, ethylhexyl, fluoro, phenyl, naphthyl, anthryl, fluorenyl or spirobifluorenyl.

The organic phosphorescent compounds according to the present invention can be specifically exemplified by the following compounds, but they are not restricted thereto: 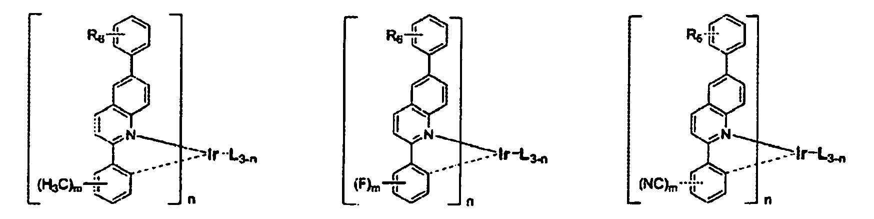 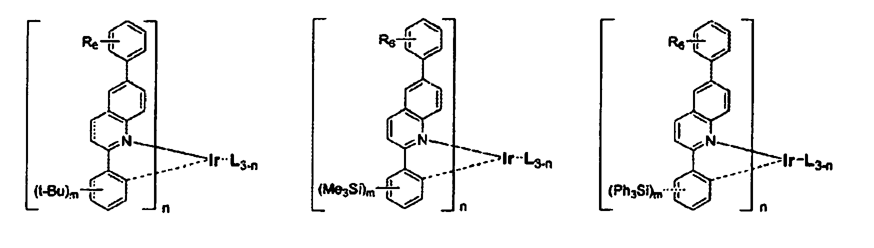 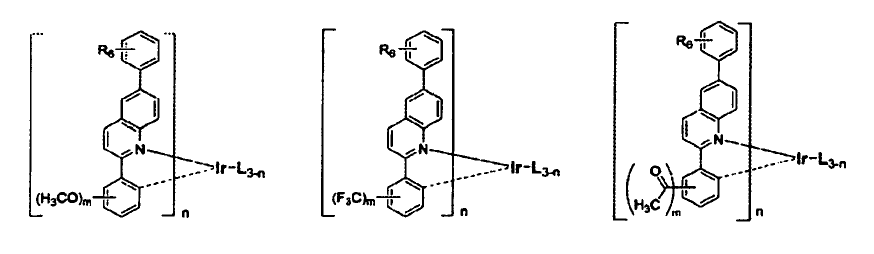 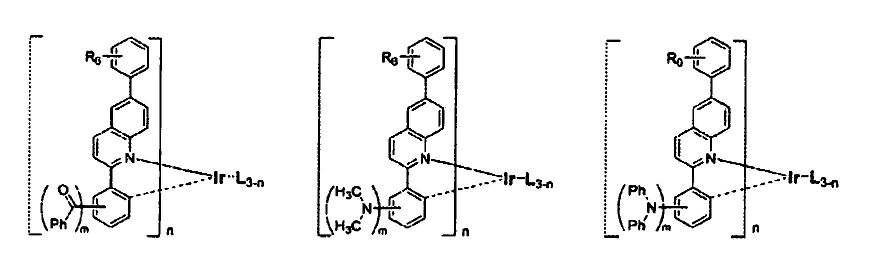 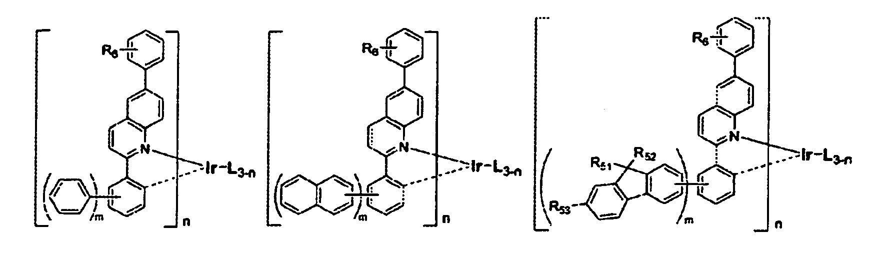 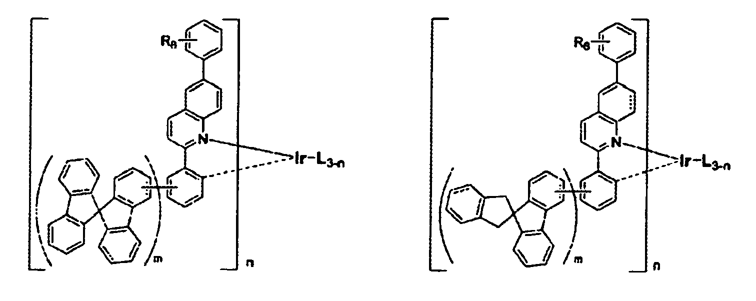 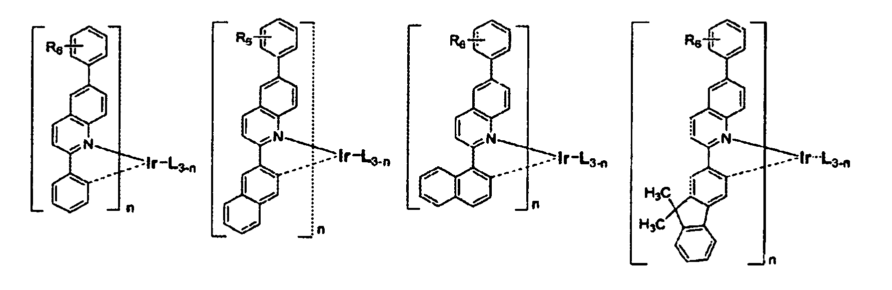 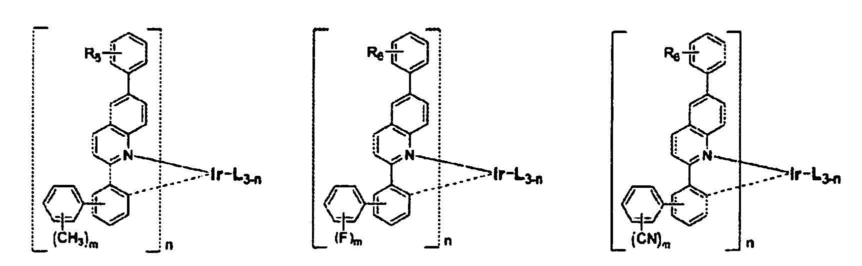 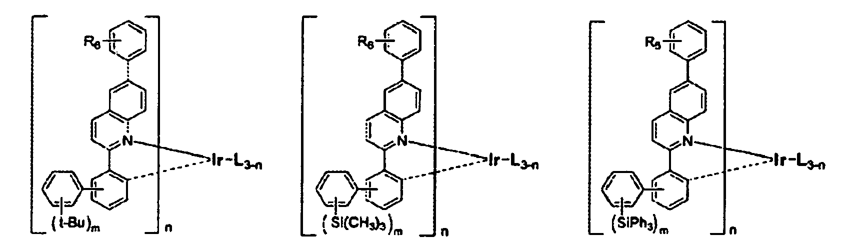 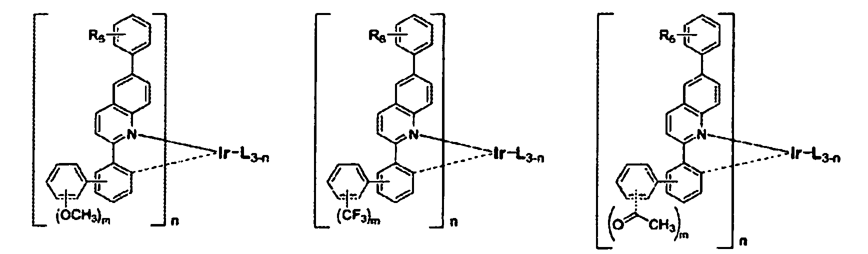 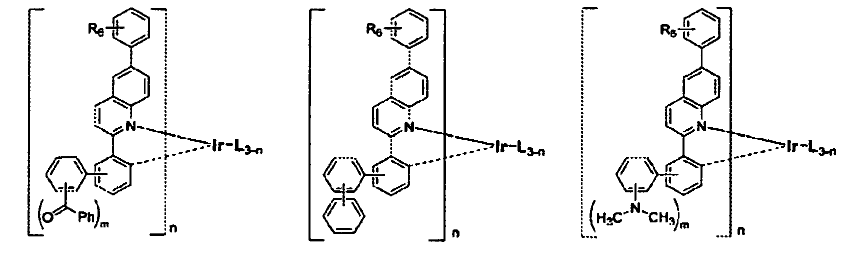 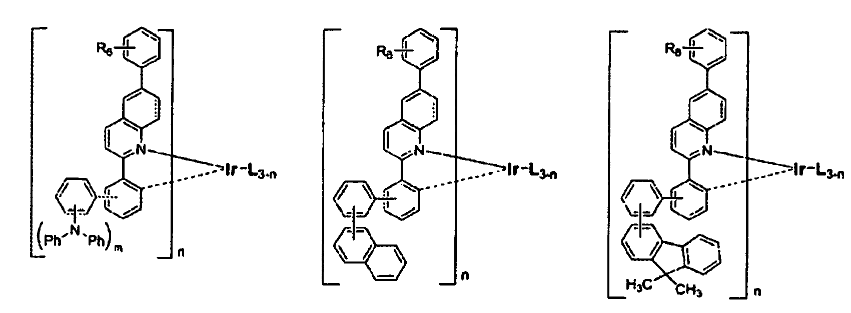 wherein, L represents an organic ligand;
R₆ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, fluoro, phenyl or naphthyl;
R₅, and R₅₂ independently represent methyl, ethyl, n-propyl, i-propyl, n-butyl, i-butyl, t-butyl, n-pentyl, i-pentyl, n-hexyl, n-heptyl, n-octyl, ethylhexyl, phenyl or naphthyl, or R₅, and R₅₂ may be linked each other via (C₃-C₁₂)alkylene or (C₃-C₁₂)alkenylene with or without a fused fing to form an alicyclic ring, or a monocyclic or polycyclic aromatic ring;
R₅₃ represents hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, trimethylsilyl, tripropylsilyl, tri(t-butyl)silyl, t-butyldimethylsilyl, triphenylsilyl, phenyl or naphthyl;
m is an integer from 1 to 3; and
n is an integer from 1 to 3.

The subsidiary ligands (L) of the organic phosphorescent compounds according to the present invention include the following structures: 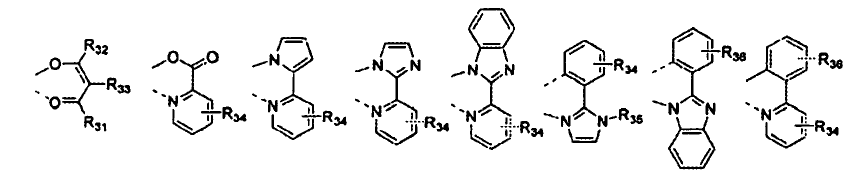 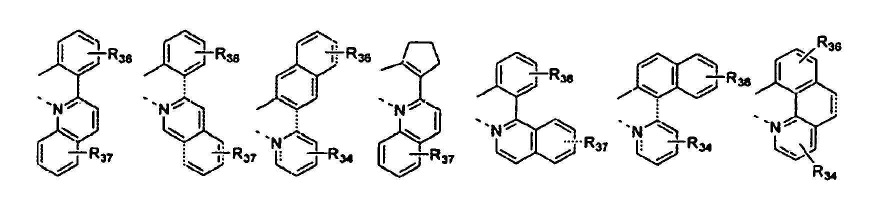 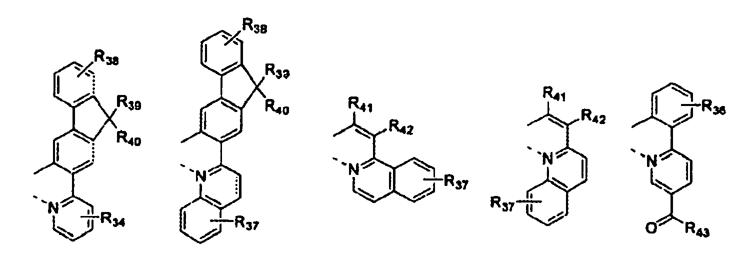 wherein, R₃₁ and R₃₂ independently represent hydrogen, (C₁-C₂₀)alkyl with or without halogen substituent(s), phenyl with or without (C₁-C₂₀)alkyl substituent(s) or halogen;
R₃₃ through R₃₈ independently represent hydrogen, (C₁-C₂₀)alkyl, phenyl with or without (C₁-C₂₀)alkyl substituent(s), tri(C₁-C₂₀)alkylsilyl or halogen;
R₃₉ through R₄₂ independently represent hydrogen, (C₁-C₂₀)alkyl, phenyl with or without (C₁-C₂₀)alkyl substituent(s); and
R₄₃ represents (C₁-C₂₀)alkyl, phenyl with or without (C₁-C₂₀)alkyl substituent(s), or halogen.

The subsidiary ligands (L) of the organic phosphorescent compounds according to the present invention can be exemplified by the following structures, but they are not restricted thereto:

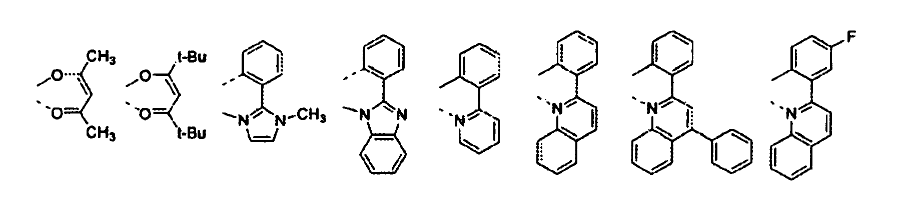

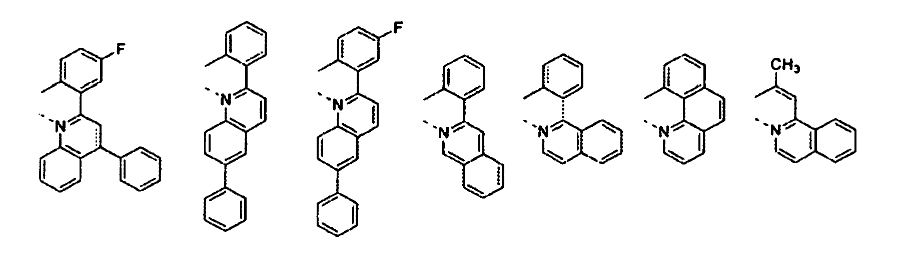

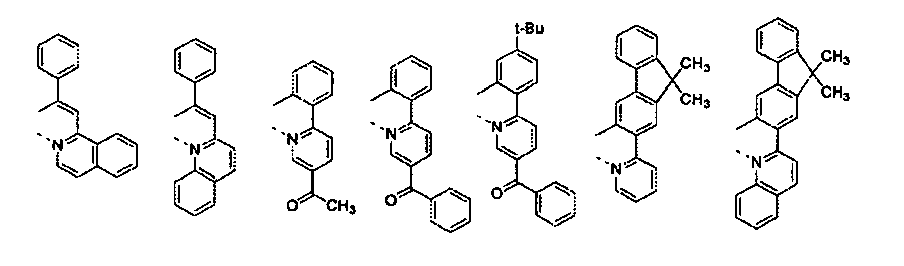

The process for preparing the organic phosphorescent compounds according to the present invention is described by referring to Reaction Schemes (1) to (3) shown below: 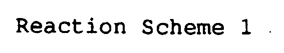 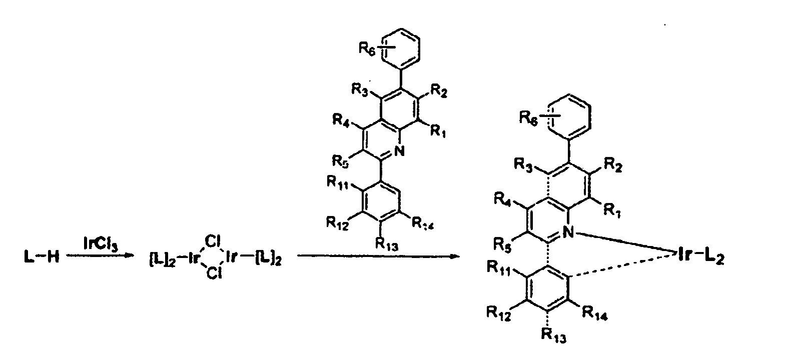 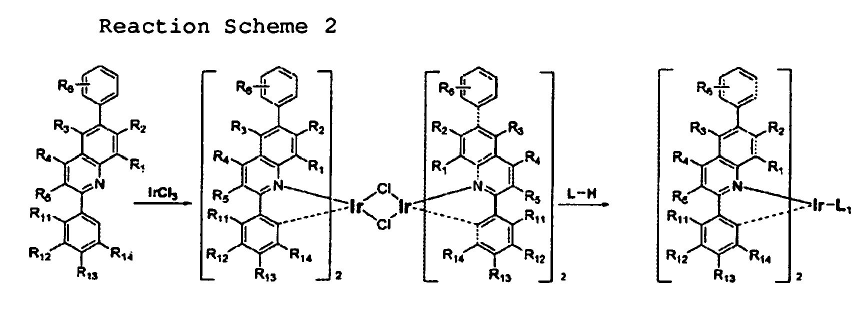 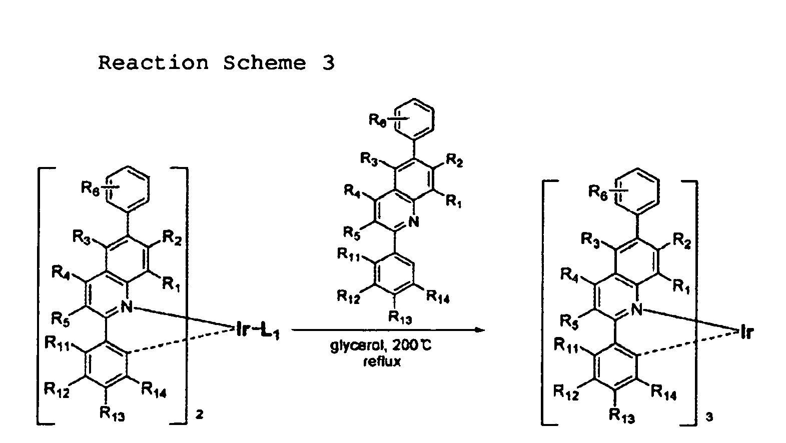 wherein, R₁, R₂, R₃, R₄, R₅, R₆, R₁₁, R₁₂, R₁₃, R₁₄ and L are defined as in Chemical Formula (I).

Reaction Scheme (1) provides a compound of Chemical Formula (I) with n=1 in which iridium trichloride (IrCl₃) and a subsidiary ligand compound (L-H) are mixed in a solvent at a molar ratio of 1:2~3, and the mixture is heated under reflux to isolate diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with a primary ligand compound as a in organic solvent to provide an organic phosphorescent iridium compound having the ratio of primary ligand: subsidiary ligand of 1:2 as the final product. The reaction is carried out with AgCF₃SO₃, Na₂CO₃ or NaOH being admixed with organic solvent such as 2-ethoxyethanol and 2-methoxyethylether.

Reaction Scheme (2) provides a compound of Chemical Formula (I) with n=2, in which iridium trichloride (IrCl₃) and a primary ligand compound are mixed in a solvent at a molar ratio of 1:2~3, and the mixture is heated under reflux to isolate diiridium dimer. In the reaction stage, preferable solvent is alcohol or a mixed solvent of alcohol/water, such as 2-ethoxyethanol, and 2-ethoxyethanol/water mixture. The isolated diiridium dimer is then heated with the subsidiary ligand compound (L-H) in organic solvent to provide an organic phosphorescent iridium compound having the ratio of primary ligand: subsidiary ligand of 2:1 as the final product.

The molar ratio of the primary ligand of Chemical Formula (I) and the subsidiary ligand (L) in the final product is determined by appropriate molar ratio of the reactant depending on the composition. The reaction may be carried out with AgCF₃SO₃, Na₂CO₃ or NaOH being admixed with organic solvent such as 2-ethoxyethanol, 2-methoxyethylether and 1,2-dichloromethane.

Reaction Scheme (3) provides a compound of Chemical Formula (I) with n=3, in which iridium complex prepared according to Reaction Scheme (2) and a compound of Chemical Formula (I) as primary ligand are mixed in glycerol at a molar ratio of 1:2~3, and the mixture is heated under reflux to obtain organic phosphorescent iridium complex coordinated with three primary ligands.

The compounds employed as a primary ligand in the present invention can be prepared according to Reaction Scheme (4), on the basis of conventional processes. 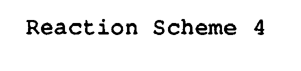 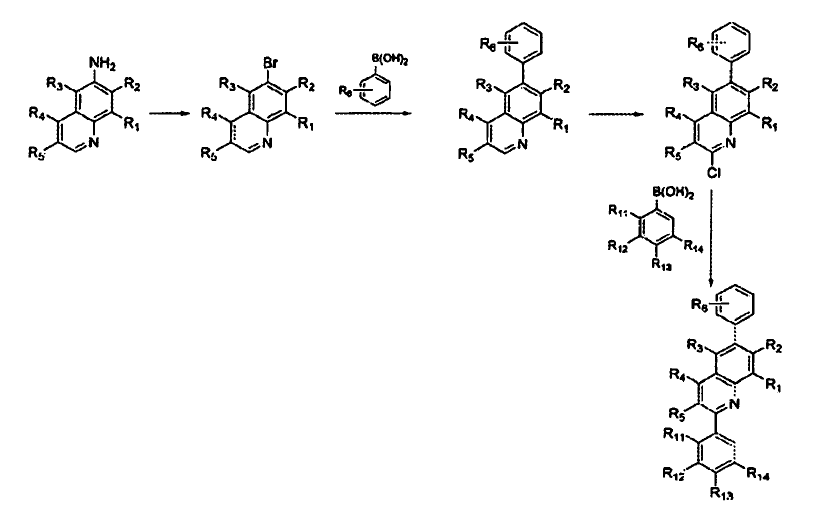 wherein, R₁ through R₆ and R₁₁ through R₁₄ are defined as in Chemical Formula (I).

The present invention also provides an organic electroluminescent device which is comprised of a first electrode; a second electrode; and at least one organic layer(s) interposed between the first electrode and the second electrode; wherein the organic layer comprises one or more compound(s) represented by Chemical Formula (I): 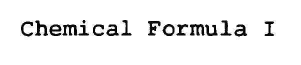 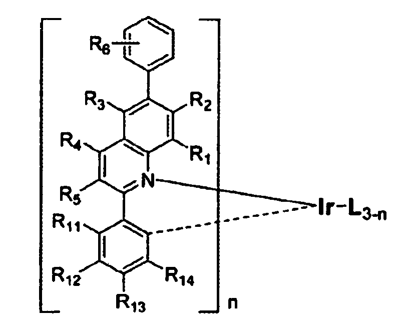 wherein, L is an organic ligand;
R₁ through R₅ independently represent hydrogen, (C₁-C₂₀)alkyl, (C₁-C₂₀)alkoxy, (C₃-C₁₂)cycloalkyl, halogen, tri(C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri(C₁-C₂₀)alkylsilyl, tri(C₆-C₂₀)arylsilyl, (C₁-C₂₀)alkoxy, (C₁-C₂₀)alkylcarbonyl, (C₆-C₂₀)arylcarbonyl, di(C₁-C₂₀)alkylamino, di(C₆-C₂₀)arylamino, phenyl, naphthyl, anthryl, fluorenyl, spirobifluorenyl or 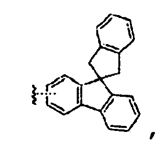 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂)alkylene or (C₃-C₁₂)alkenylene with or without a fused ring may be further substituted by one or more substituent(s) selected from (C₁-C₂₀)alkyl with or without halogen substituent(s), (C₁-C₂₀)alkoxy, halogen, tri(C₁-C₂₀)alkylsilyl, tri (C₆-C₂₀)arylsilyl, (C₁-C₂₀)alkylcarbonyl, (C₆-C₂₀)arylcarbonyl, di(C₁-C₂₀)alkylamino, di(C₆-C₂₀)arylamino and (C₆-C₂₀)aryl; and
n is an integer from 1 to 3.

The organic electroluminescent device according to the present invention is characterized in that the organic layer comprises an electroluminescent region, which comprises one or more compound(s) represented by Chemical Formula (I) as electroluminescent dopant, and one or more host(s). The host applied to the organic electroluminescent device according to the invention is not particularly restricted, but can be exemplified by the compounds represented by one of Chemical Formulas (VII) to (IX):

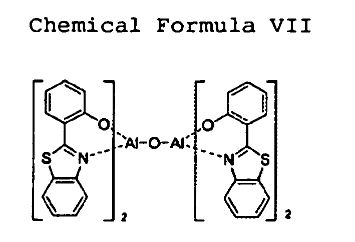

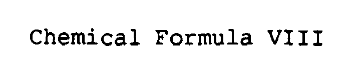

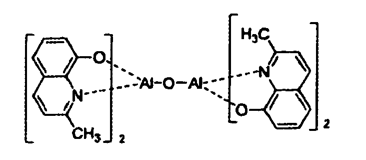

Chemical Formula IX L¹L²M(Q)_{y}

wherein, the ligands, L¹ and L² independently represent one of the following structures: 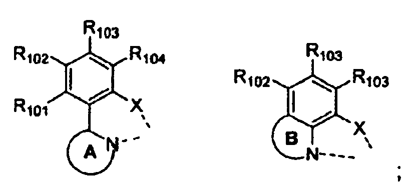 M is a bivalent or trivalent metal;
y is 0 when M is a bivalent metal, while y is 1 when M is a trivalent metal;
Q represents (C₆-C₂₀)aryloxy or tri(C₆-C₂₀)arylsilyl, and the aryloxy and triarylsilyl of Q may be further substituted by (C₁-C₅)alkyl or (C₆-C₂₀)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C₁-C₅)alkyl, or substituted or unsubstituted phenyl or naphthyl;
R₁₀₁ through R₁₀₄ independently represent hydrogen, (C₁-C₅)alkyl, halogen, tri(C₁-C₅)alkylsilyl, tri(C₆-C₂₀)arylsilyl or (C₆-C₂₀)aryl, or each of them may be linked to an adjacent substituent via alkylene or alkenylene to form a fused ring, and the pyridine or quinoline may form a chemical bond together with R₁₀₁ to form a fused ring; and
the ring A or aryl group of R₁₀₁ through R₁₀₄ may be further substituted by (C₁-C₅)alkyl, halogen, (C₁-C₅)alkyl with halogen substituent(s), phenyl, naphthyl, tri(C₁-C₅)alkylsilyl, tri(C₆-C₂₀)arylsilyl or amino group.

The ligands, L¹ and L² are independently selected from the following structures: 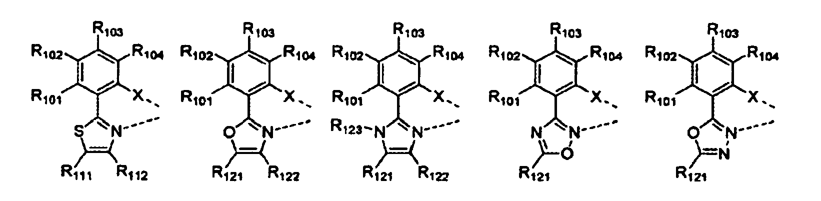 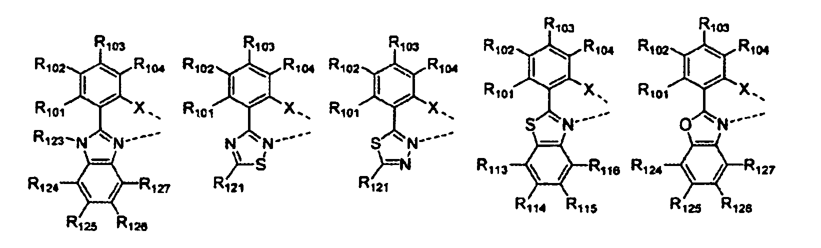 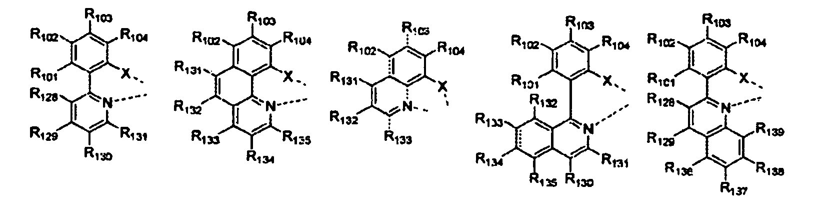 wherein, X represents O, S or Se; R₁₀₁ through R₁₀₄ independently represent hydrogen, (C₁-C₅)alkyl with or without halogen substituent(s), halogen, (C₆-C₂₀)aryl, (C₄-C₂₀)heteroaryl, tri (C₁-C₅)alkylsilyl, tri (C₆-C₂₀)arylsilyl, di(C₁-C₅)alkylamino, di (C₆-C₂₀)arylamino, thiophenyl or furanyl, or each of them may be linked to an adjacent substituent via alkylene or alkenylene to form a fused ring;
R₁₁₁ through R₁₁₆, R₁₂₁ and R₁₂₂ independently represent hydrogen, (C₁-C₅)alkyl, halogen, (C₁-C₅)alkyl with halogen substituent(s), phenyl, naphthyl, biphenyl, fluorenyl, tri(C₁-C₅)alkylsilyl, tri(C₆-C₂₀)arylsilyl, di(C₁-C₅)alkylamino, di(C₆-C₂₀)arylamino, thiophenyl or furanyl;
R₁₂₃ represents (C₁-C₂₀)alkyl, phenyl or naphthyl;
R₁₂₄ through R₁₃₉ independently represent hydrogen, (C₁-C₅)alkyl, halogen, (C₁-C₅)alkyl with halogen substituent(s), phenyl, naphthyl, biphenyl, fluorenyl, tri(C₁-C₅)alkylsilyl, tri (C₆-C₂₀) arylsilyl, di(C₁-C₅) alkylamino, di (C₆-C₂₀)arylamino, thiophenyl or furanyl; and
the phenyl, naphthyl, biphenyl, fluorenyl, thiophenyl or furanyl of R₁₁₁ through R₁₁₆ and R₁₂₁ through R₁₃₉ may be further substituted by one or more substituent(s) selected from (C₁-C₅)alkyl, halogen, naphthyl, fluorenyl, tri(C₁-C₅)alkylsilyl, tri(C₆-C₂₀)arylsilyl, di (C₁-C₅) alkylamino and di(C₆-C₂₀)arylamino.

In Chemical Formula (IX), M is a bivalent metal selected from Be, Zn, Mg, Cu and Ni, or a trivalent metal selected from Al, Ga, In and B, and Q is selected from the following structures.

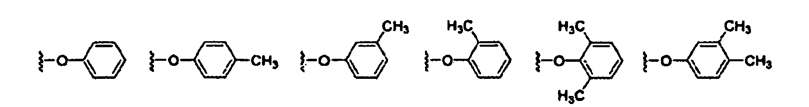

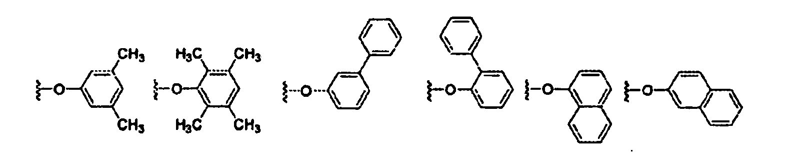

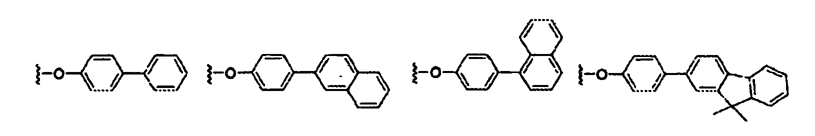

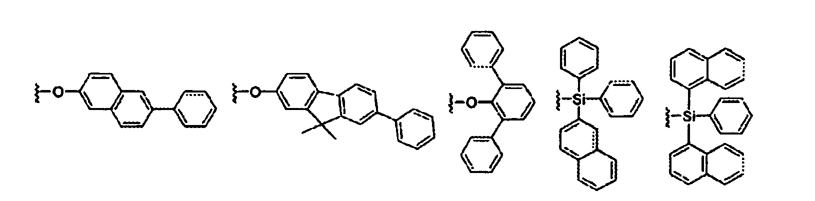

The compound of Chemical Formula (IX) is selected from the compounds represented by the following structures.

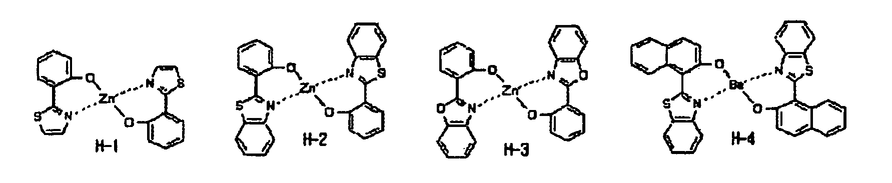

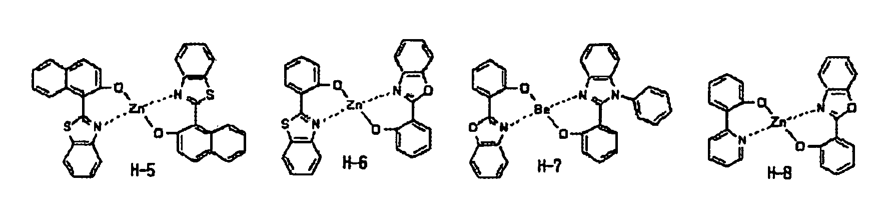

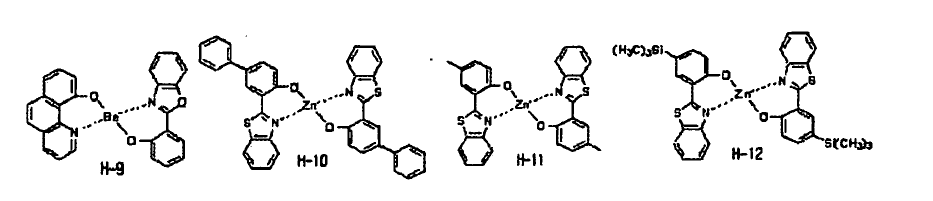

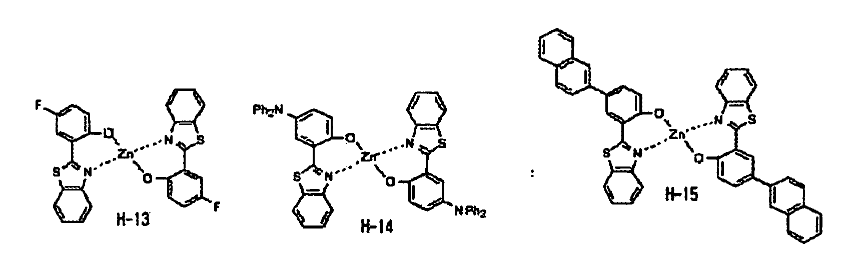

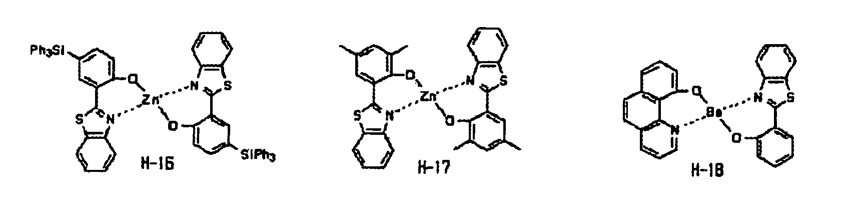

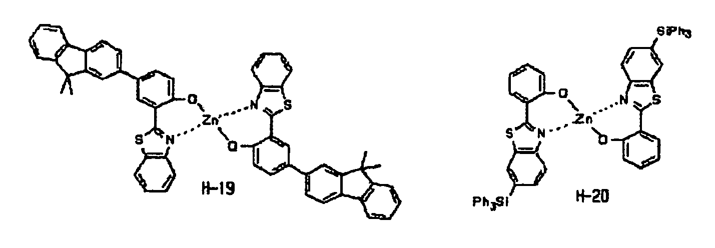

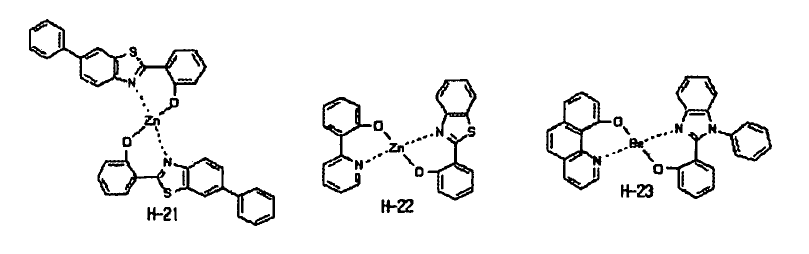

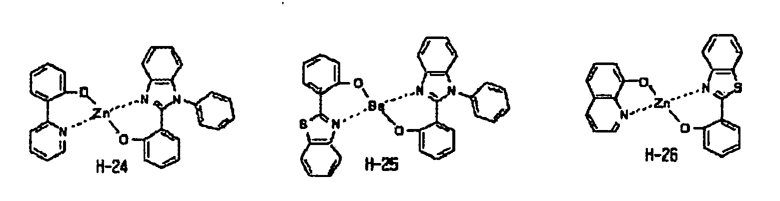

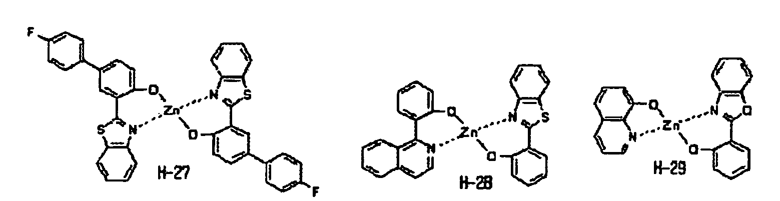

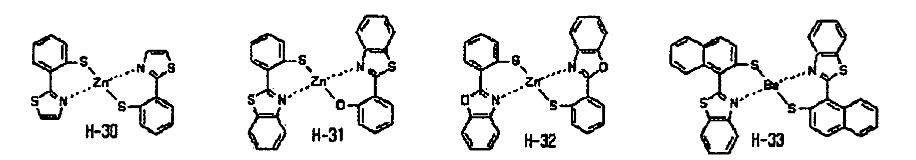

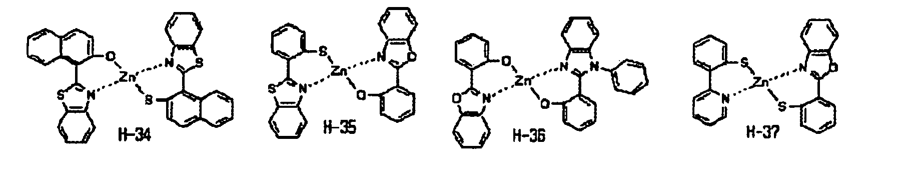

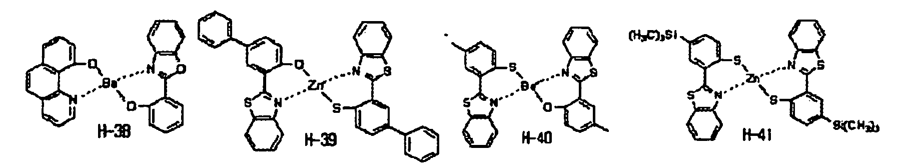

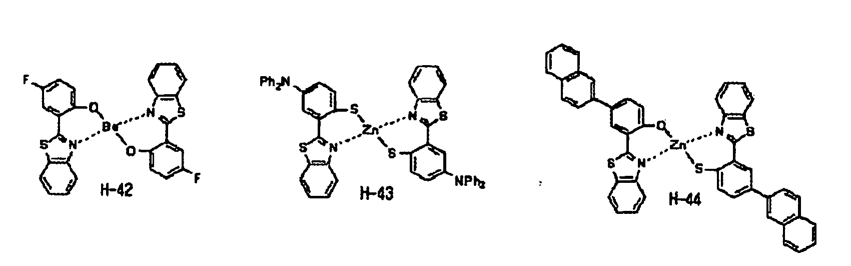

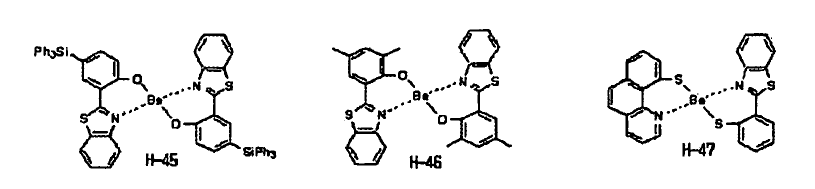

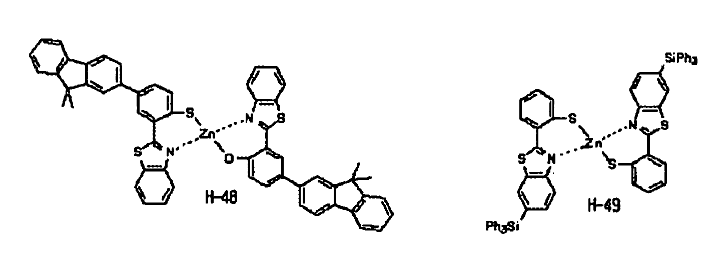

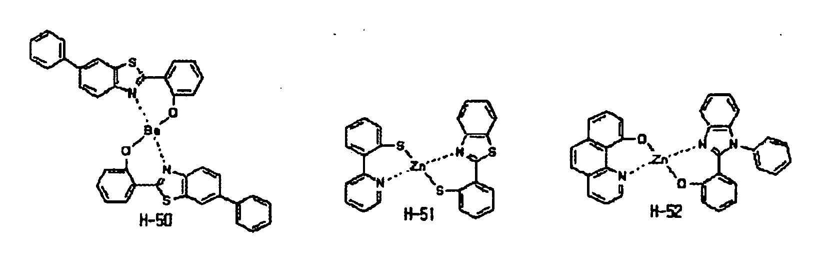

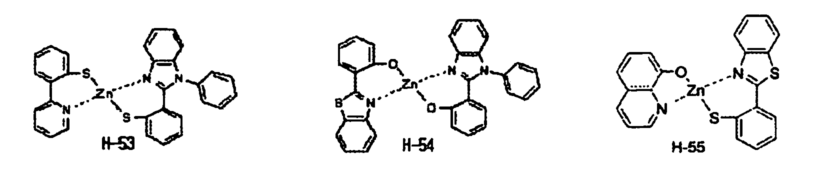

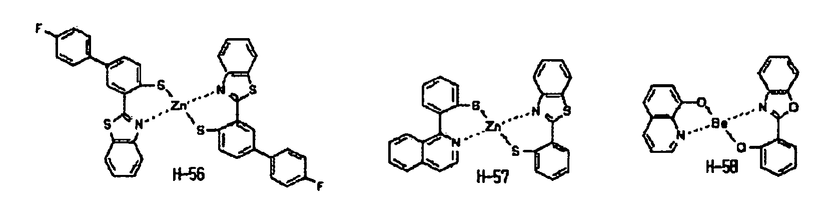

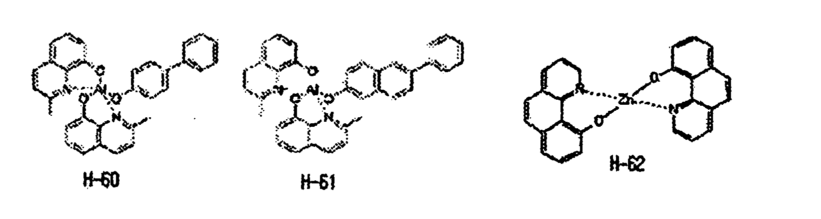

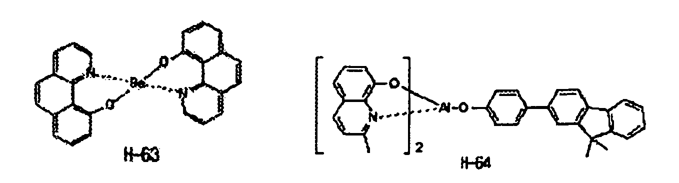

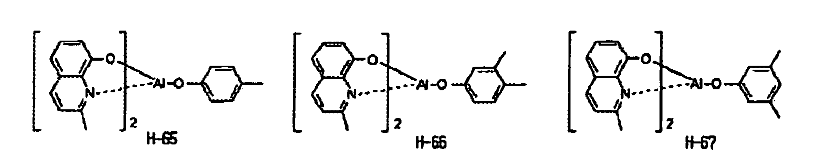

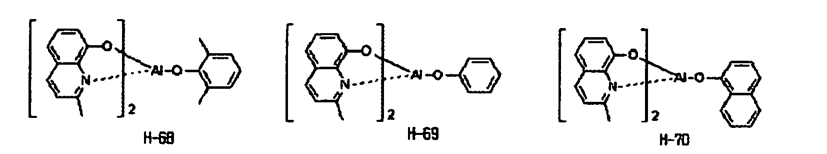

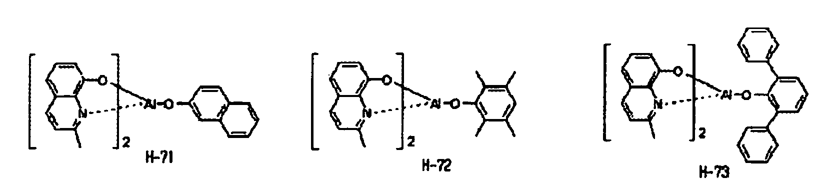

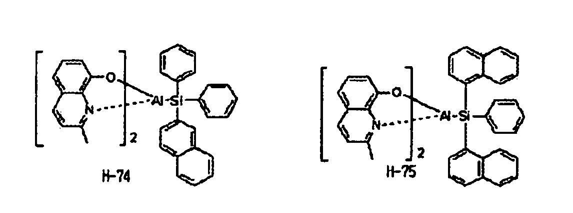

The red electroluminescent compounds according to the present invention, being a compound of more beneficial skeletal in terms of better properties and thermal stability than conventional red phosphorescent materials, exhibit excellent luminous efficiency and color purity, and thus an OLED with lowered operation voltage can be manufactured therefrom.

The present invention is further described with respect to the processes for preparing novel organic phosphorescent compounds according to the invention by referring to Examples, which are provided for illustration only but are not intended to limit the scope of the invention by any means.

### Preparation Examples

### Preparation Example 1 - Preparation of Compound (11)

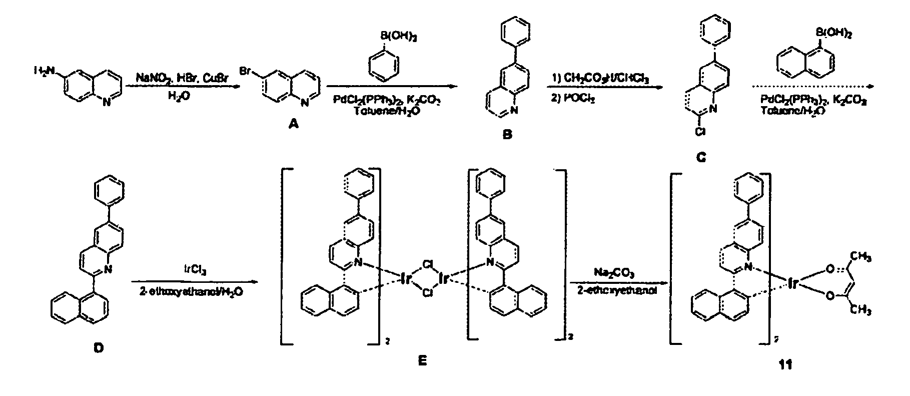

### Preparation of Compound (A)

In aqueous hydrobromide solution (48% aq. HBr) (60 mL), dissolved was 6-aminoquinoline (20.0 g, 138.7 mmol), and the solution was chilled to -10°C. After adding aqueous sodium nitrate solution (10.9 g in 100 mL of H₂O) (158.1 mmol) thereto, the reaction mixture was stirred at 0°C for 10 minutes. To the mixture, added was solution of copper bromide (23.1 g, 160.9 mmol) in 240 mL of water and 65 mL of aqueous HBr. The resultant mixture was heated with stirring at 60°C for 30 minutes. When the reaction was completed, the mixture was cooled to room temperature, and ice water was added thereto. After adjusting the pH to about 10 by using aqueous NaOH (4M) solution, the mixture was extracted with ethyl acetate, and the extract was filtered under reduced pressure. Purification via silicagel column chromatography gave Compound (A) (18.2 g, 87.4 mmol).

### Preparation of Compound (B)

In toluene (150 mL) and ethanol (45 mL), dissolved were Compound (A) (18.0 g, 86.5 mmol), phenylboronic acid (12.7 g, 103.8 mmol), tetraki spalladium (0) triphenylphosphine (Pd(PPh₃)₄) (3.6 g, 5.2 mmol). To the solution, aqueous 2M sodium carbonate solution (70 mL) was added, and the mixture was stirred under reflux at 120°C for 4 hours. After cooling the mixture to 25°C, distilled water (200 mL) was added to quench the reaction. The mixture was extracted with ethyl acetate (300 mL), and the extract was dried under reduced pressure. Purification via silicagel column chromatography gave Compound (B) (14.6 g, 70.9 mmol).

### Preparation of Compound (C)

Compound (B) (14.0 g, 68.2 mmol) was dissolved in chloroform (200 mL), and peroxyacetic acid (150 mL) was added thereto. The reaction mixture was stirred under reflux for 4 hours. When the reaction was completed, the reaction mixture was cooled to room temperature, and ice water was added thereto. After adjusting the pH to about 10 by using aqueous sodium hydroxide solution (10M), the solid produced was obtained under reduced pressure. The solid was cooled to 5°C, and POCl₃ 150 mL was added thereto, and the resultant mixture was stirred under reflux at 100°C for 1 hour. After cooling the solution to room temperature, ice water was added thereto. By using aqueous sodium hydroxide solution (10M), the pH of the solution was adjusted to about 8, and the solution was then extracted with dichloromethane. The extract was filtered under reduced pressure. Purification via silicagel column chromatography gave Compound (C) (6.2 g, 25.9 mmol).

### Preparation of Compound (D)

In toluene (100 mL) and ethanol (30 mL), dissolved were Compound (C) (6.0 g, 25.0 mmol), 1-naphthalene boronic acid (6.0 g, 30.0 mmol), tetrakispalladium (0) triphenylphosphine (Pd(PPh₃)₄) (1.1 g, 1.5 mmol). To the solution, aqueous 2M sodium carbonate solution (30 mL) was added, and the mixture was stirred under reflux at 120°C for 4 hours. After cooling the mixture to 25°C, distilled water (200 mL) was added thereto to quench the reaction. The mixture was extracted with ethyl acetate (300 mL), and the extract was dried under reduced pressure. Purification via silicagel column chromatography gave Compound (D) (7.2 g, 20.0 mmol).

### Preparation of Compound (E)

In 2-ethoxyethanol (80 mL) and distilled water (35 mL), dissolved were Compound (D) (7.0 g, 19.6 mmol) and iridium chloride (IrCl₃) (2.63 g, 8.82 mmol), and the solution was stirred under reflux for 24 hours. When the reaction was completed, the reaction mixture was cooled to room temperature. The solid thus produced was filtered and dried to obtain Compound (E) (9.1 g, 7.79 mmol).

### Preparation of (Compound (11)

In 2-ethoxyethanol (240 mL), dissolved were Compound (E) (9.1 g, 7.8 mmol), 2,4-pentanedione (0.9 g, 9.3 mmol), and Na₂CO₃ (3.0 g, 28.0 mmol), and the solution was heated for 4 hours. When the reaction was completed, the reaction mixture was cooled to room temperature, and the solid precipitate produced was filtered. Purification via silicagel column chromatography and recrystallization gave Compound (11) (0.8 g, 1.3 mmol, overall yield: 16%) as red crystal.

According to the same procedure as Preparation Example 1, organic phosphorescent compounds (Compound 1 through Compound 1023) in Table 1 were prepared, of which the ¹H NMR and MS/FAB data are listed in Table 2.

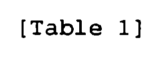

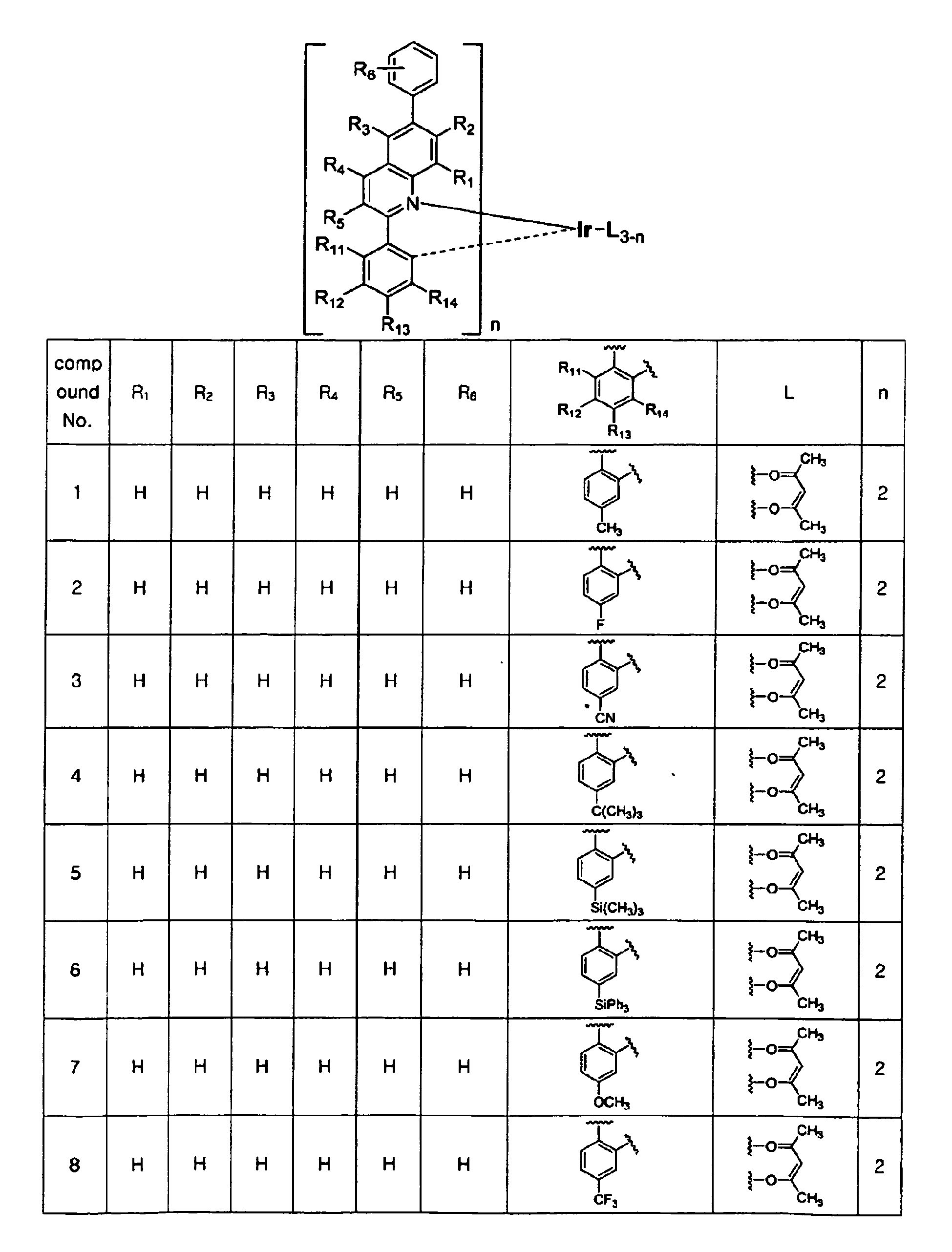

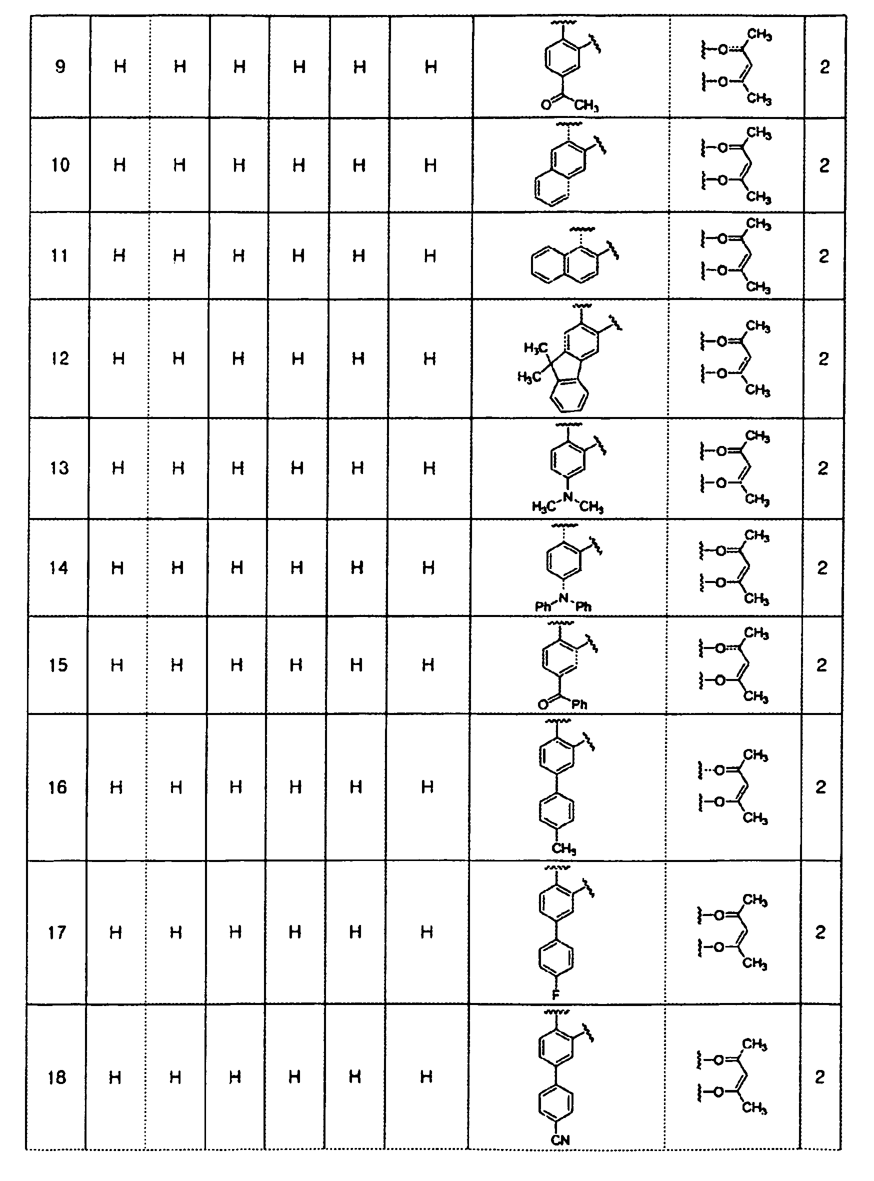

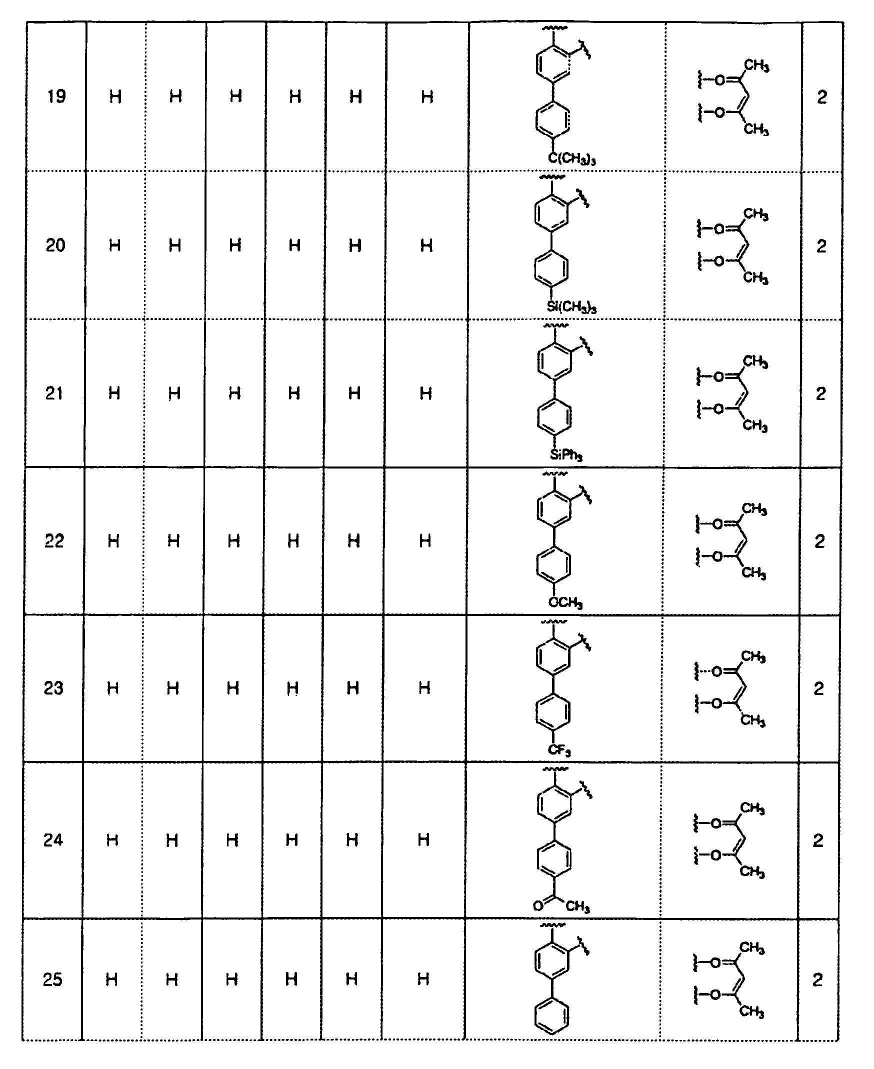

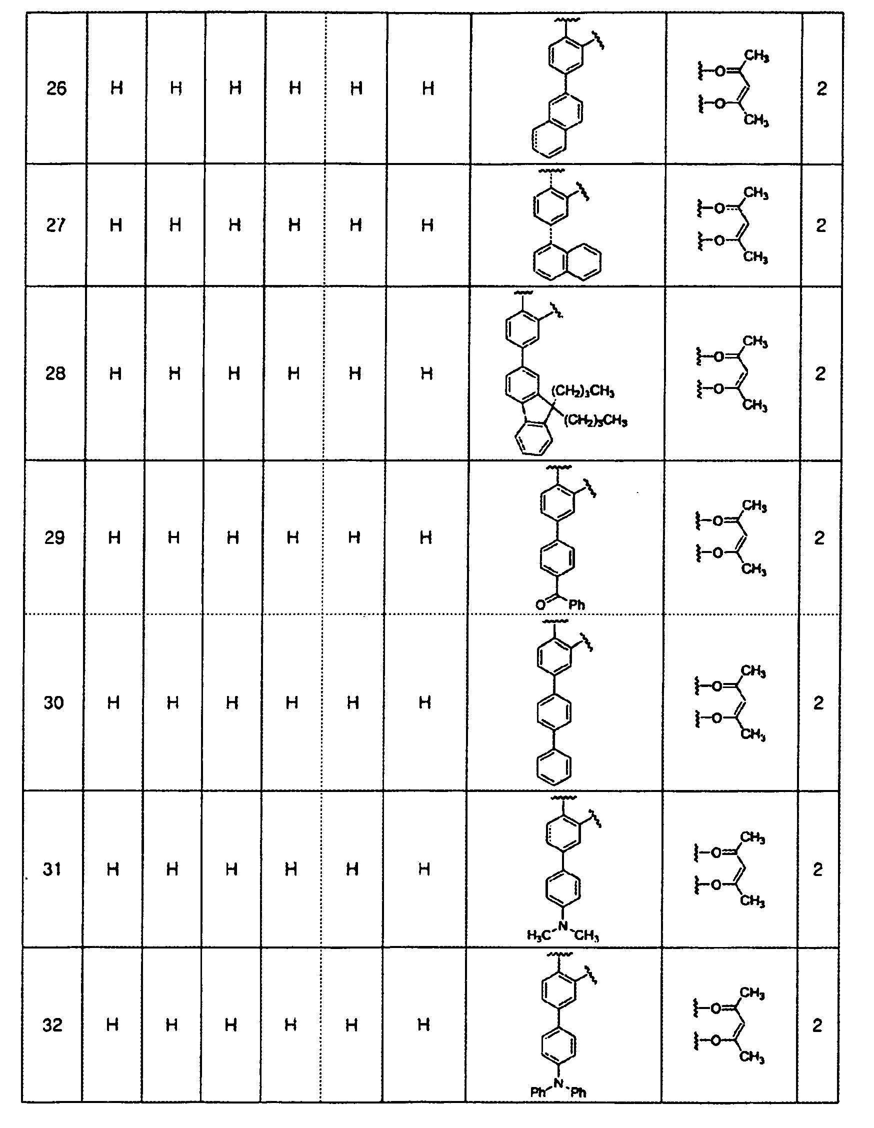

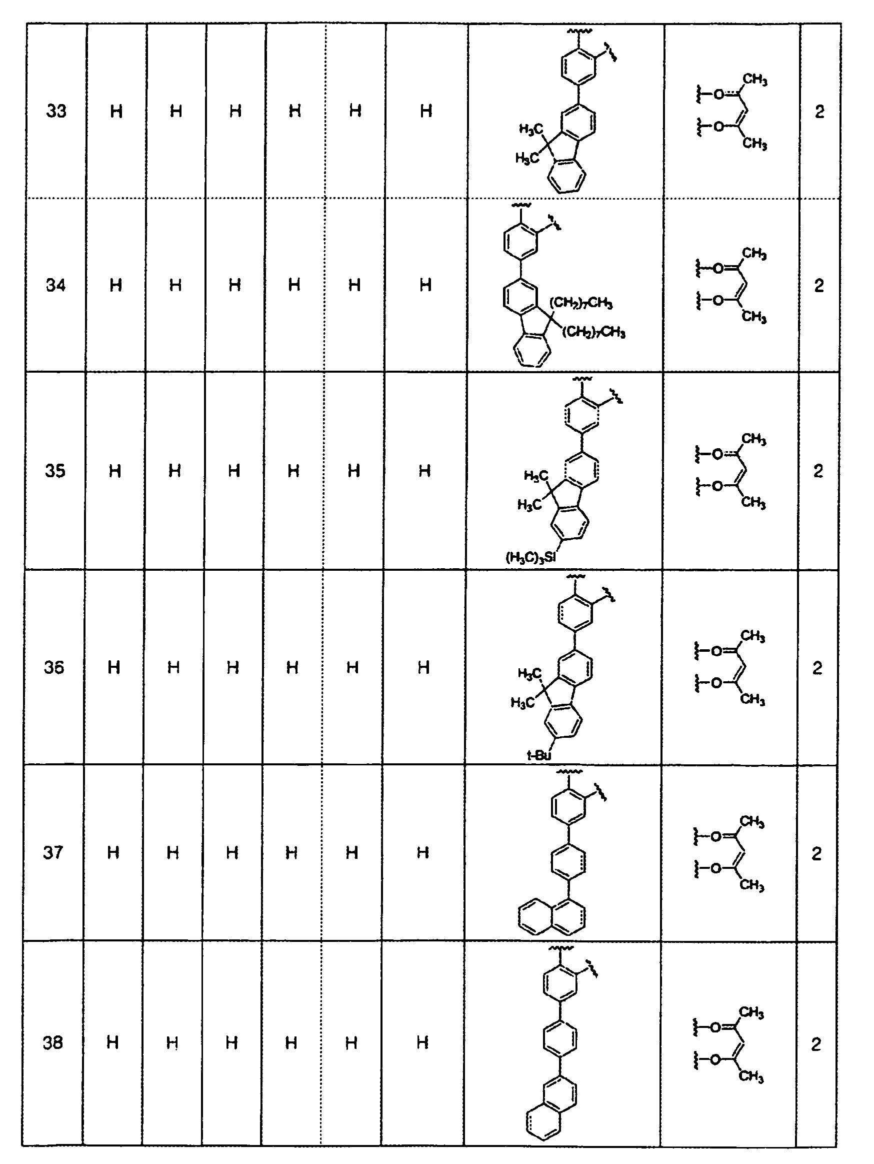

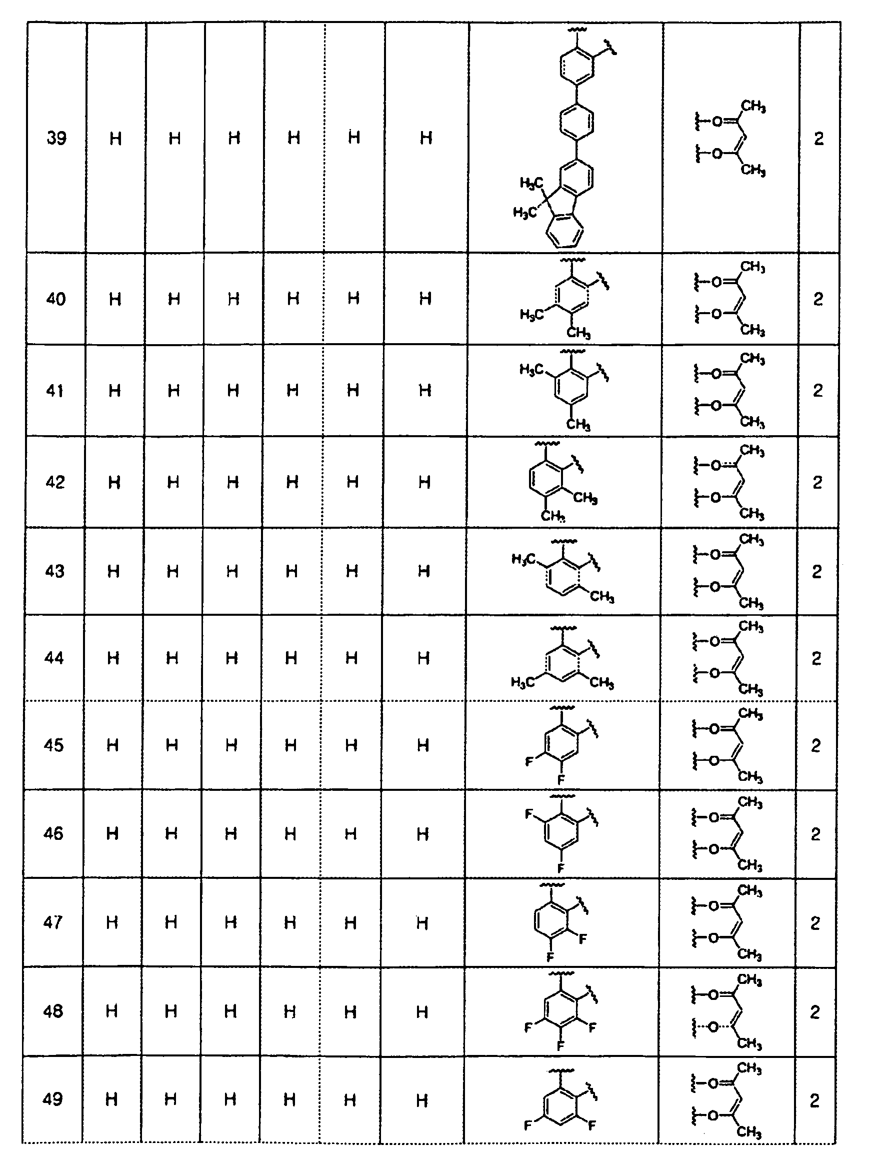

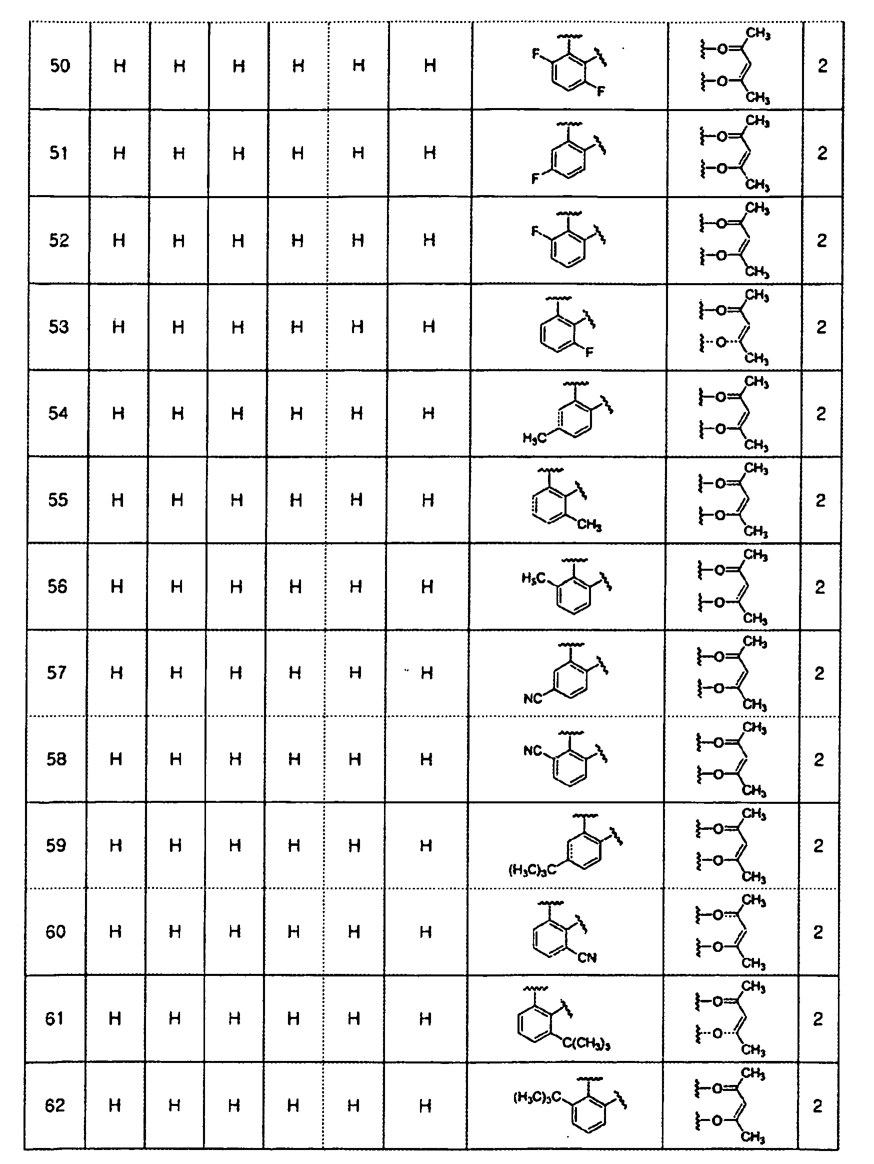

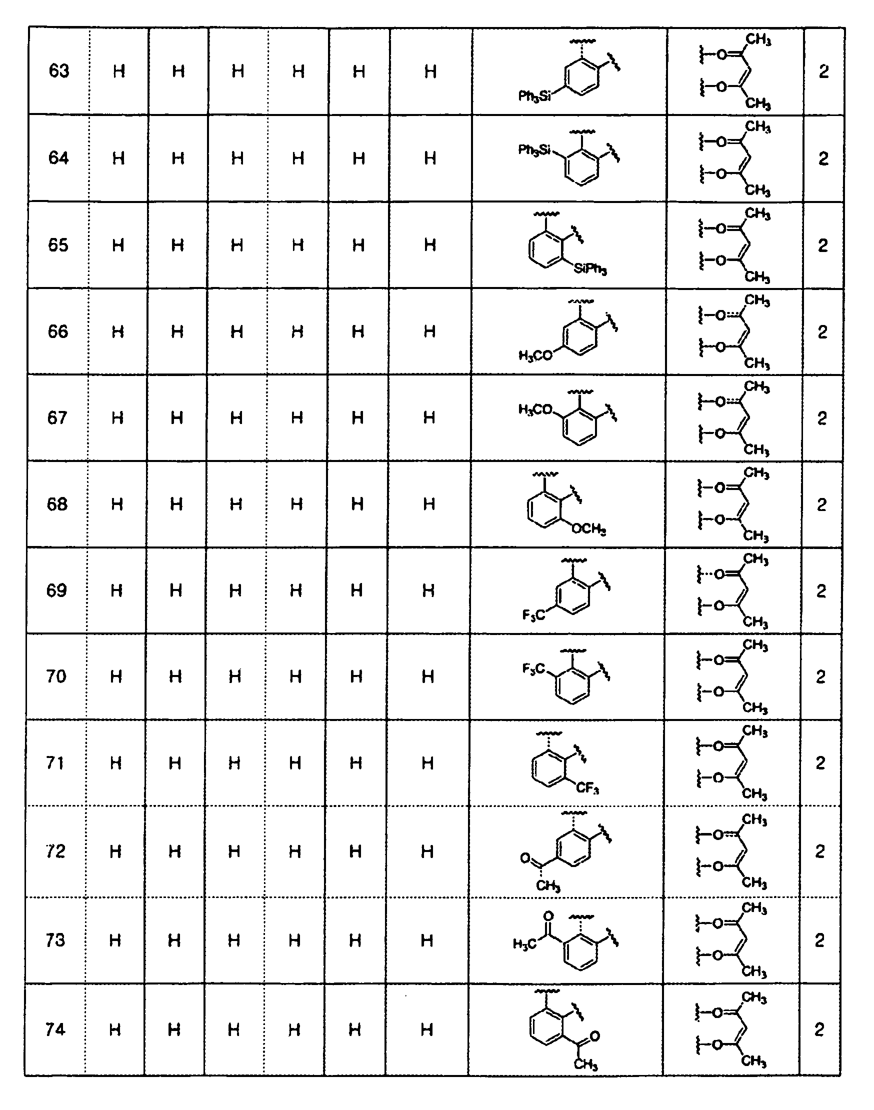

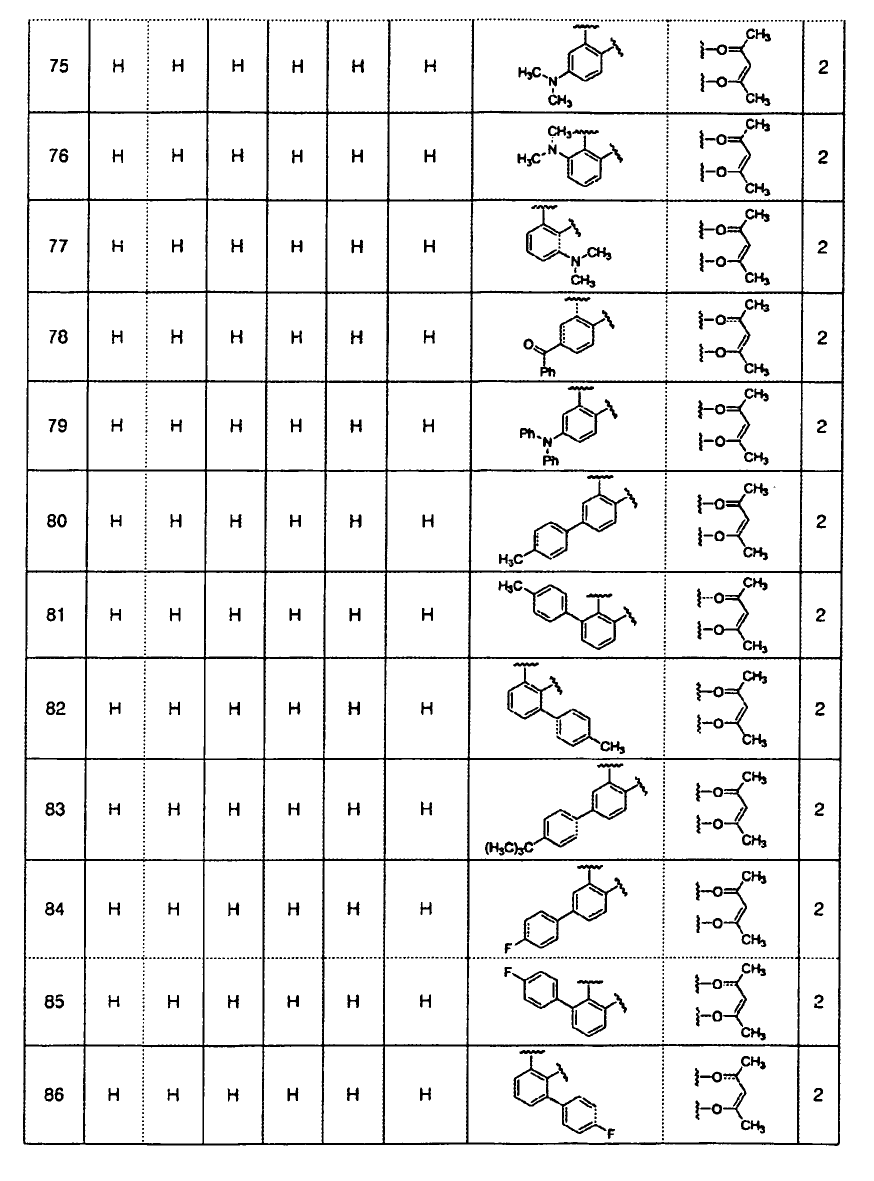

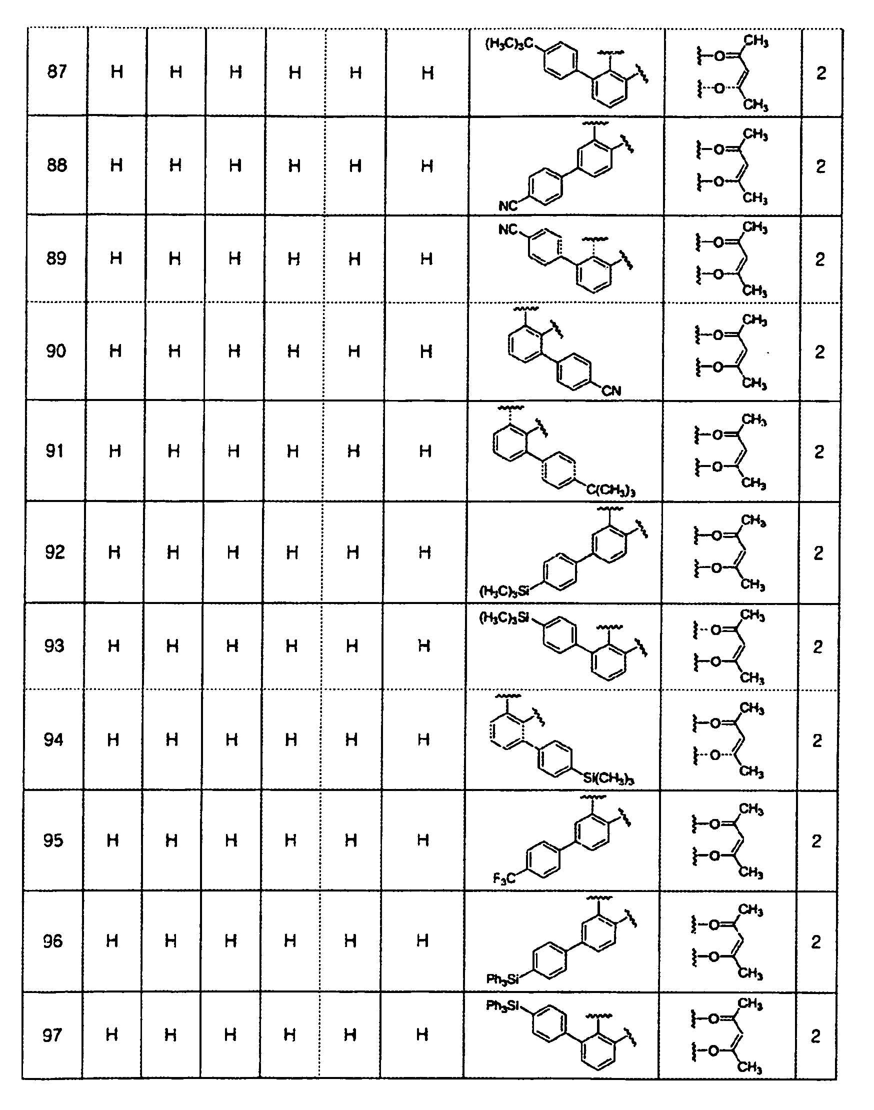

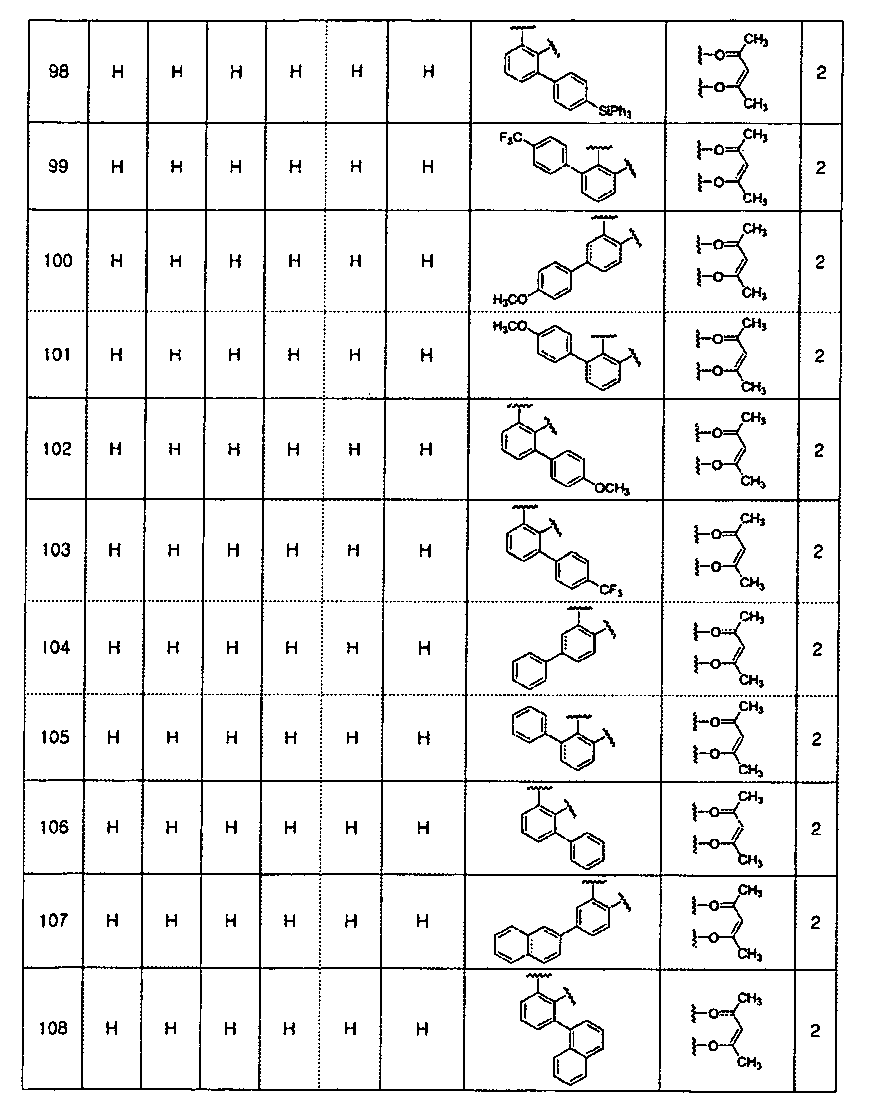

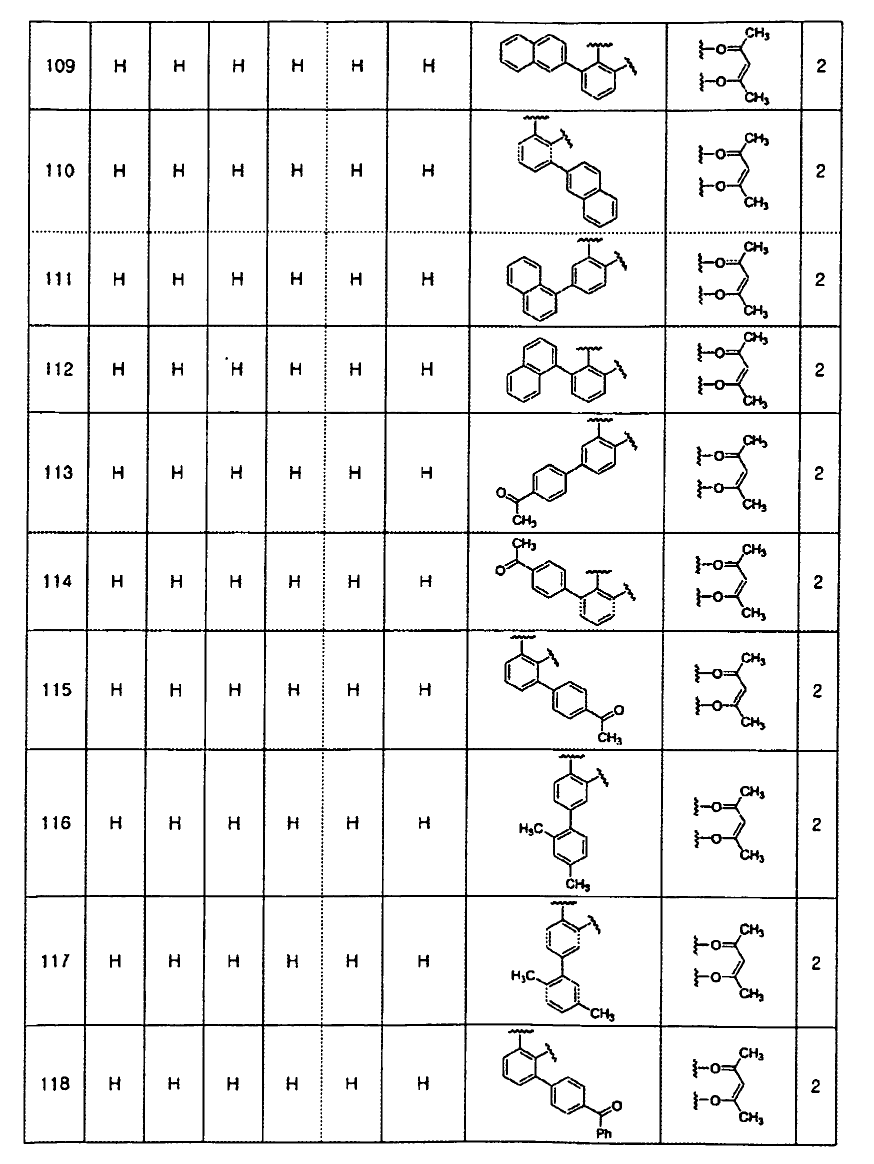

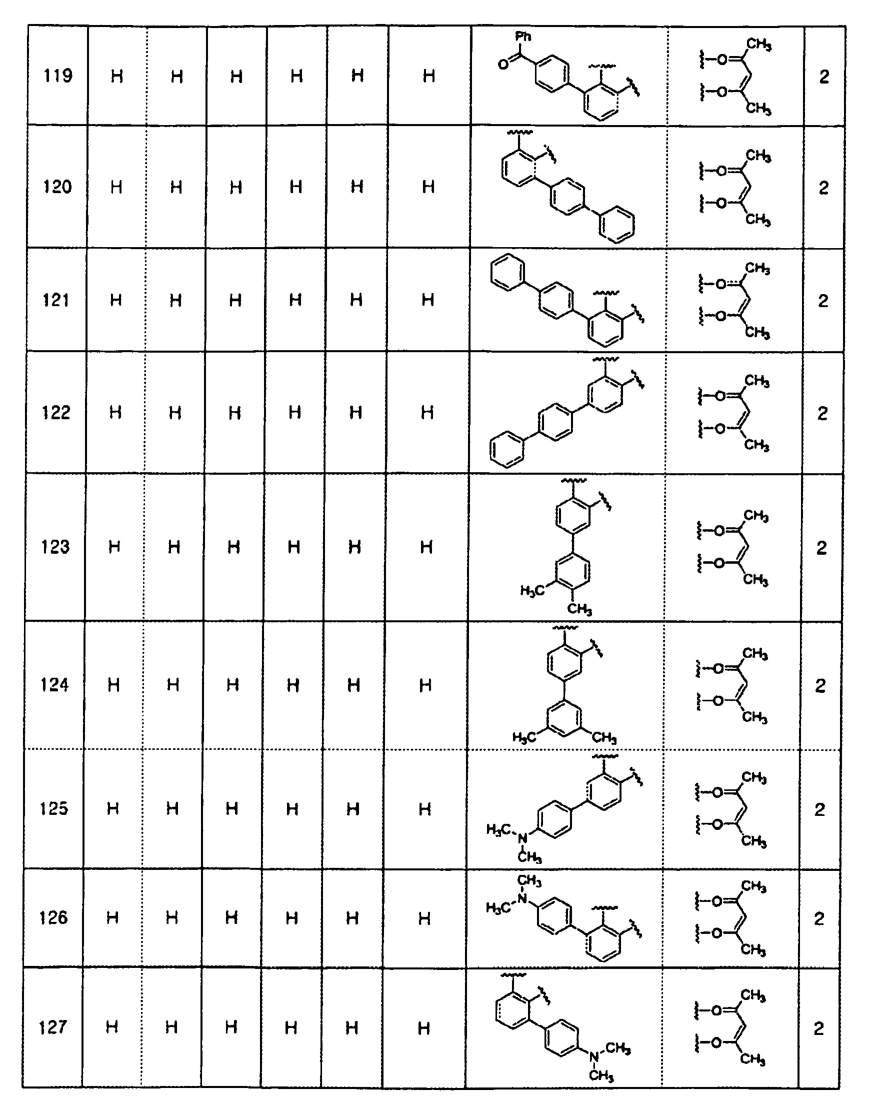

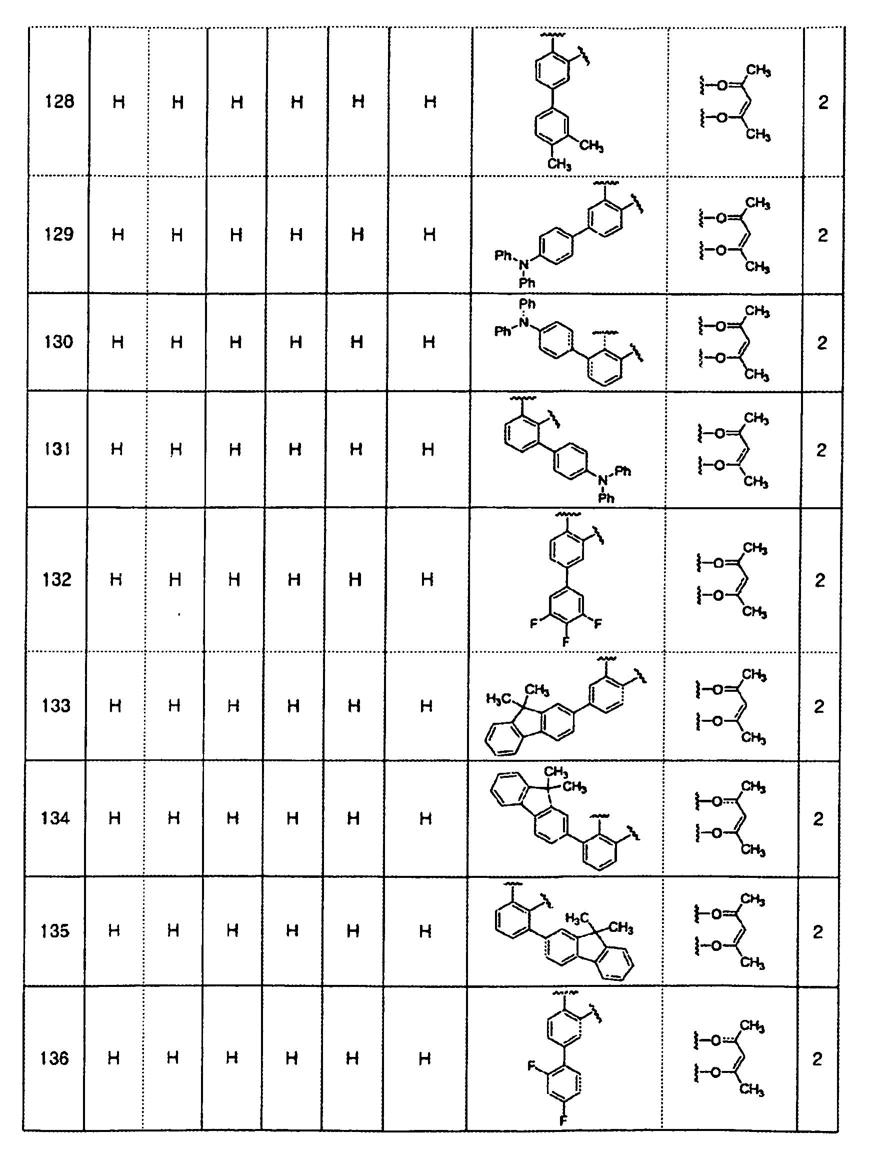

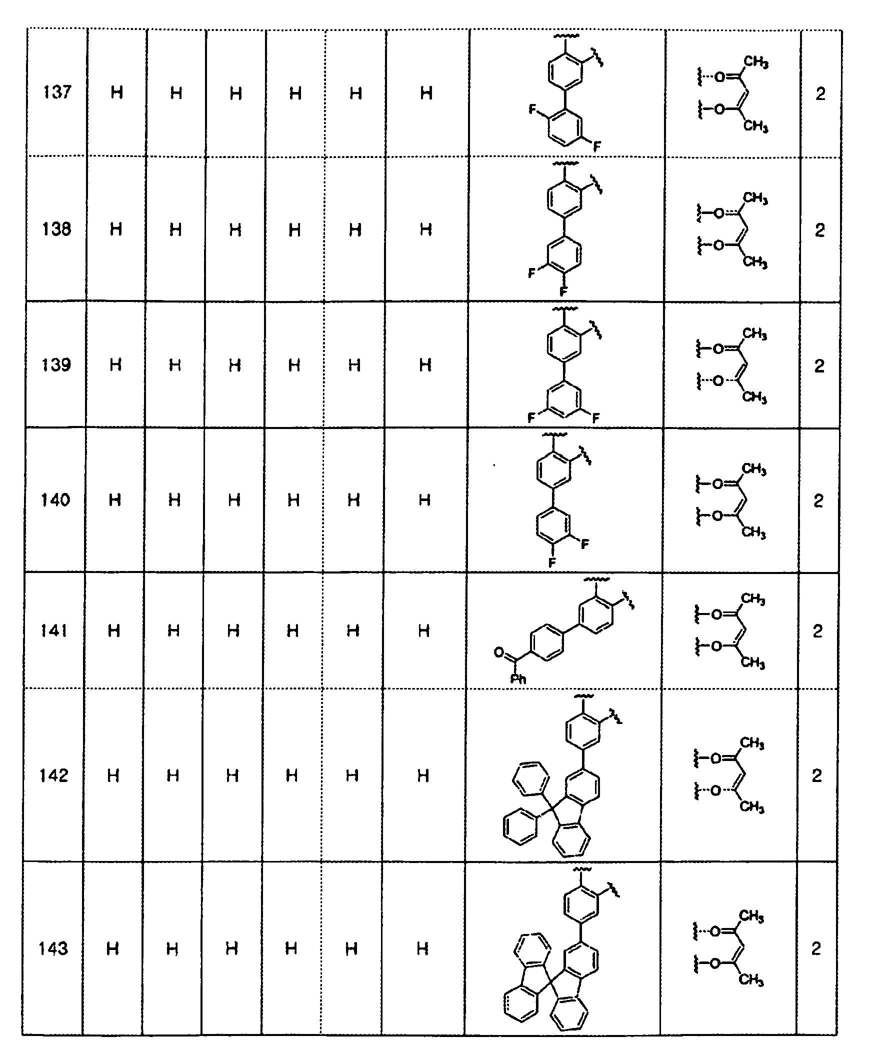

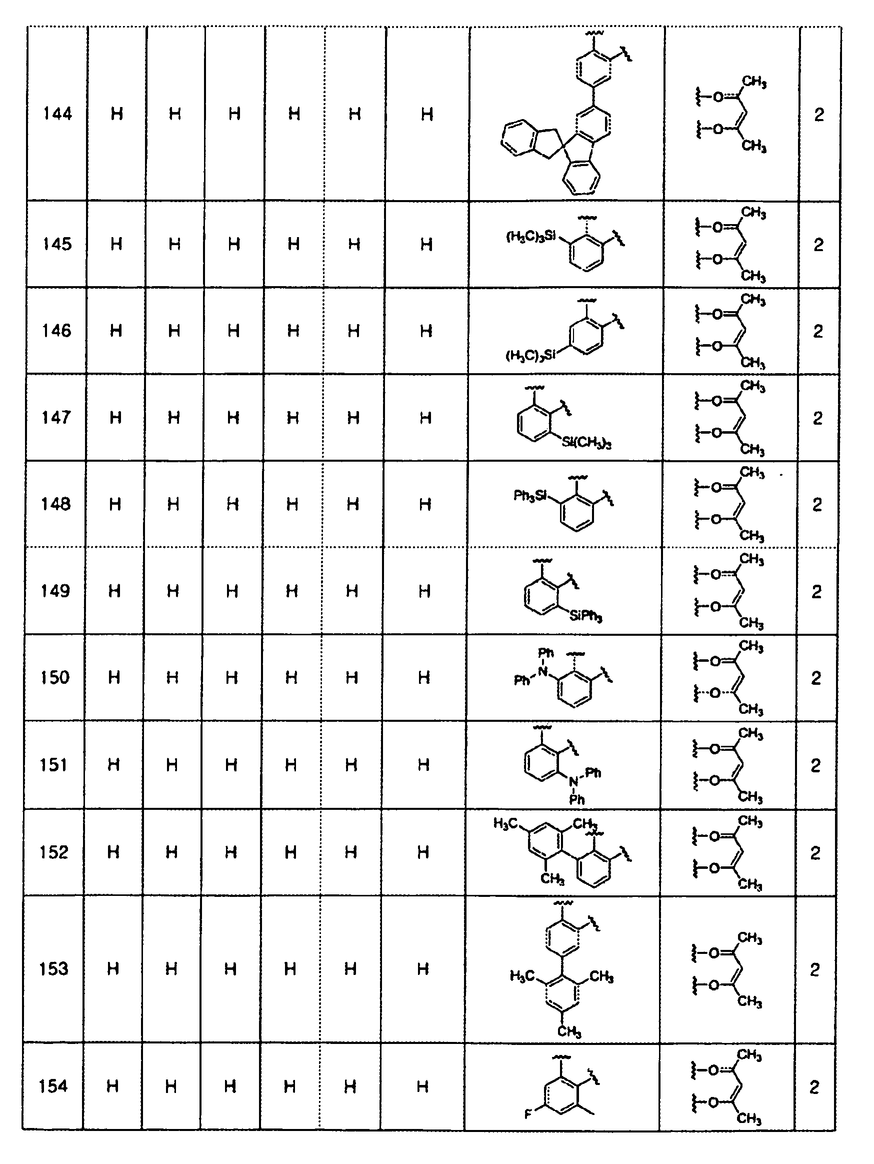

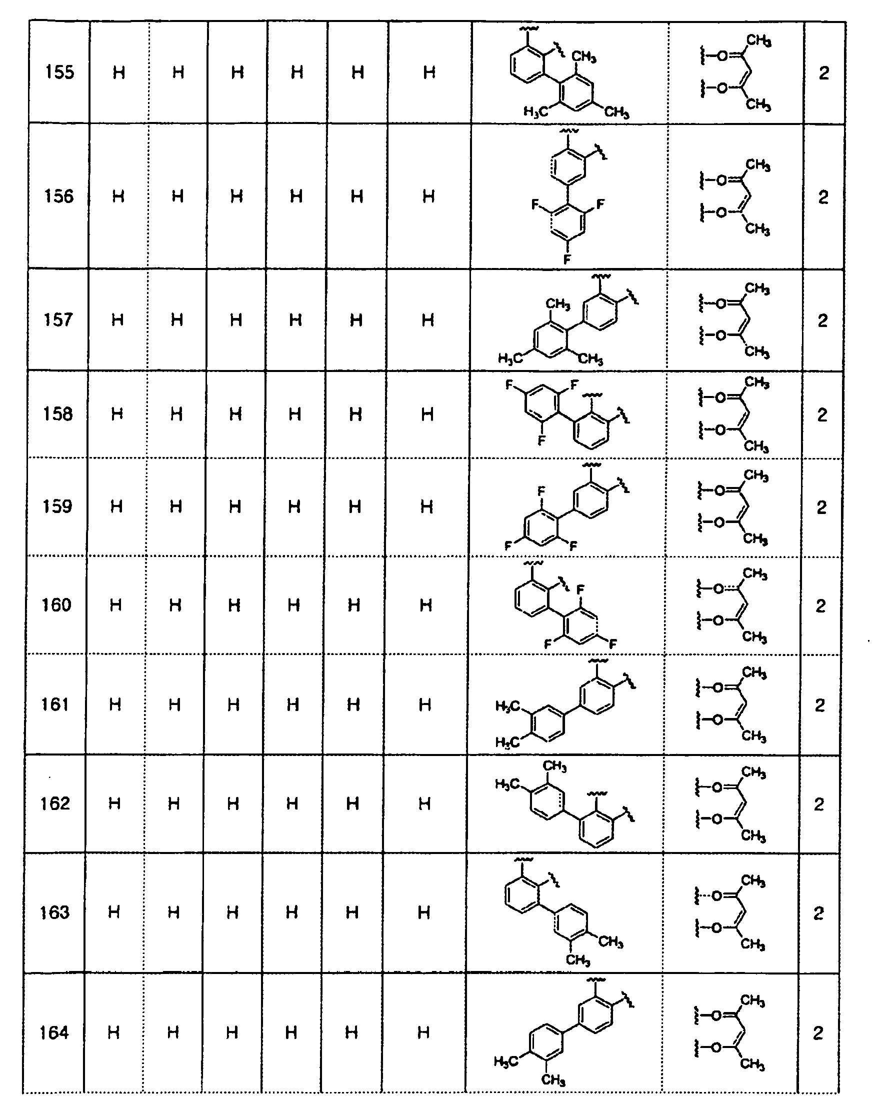

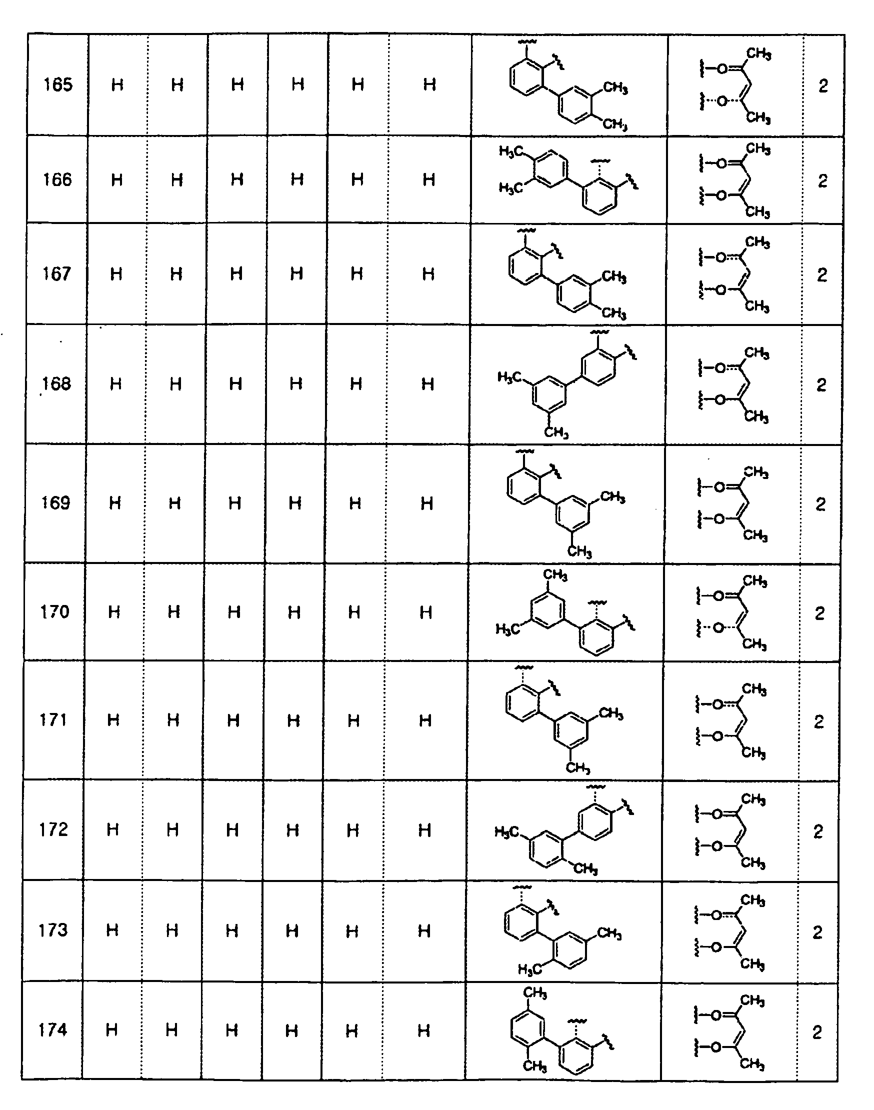

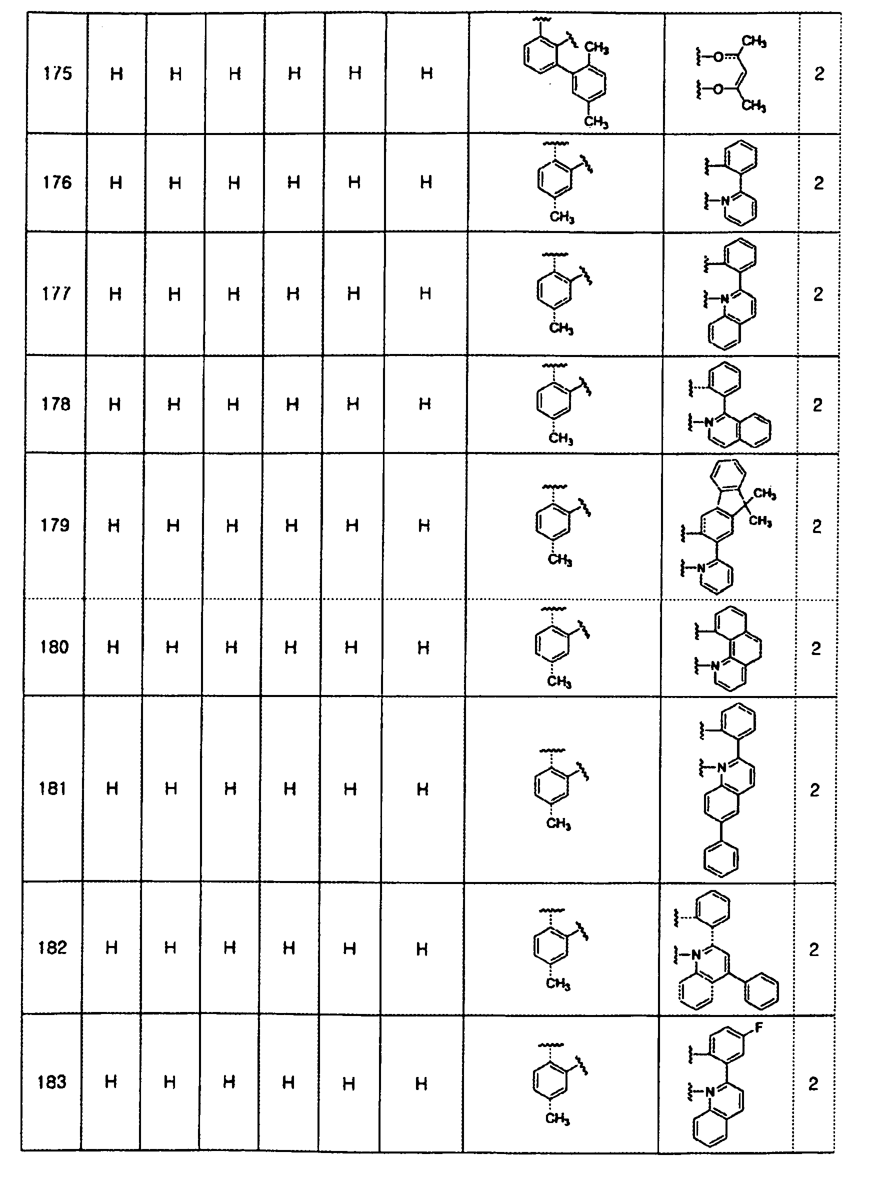

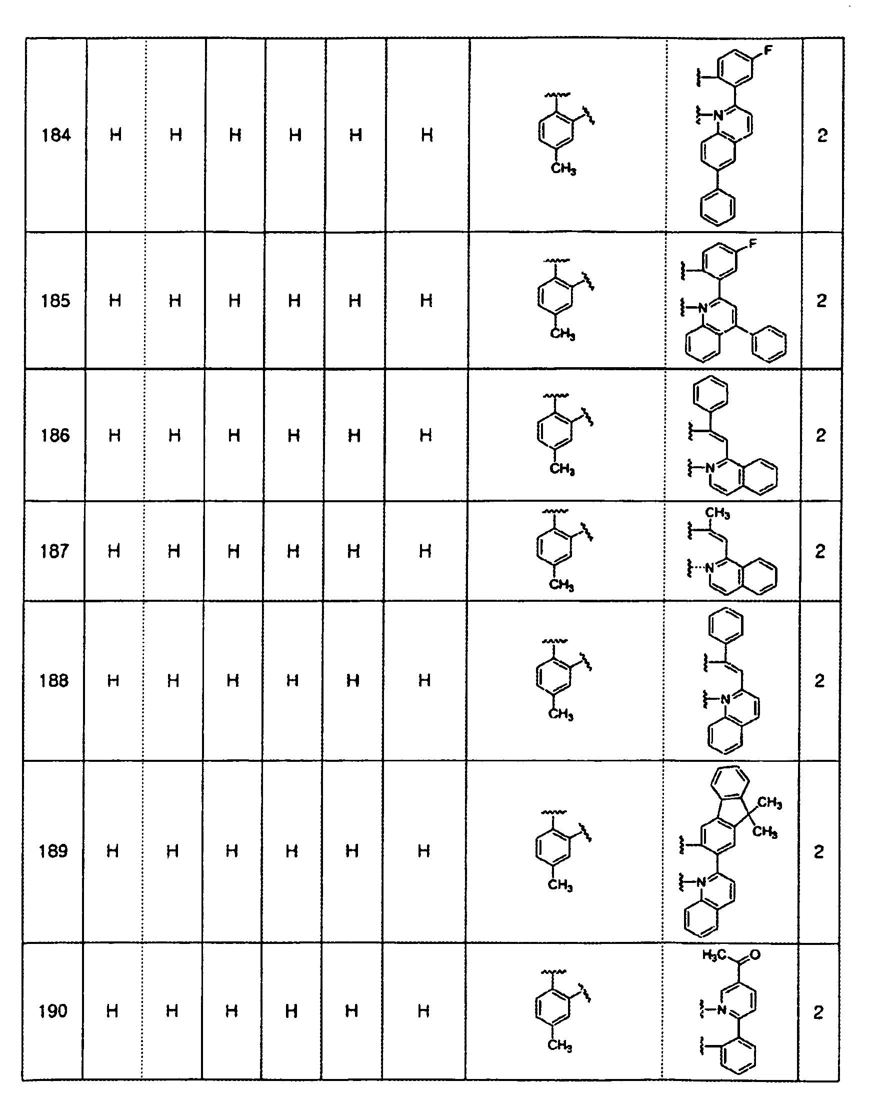

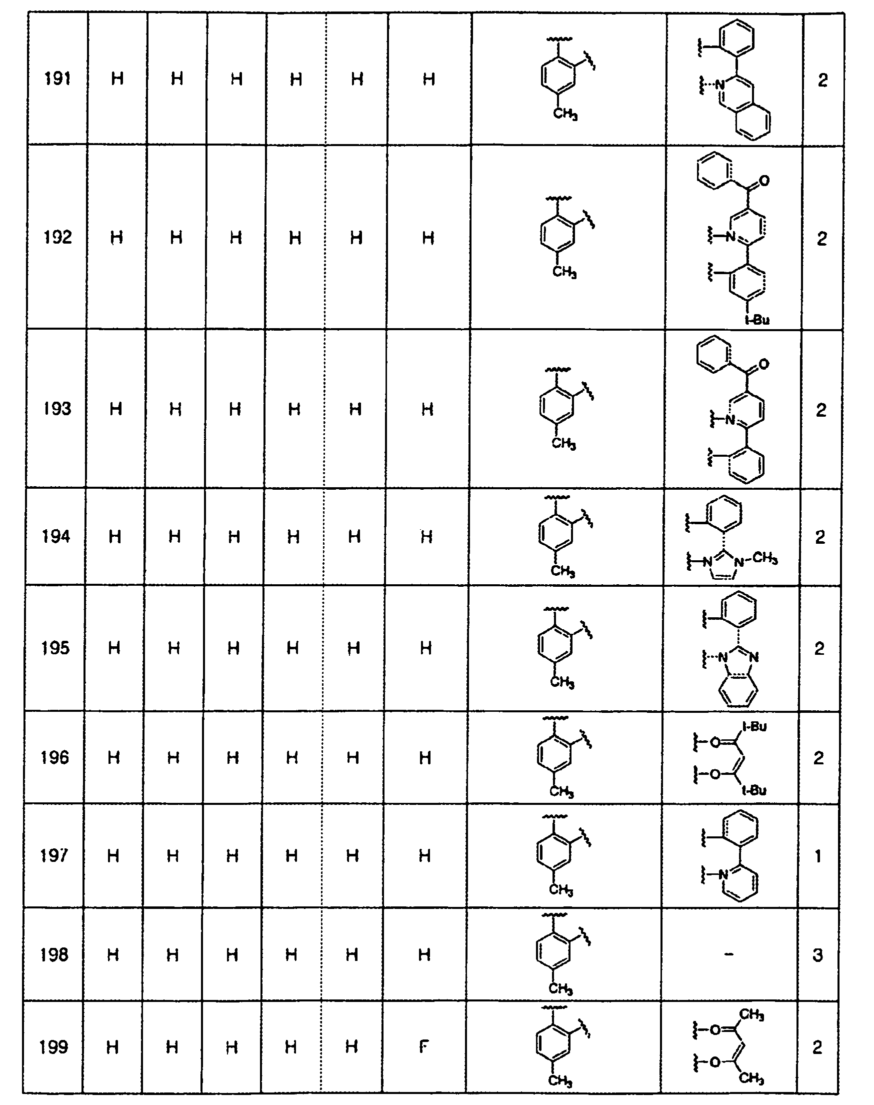

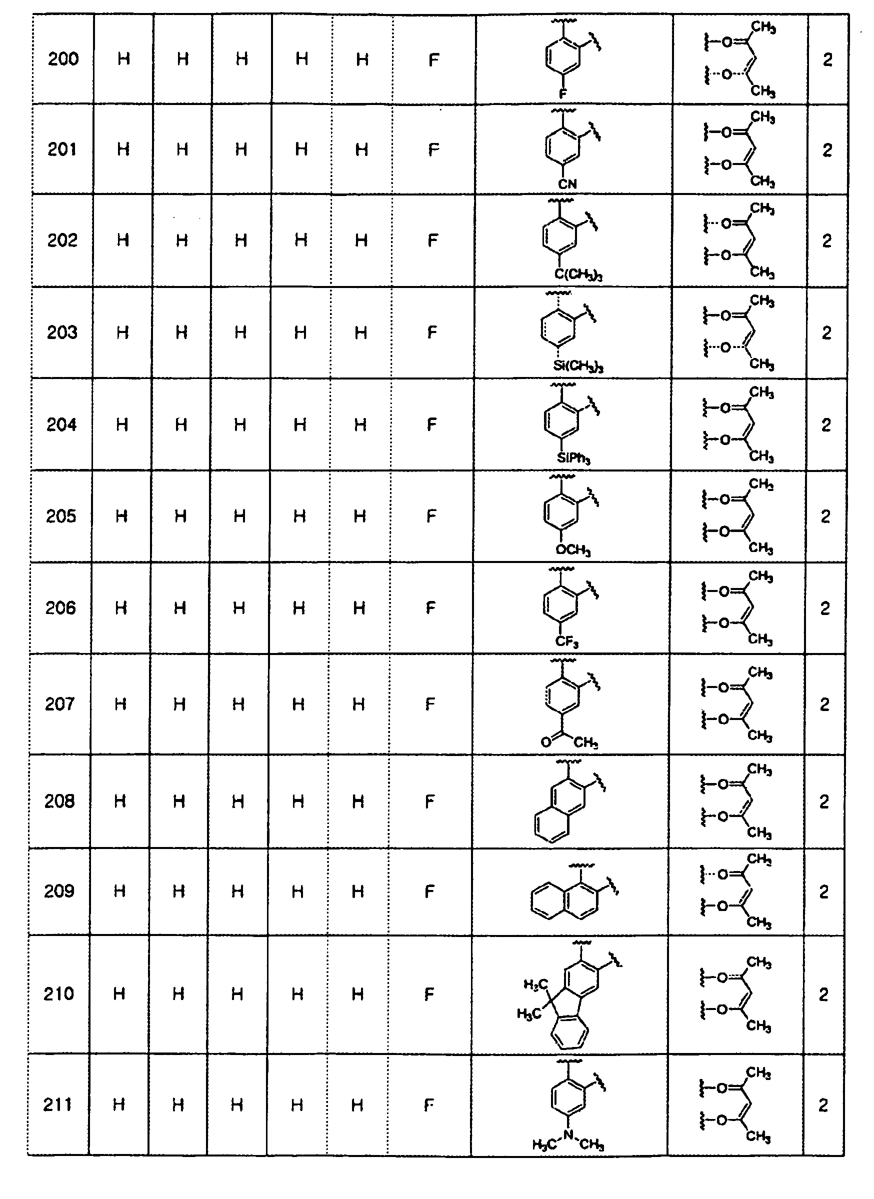

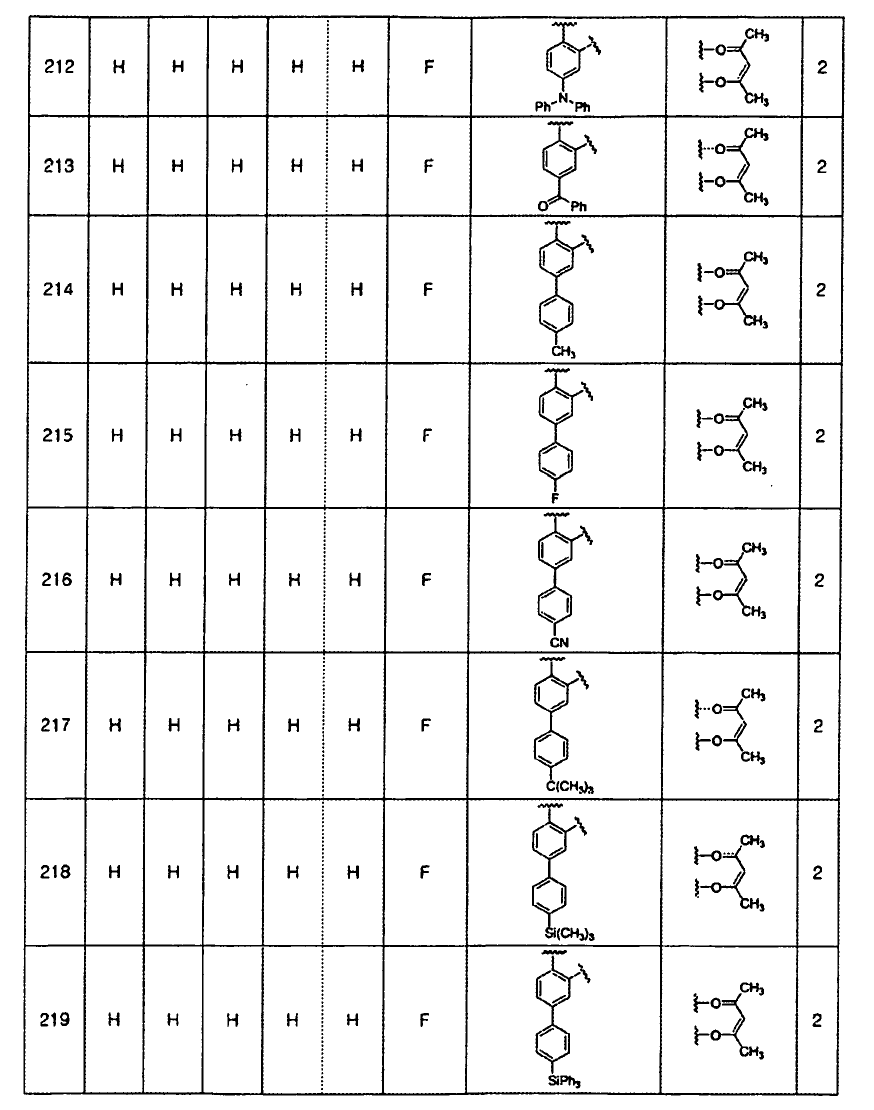

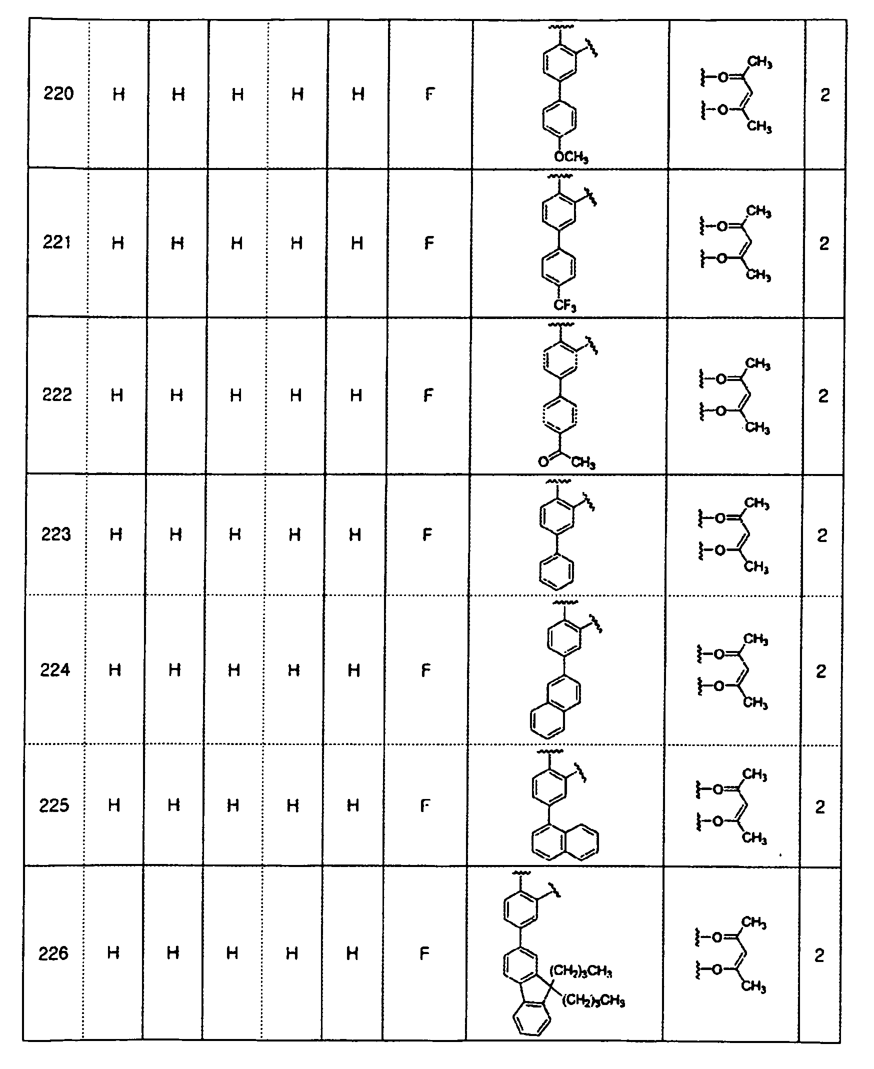

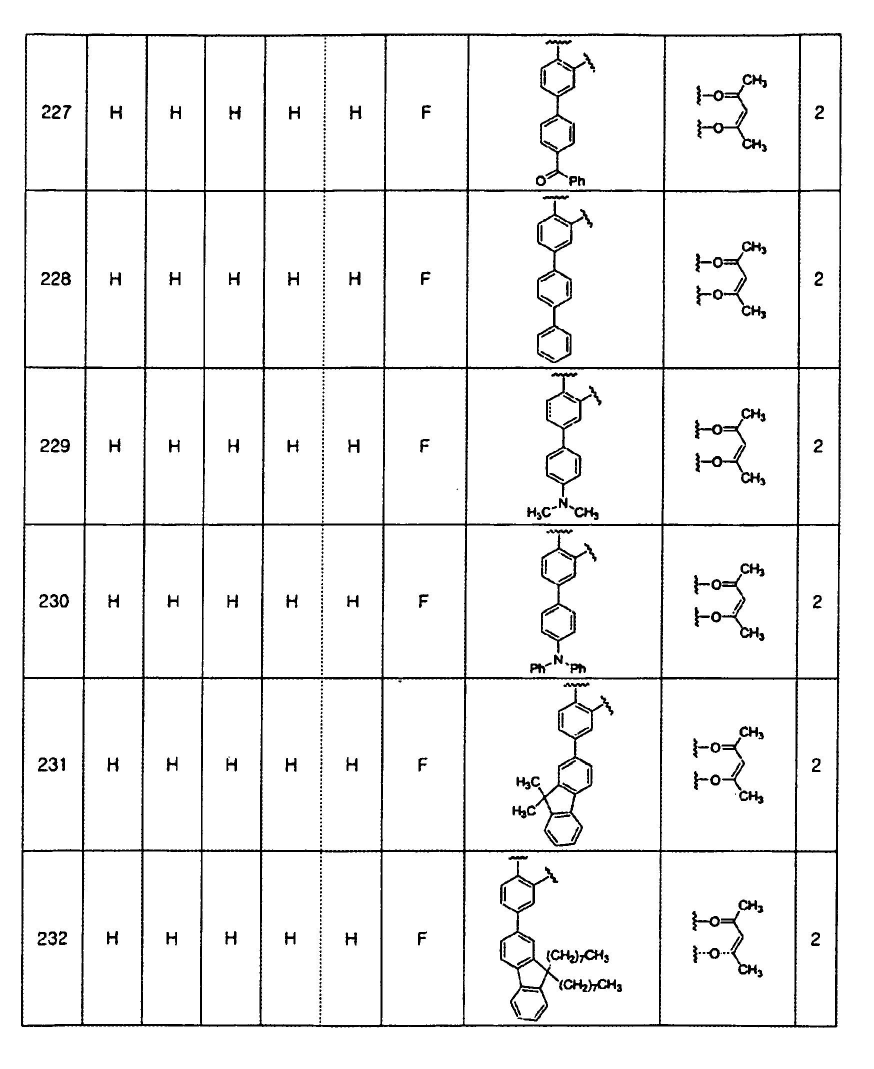

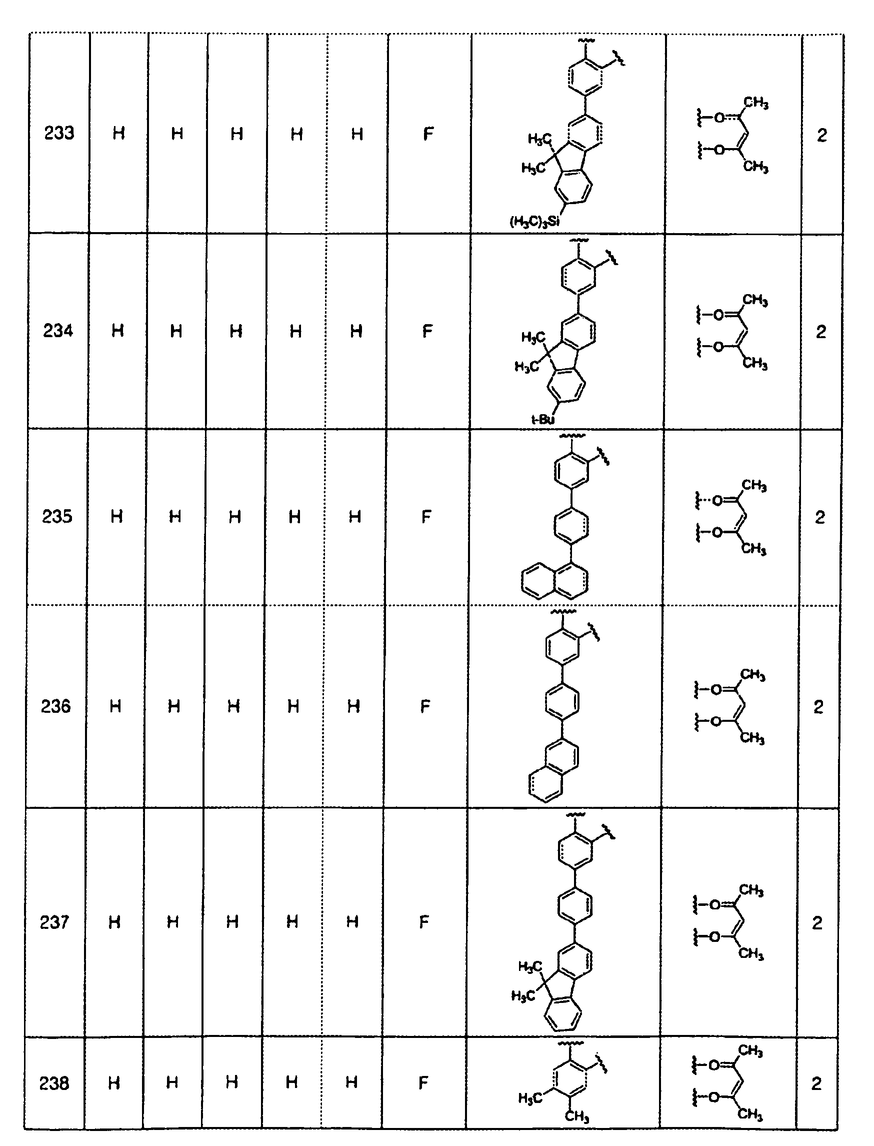

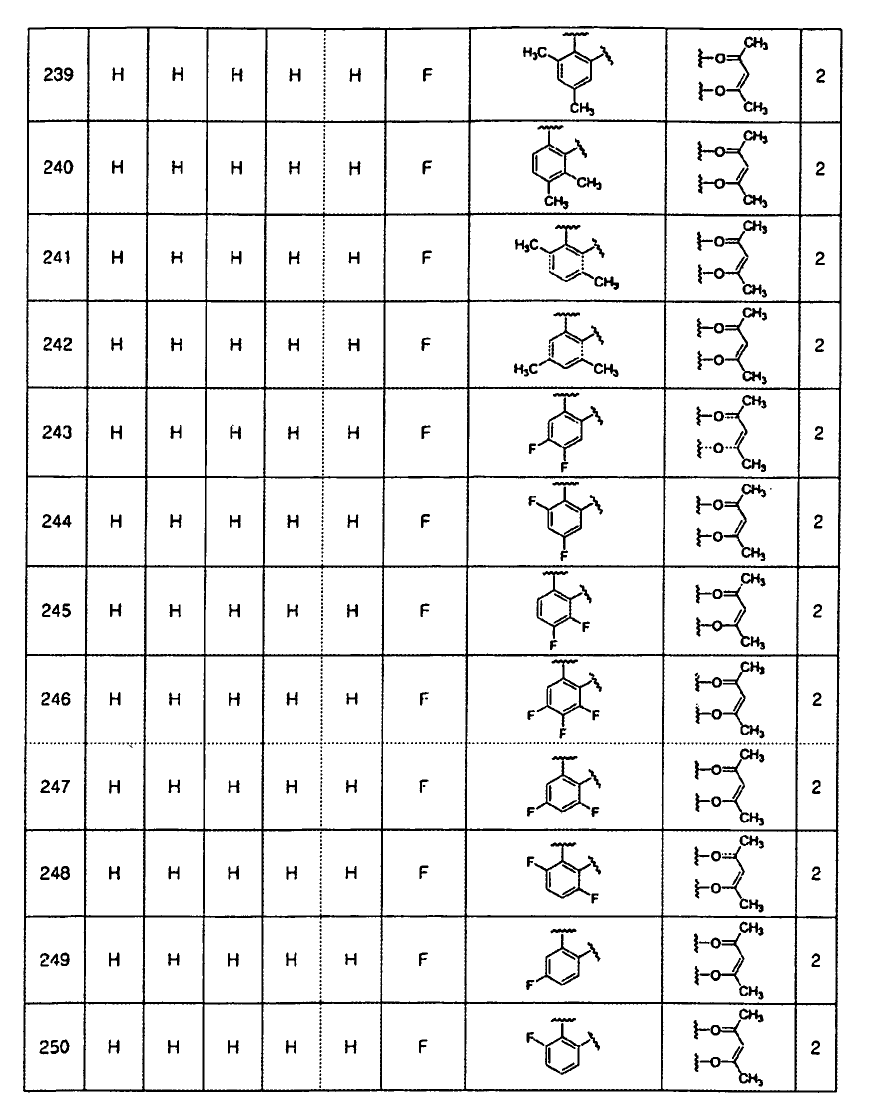

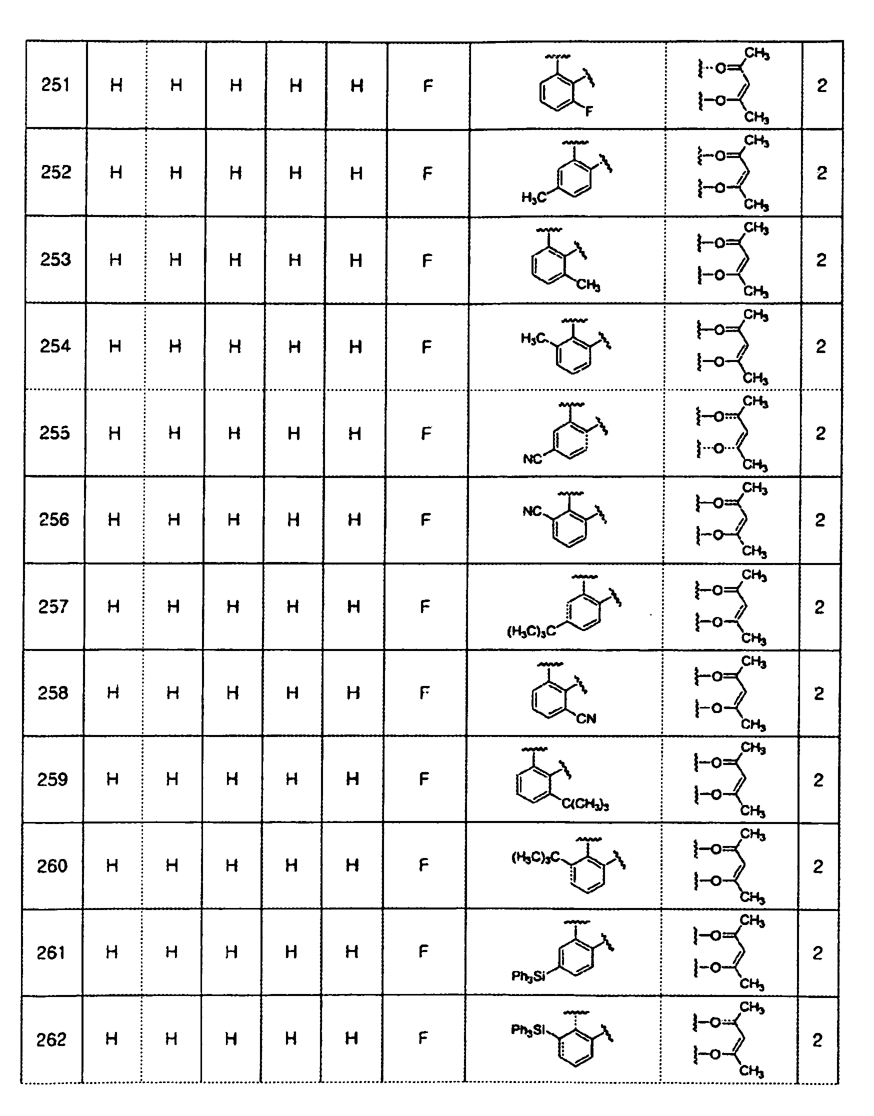

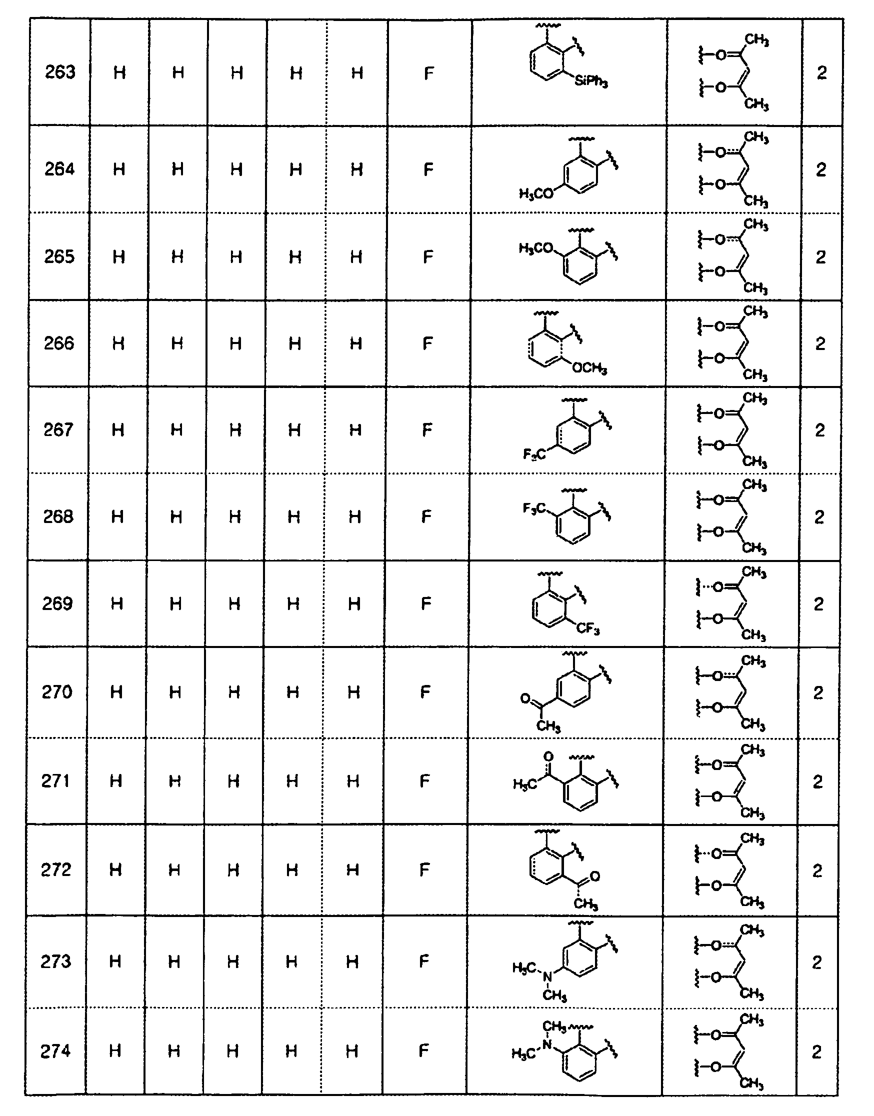

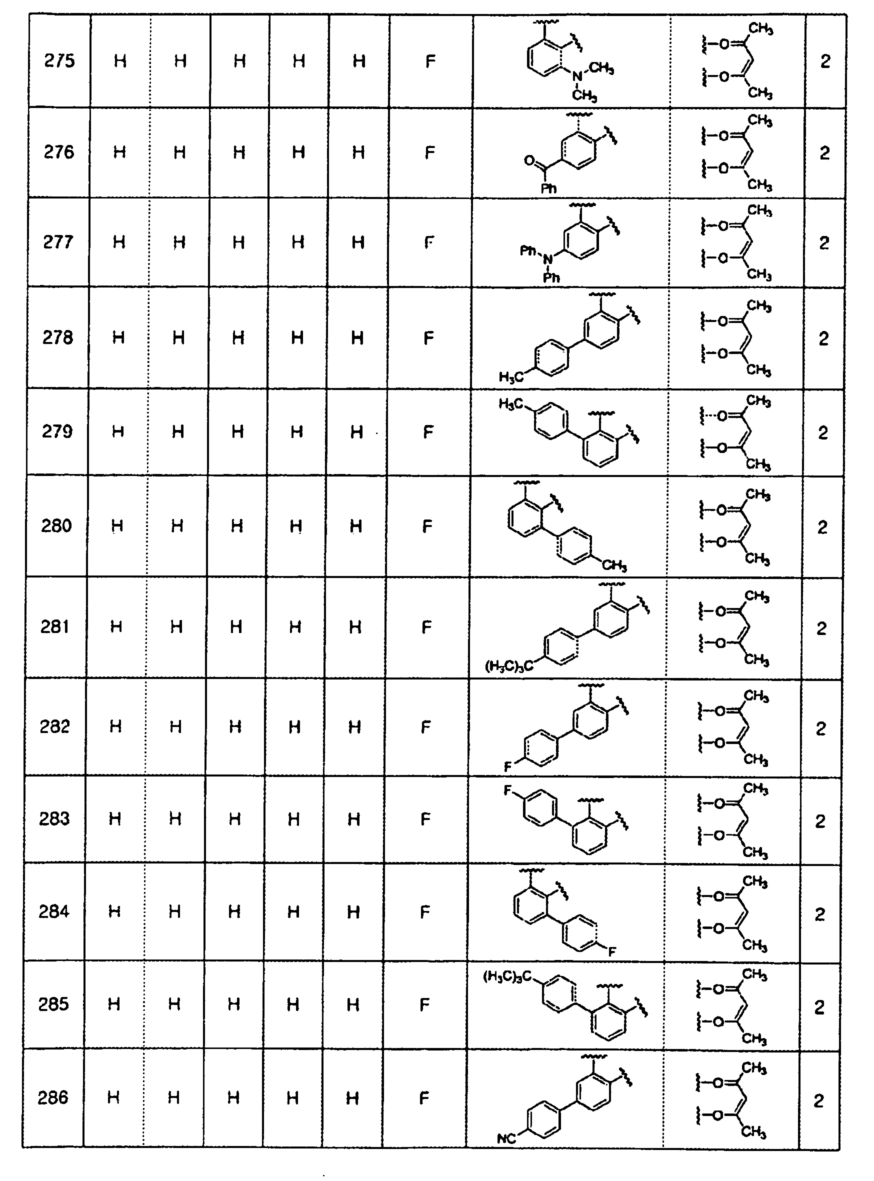

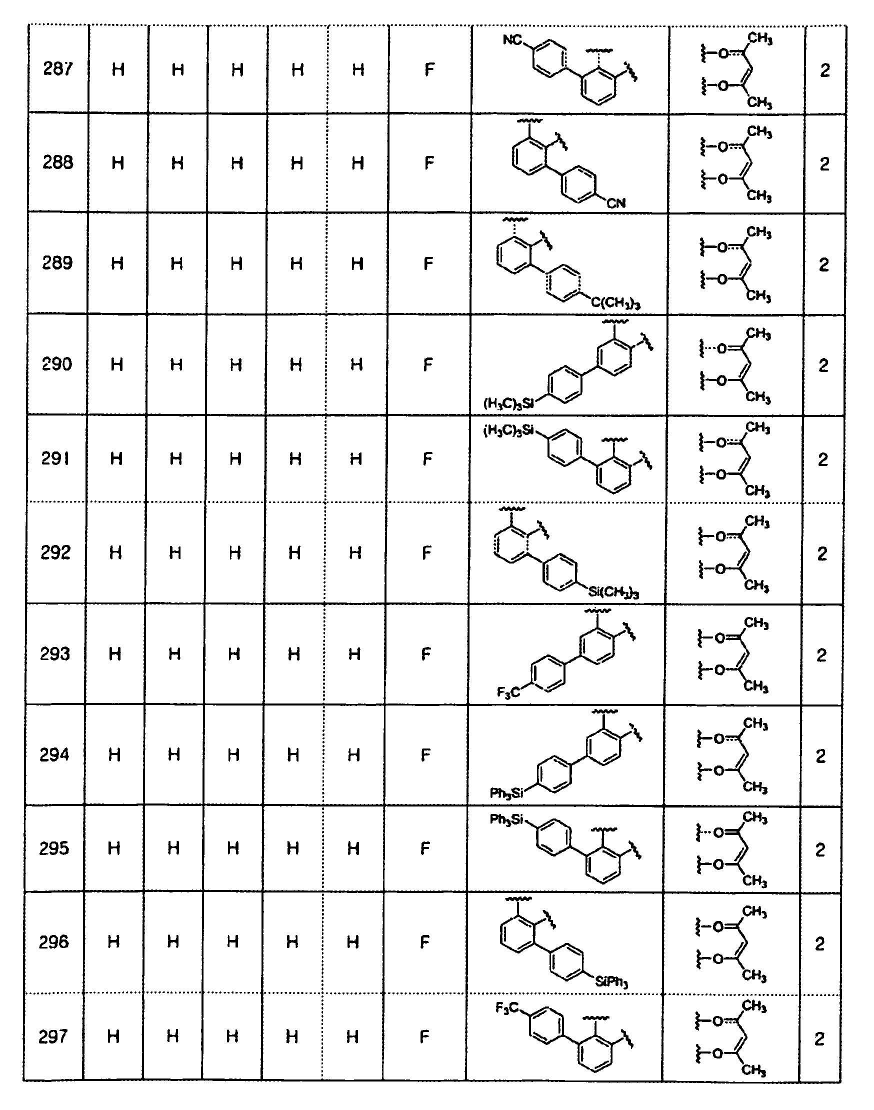

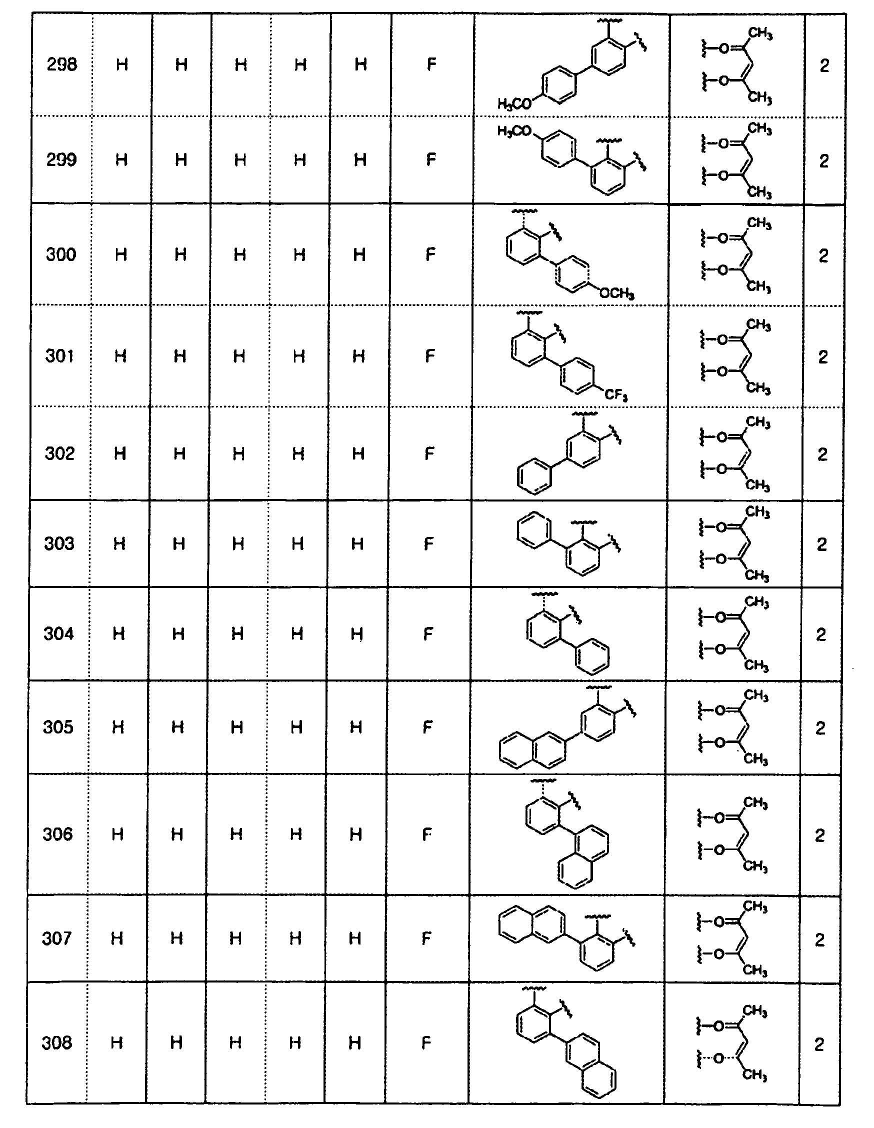

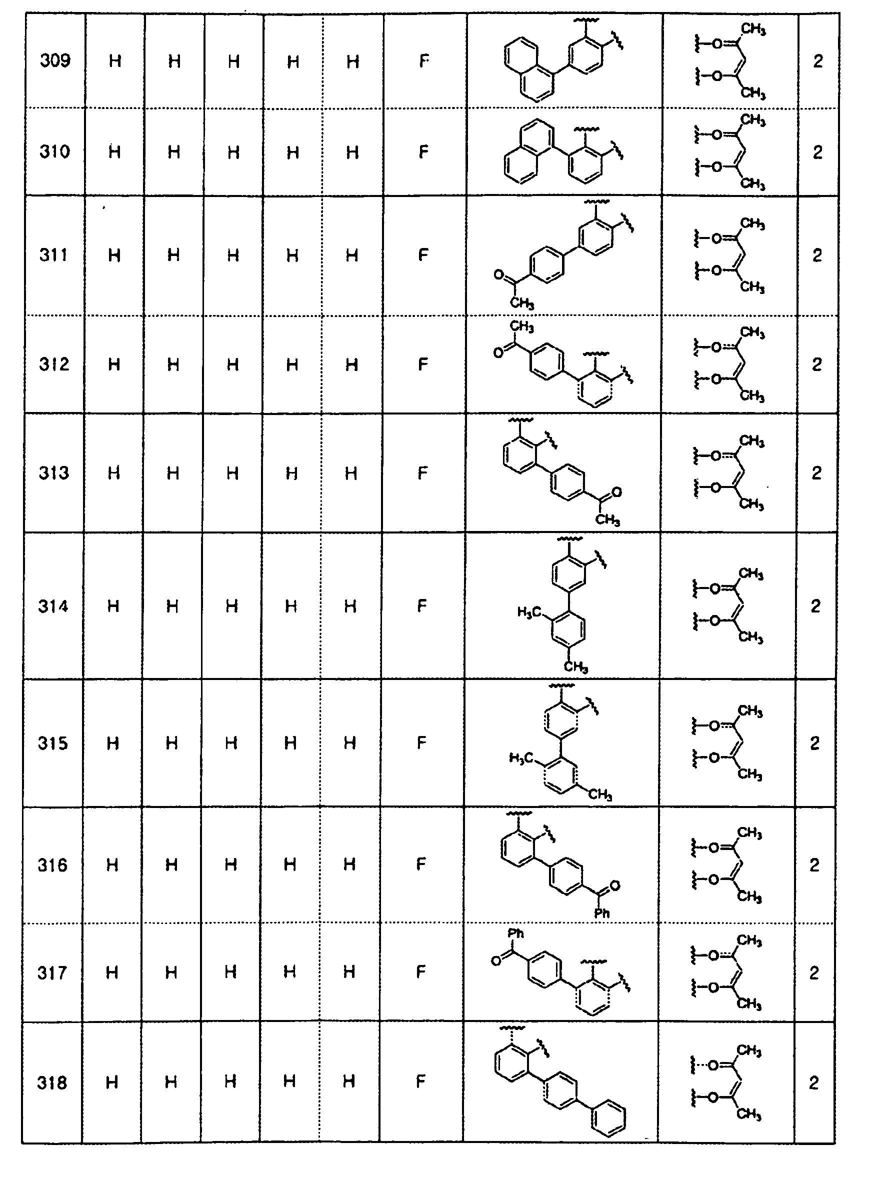

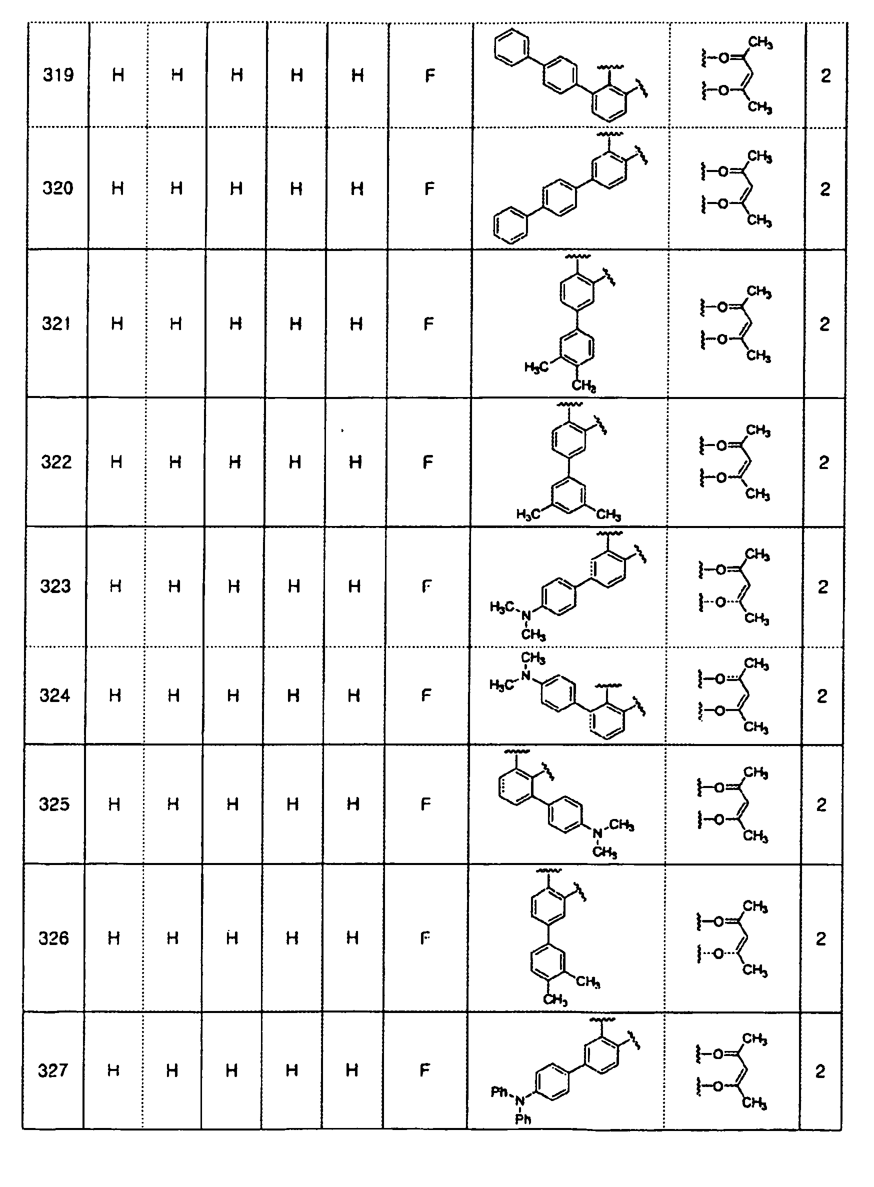

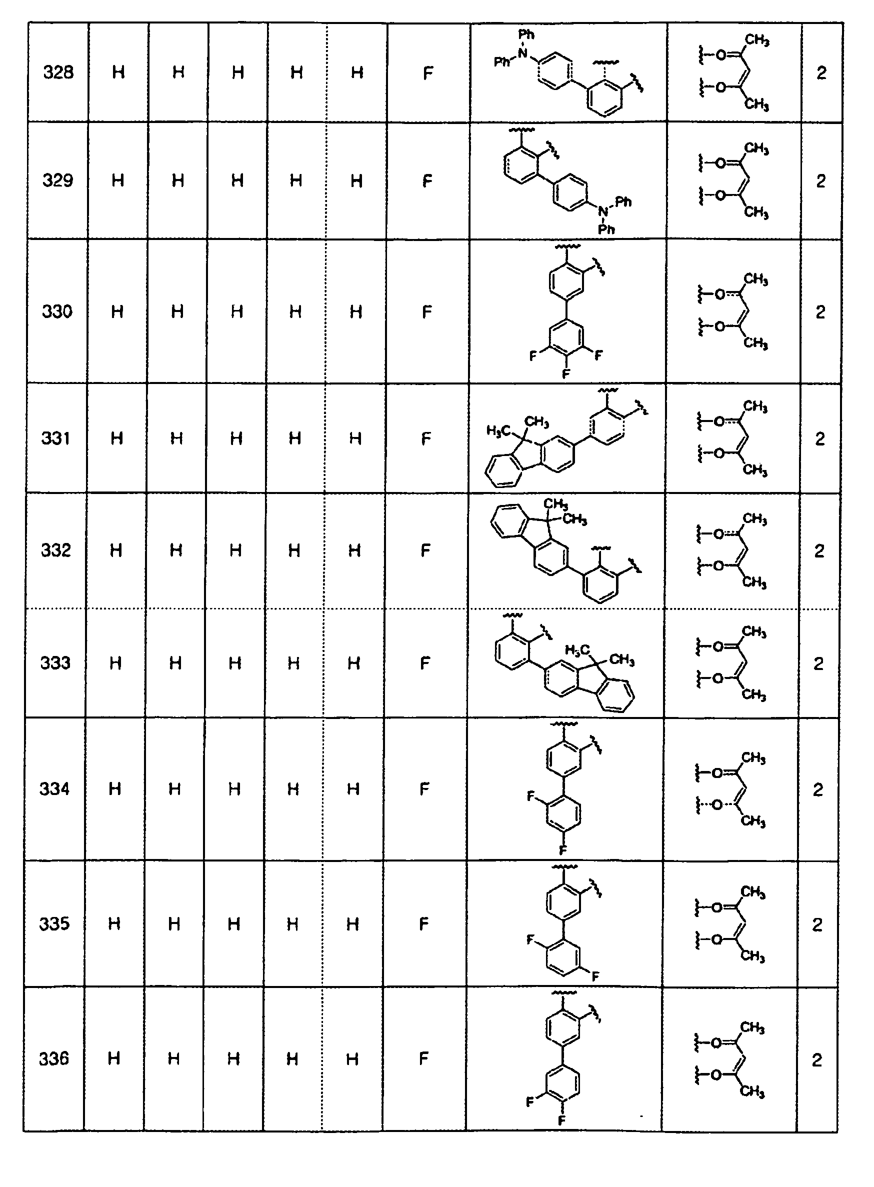

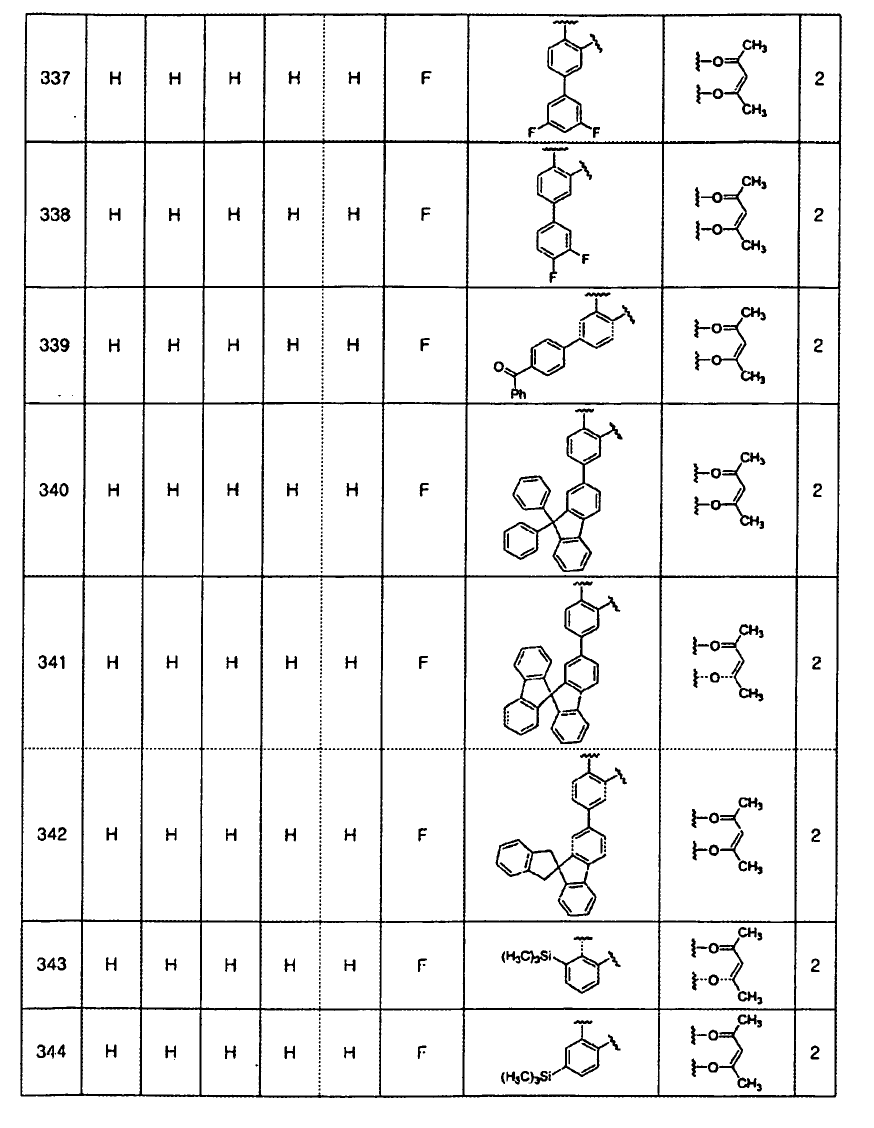

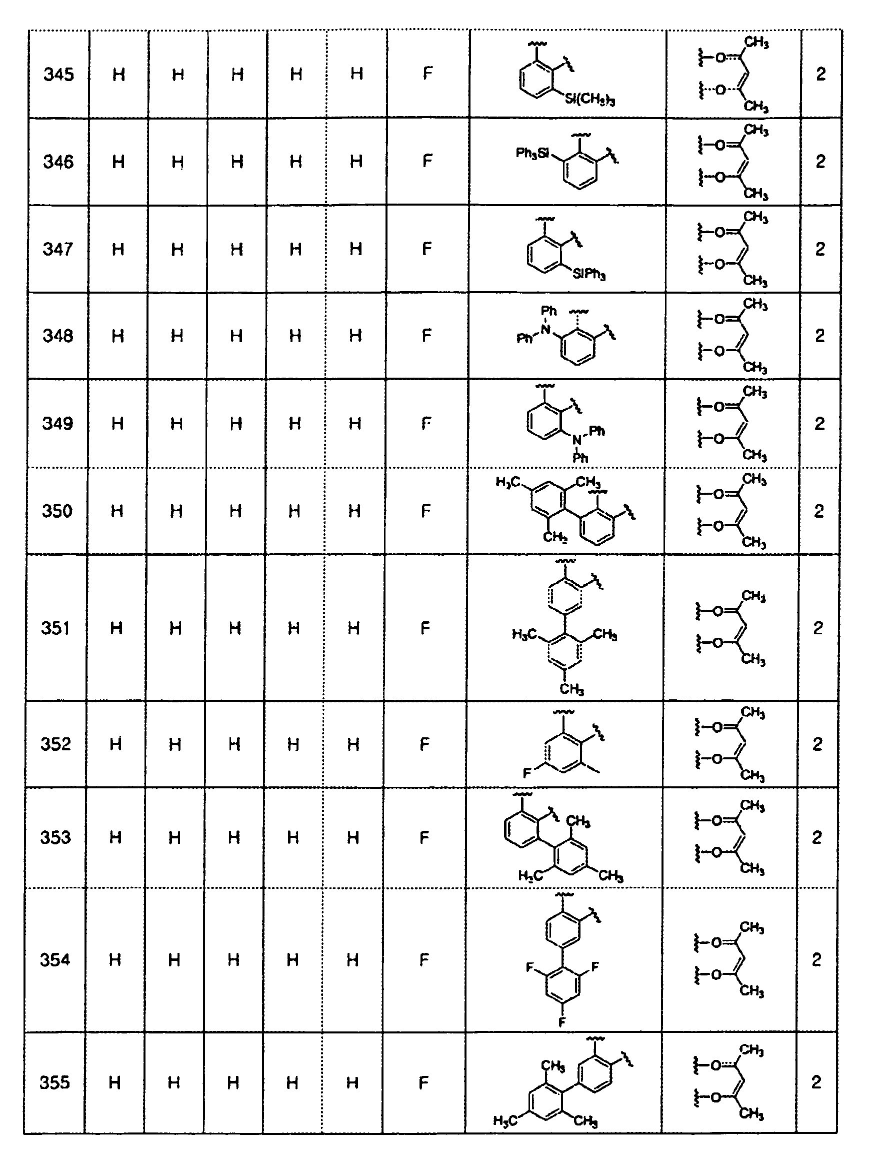

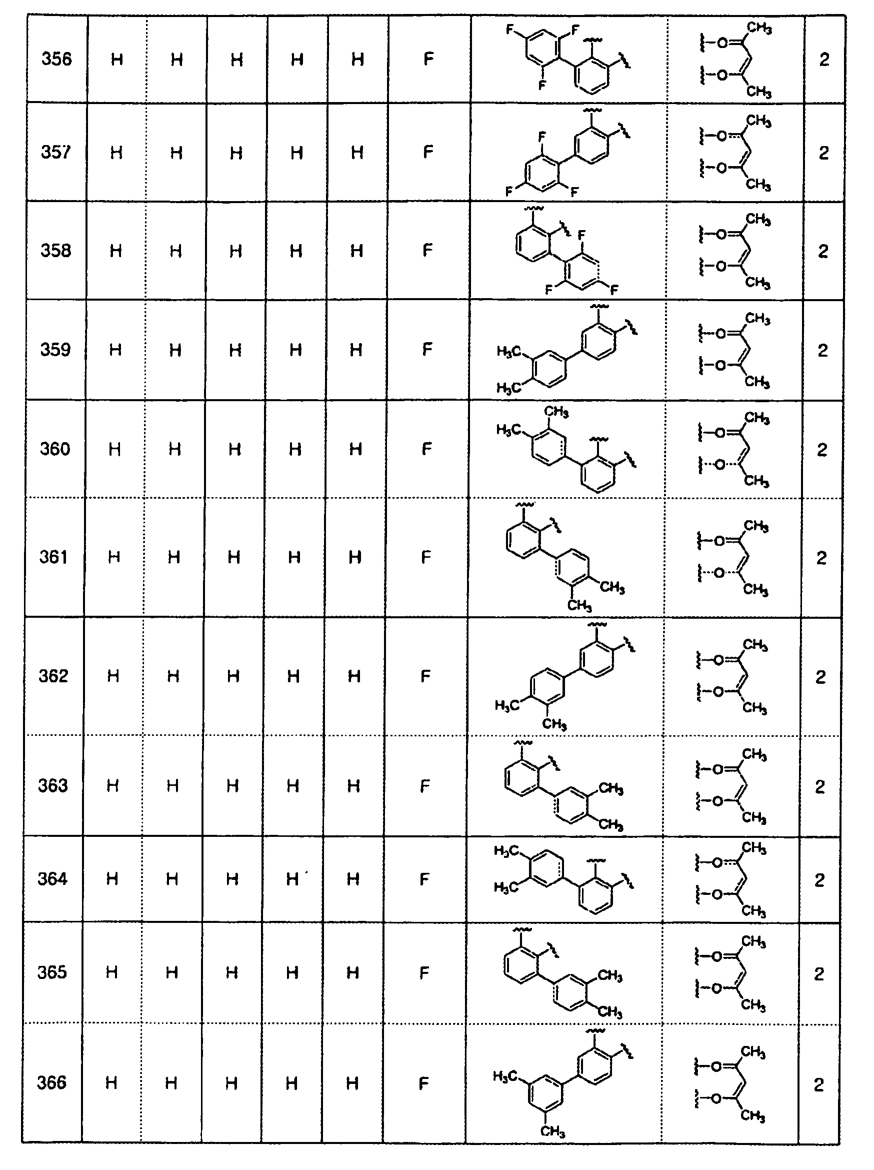

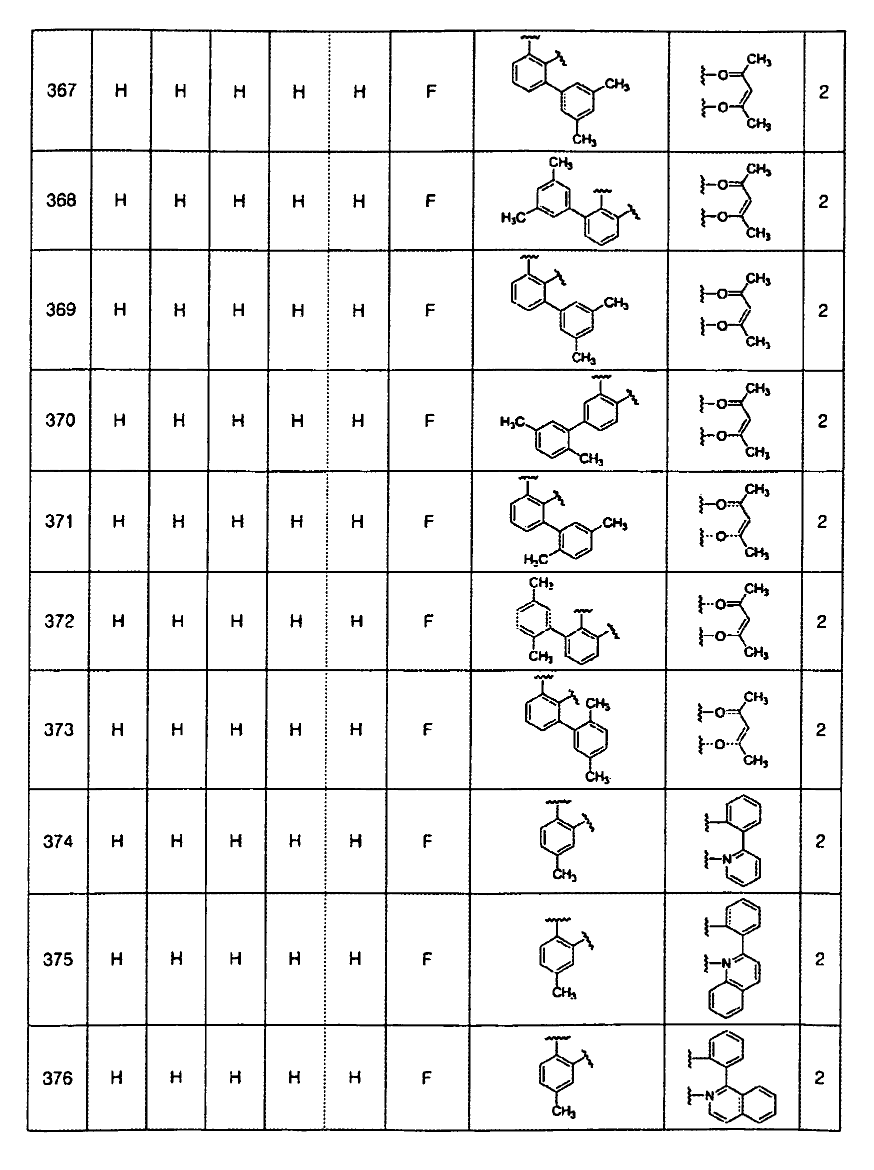

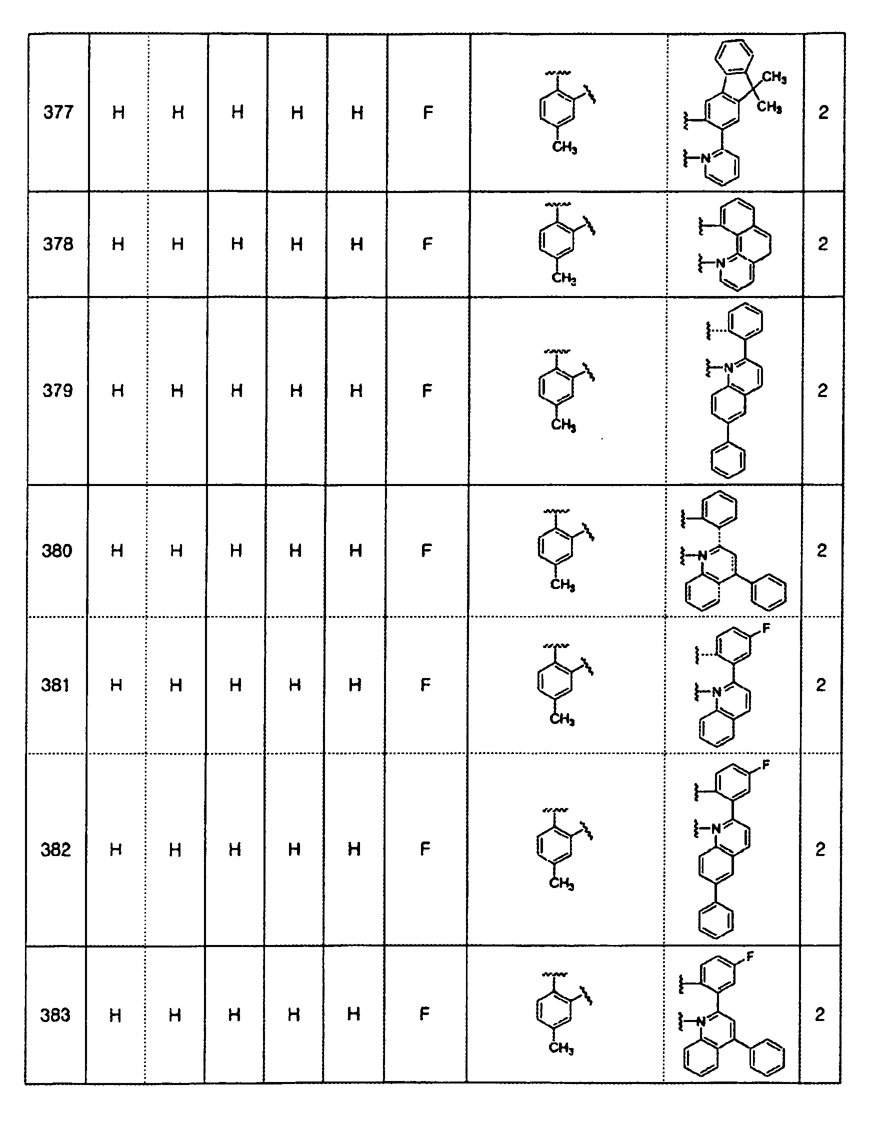

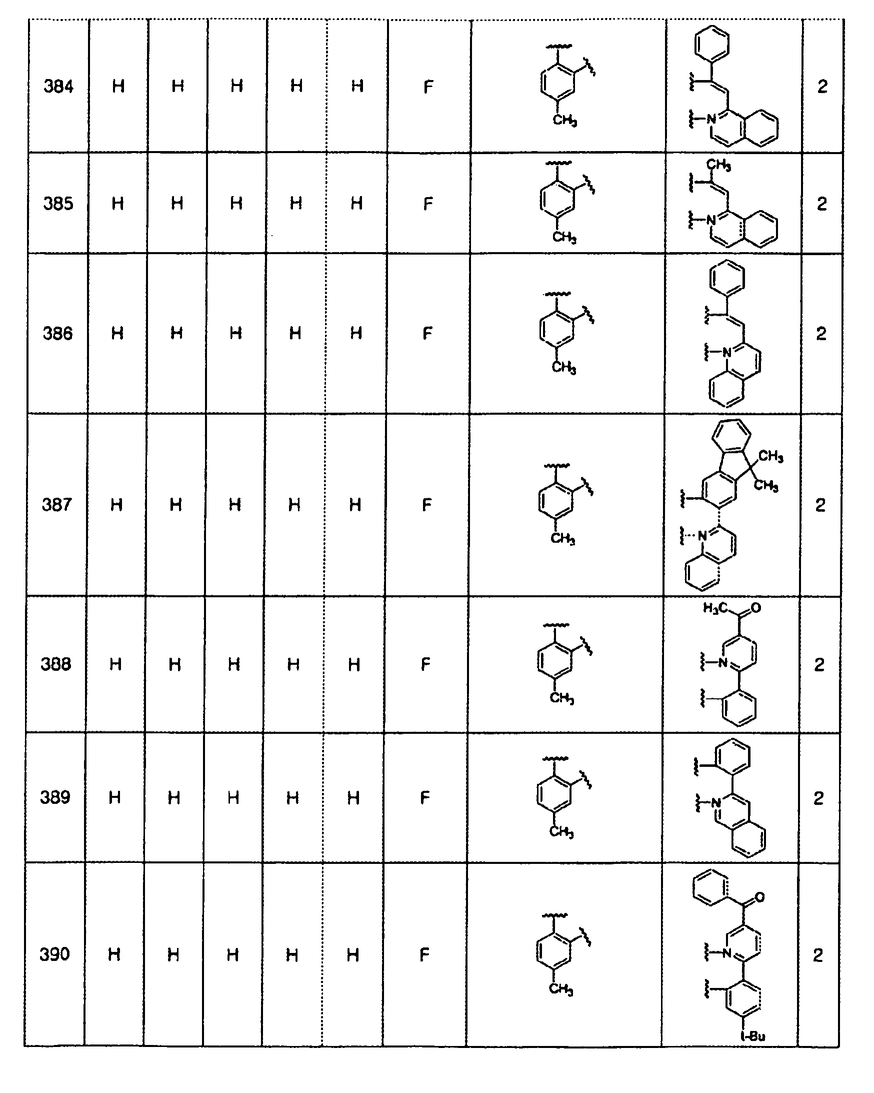

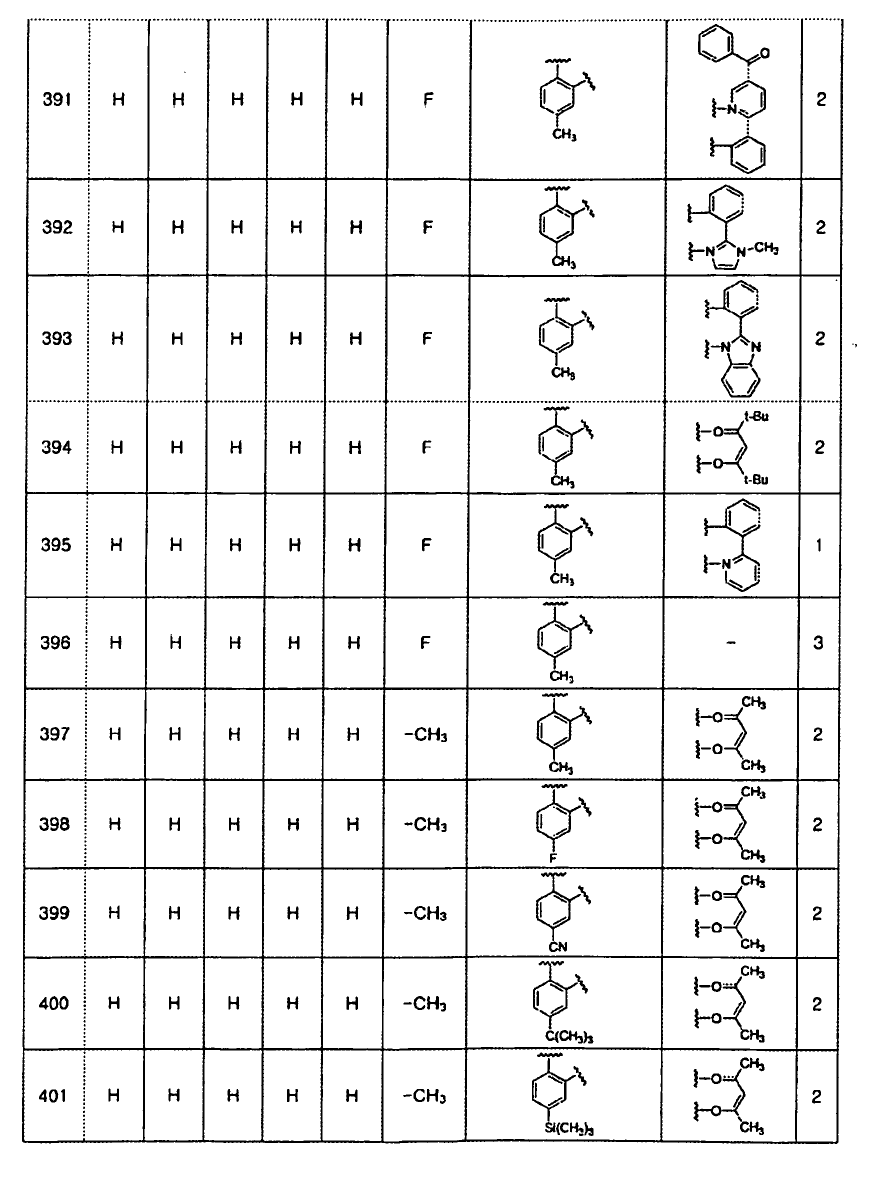

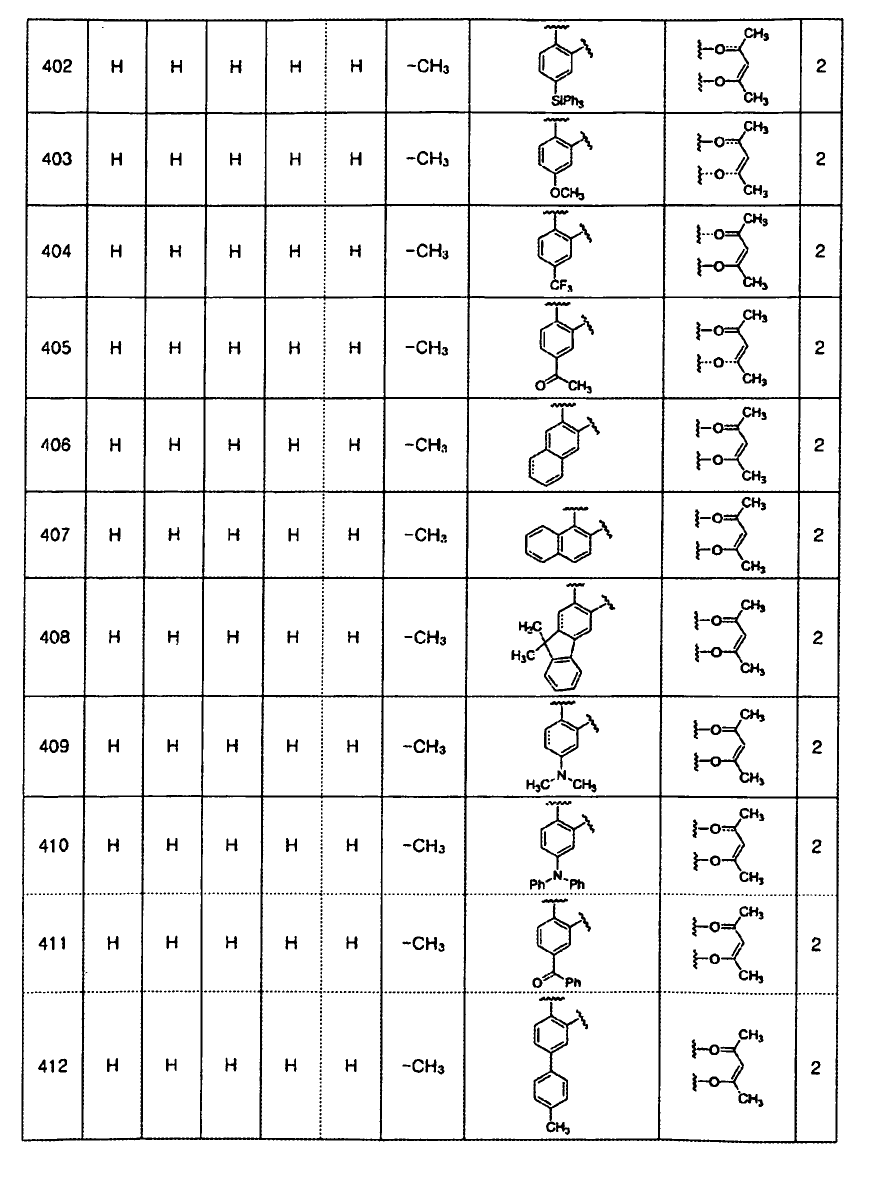

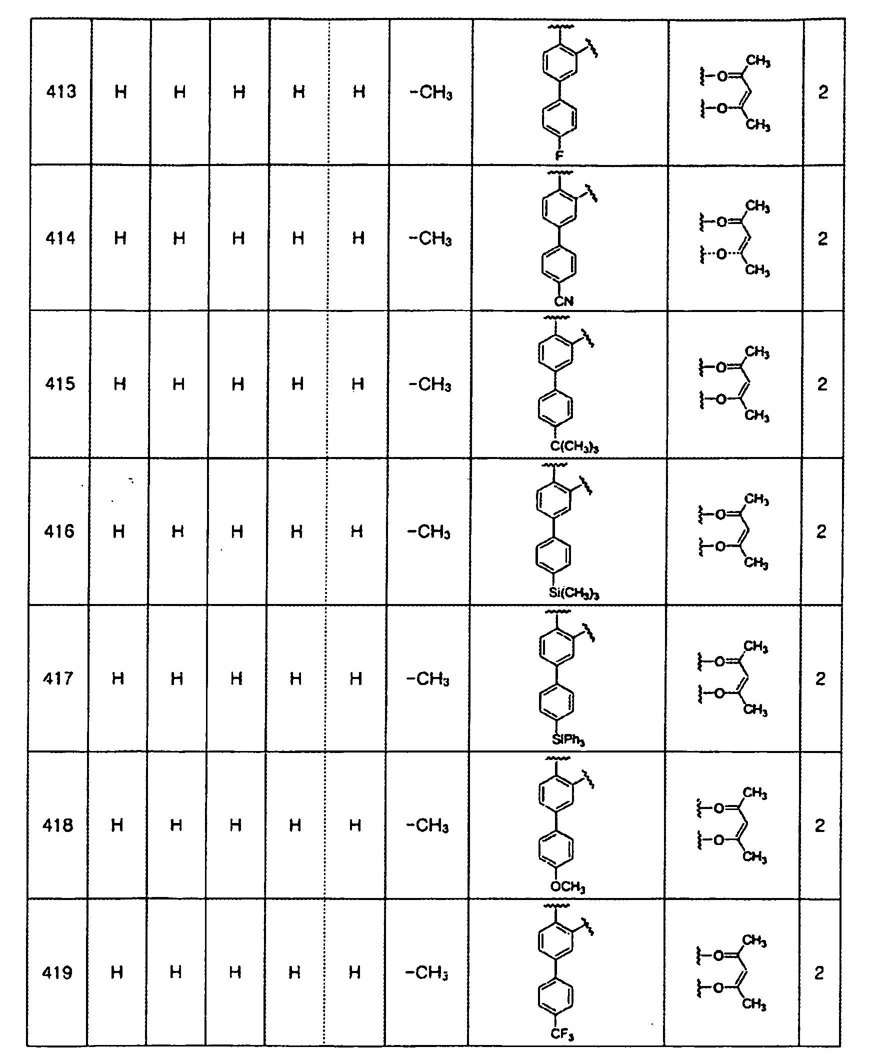

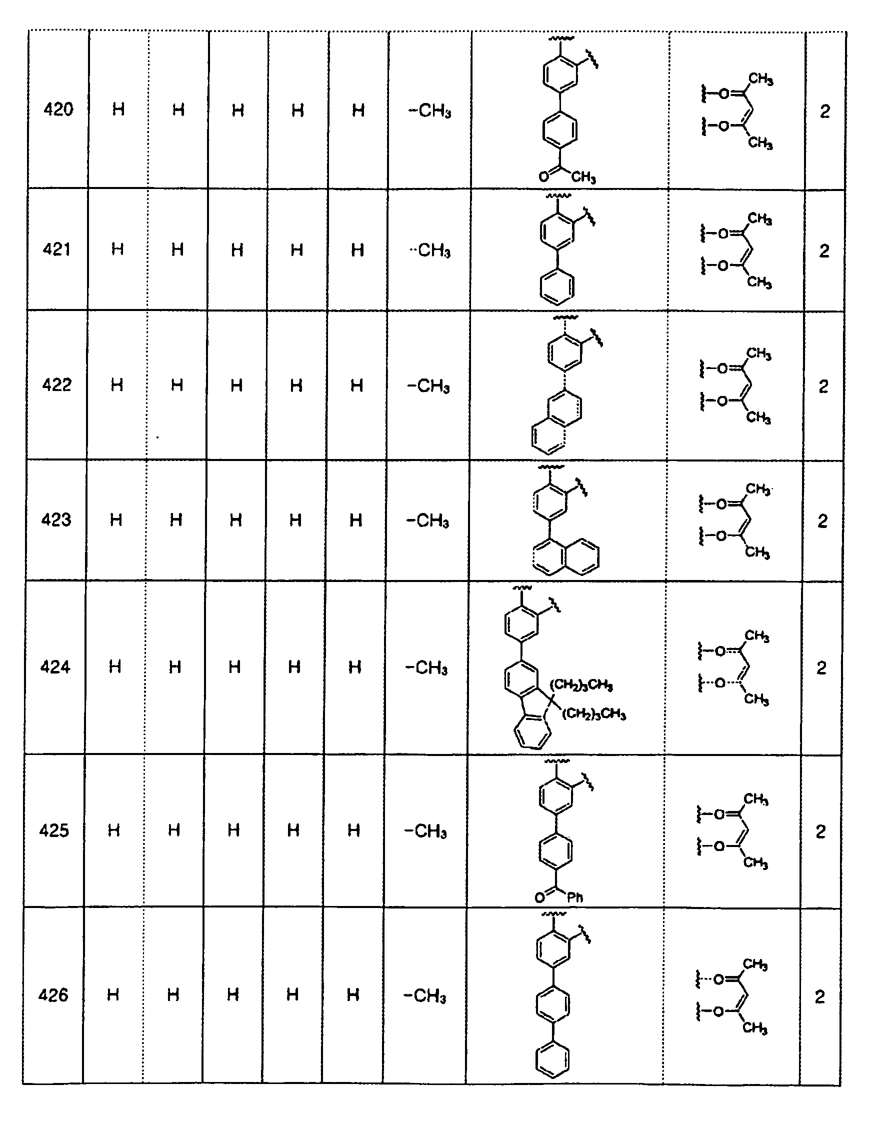

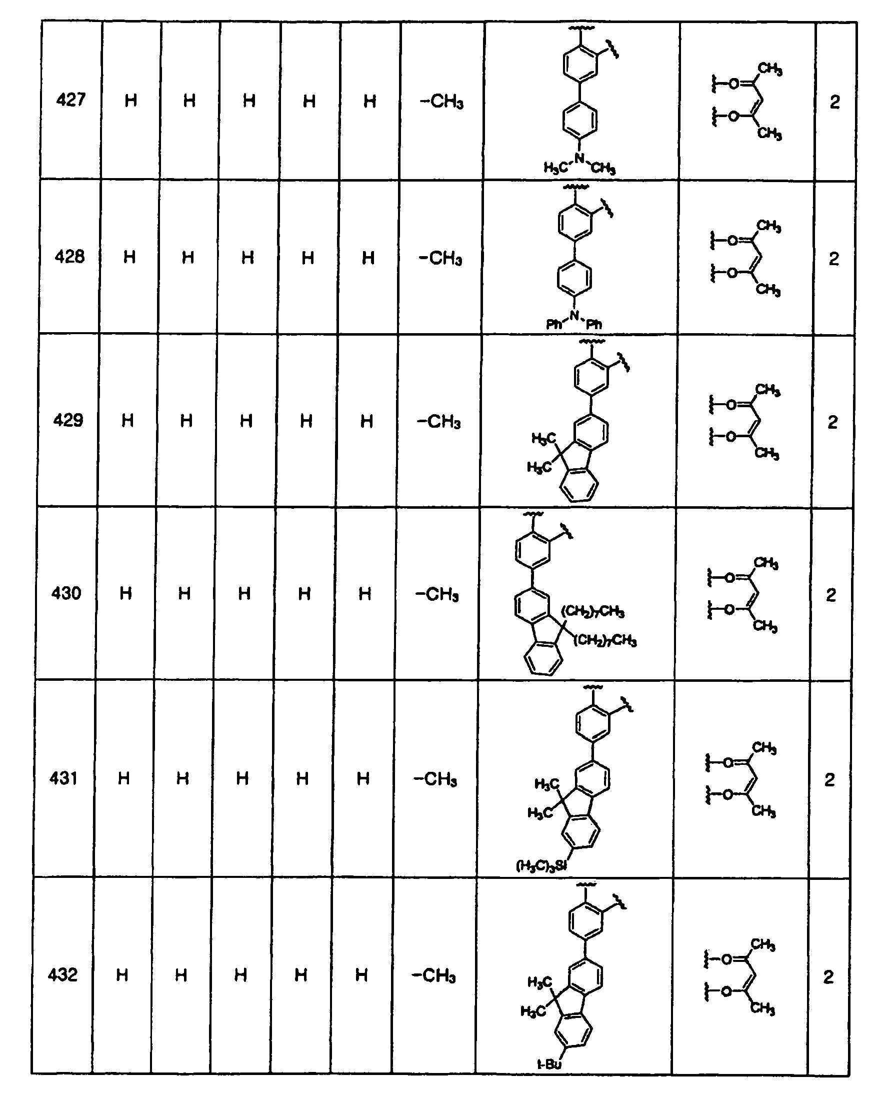

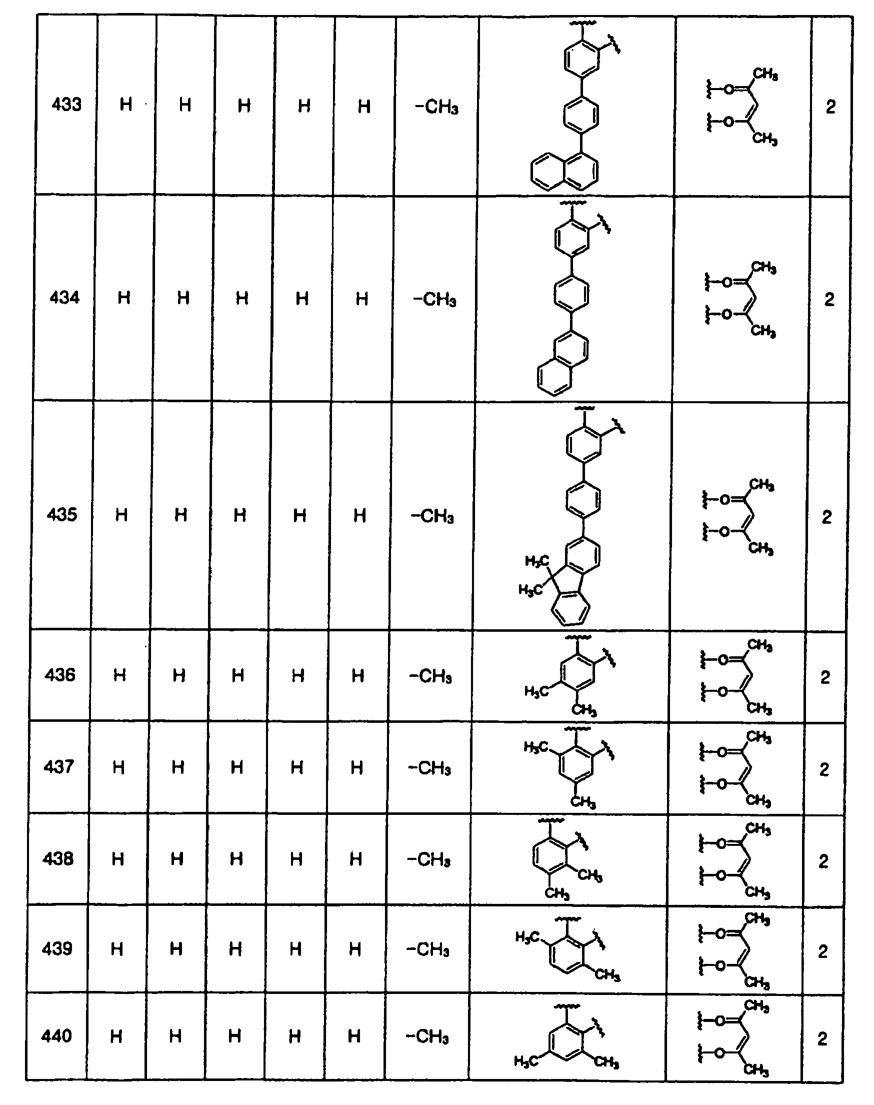

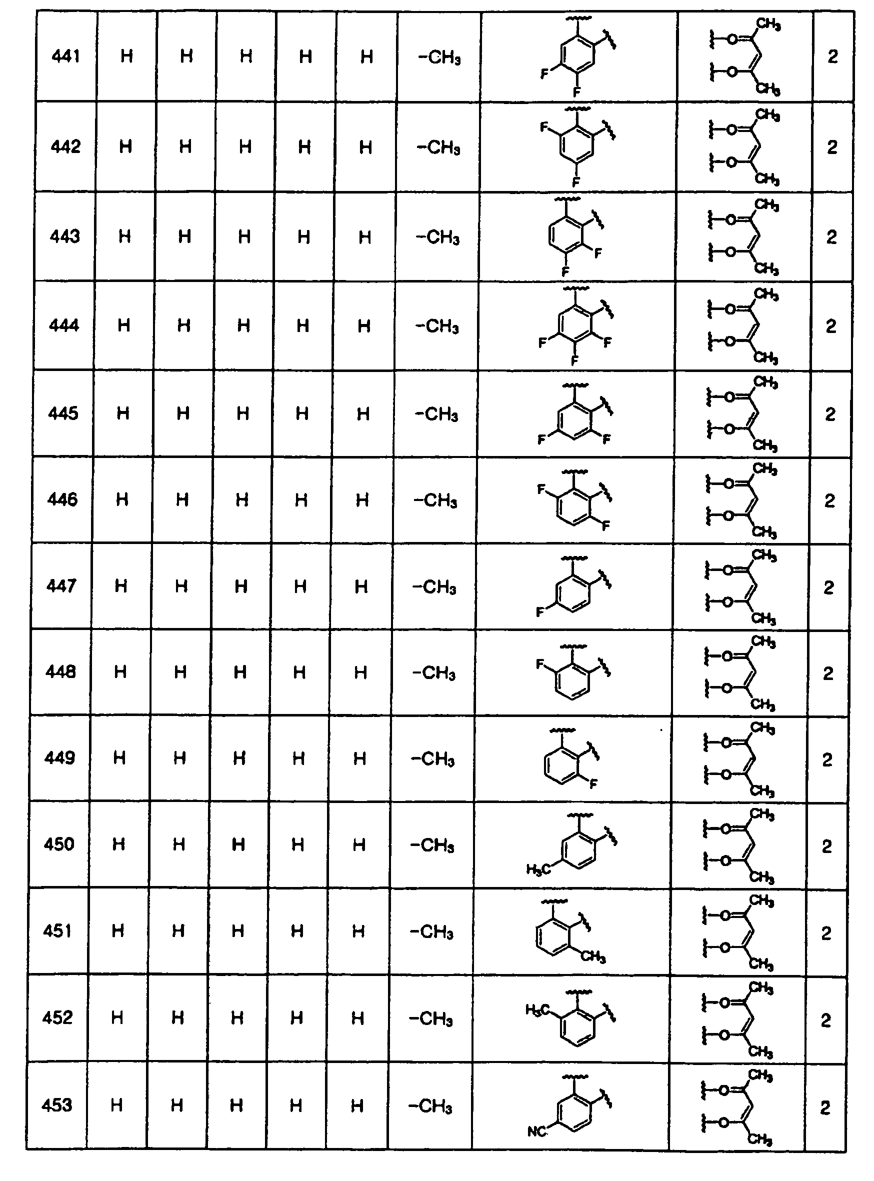

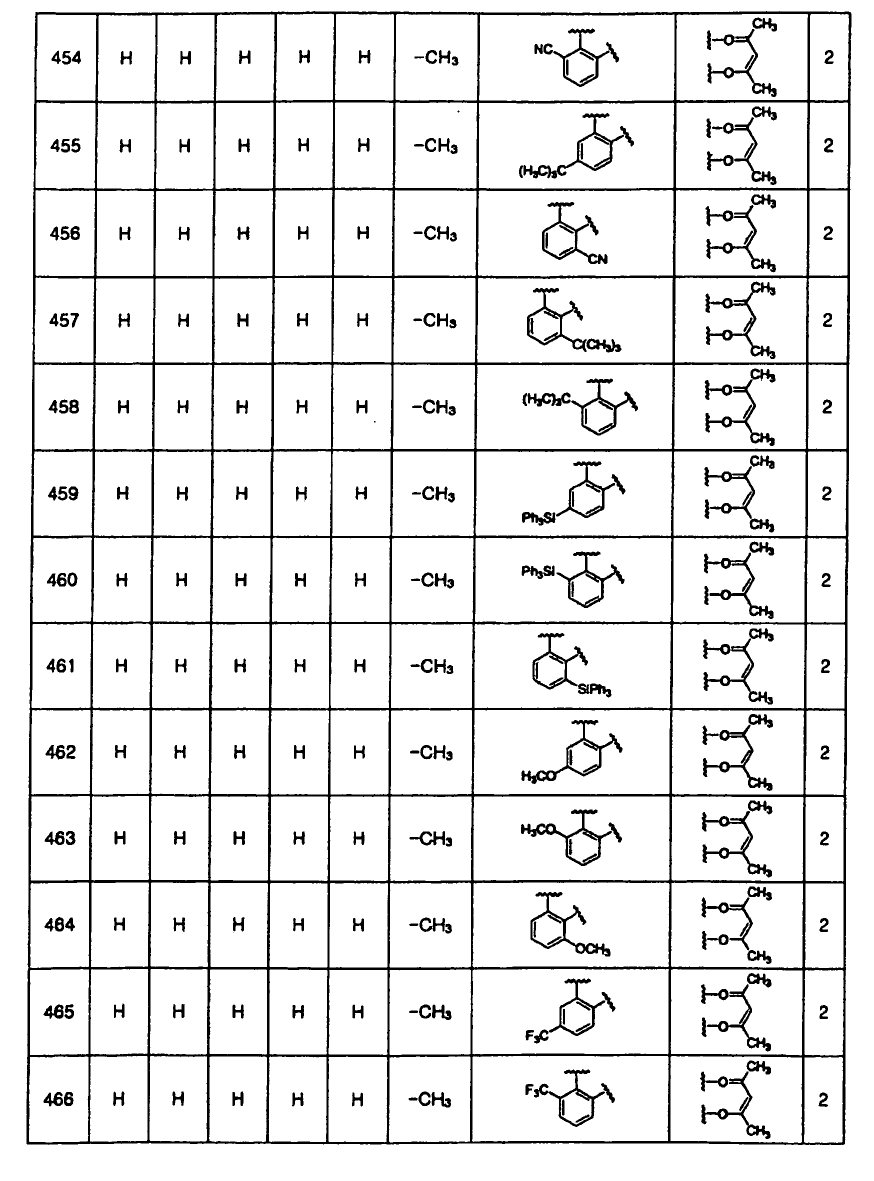

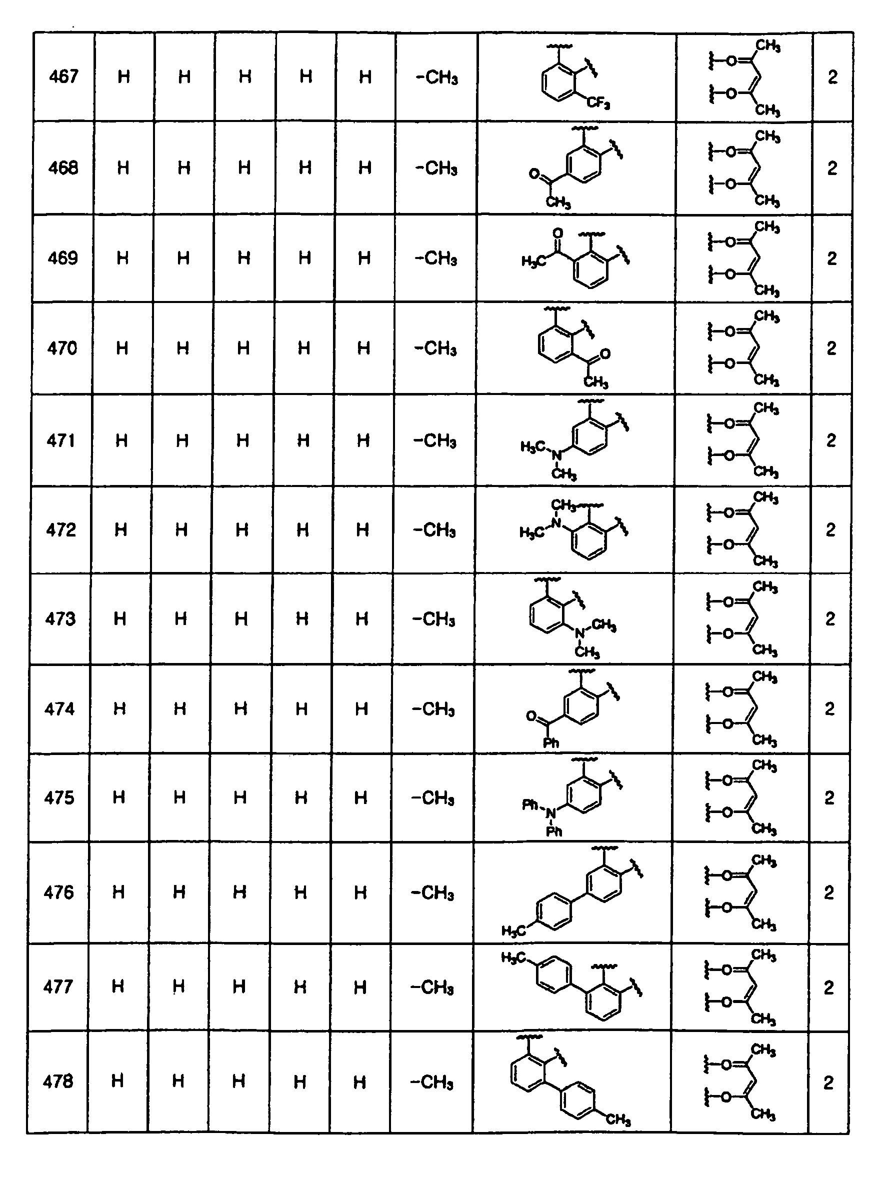

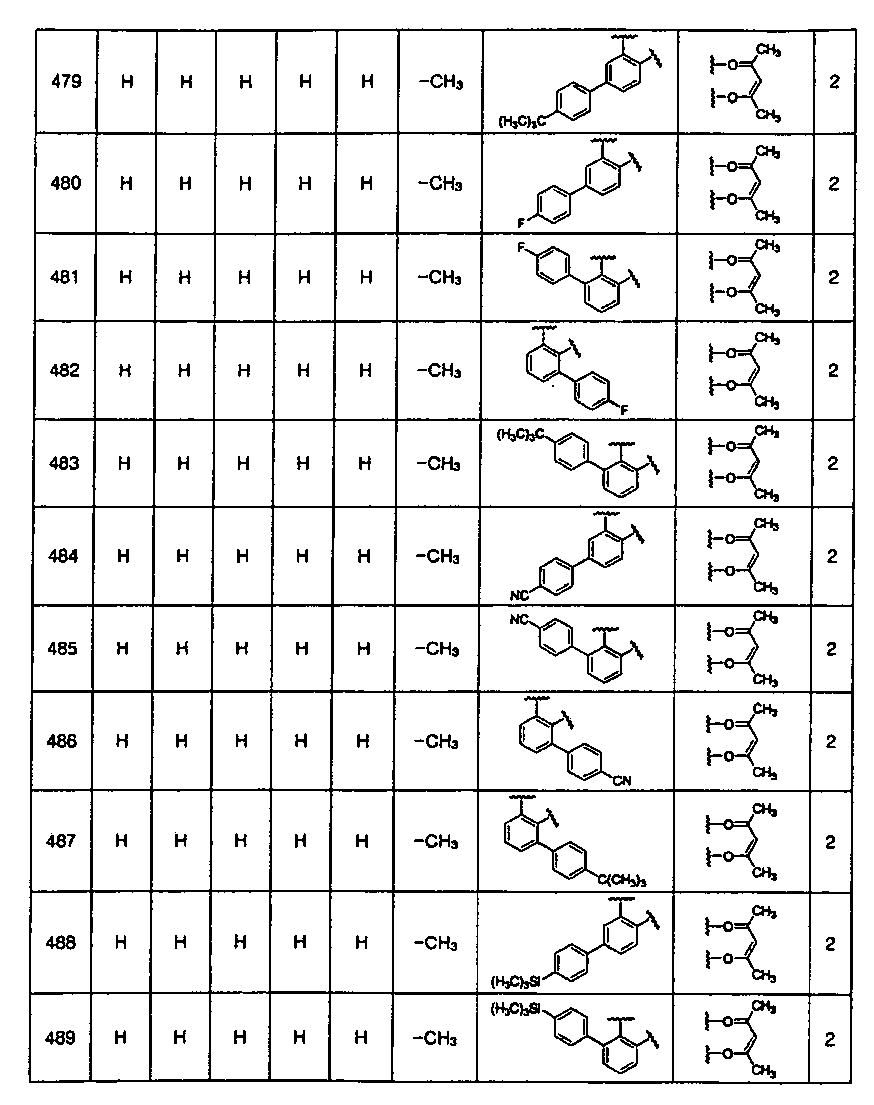

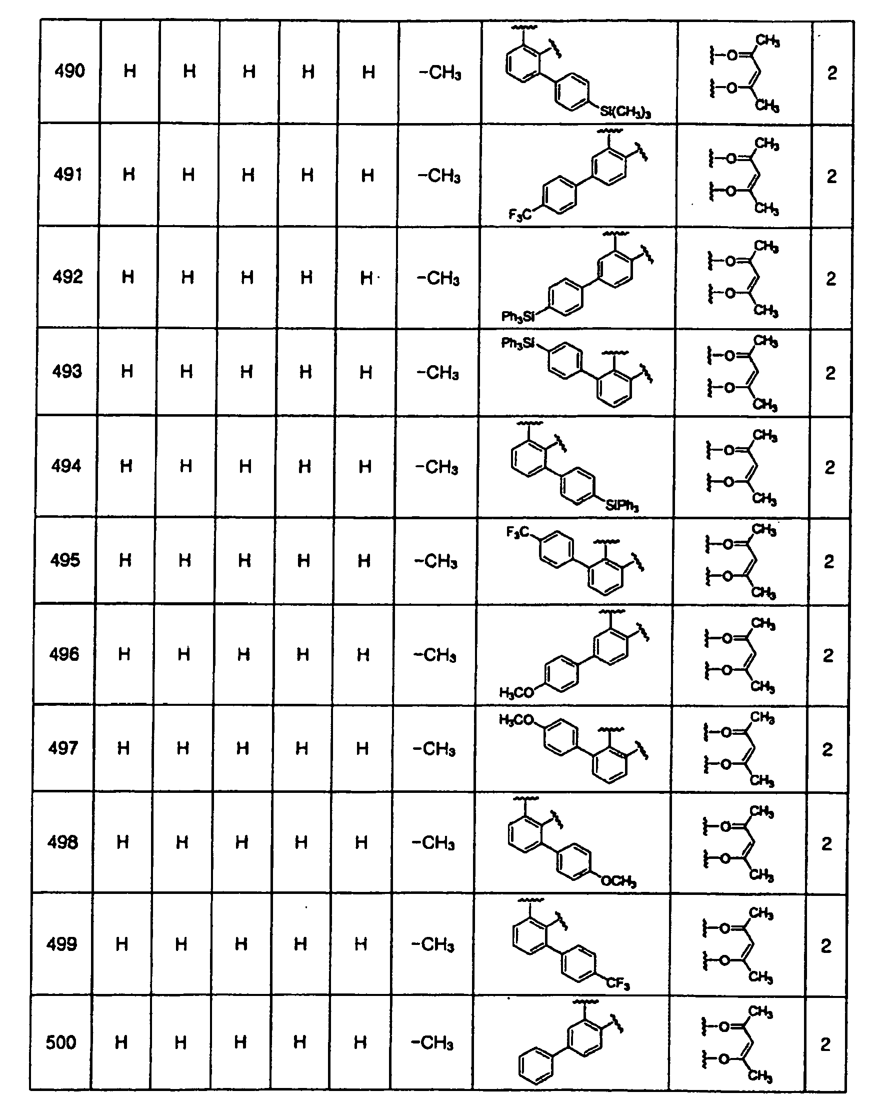

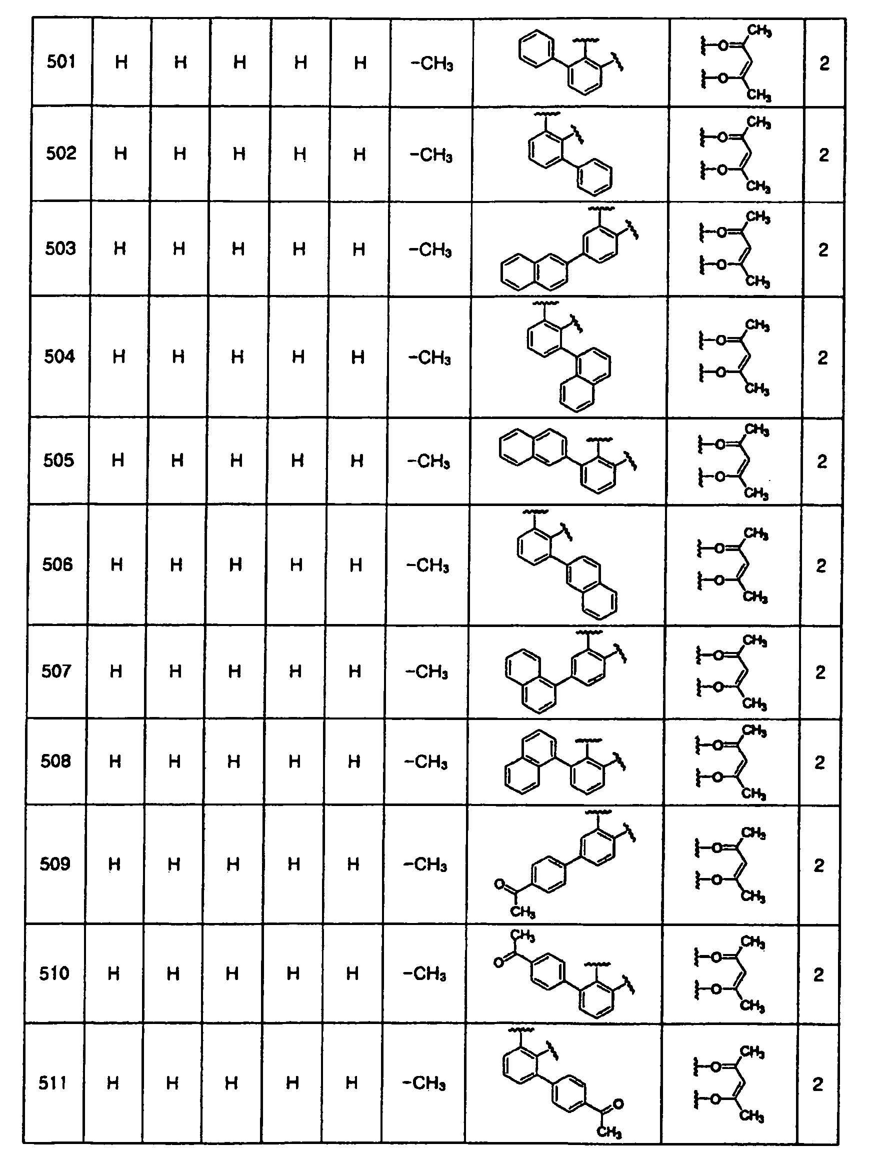

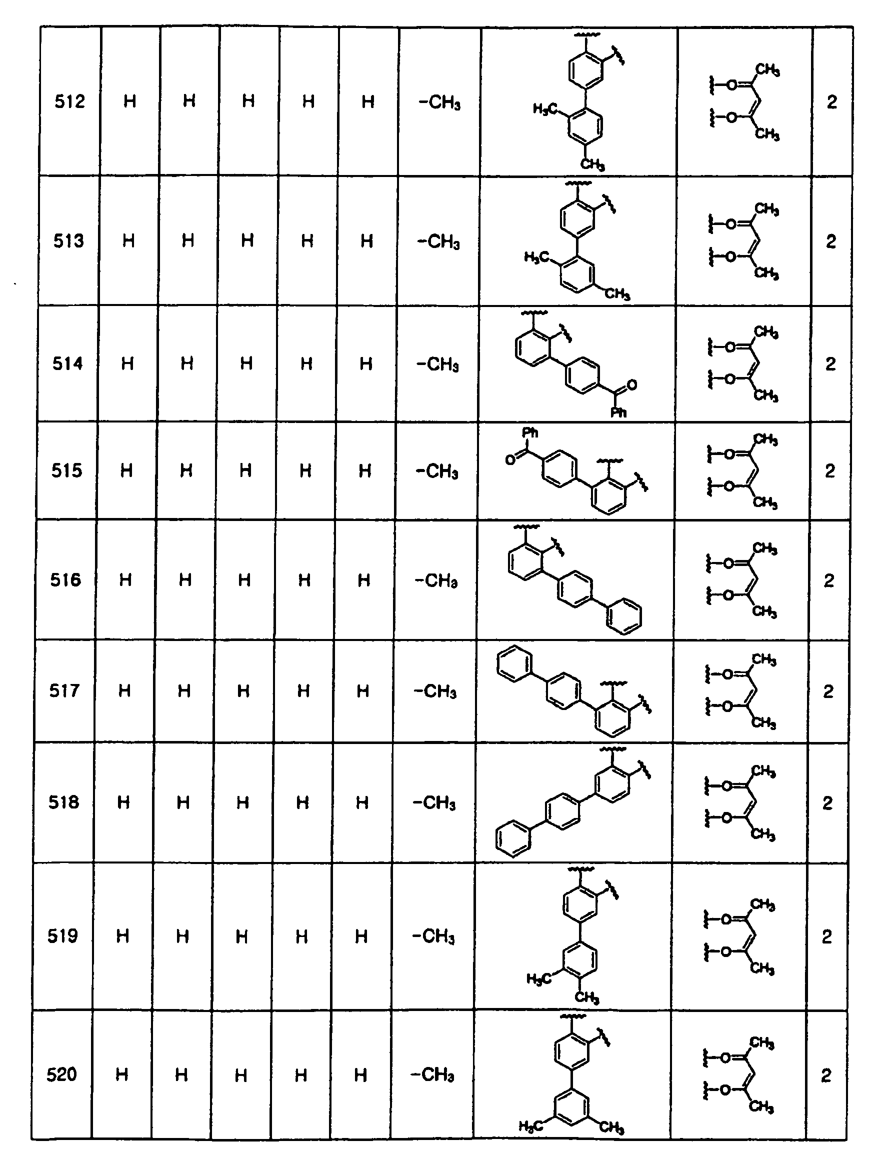

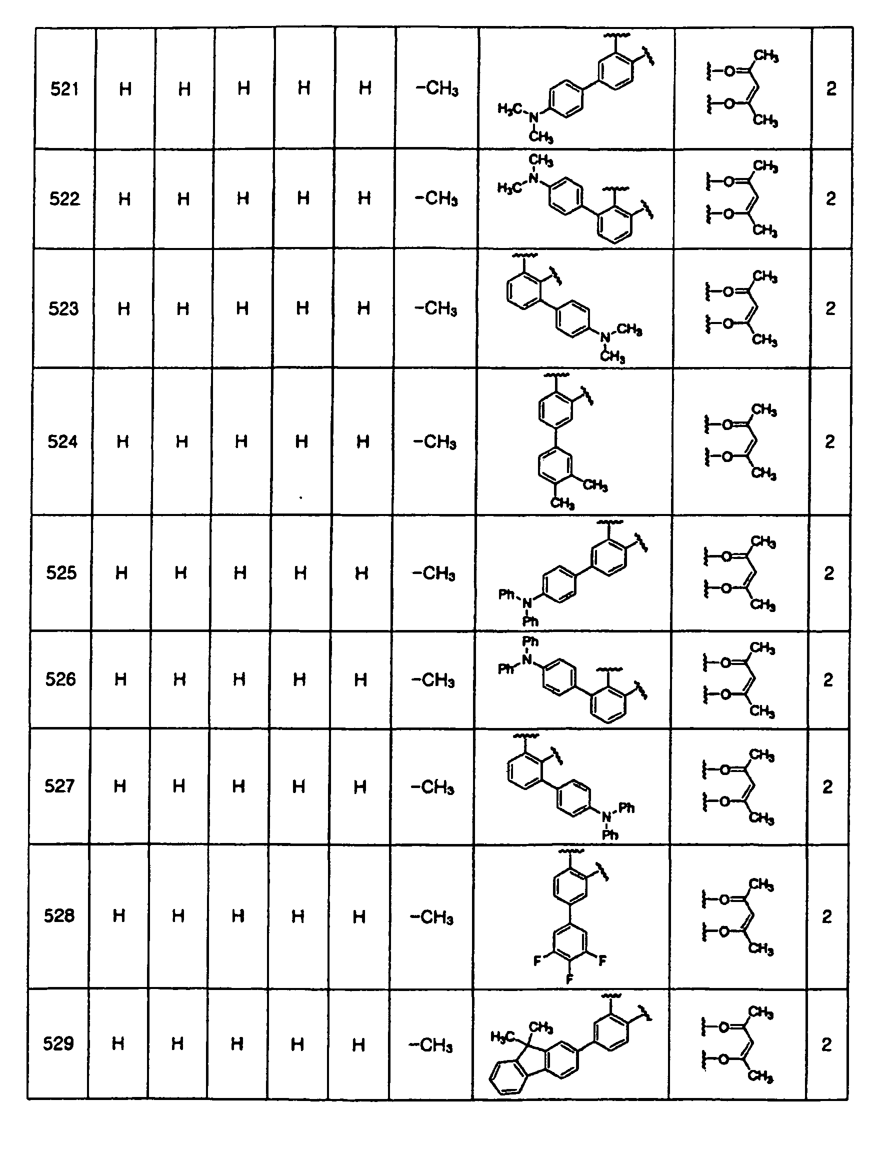

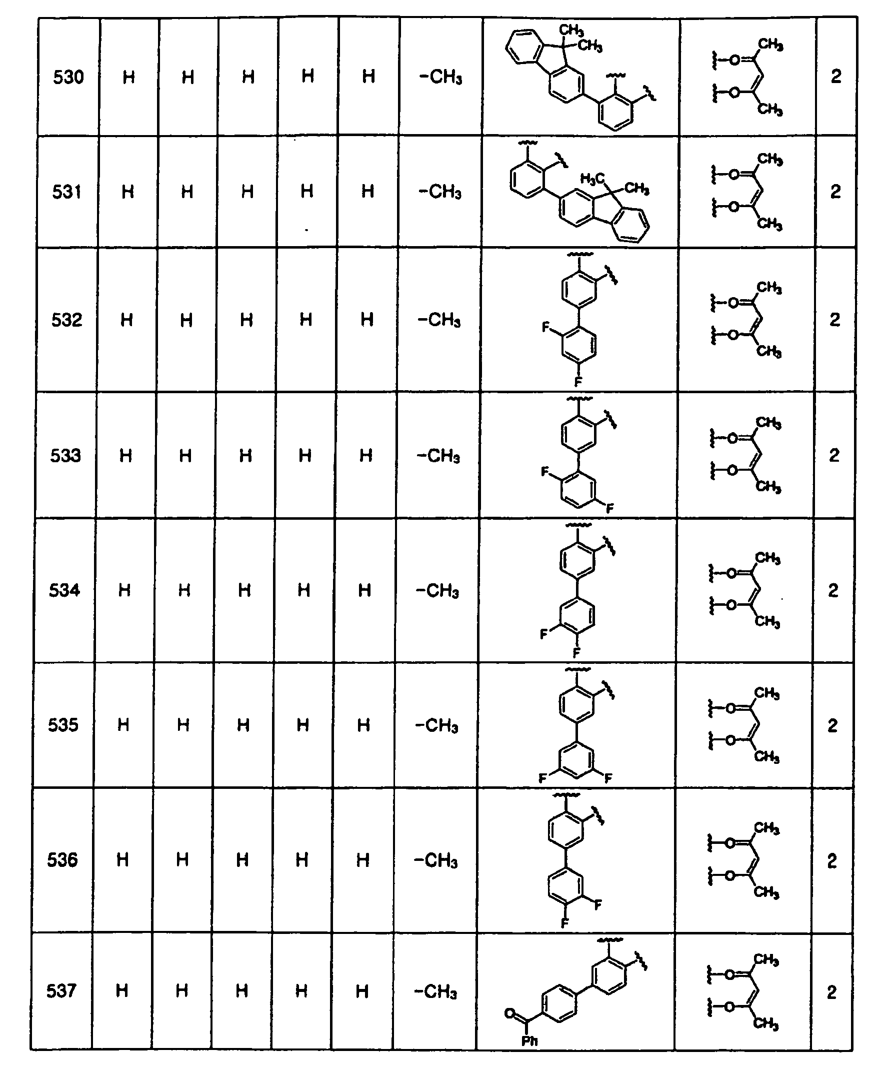

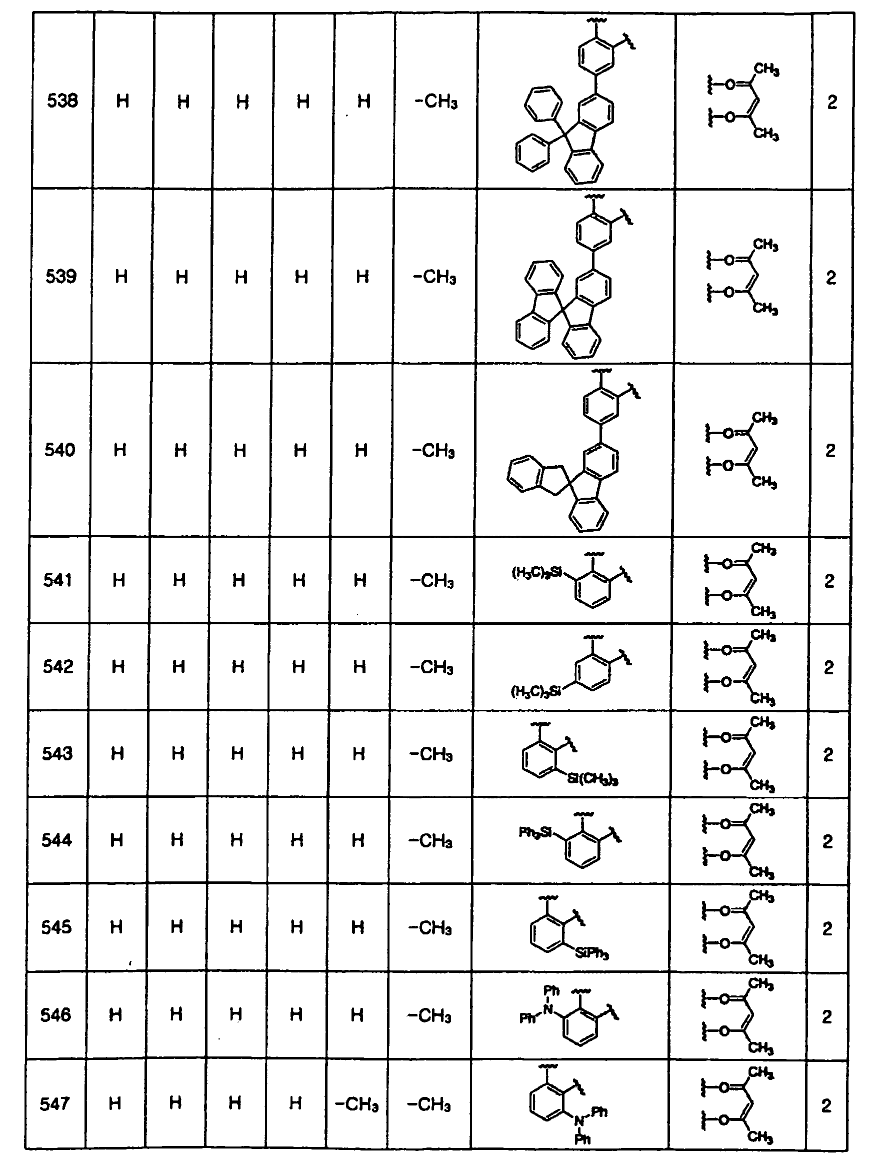

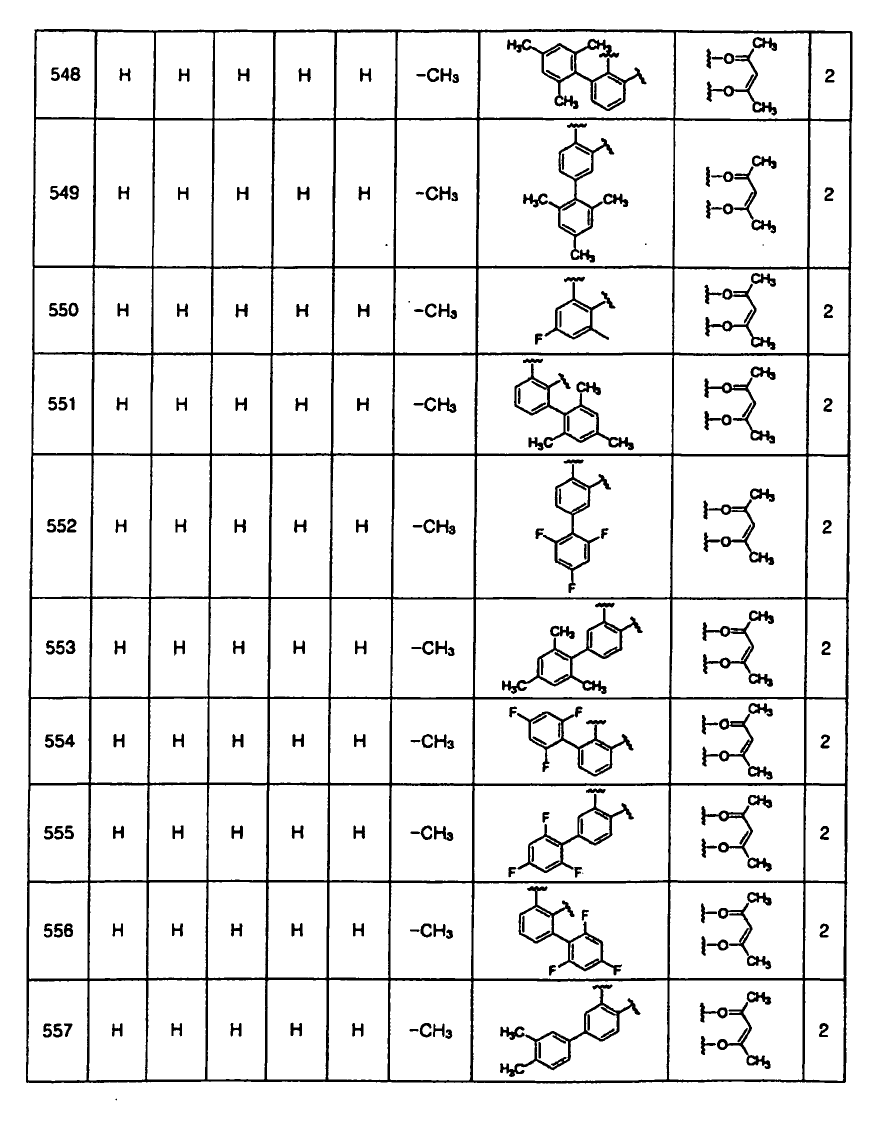

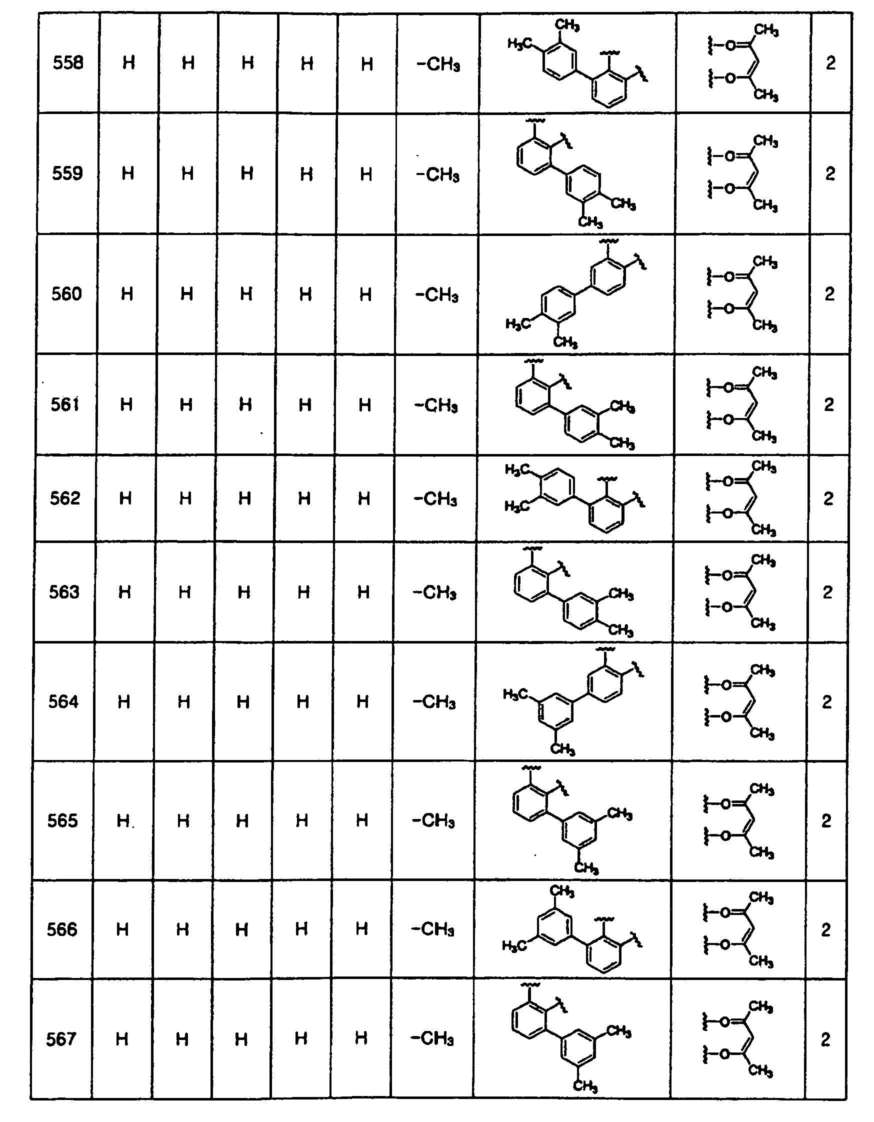

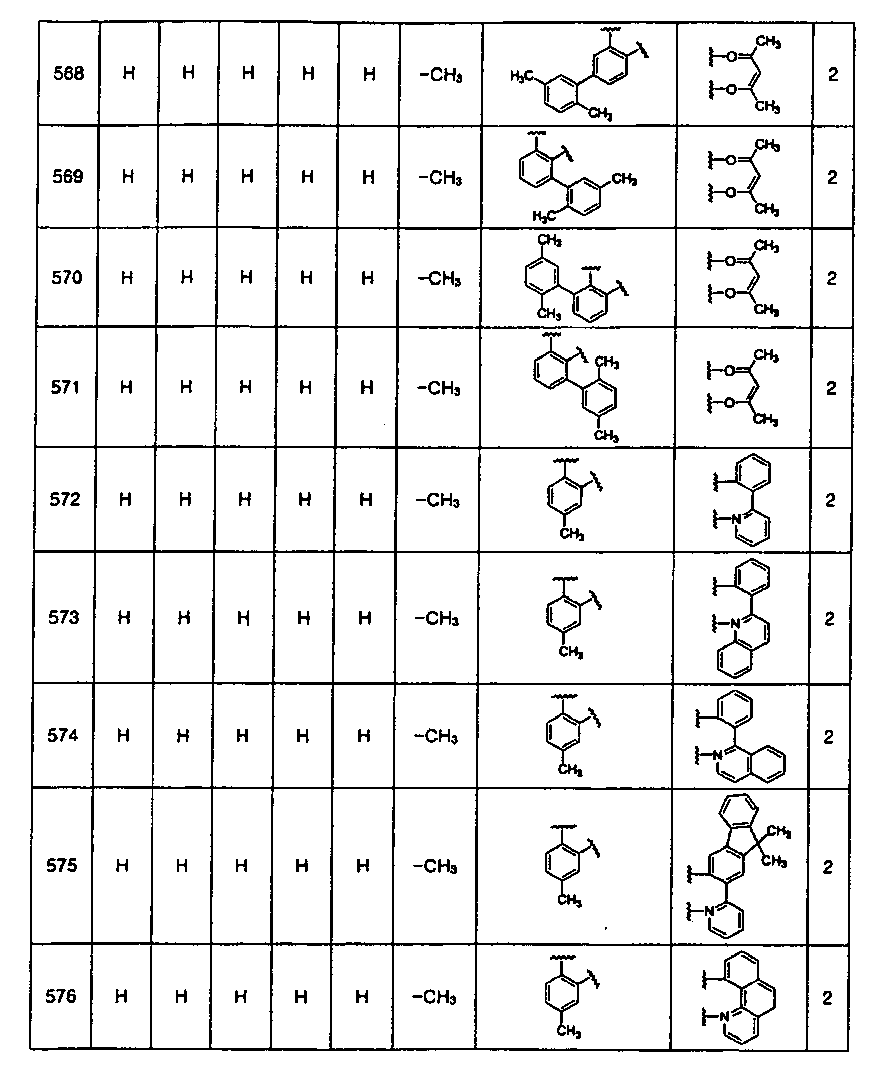

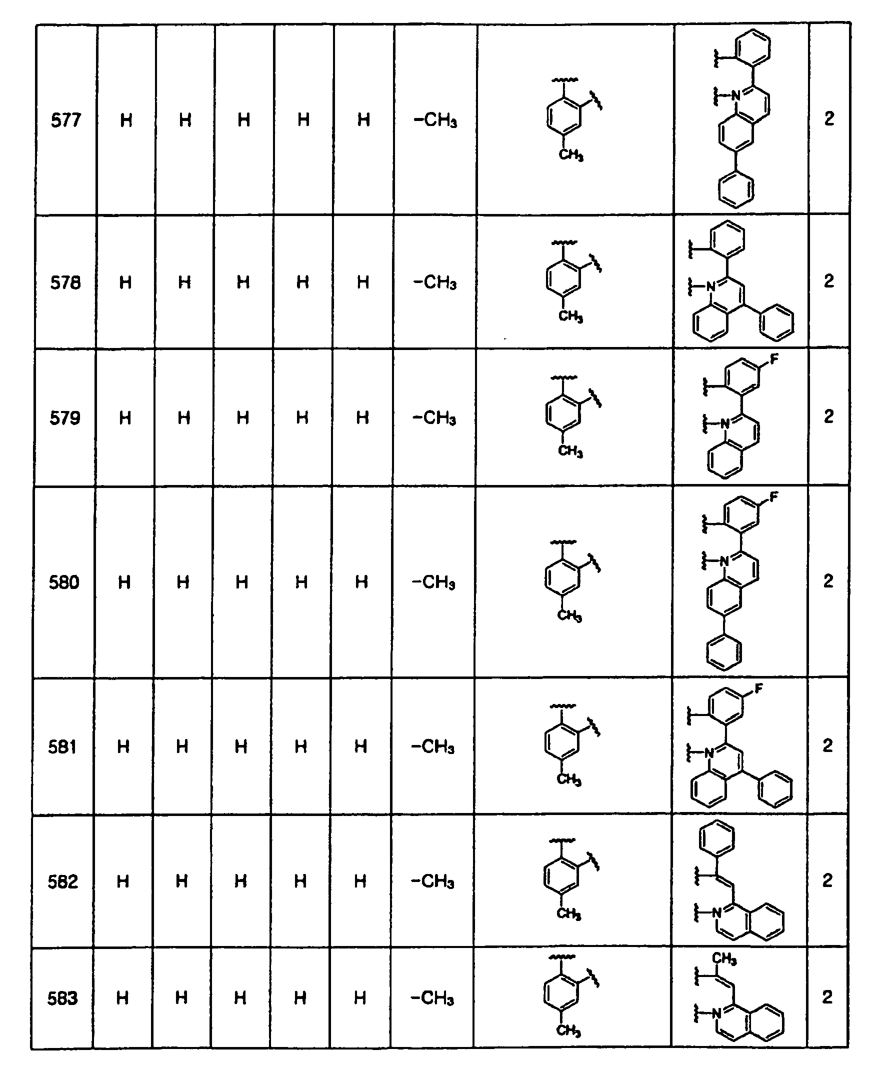

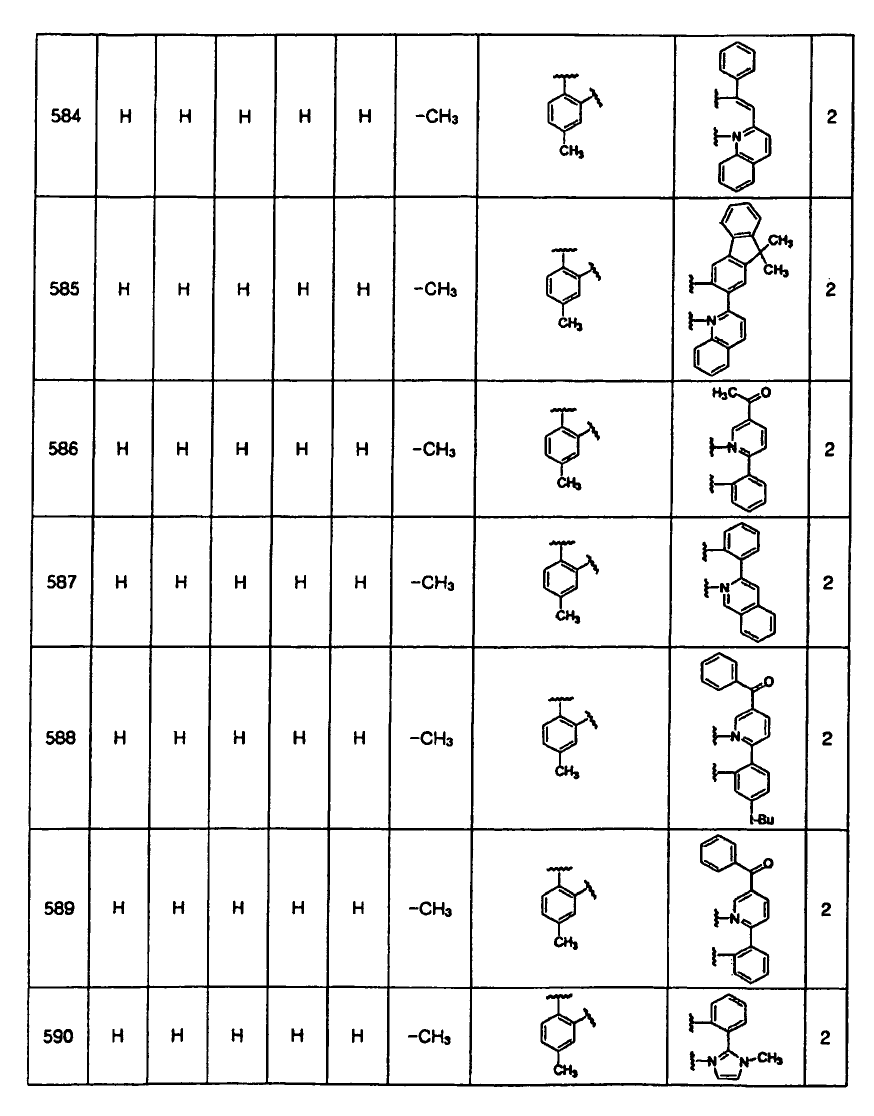

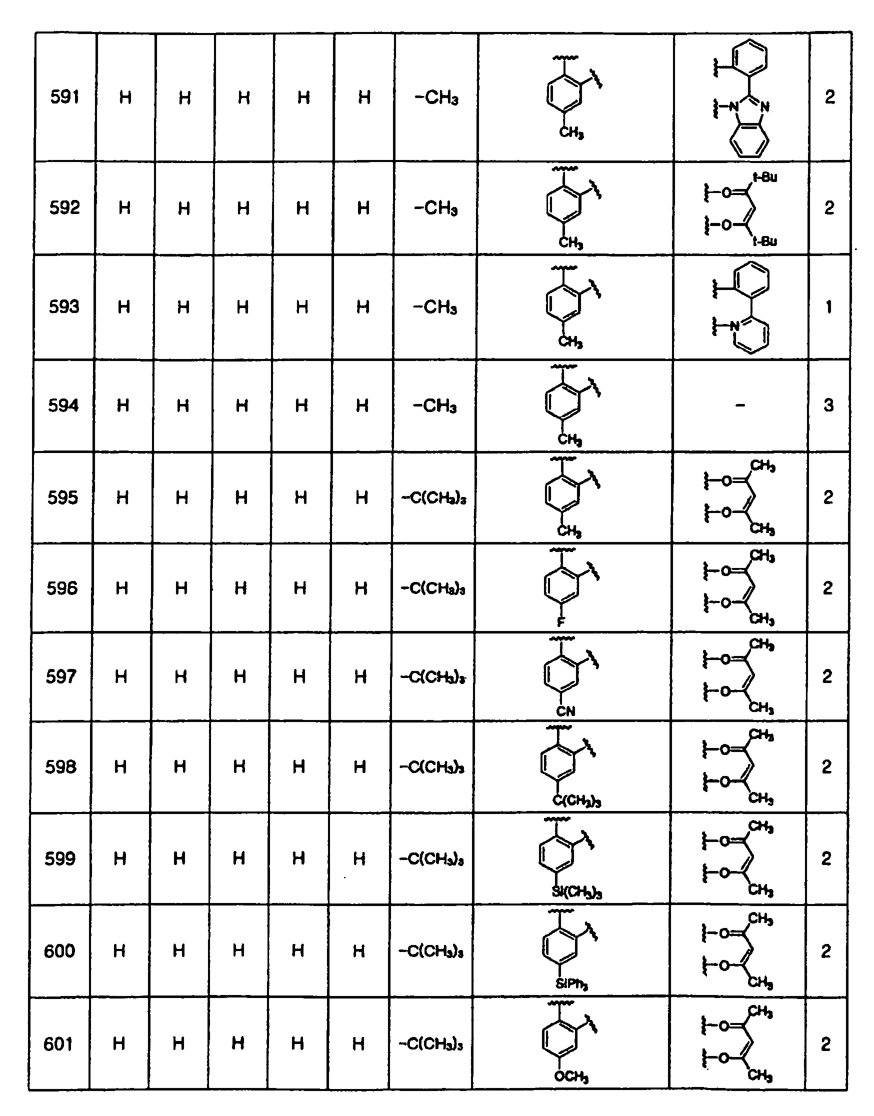

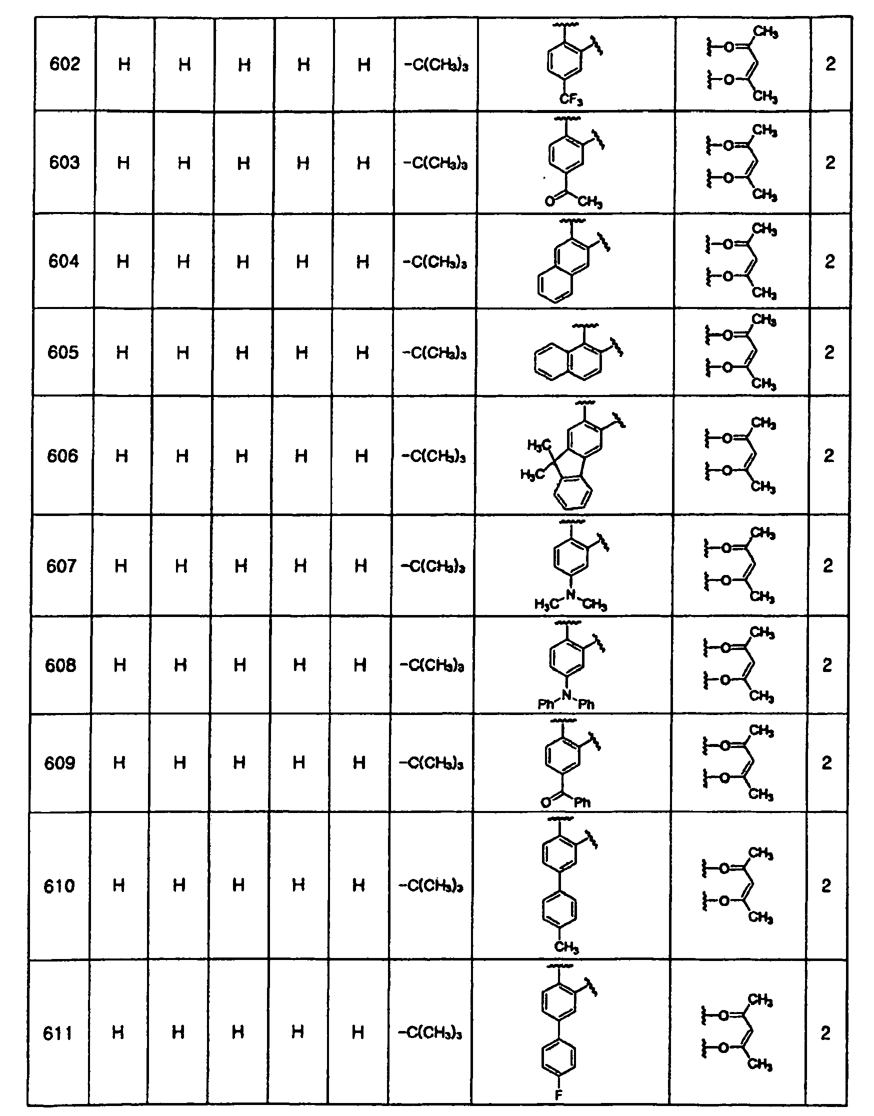

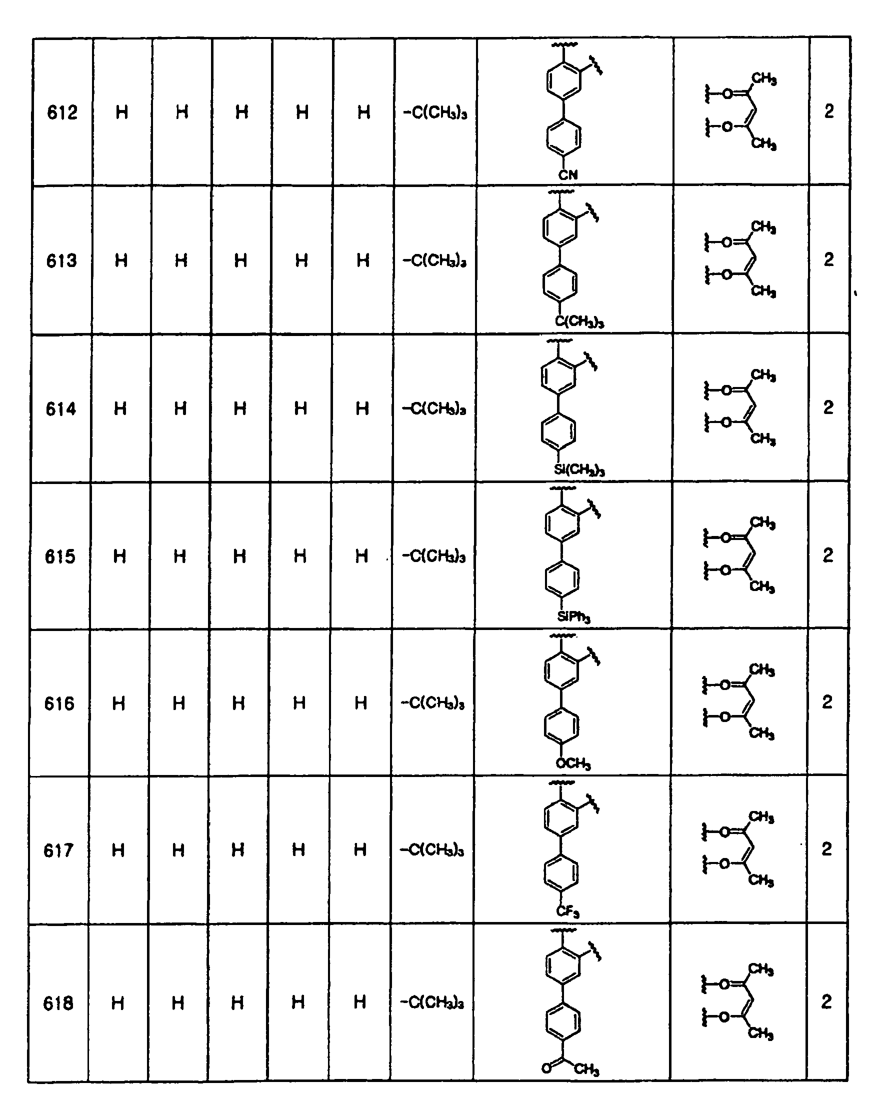

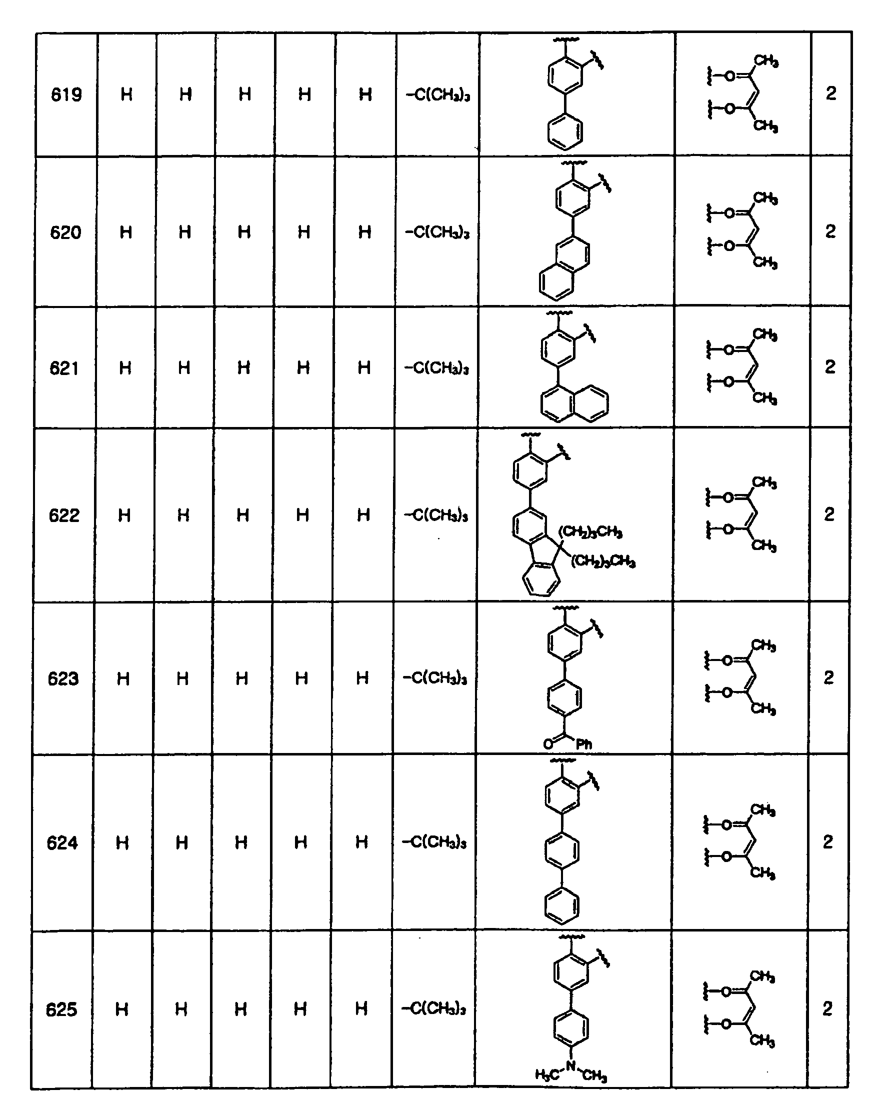

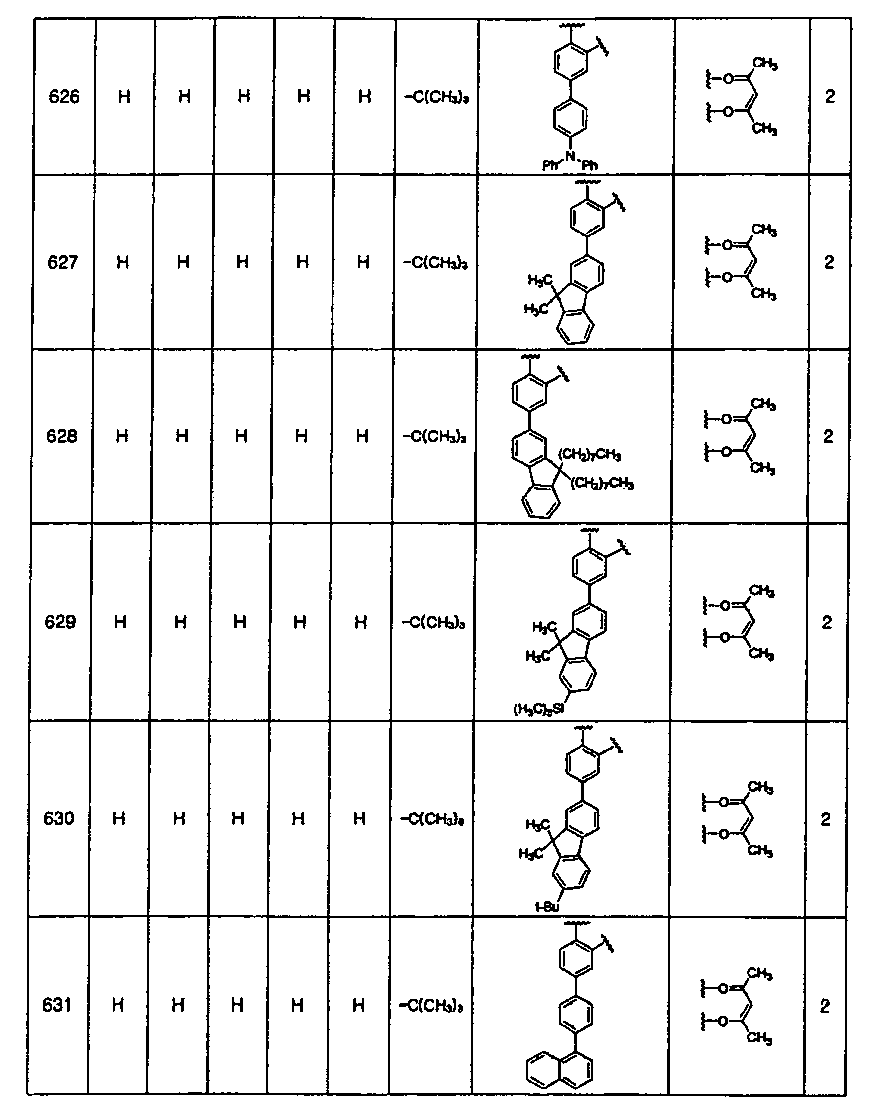

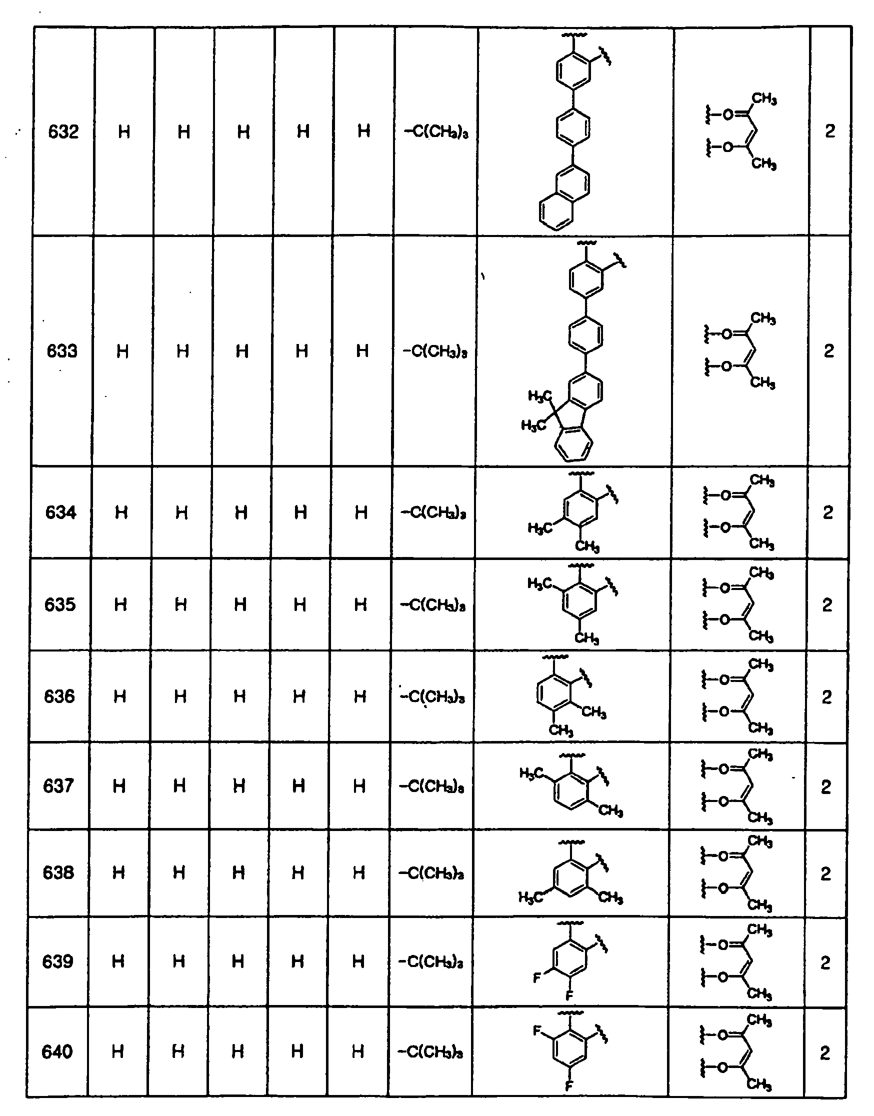

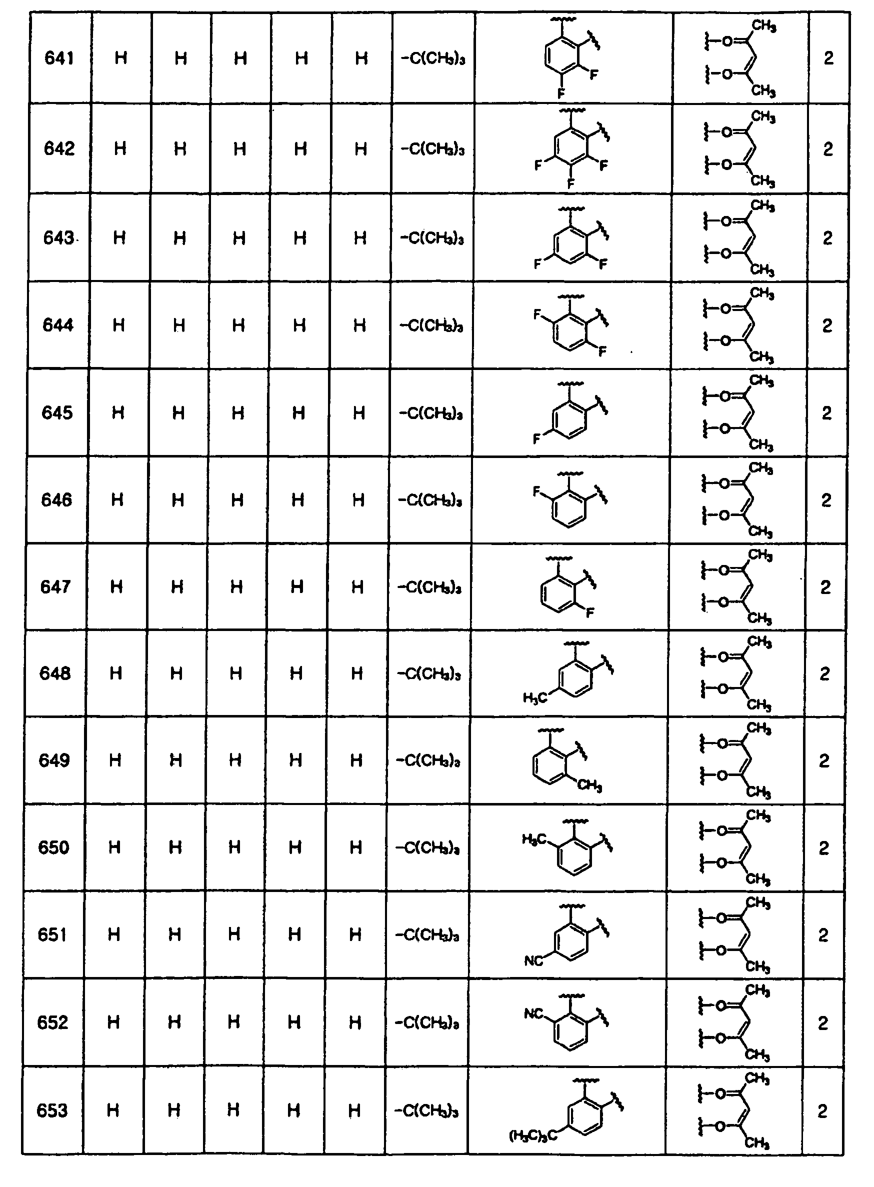

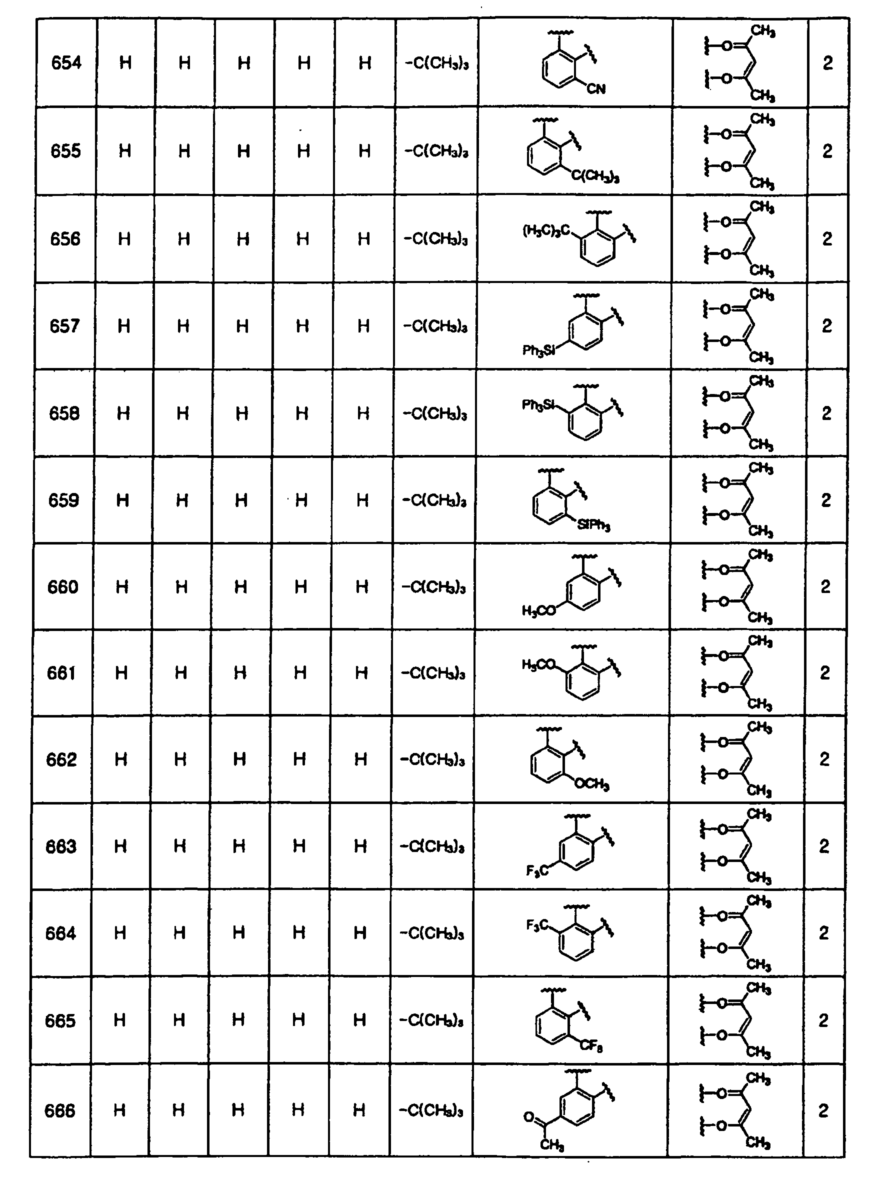

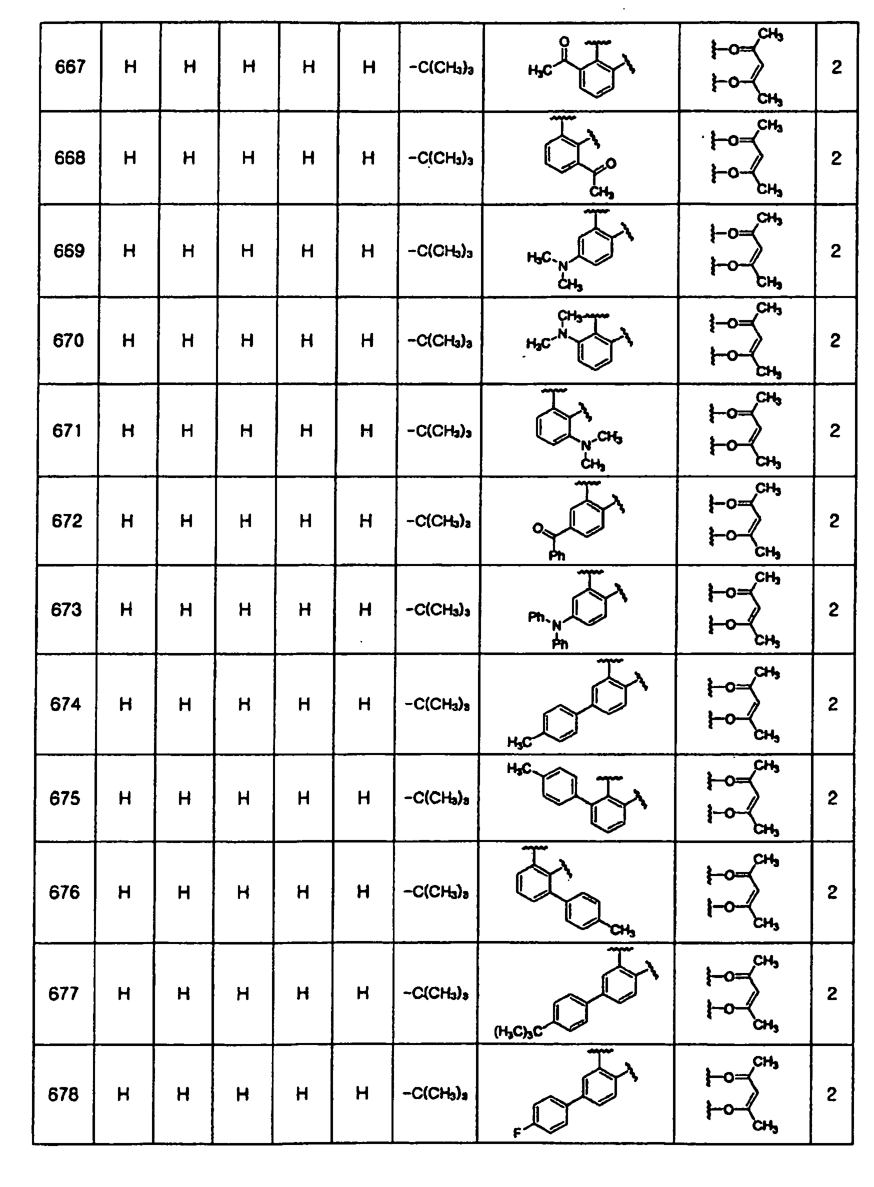

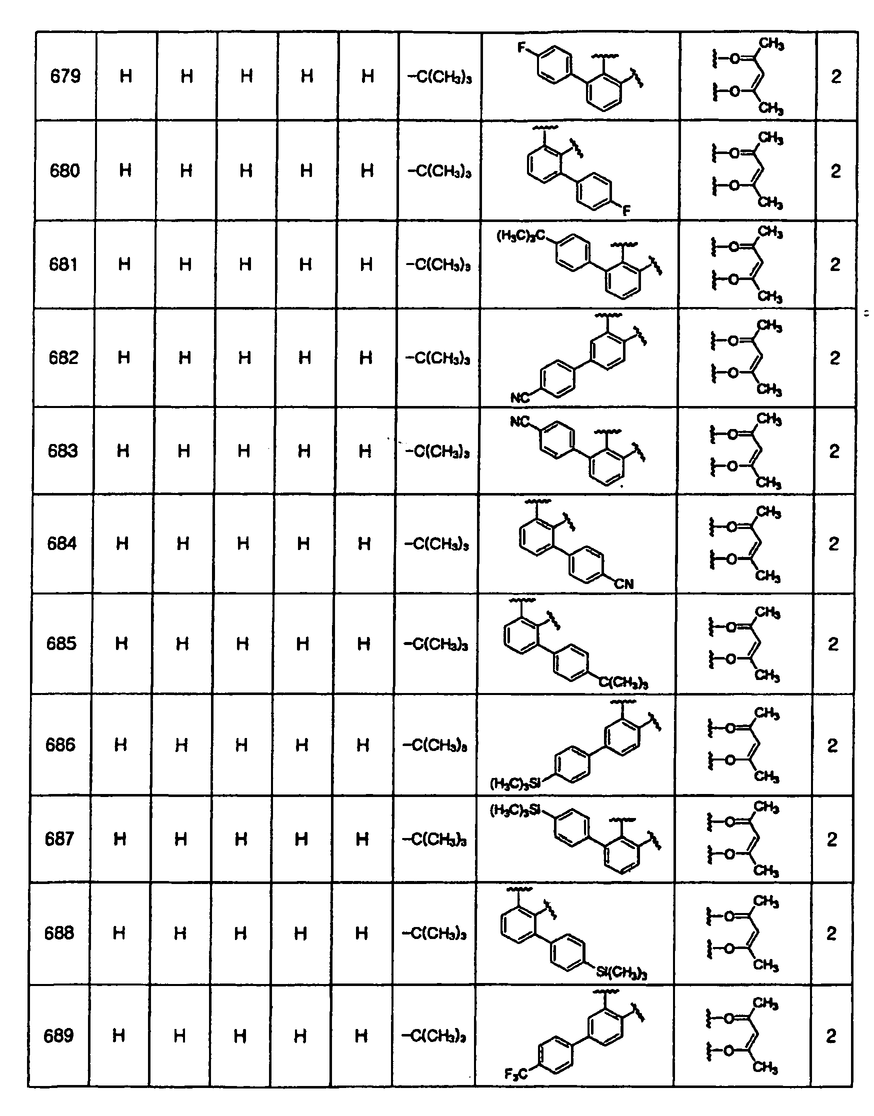

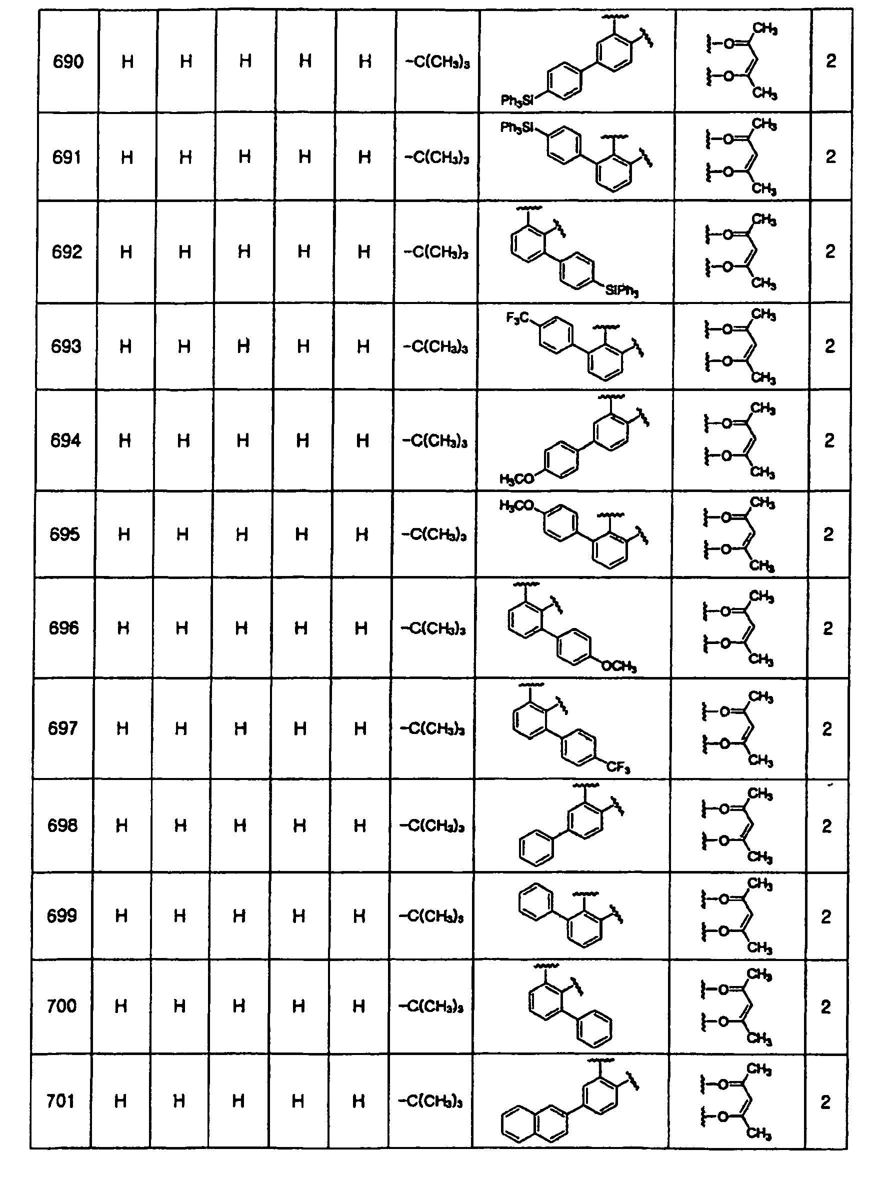

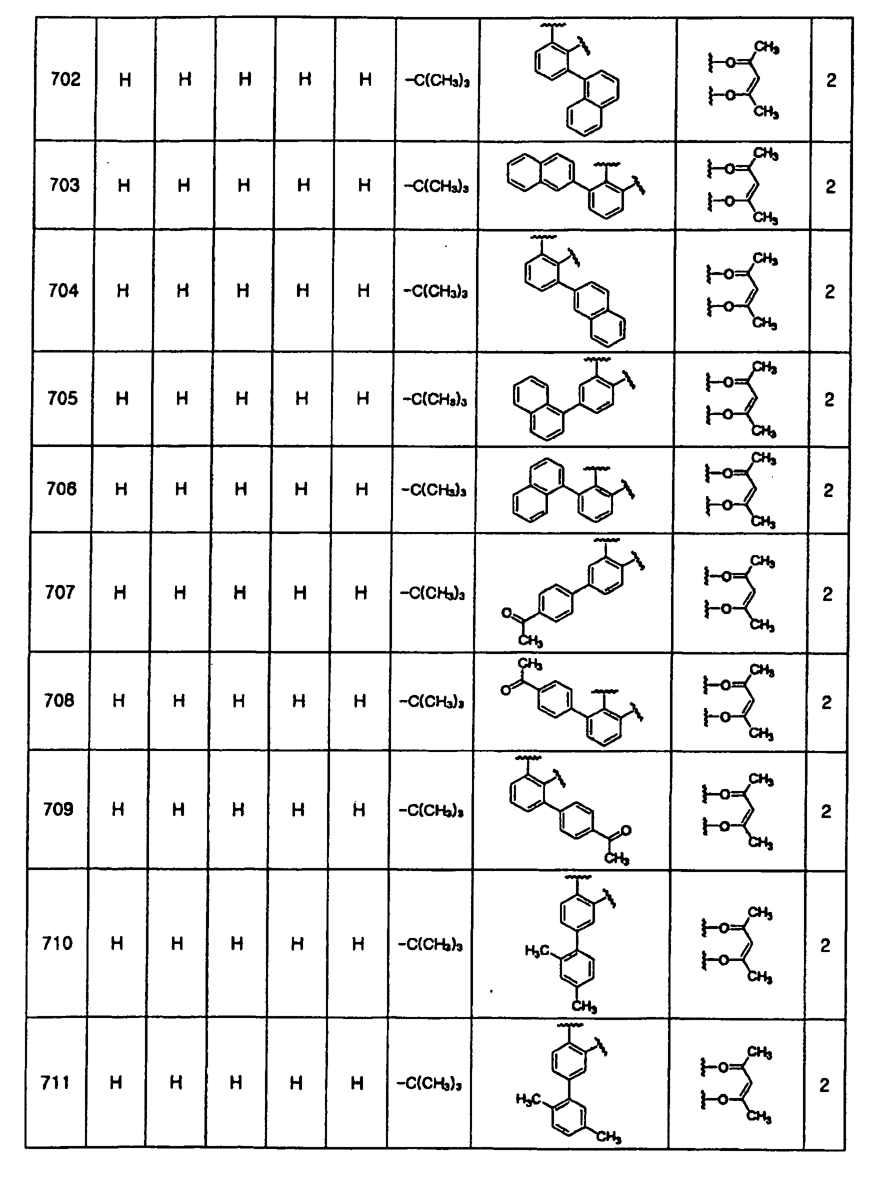

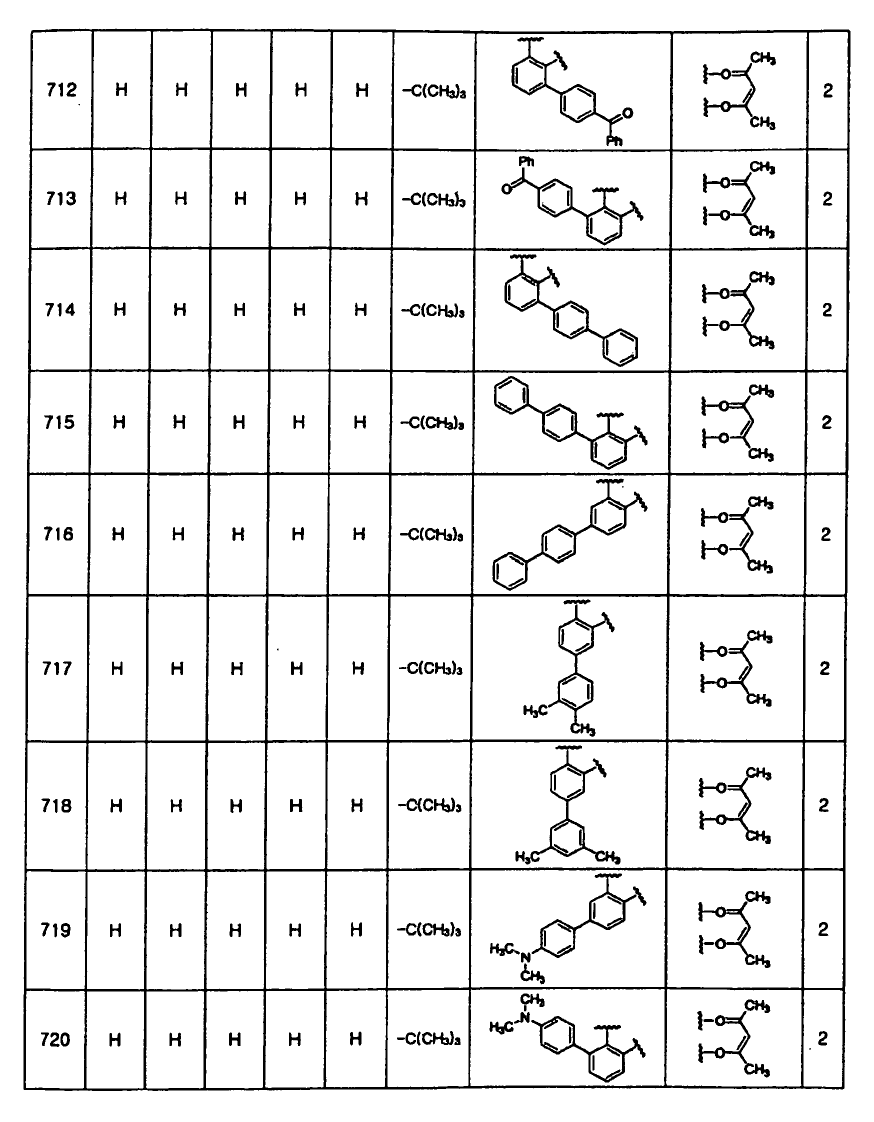

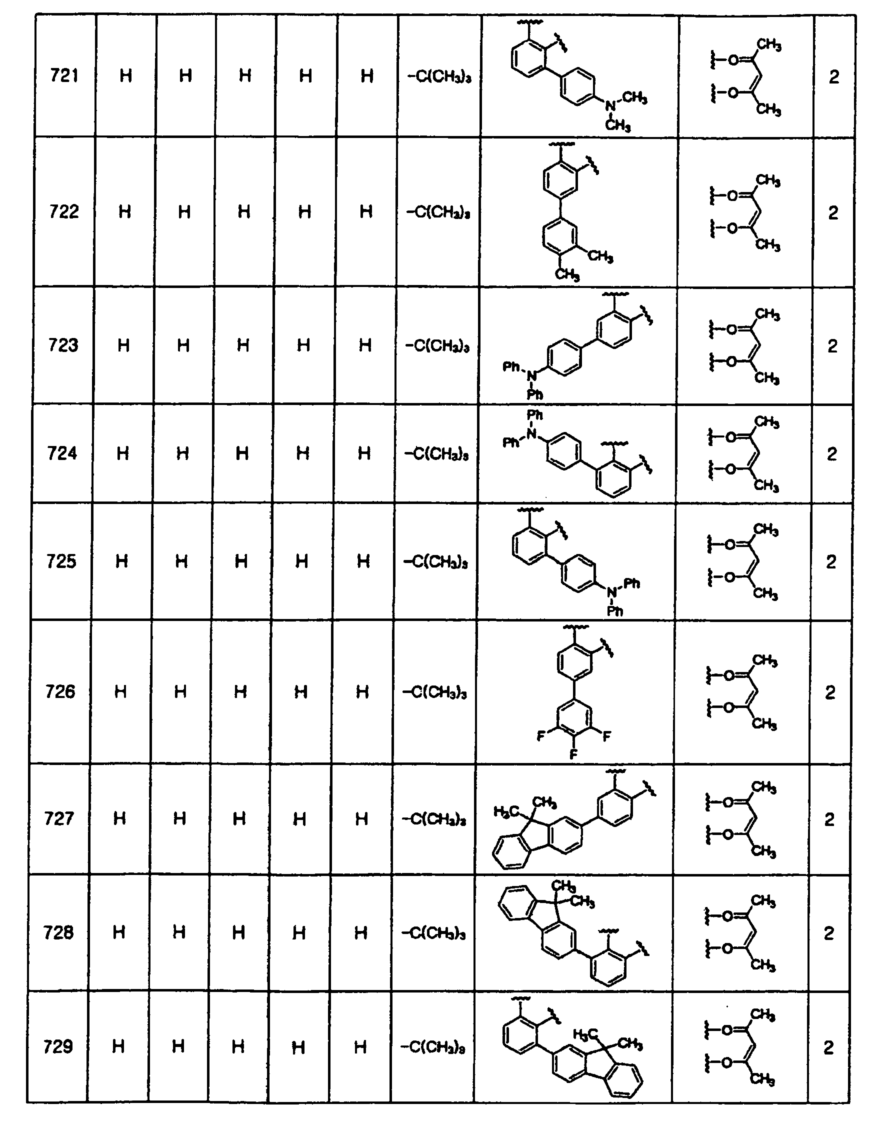

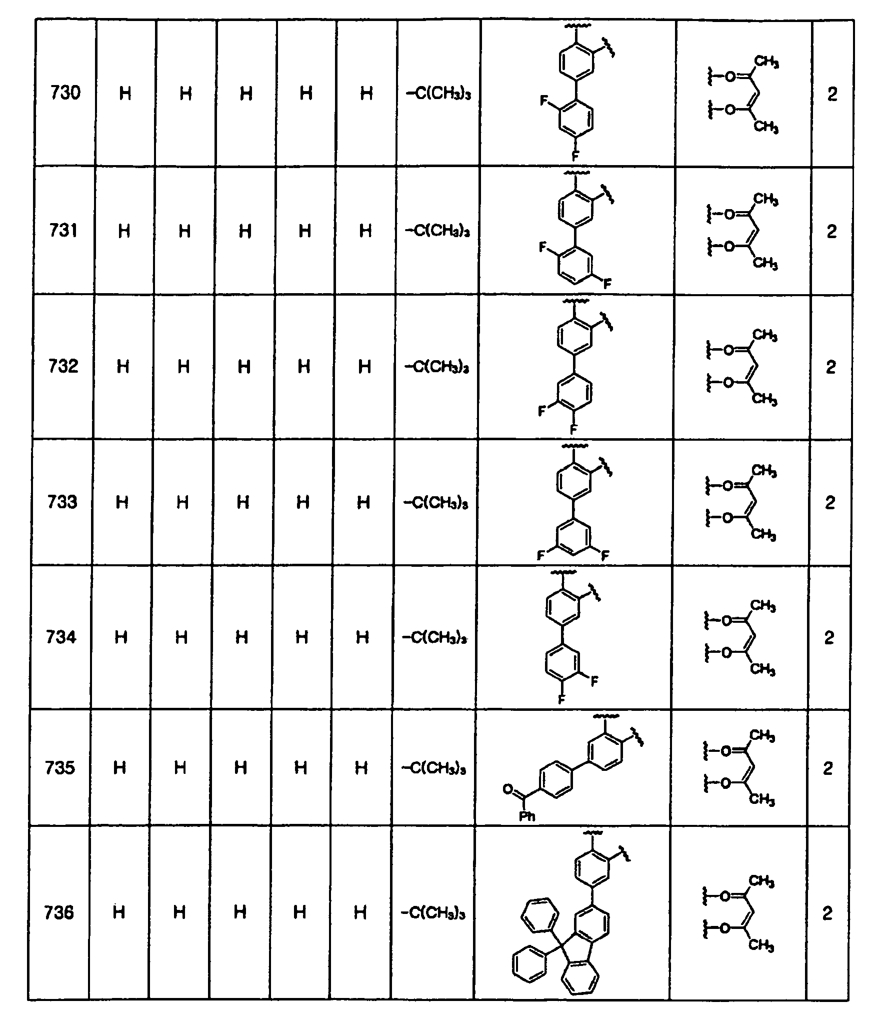

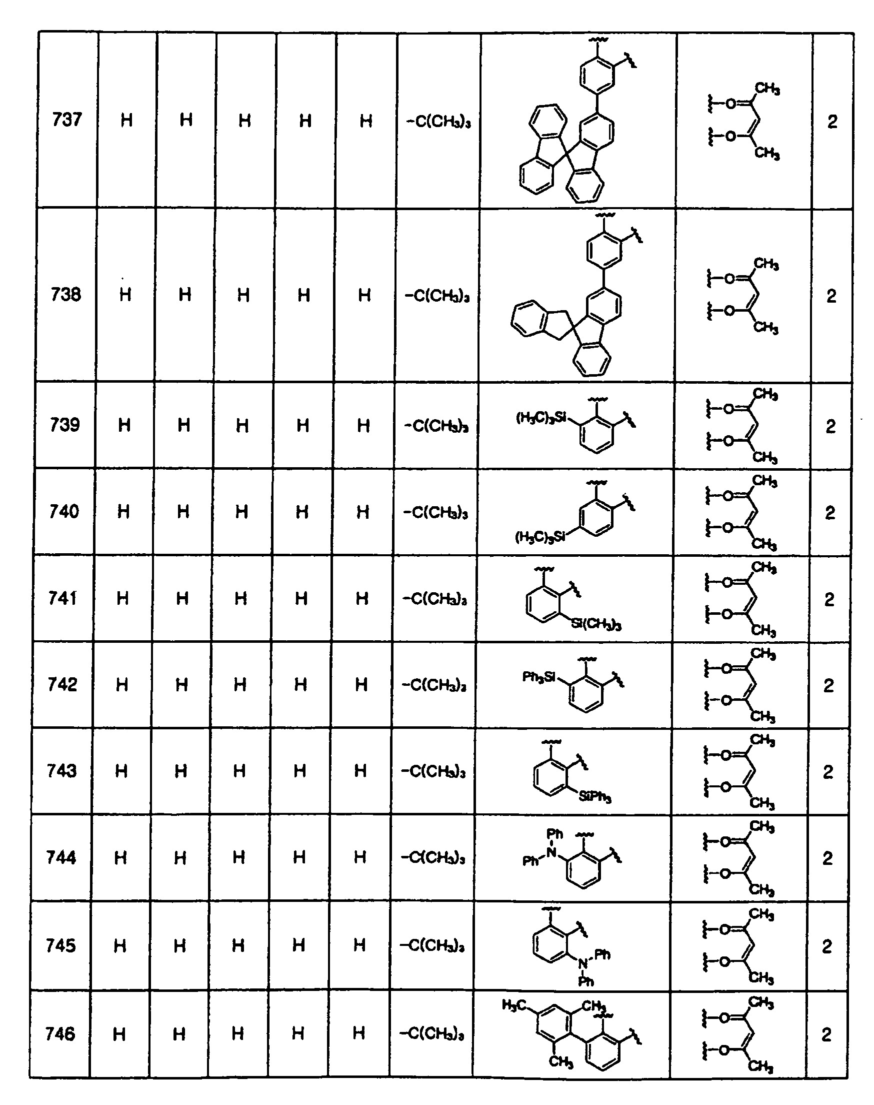

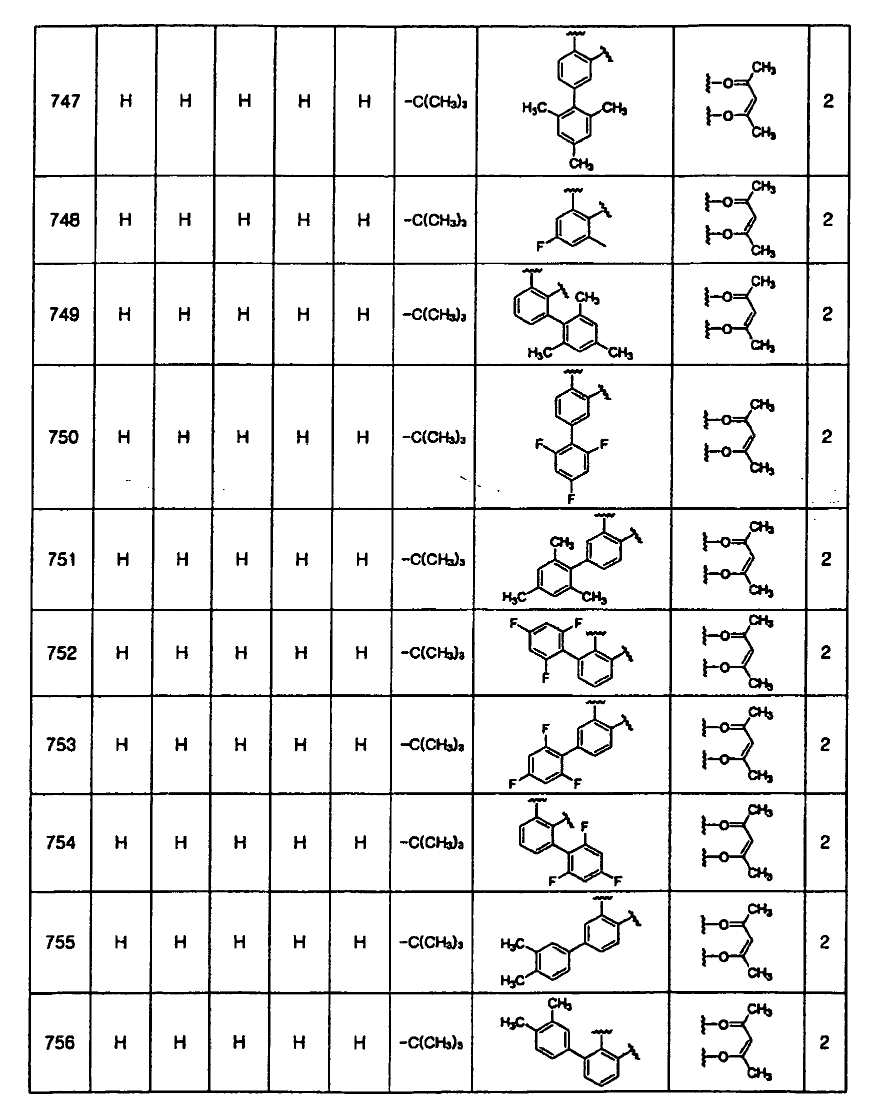

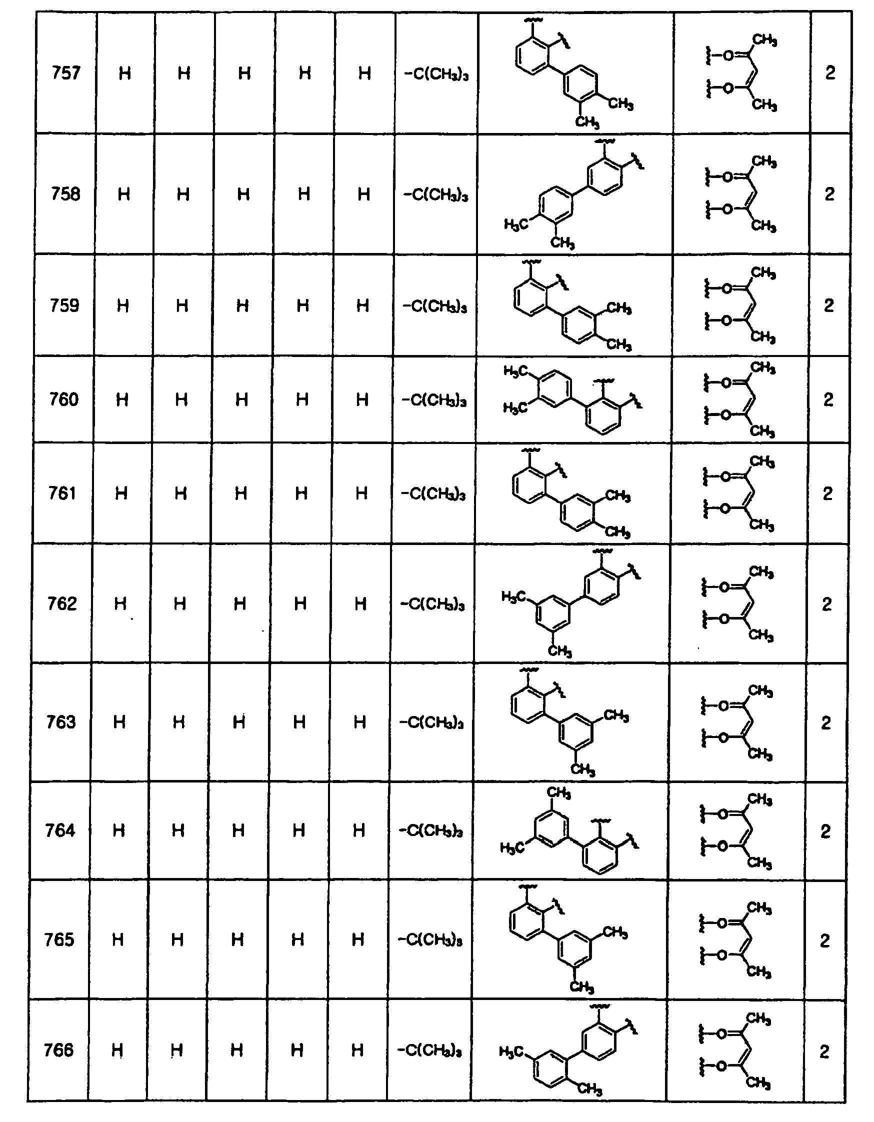

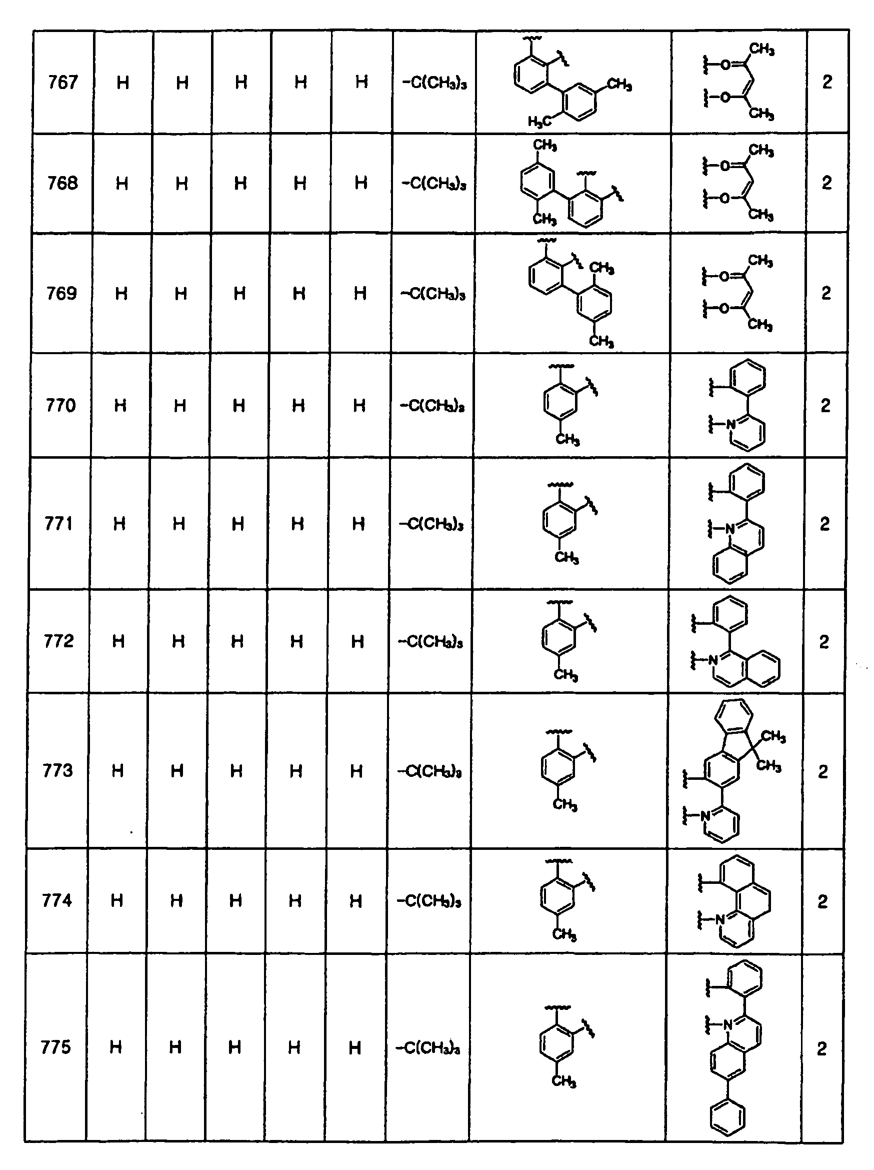

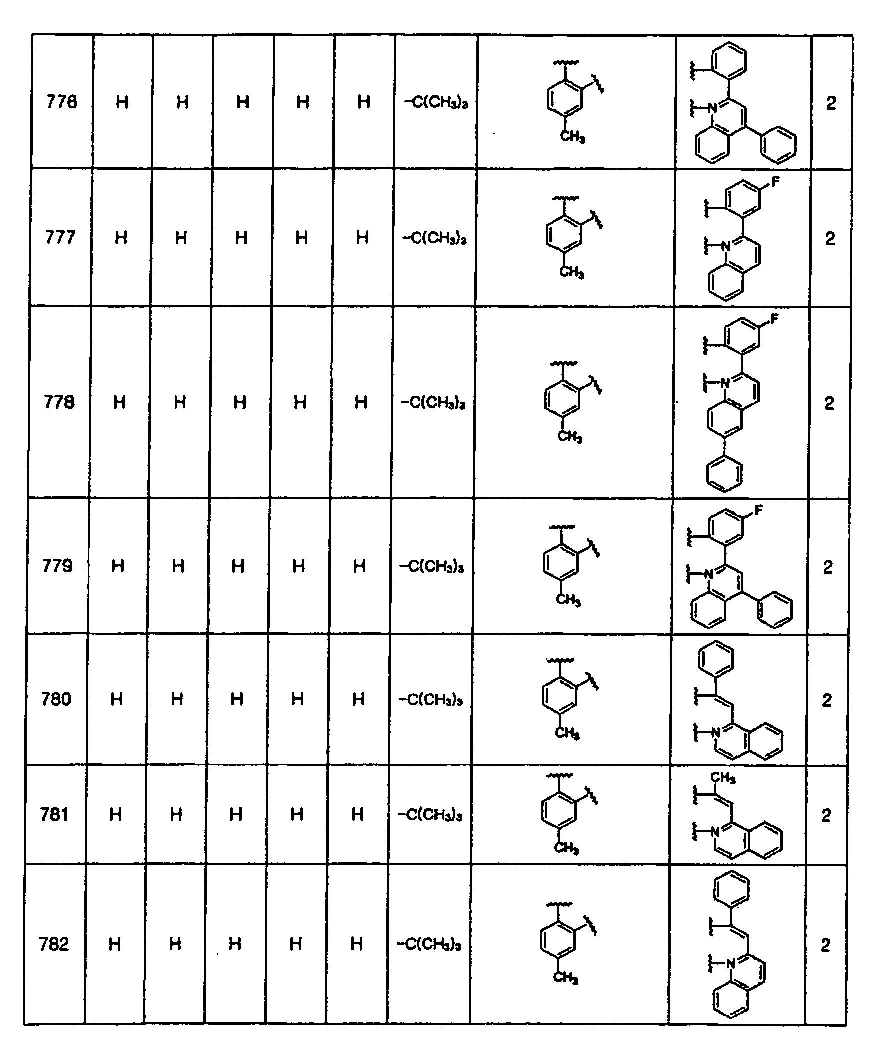

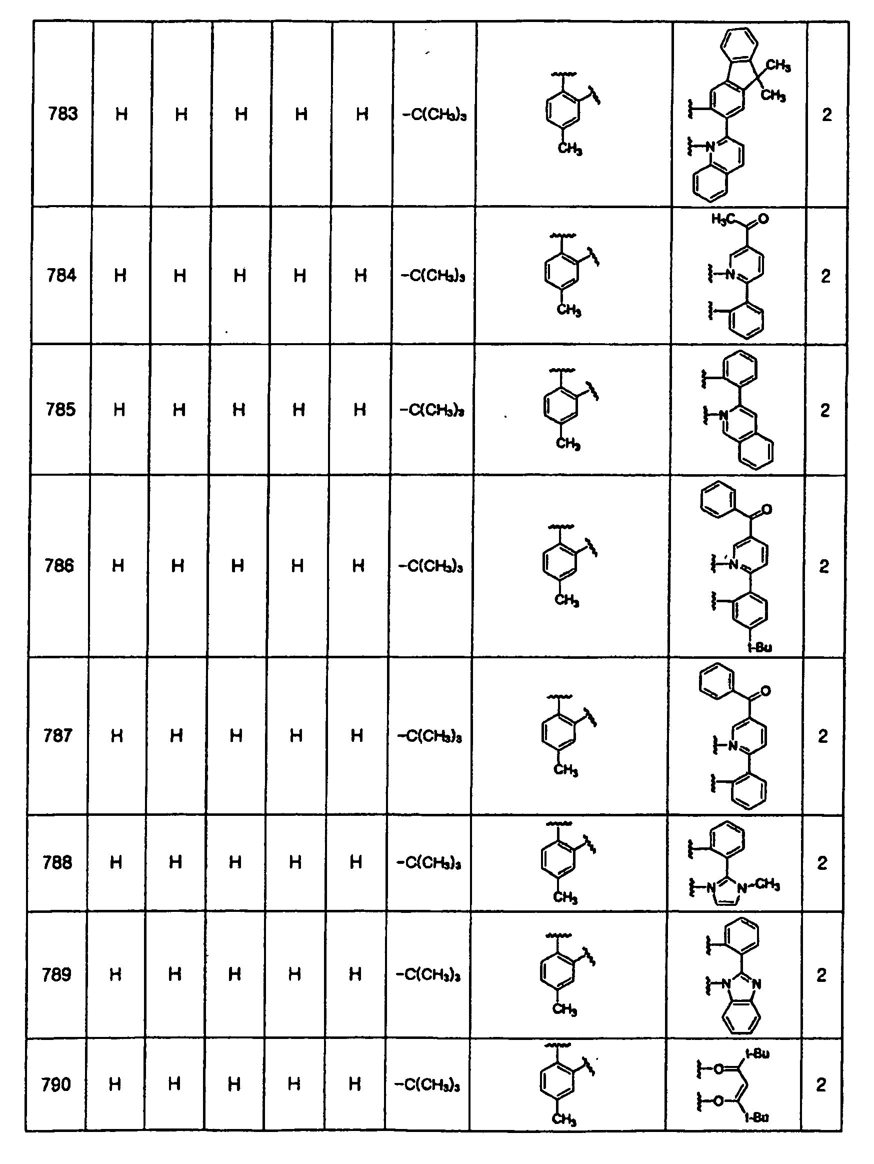

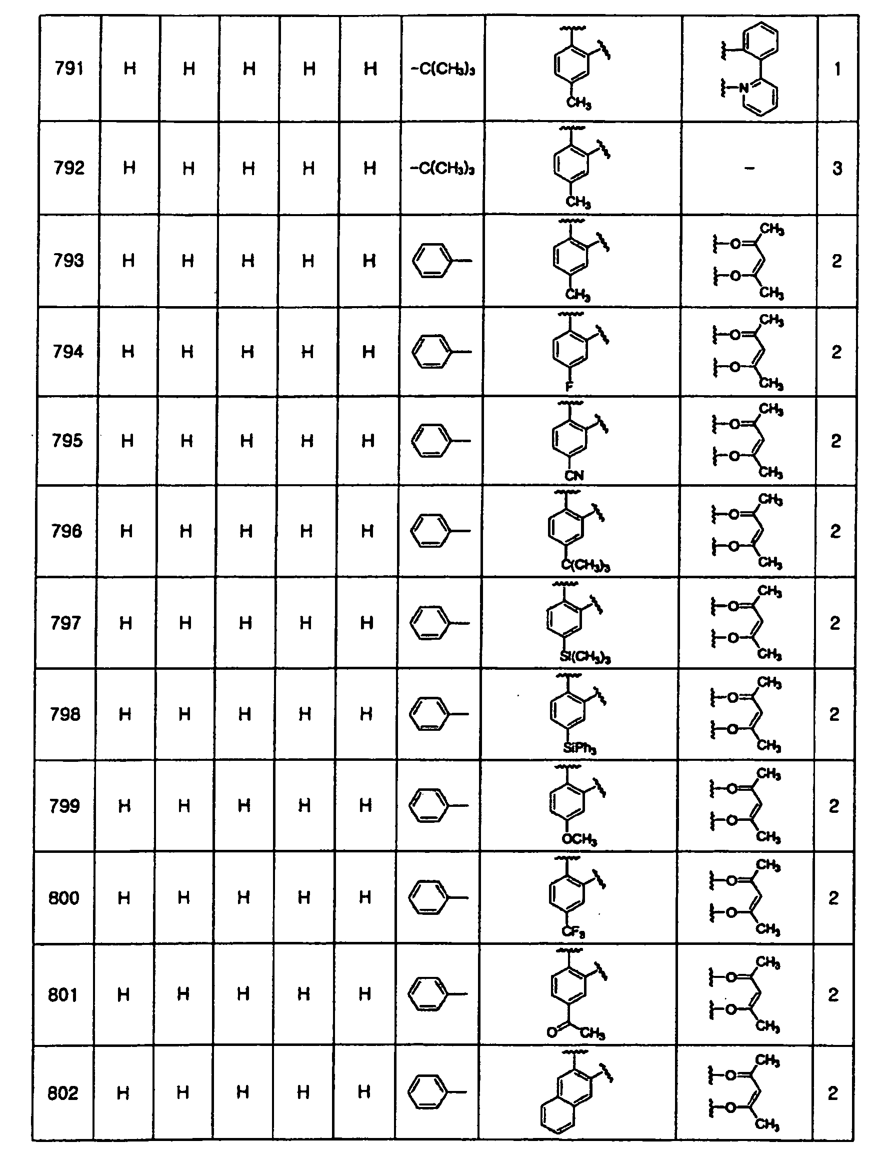

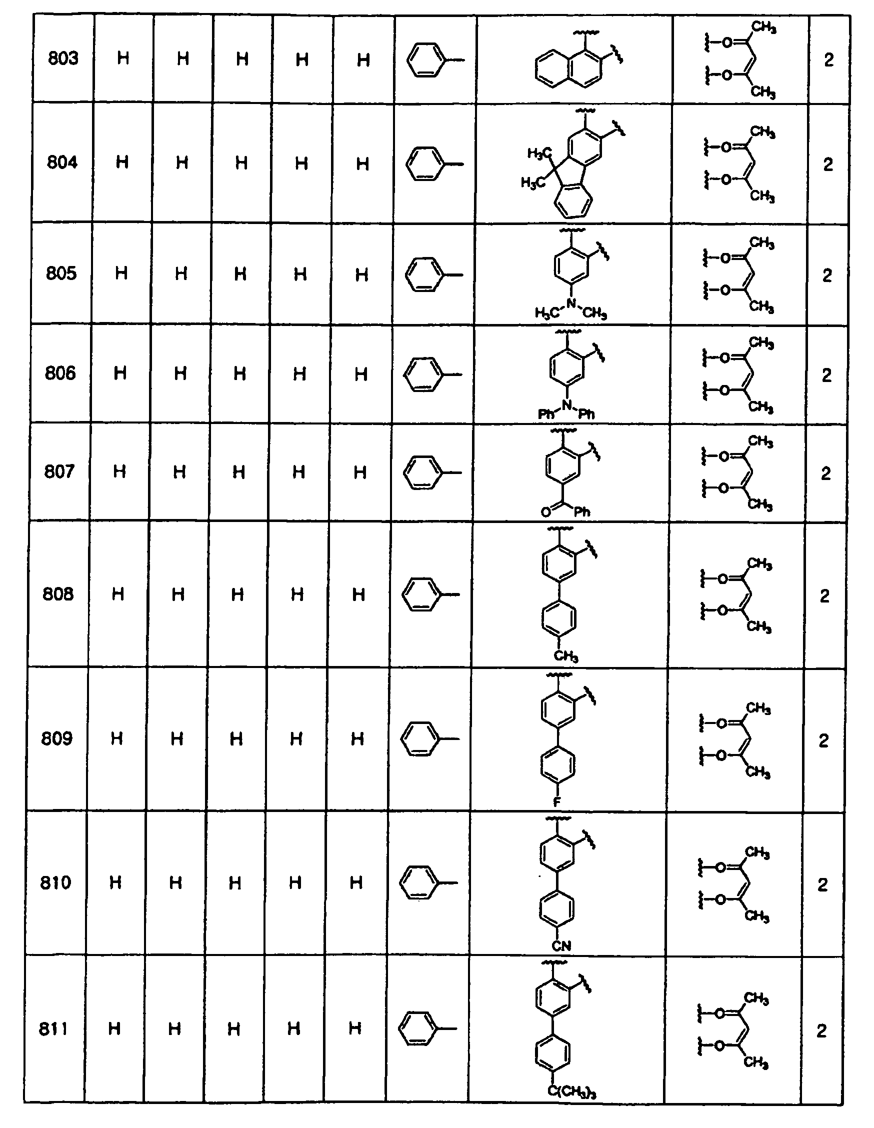

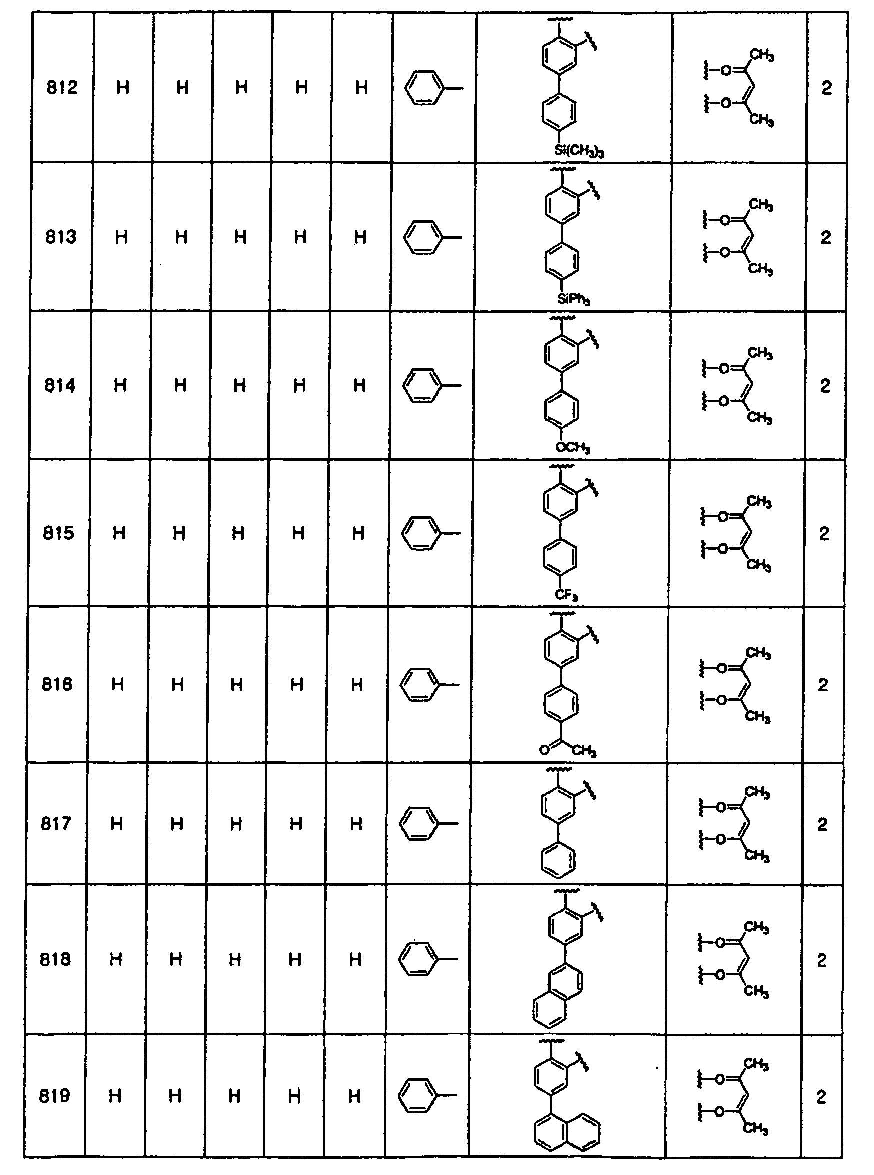

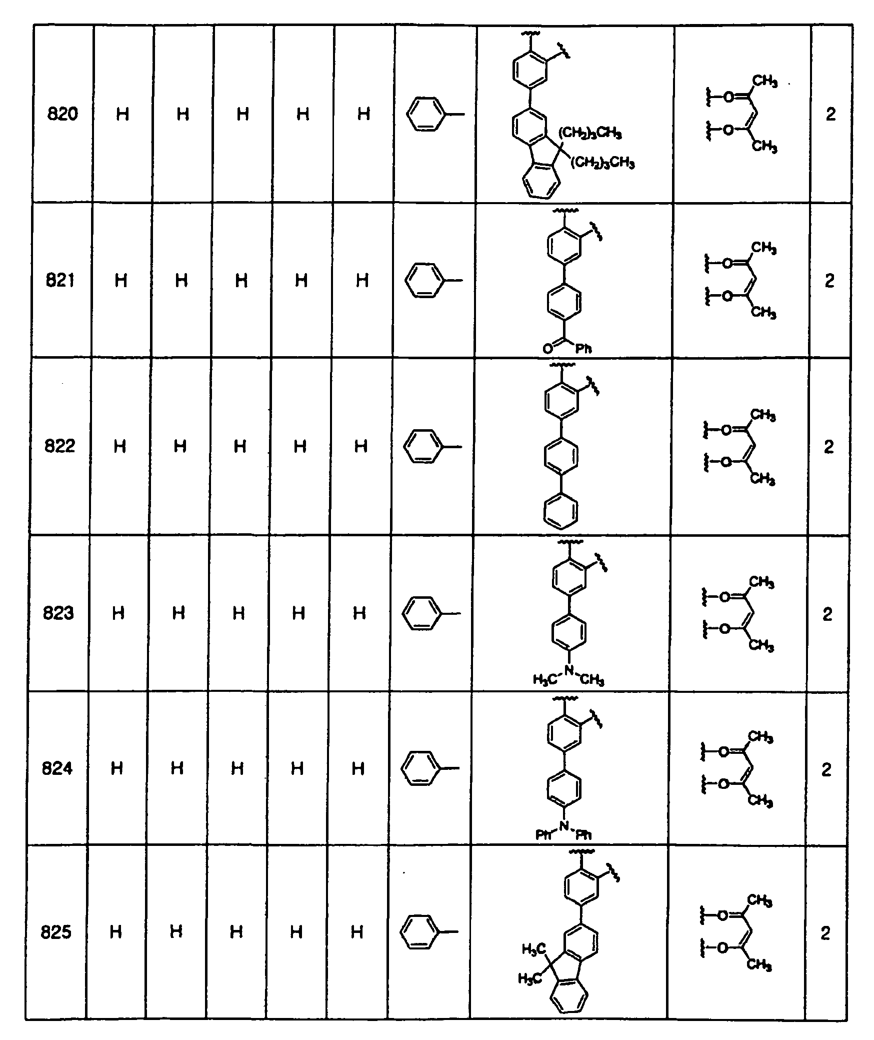

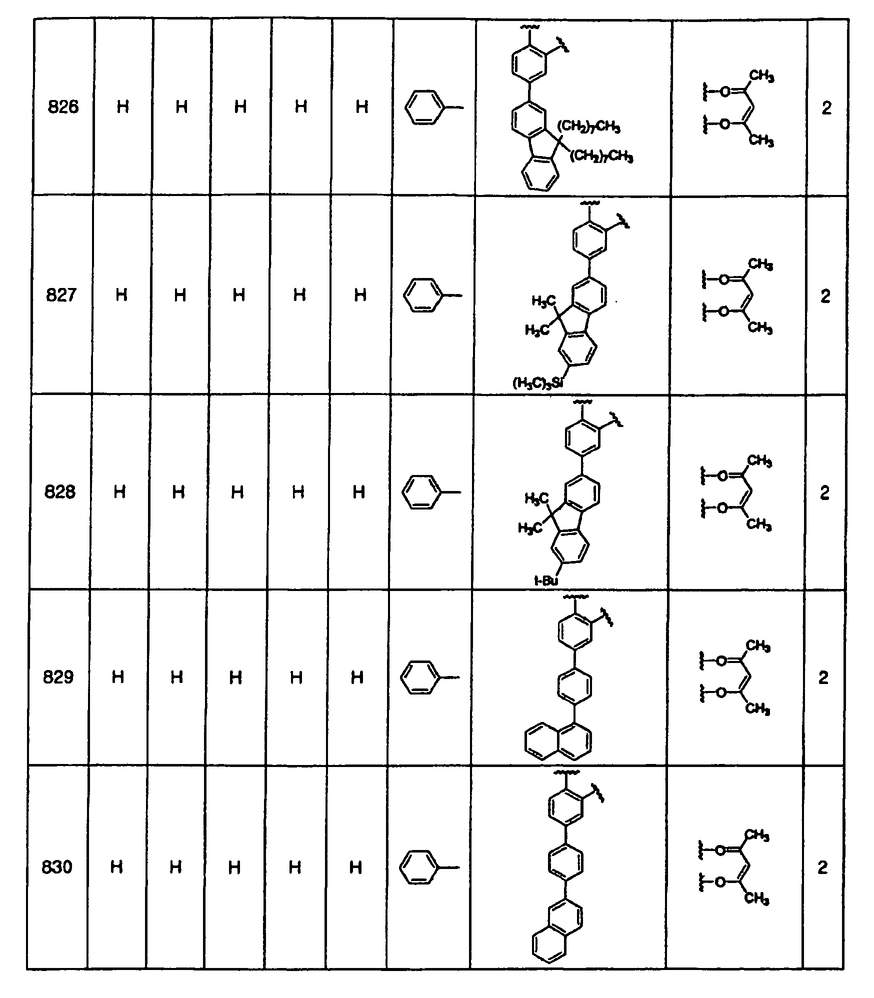

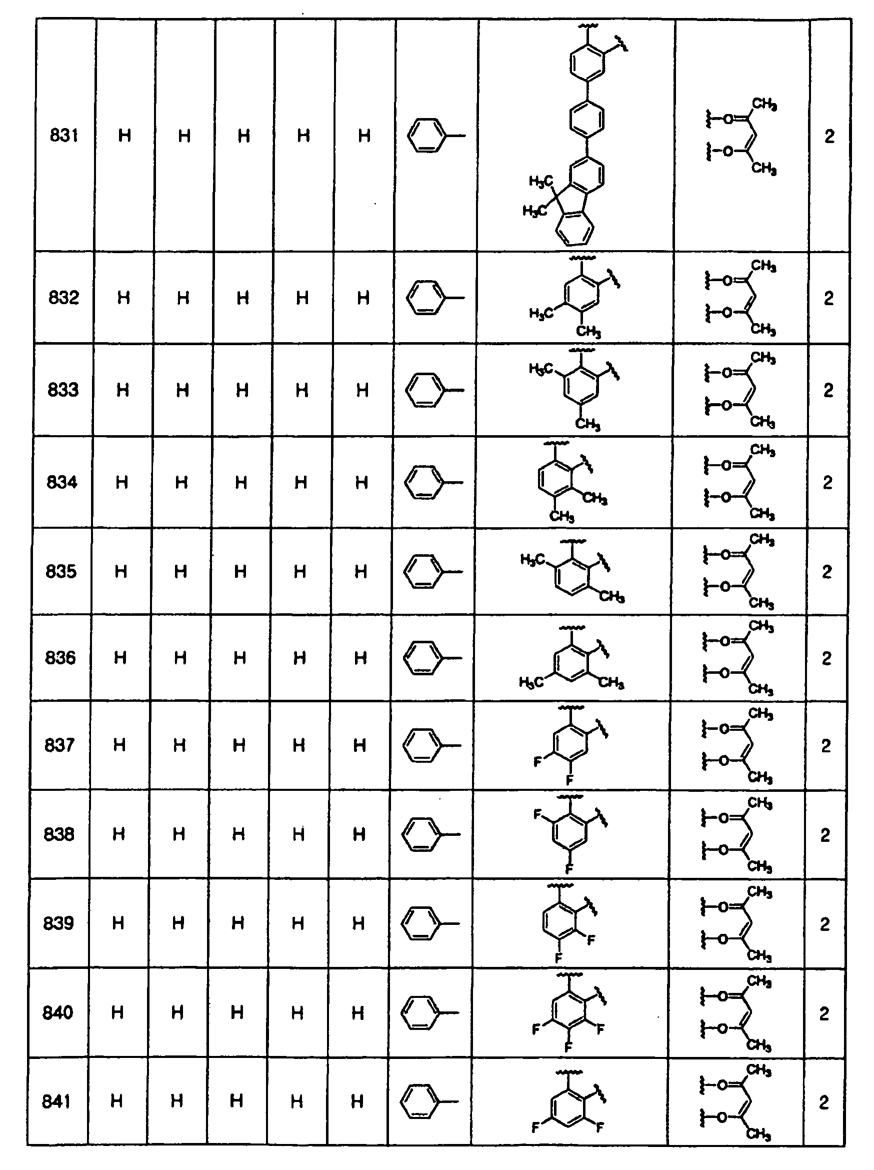

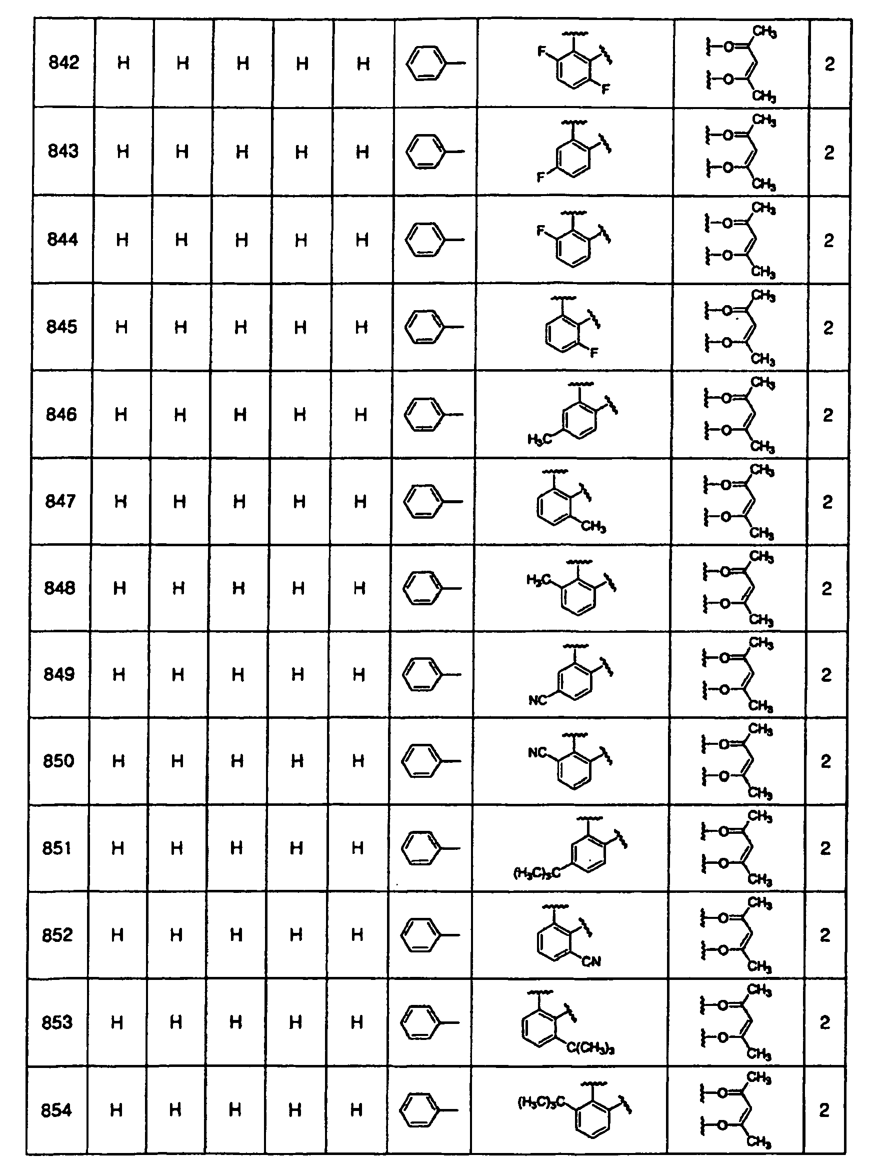

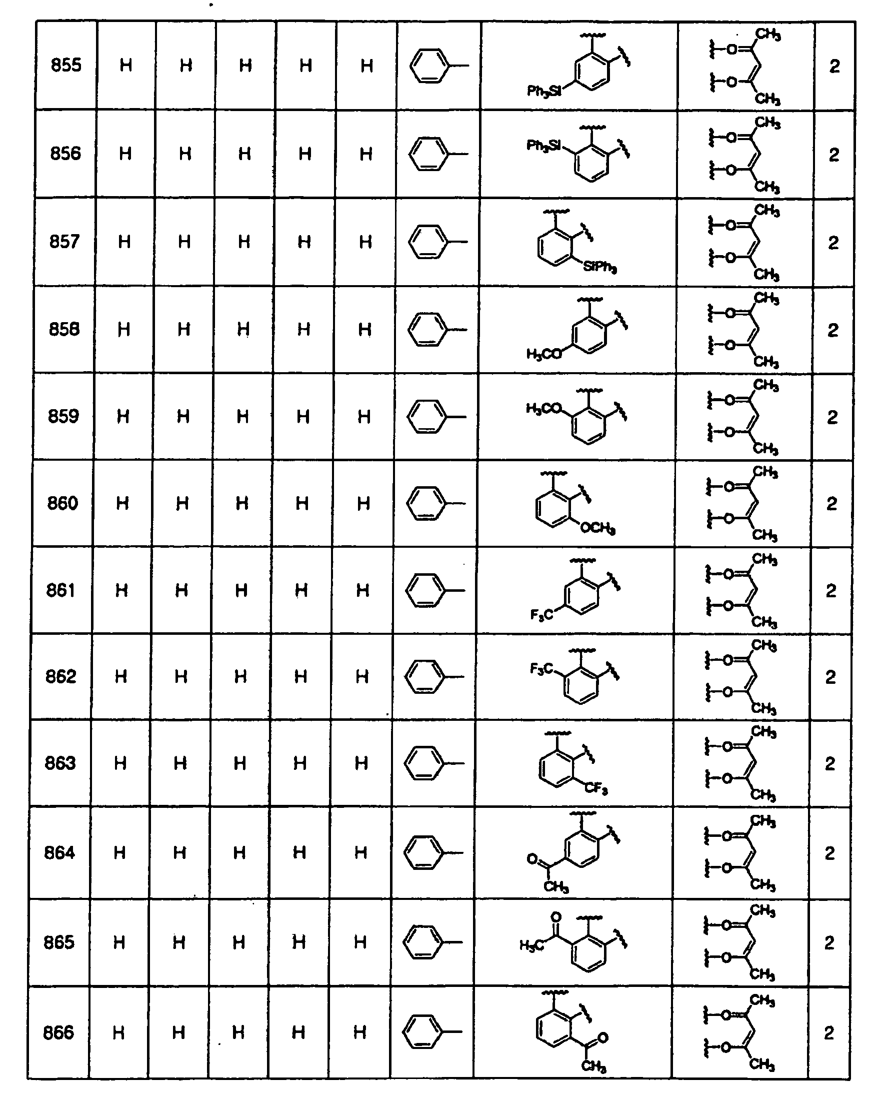

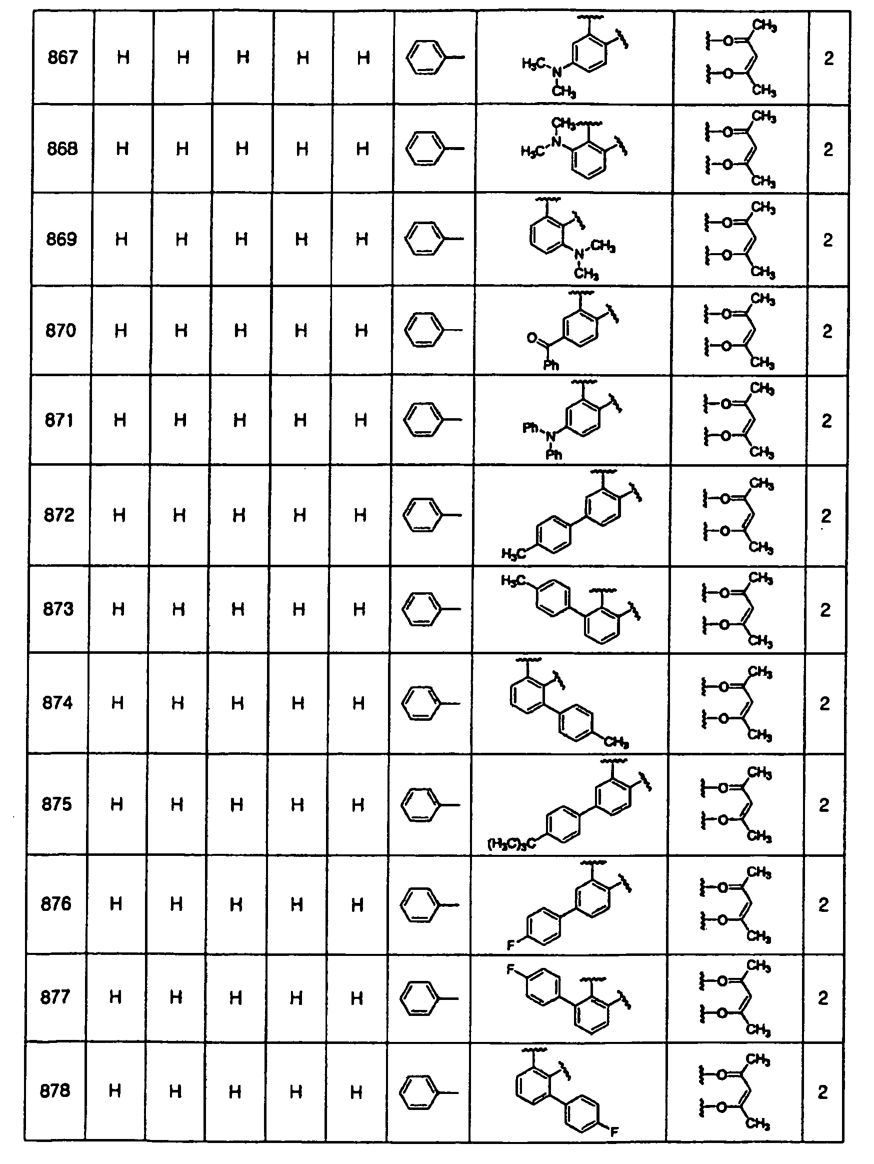

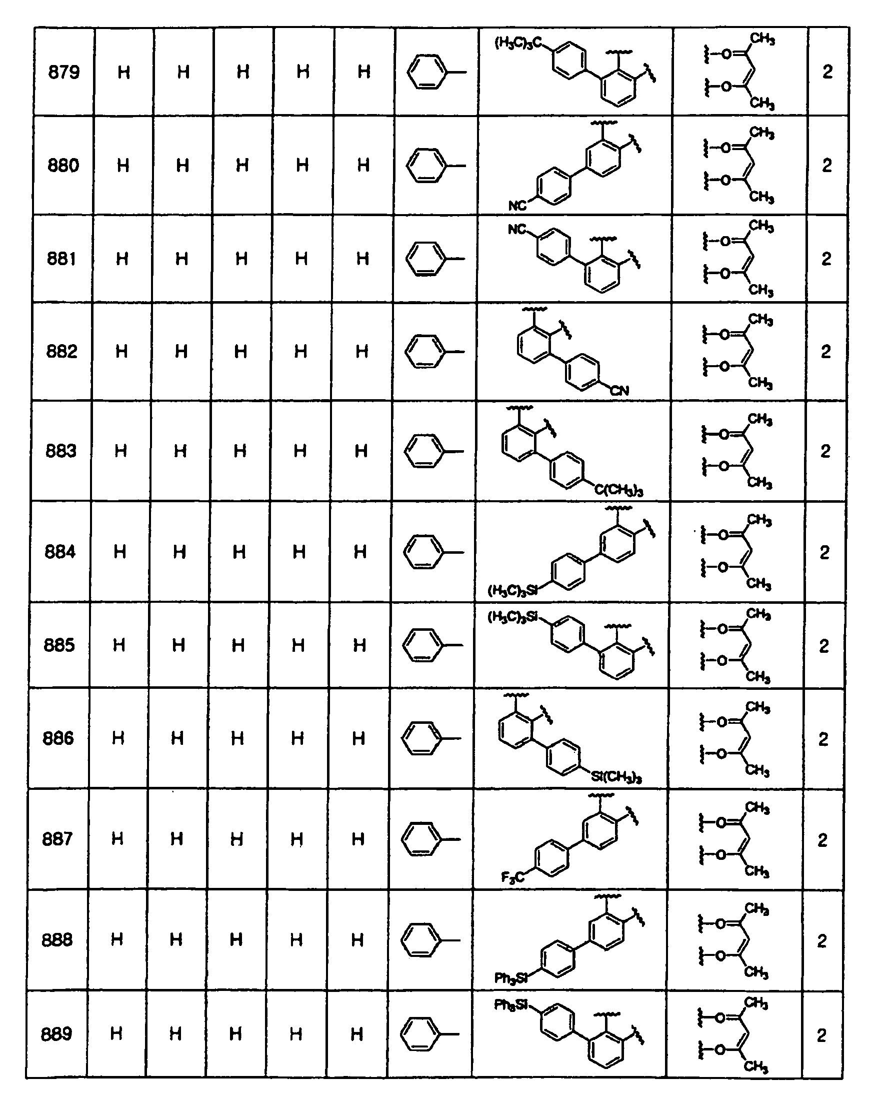

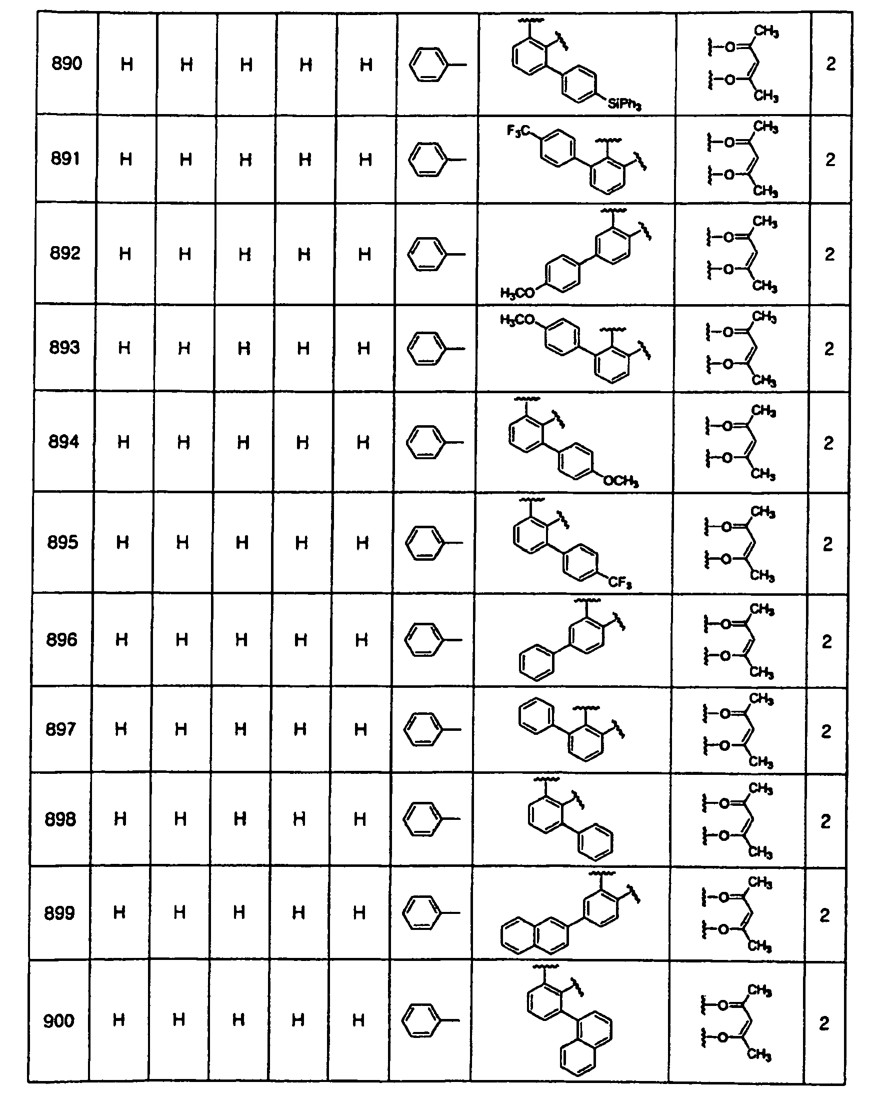

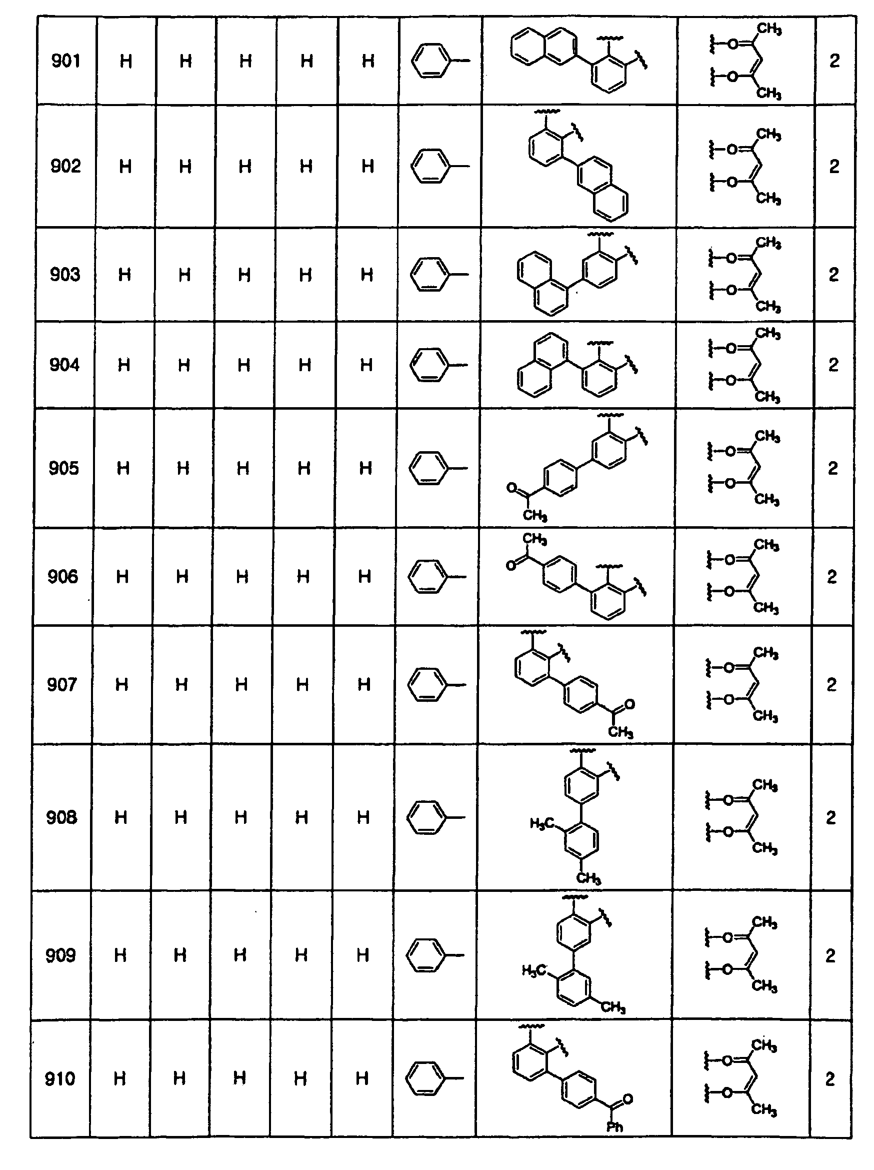

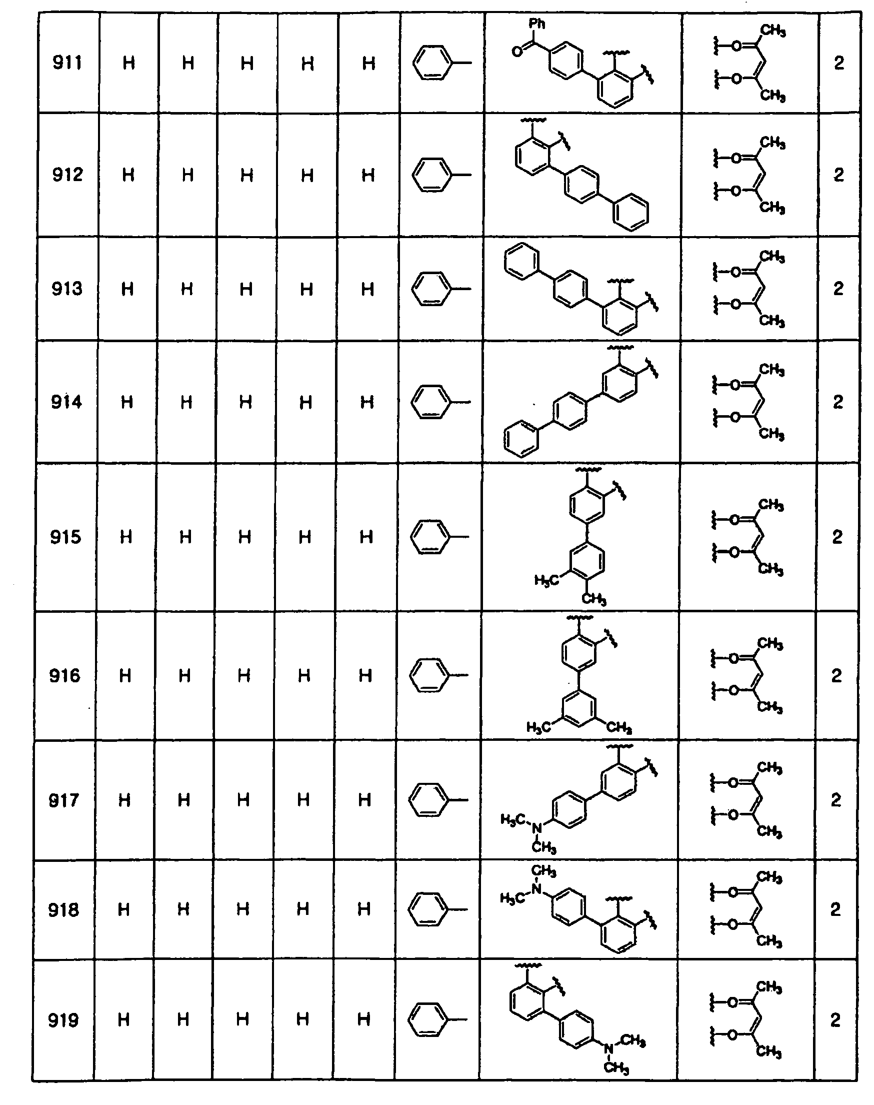

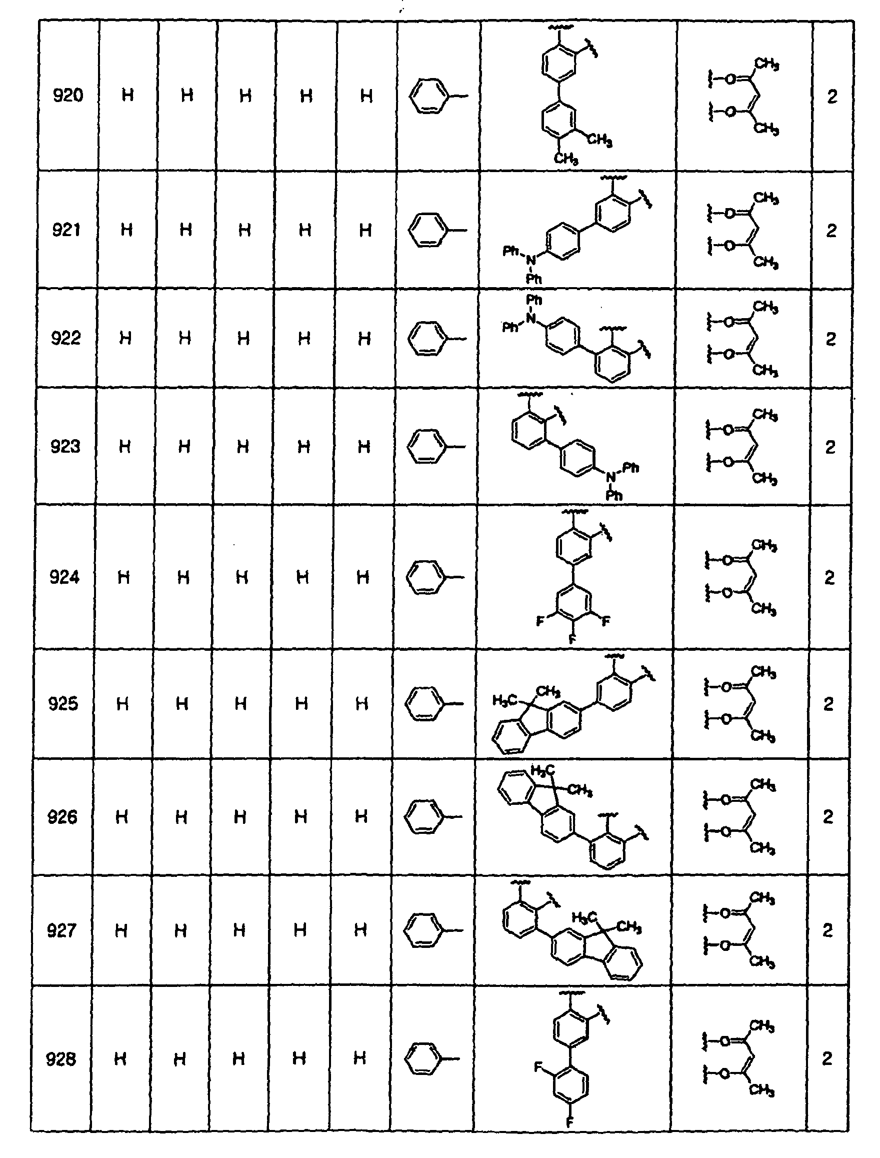

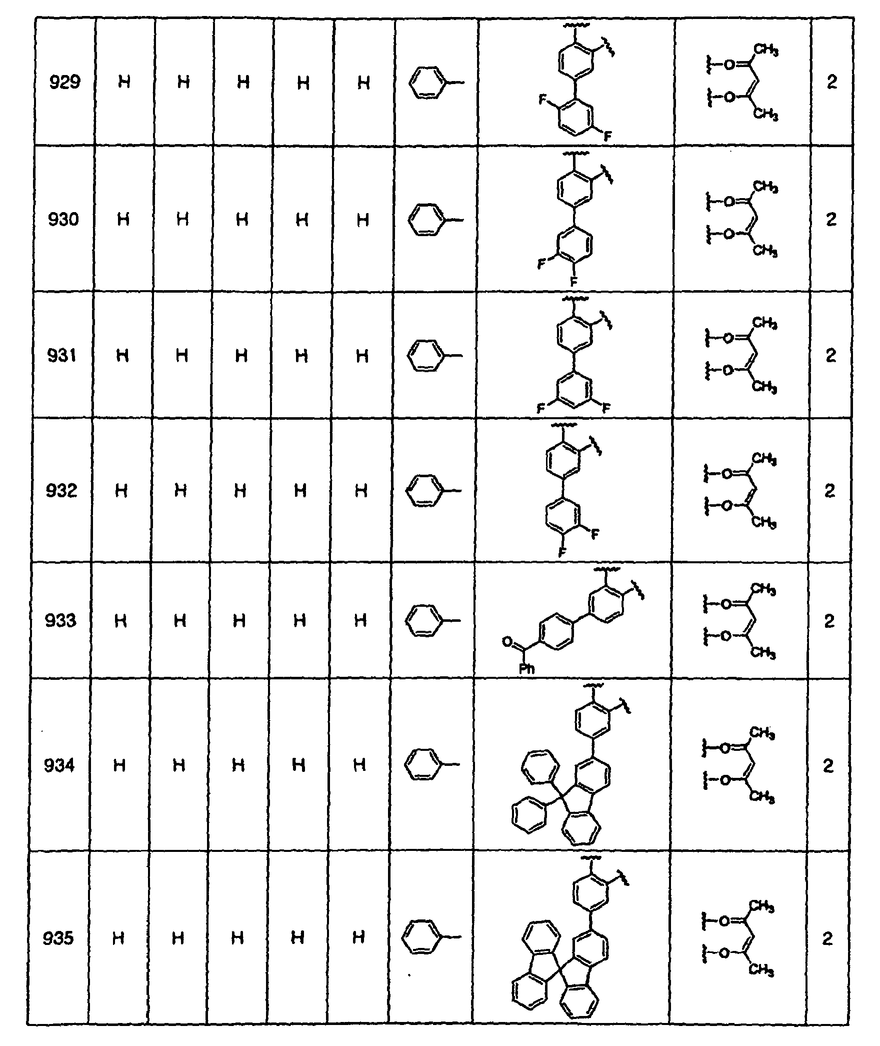

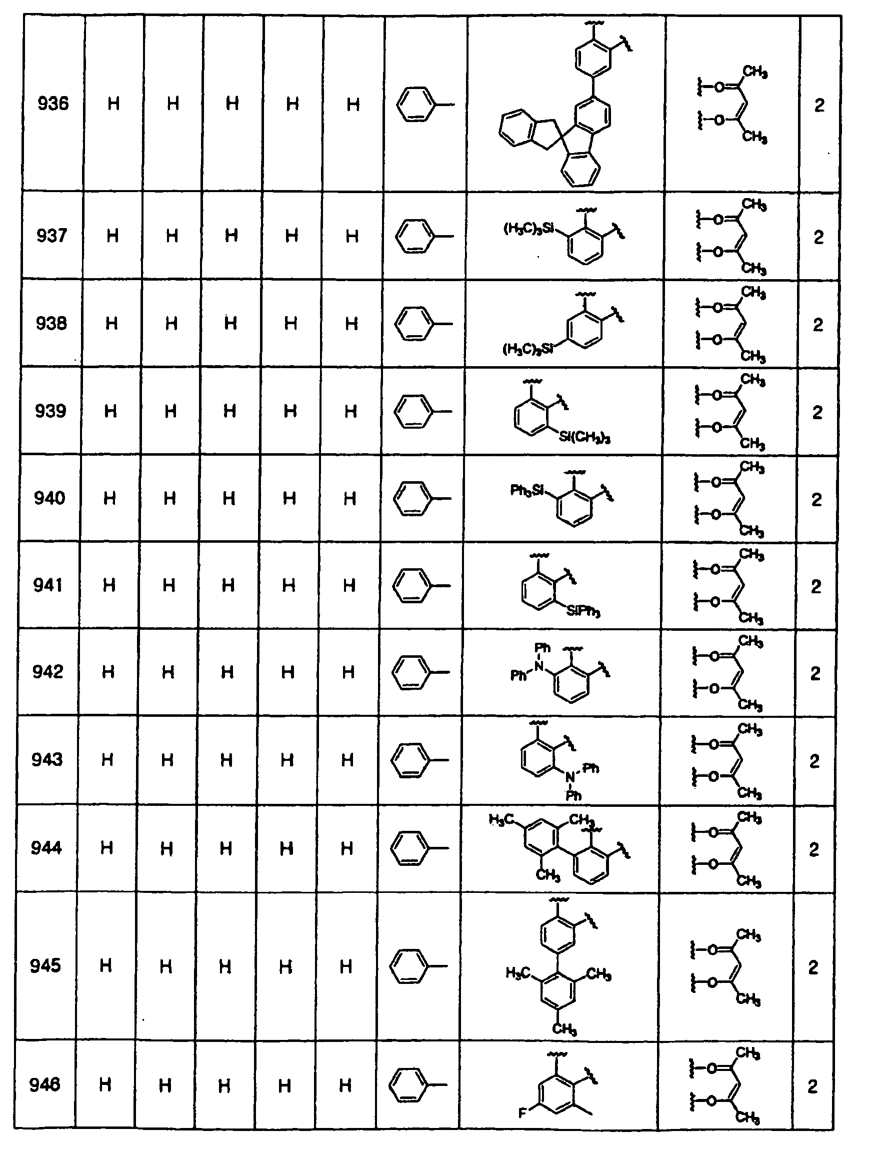

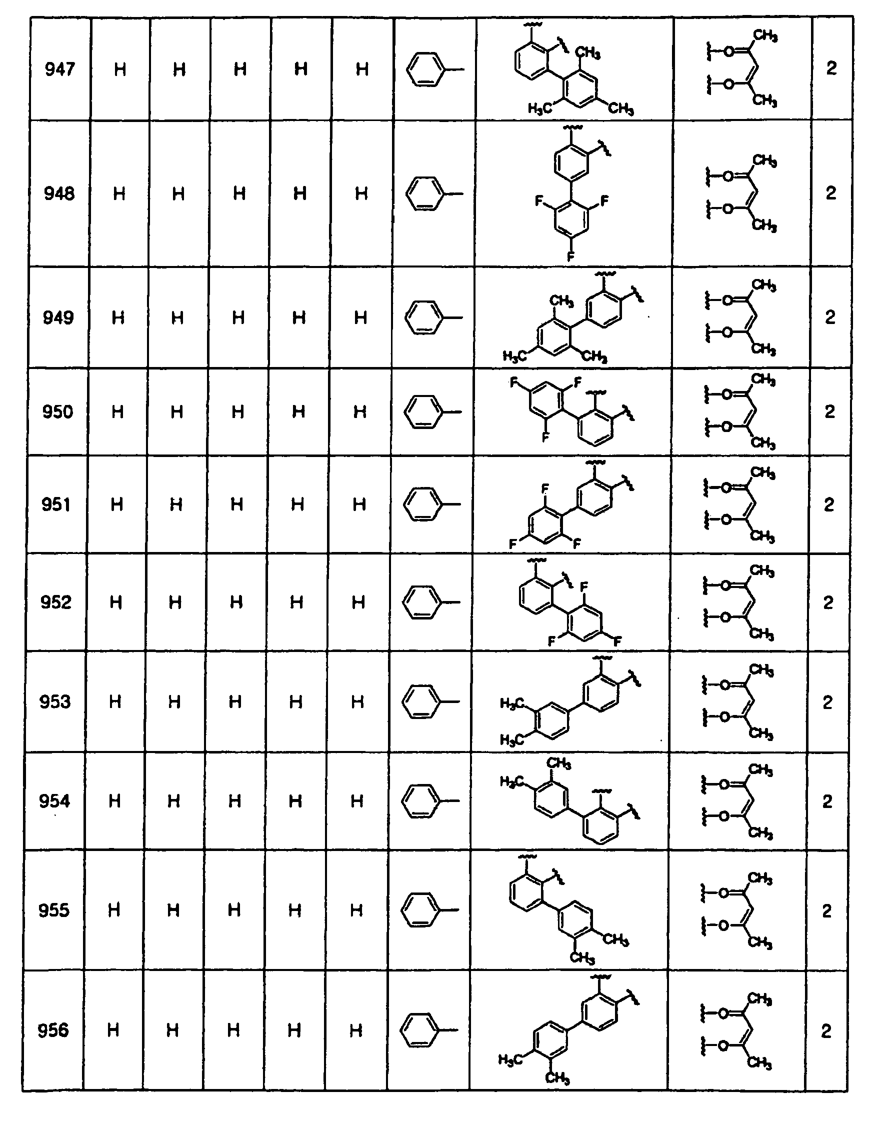

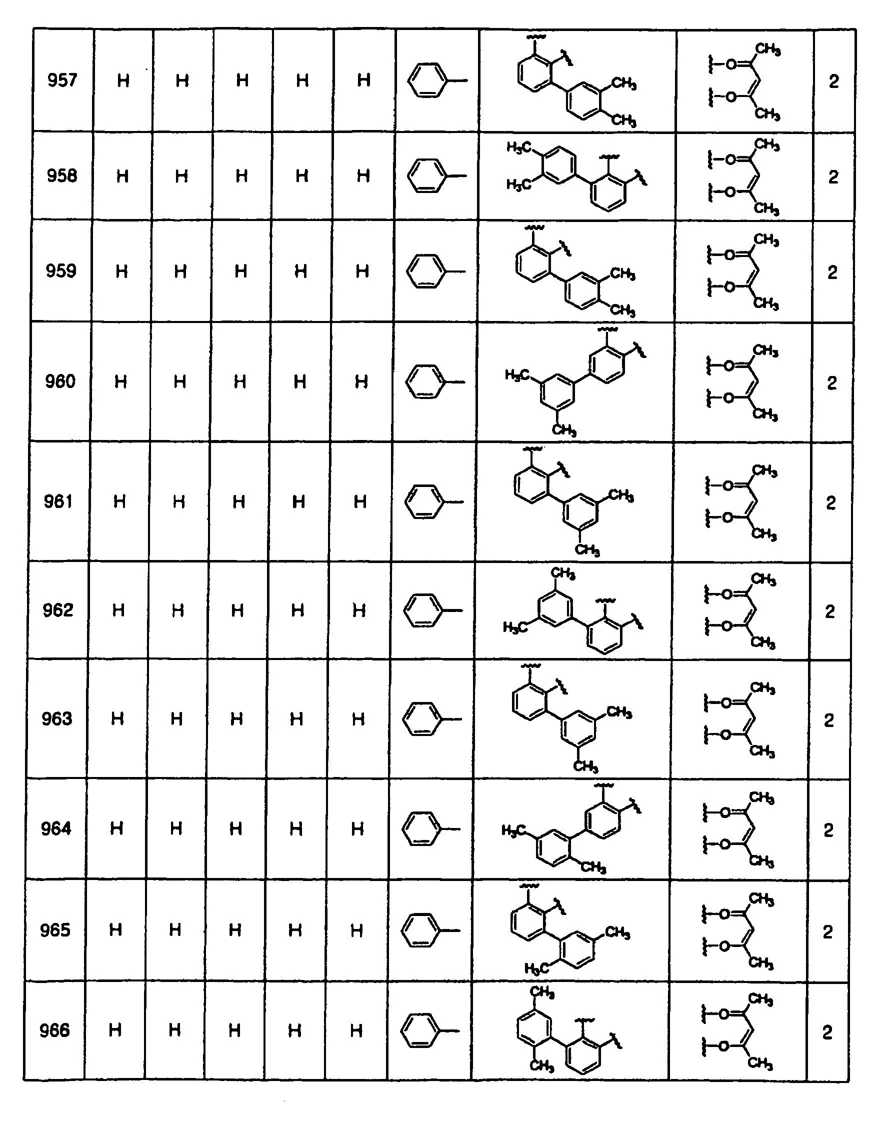

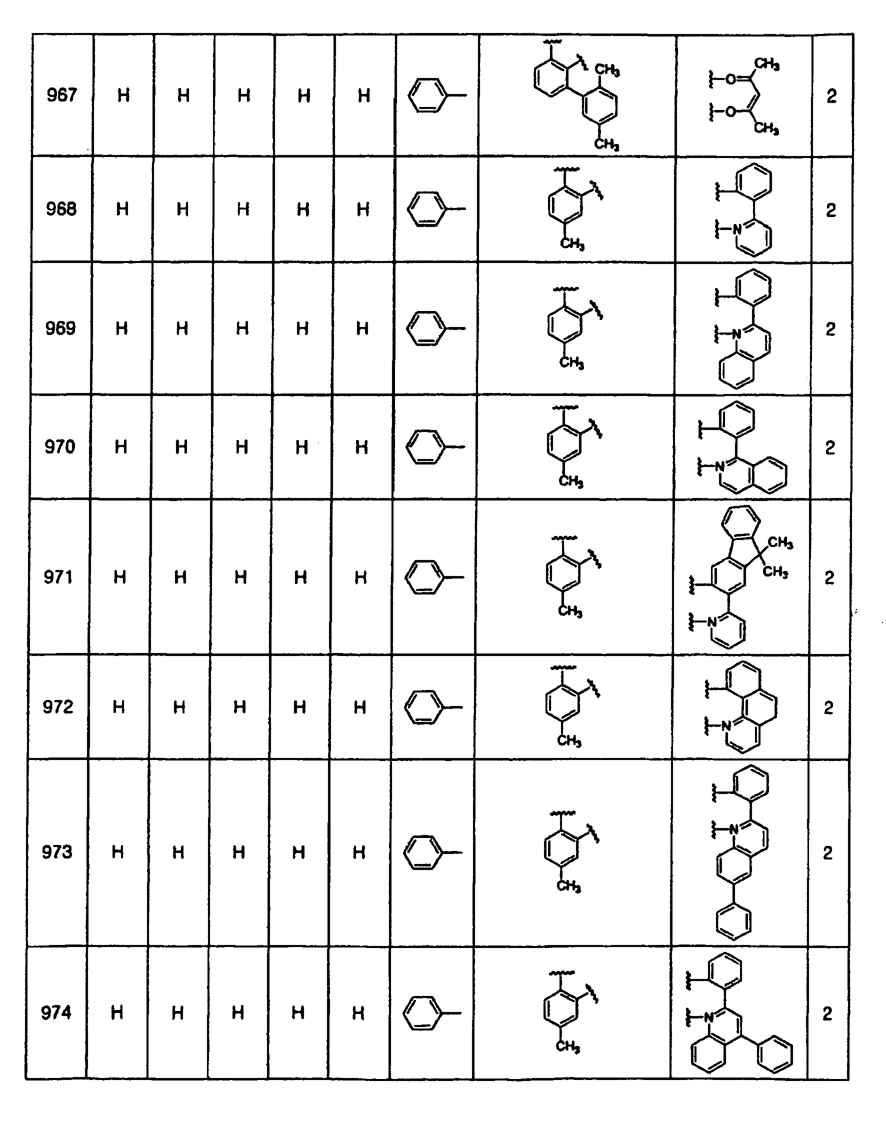

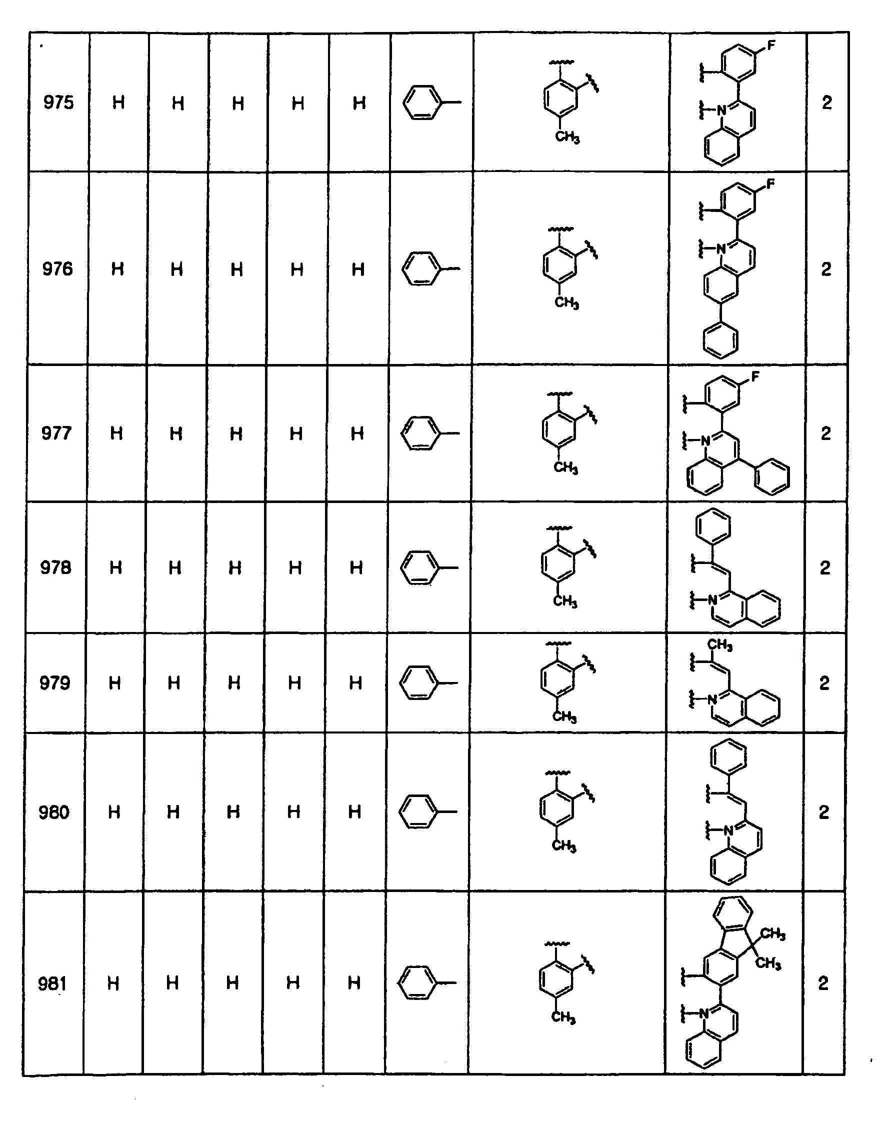

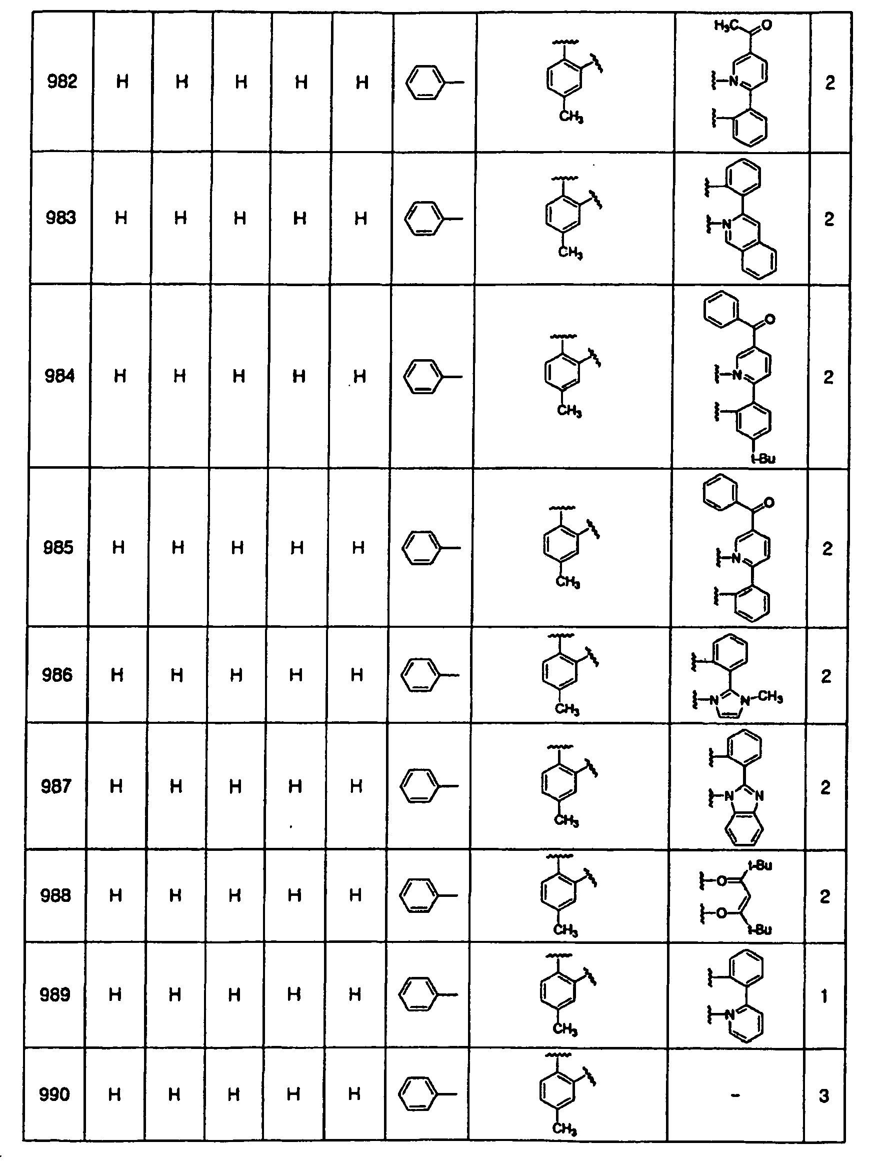

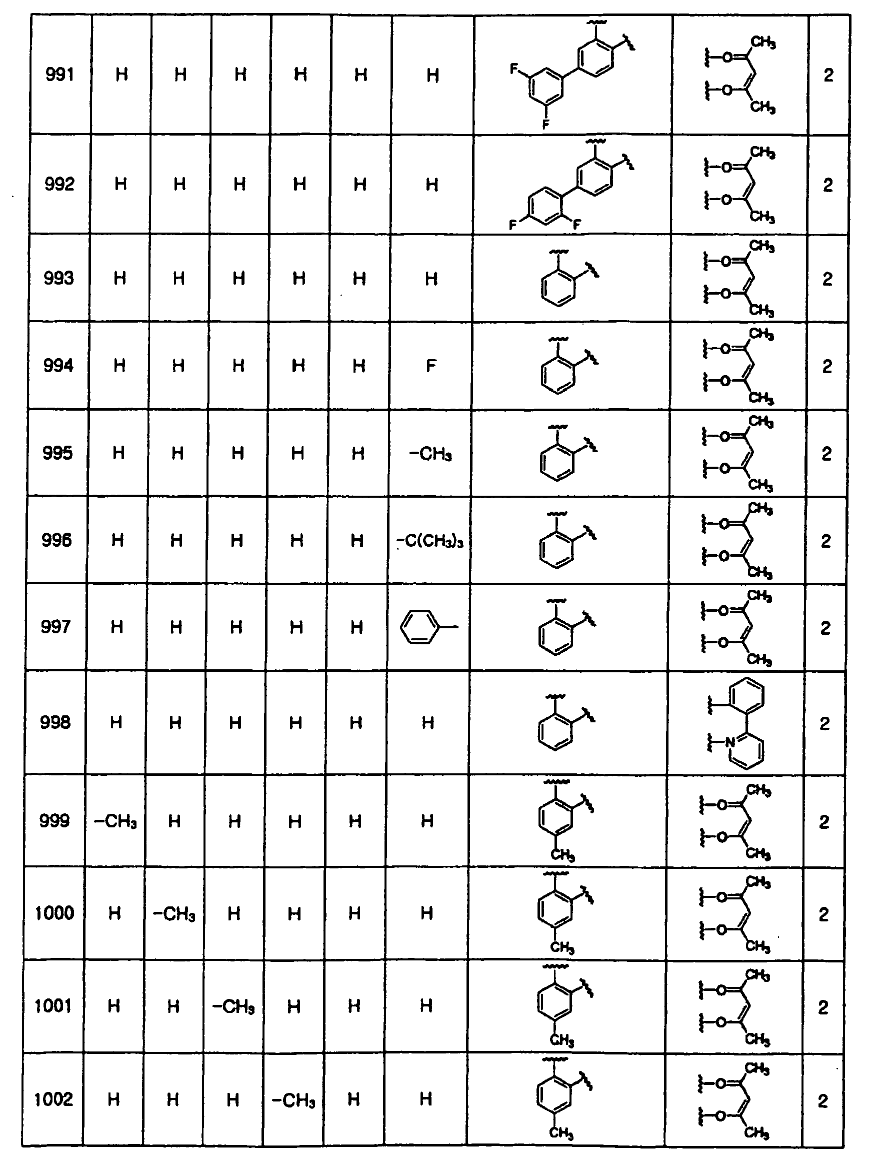

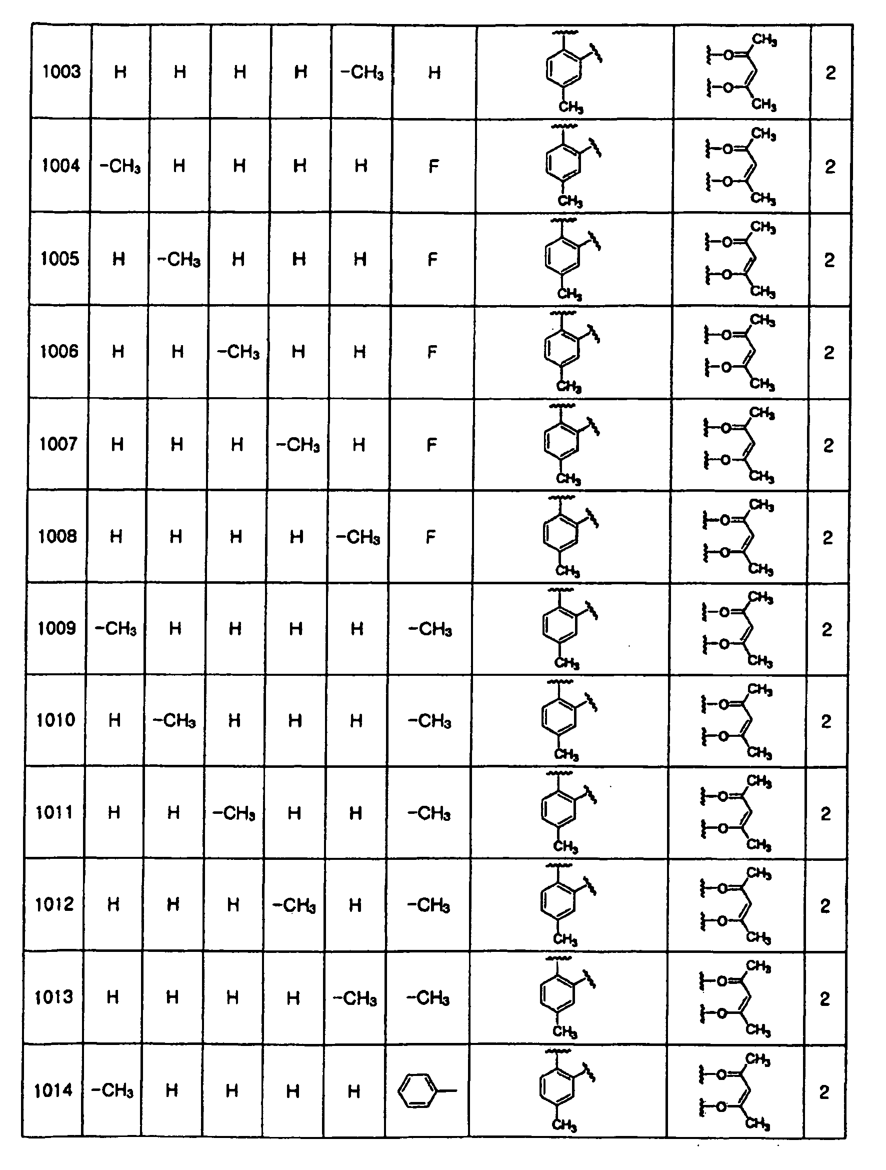

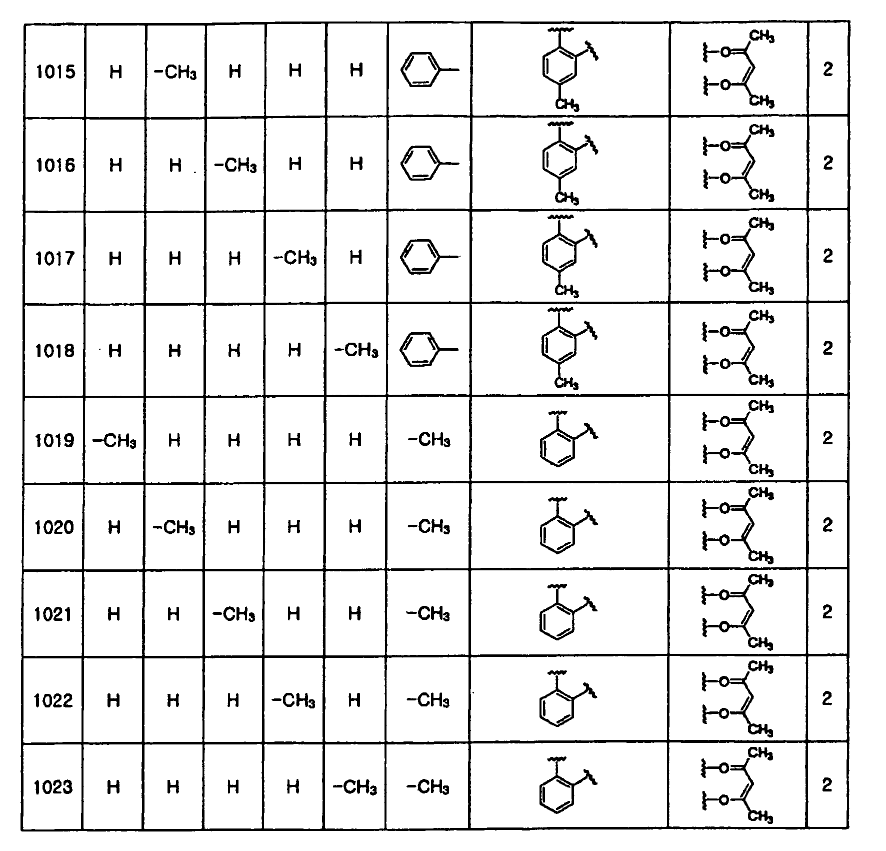

**[Table 2]**

| compound No. | ¹H NMR(CDCl₃, 200 MHz) | MS/FAB | |
|---|---|---|---|
| | | found | calculated |
| 11 | δ = 8.6 (d, 2H), 8.1 (d, 2H), 7.9-7.7 (m, 14H), 7.5-7.3(m. 14H), 1.71(s, 3H), 1.31 (s, 3H), | 623 | 624.15 |
| 12 | δ = 8.3(s, 2H), 8.1 (d, 2H), 7.9-7.7 (m, 14H), 7.5-7.3(m, 14H), 1.71 (s, 3H), 1.67 (s, 6H), 1.31 (s, 3H) | 689 | 690.20 |
| 84 | δ = 8.2(s, 2H), 8.1 (d, 2H), 7.9 (m, 2H), 7.8-7.7 (m, 8H), 7.5-7.3(m, 20H), 1.71 (s, 3H), 1.33 (s. 9H). 1.31 (s, 3H), | 667 | 668.16 |
| 104 | δ = 8.2(s, 2H), 8.1 (d, 2H), 7.9 (m, 2H), 7.8-7.7 (m, 12H) 7.5-7.4 (m, 18H), 1.71 (s. 3H), 1.31 (s, 3H) | 649 | 650.17 |
| 302 | δ = 8.2(s, 2H), 8.1(d, 2H), 7.9-7.7 (m, 10H), 7.5-7.3 (m, 16H) 7.1 (d, 4H), 1.71 (s, 3H), 1.31 (s, 3H) | 667 | 668.16 |
| 698 | δ = 8.2(s, 2H), 8.1 (d, 2H), 7.9-7.7 (m, 10H), 7.5-7.3(m, 20H), 1.71 (s, 3H), 1.33 (s, 9H), 1.31 (s, 3H) | 705 | 706.23 |
| 896 | δ = 8.2(s, 2H), 8.1 (d, 2H), 7.9-7.7 (m, 16H), 7.5-7.3(m, 18H), 7.2 (s, 8H), 1.71 (s, 3H), 1.31 (s, 3H) | 725 | 726.20 |

### Example 1 - Manufacture of an OLED (1)

An OLED device was manufactured by using a red phosphorescent compound according to the invention.

First, a transparent electrode ITO thin film (15 Ω/□) (2) prepared from a glass for OLED (produced by Samsung Corning) (1) was subjected to ultrasonic washing with trichloroethylene, acetone, ethanol and distilled water, sequentially, and stored in isopronanol before use.

Then, an ITO substrate was equipped in a substrate folder of a vacuum vapor-deposit device, and 4,4',9"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

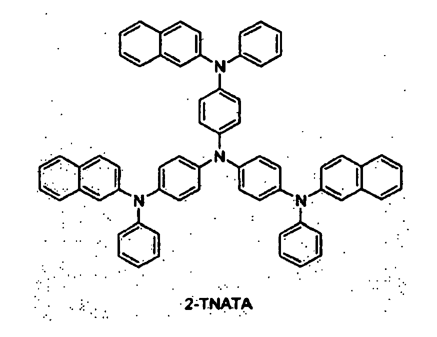

Then, to another cell of the vacuum vapor-deposit device, charged was N,N'-bis(a-naphthyl)-N,N'-diphenyl-9,9'-diamine (NPB), and electric current was applied to the cell to evaporate NPB, thereby providing vapor-deposit of a hole transportation layer (4) of 20 nm of thickness on the hole injection layer.

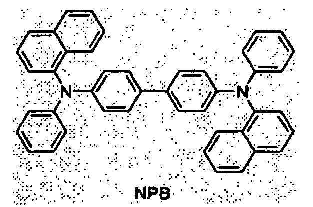

In another cell of said vacuum vapor-deposit device, charged was 4,4'-N,N'-dicarbazole-biphenyl (CBP) as an electroluminescent host material, and a red phosphorescent compound (Compound 1) according to the present invention was charged to still another cell. The two materials were evaporated at different rates to carry out doping to vapor-deposit an electroluminescent layer (5) having 30 nm of thickness on the hole transportation layer. The suitable doping concentration is 4 to 10 mol% on the basis of CBP.

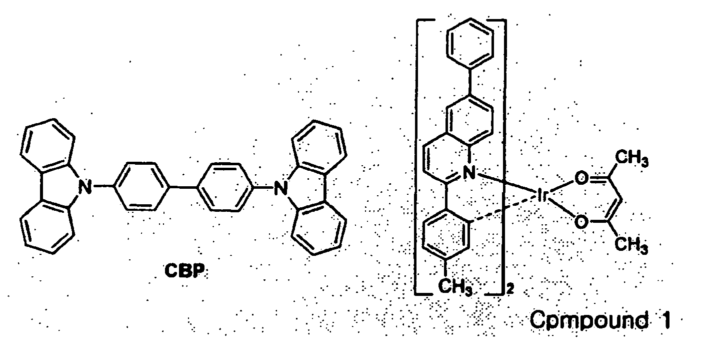

Then, on the electroluminescent layer, bis(2-methyl-8-quinolinato)(p-phenylphenolato)aluminum (III) (BAlq) was vapor-deposited as a hole blocking layer in a thickness of 10 nm in the same manner for NPB, tris(8-hydroxyquinoline)aluminum (III) (Alq) was vapor-deposited as an electron transportation layer (6) in a thickness of 20 nm, and then lithium quinolate (Liq) was vapor-deposited as an electron injection layer (7) in a thickness of 1 to 2 nm. Thereafter, an Al cathode (8) was vapor-deposited in a thickness of 150 nm by using another vacuum vapor-deposit device to manufacture an OLED.

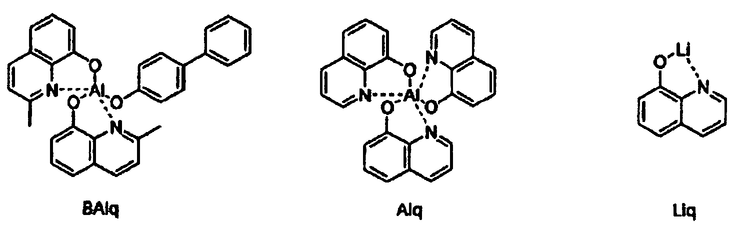

### Example 2 - Manufacture of an OLED (2)

An hole injection layer and a hole transport layer were formed according to the procedure of Example 1, and an electroluminescent layer was vapor-deposited as follows. In another cell of said vacuum vapor-deposit device, charged was H-4 as an electroluminescent host material, and a red phosphorescent compound (Compound 12) according to the present invention was charged to still another cell. The two materials were evaporated at different rates to carry out doping to vapor-deposit an electroluminescent layer (5) having 30 nm of thickness on the hole transportation layer. The suitable doping concentration is 4 to 10 mol% on the basis of the host. Then, a hole blocking layer, an electron transport layer and an electron injection layer were vapor-deposited according to the same procedure as in Example 1, and then Al cathode (8) was vapor-deposited in a thickness of 150 nm by using another vacuum vapor-deposit device to manufacture an OLED.

### Example 3 - Manufacture of an OLED (3)

A hole injection layer, an hole transport layer and an electroluminescent layer were formed according to the same procedure as in Example 2, and then an electron transport layer and an electron injection layer were vapor-deposited. Thereafter, Al cathode was vapor-deposited in a thickness of 150 nm by using another vacuum vapor-deposit device to manufacture an OLED.

In order to confirm the performance of the OLED's prepared according to Example 1 through Example 3, the luminous efficiency of the OLED's was measured at 10 mA/cm² Various properties are shown in Tables 3.

**Table 3**

| | Material | Host | Hole blocking layer | EL color | Operation voltage | Max. luminous efficiency (cd/A) |
|---|---|---|---|---|---|---|
| | Compund 1 | CBP | BAlq | Red | 7.9 | 8.1 |
| | Compound 12 | CBP | BAlq | Red | 7.9 | 7.4 |
| | Compound 44 | CBP | BAlq | Red | 7.8 | 8.6 |
| | Compound 53 | CBP | BAlq | Red | 8.1 | 9.7 |
| | Compound 176 | CBP | BAlq | Red | 8.3 | 10.0 |
| | Compound 181 | CBP | BAlq | Red | 8.2 | 9.9 |
| | Compound 188 | CBP | BAlq | Red | 8.0 | 11.2 |
| | Compound 215 | CBP | BAlq | Red | 8.0 | 10.4 |
| | Compound 335 | CBP | BAlq | Red | 8.1 | 10.9 |
| Ex. 1 | Compound 574 | CBP | BAlq | Red | 8.2 | 6.8 |
| | Compound 575 | CBP | BAlq | Red | 7.9 | 8.8 |
| | Compound 787 | CBP | BAlq | Red | 8.0 | 11.2 |
| | Compound 791 | CBP | BAlq | Red | 7.9 | 9.8 |
| | Compound 835 | CBP | BAlq | Red | 7.8 | 10.7 |
| | Compound 968 | CBP | BAlq | Red | 8.0 | 10.4 |
| | Compound 974 | CBP | BAlq | Red | 8.1 | 9.9 |
| | Compound 979 | CBP | BAlq | Red | 8.2 | 10.5 |
| | Compound 993 | CBP | BAlq | Red | 8.5 | 10.6 |
| | Compound 12 | H-4 | BAlq | Red | 7.4 | 7.8 |
| | Compound 53 | H-6 | BAlq | Red | 7.6 | 9.8 |
| Ex. 2 | Compound 188 | H-39 | BAlq | Red | 7.4 | 11.1 |
| | Compound 575 | Chem. For. VIII | BAlq | Red | 7.4 | 9.0 |
| Ex. 3 | Compound 1 | H-2 | - | Red | 6.6 | 8.3 |
| | Compound 835 | H-5 | - | Red | 6.5 | 10.7 |
| | Compound 974 | H-10 | - | Red | 6.6 | 10.0 |
| | Compound 993 | H-62 | - | Red | 6.8 | 11.1 |

Compound (176) and Compound (188), to which ppy and styrylquinoline were introduced as a subsidiary ligand, respectively, showed high luminous efficiency of 10 cd/A or more. Compound (335), to which F was applied to a ligand as an electron withdrawer, showed the effect of increased efficiency. Compound (787), which employs phenyl(6-phenylpyridin-3-yl)methanone as a subsidiary ligand, showed the highest efficiency among the compounds developed by the present invention.

With identical device structure, using the host according to the present invention instead of CBP did not provide significant change of efficiency, but the operation voltage was advance by approximately 0.5 V, and thus enhancement of power consumption could be anticipated. When the host according to the present invention is employed without using a hole blocking layer, the device exhibits comparable or higher luminous efficiency as compared to that using conventional host, and provides decreased power consumption of the OLED due to lowered operation voltage by about 1.3 V - 1.7 V. If the invention is applied to mass production of OLEDs, the time for mass production can be also reduced to give great benefit on its commercialization.

## Claims

1. An organic phosphorescent compound represented by Chemical Formula (I): 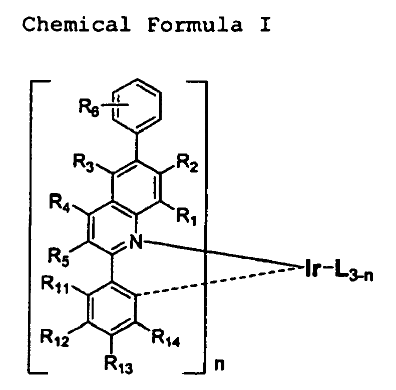 wherein, L is an organic ligand;
R₁ through R₅ independently represent hydrogen, (C₁-C₂₀)alkyl, (C₁-C₂₀) alkoxy, (C₃-C₁₂) cycloalkyl, halogen, tri (C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri(C₁-C₂₀)alkylsilyl, tri(C₆-C₂₀)arylsilyl, (C₁-C₂₀) alkoxy, (C₁-C₂₀) alkylcarbonyl, (C₆-C₂₀)arylcarbonyl, di (C₁-C₂₀)alkylamino, di(C₆-C₂₀) arylamino, phenyl, naphthyl, anthryl, fluorenyl, spirobifluorenyl or 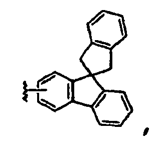 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₉, and the alicyclic ring, or the monocyclic or polycyclic aromatic ring formed therefrom by linkage via (C₃-C₁₂)alkylene or (C₃-C₁₂) alkenylene with or without a fused ring may be further substituted by one or more substituent(s) selected from (C₁-C₂₀) alkyl with or without halogen substituent(s), (C₁-C₂₀)alkoxy, halogen, tri(C₁-C₂₀)alkylsilyl, tri(C₆-C₂₀)arylsilyl, (C₁-C₂₀)alkylcarbonyl, (C₆-C₂₀)arylcarbonyl, di(C₁-C₂₀)alkylamino, di(C₆-C₂₀)arylamino and (C₆-C₂₀)aryl; and
n is an integer from 1 to 3.

2. The organic phosphorescent compound according to claim 1, wherein R₁₁ through R₁₄ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, methylcarbonyl, ethylcarbonyl, t-butylcarbonyl, phenylcarbonyl, dimethylamino, diphenylamino, phenyl, naphthyl, anthryl, fluorenyl or 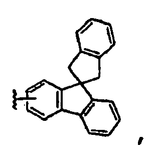 and the fluorenyl may be further substituted by methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, phenyl, naphthyl, anthryl, trimethylsilyl, tripropylsilyl, tri(t-butyl)silyl, t-butyldimethylsilyl or triphenylsilyl.

3. The organic phosphorescent compound according to claim 1, which is selected from the compounds represented by one of Chemical Formulas (II) to (VI): 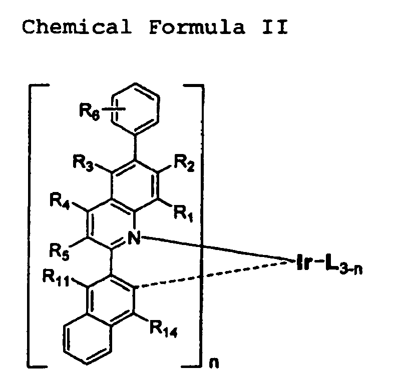 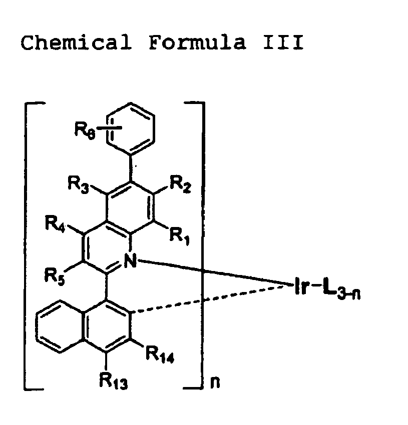 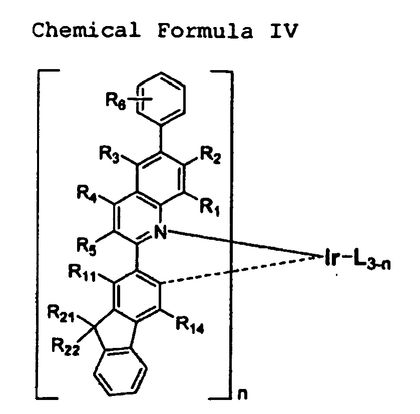 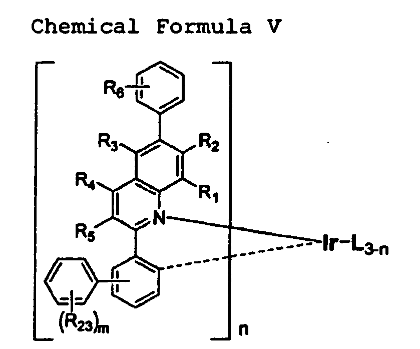 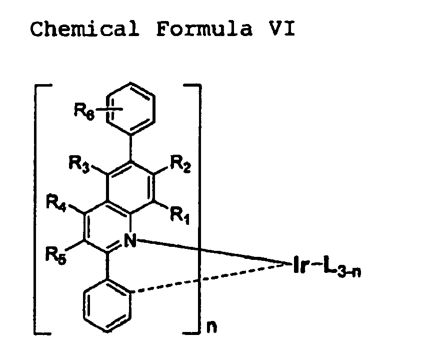 wherein, L, R₁, R₂, R₃, R₄, R₅, R₆, R₁₁, R₁₃, R₁₄ and n are defined as in Chemical Formula (I) of claim 1;
R₂₁ and R₂₂ independently represent hydrogen, (C₁-C₂₀)alkyl, (C₆-C₂₀)aryl, or R₂, and R₂₂ may be linked via (C₃-C₁₂)alkylene or (C₃-C₁₂)alkenylene with or without a fused ring to form an alicyclic ring, or a monocyclic or polycyclic aromatic ring;
R₂₃ represents (C₁-C₂₀)alkyl, halogen, cyano, tri(C₁-C₂₀) alkylsilyl, tri (C₆-C₂₀)arylsilyl, (C₁-C₂₀) alkoxy, (C₁-C₂₀) alkylcarbonyl, (C₆-C₂₀)arylcarbonyl, phenyl, di(C₁-C₂₀)alkylamino, di(C₆-C₂₀)arylamino, naphthyl, 9,9-di(C₁-C₂₀)alkylfluorenyl or 9,9-di(C₆-C₂₀)arylfluorenyl; and
m is an integer from 1 to 5.

4. The organic phosphorescent compound according to claim 1, wherein R₁ through R₅ independently represent hydrogen, methyl, ethyl, n-propyl, i-propyl, n-butyl, i-butyl, t-butyl, n-pentyl, i-pentyl, n-hexyl, n-heptyl, n-octyl, ethylhexyl, methoxy, ethoxy, butoxy, cyclopropyl, cyclohexyl, cycloheptyl, fluoro, trimethylsilyl, tripropylsilyl, tri(t-butyl)silyl, t-butyldimethylsilyl or triphenylsilyl; and R₆ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, fluoro, phenyl, naphthyl, anthryl, fluorenyl or spirobifluorenyl.

5. The organic phosphorescent compound according to claim 2, which is selected from the compounds represented by one of the following chemical formulas: 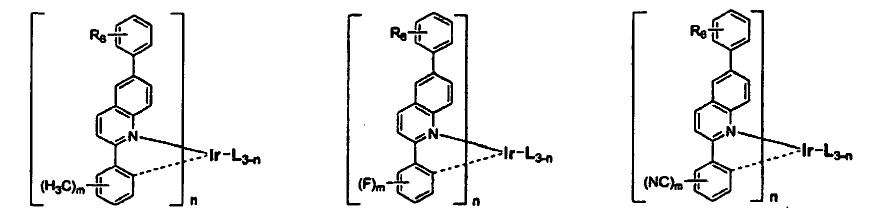 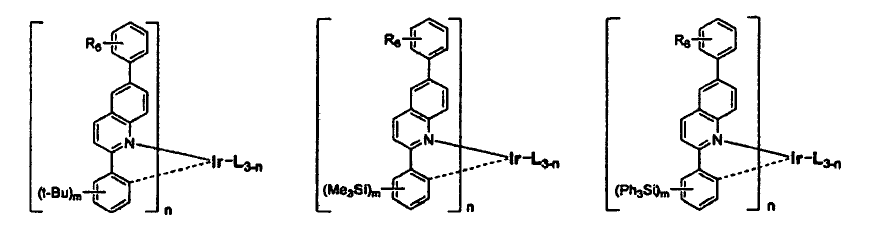 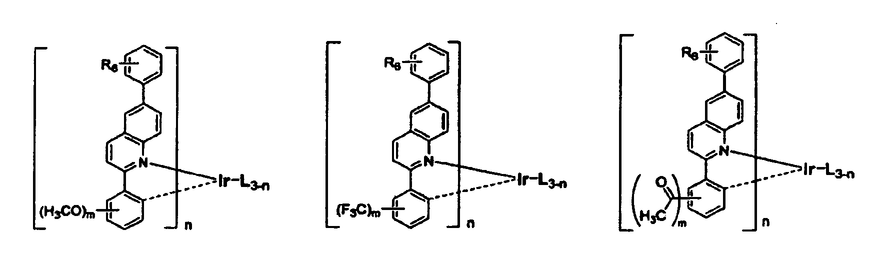 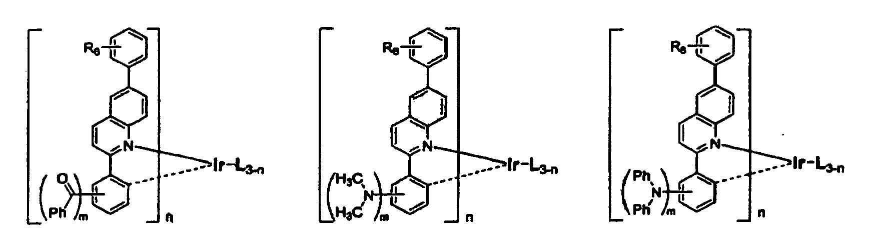 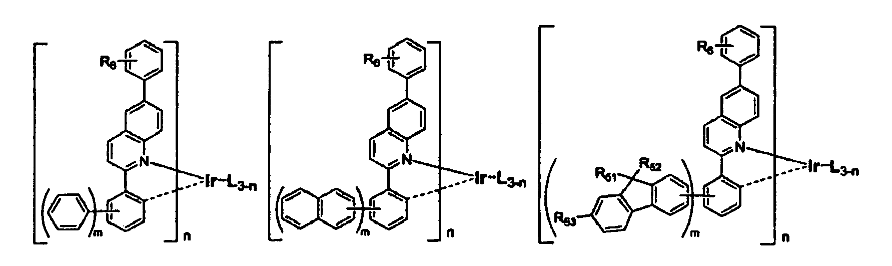 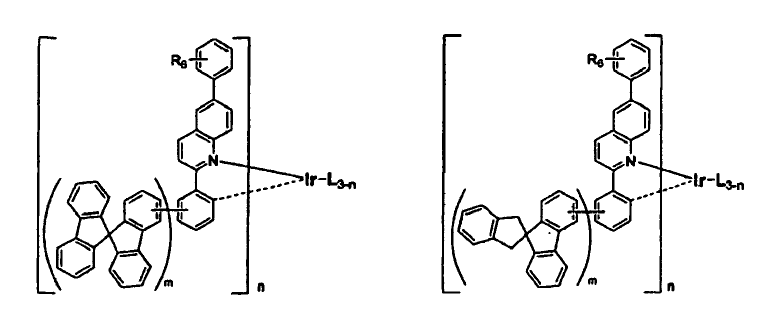 wherein, L and n are defined as in Chemical Formula (1) of claim 1;
R₆ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, fluoro, phenyl or naphthyl;
R₅, and R₅₂ independently represent methyl, ethyl, n-propyl, i-propyl, n-butyl, i-butyl, t-butyl, n-pentyl, i-pentyl, n-hexyl, n-heptyl, n-octyl, ethylhexyl, phenyl or naphthyl, or R₅₁ and R₅₂ may be linked each other via (C₃-C₁₂)alkylene or (C₃-C₁₂)alkenylene with or without a fused fing to form an alicyclic ring, or a monocyclic or polycyclic aromatic ring;
R₅₃ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, trimethylsilyl, tripropylsilyl, tri(t-butyl)silyl, t-butyldimethylsilyl or triphenylsilyl; and
m is an integer from 1 to 3.

6. The organic phosphorescent compound according to claim 3, which is selected from the following compounds: 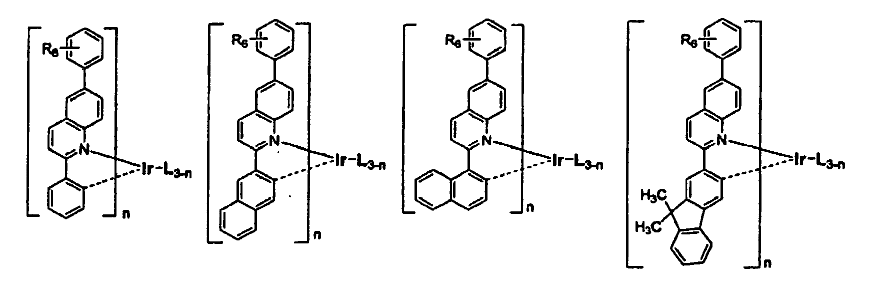 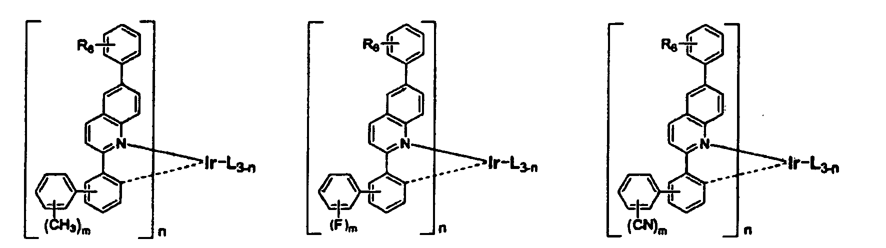 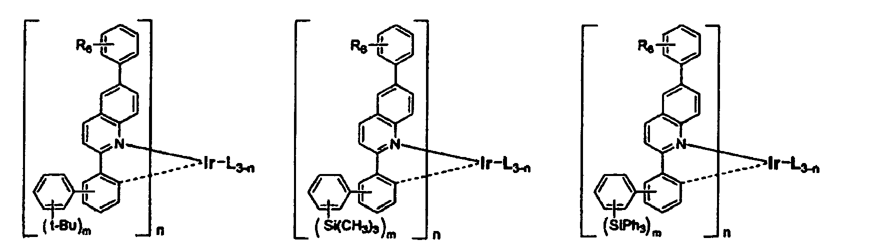 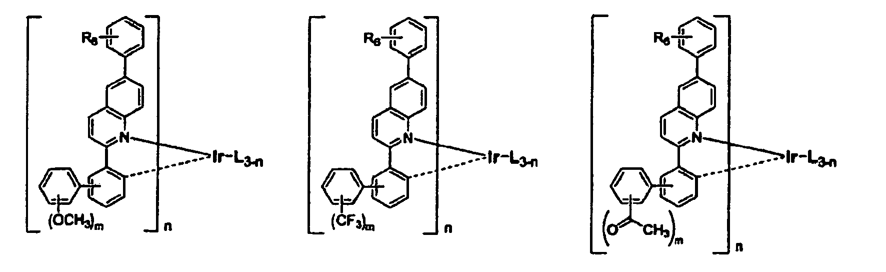 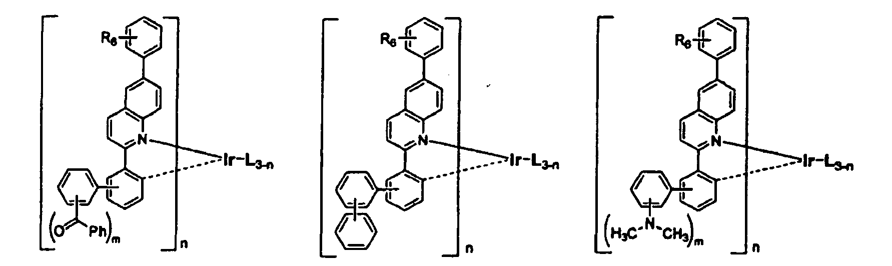 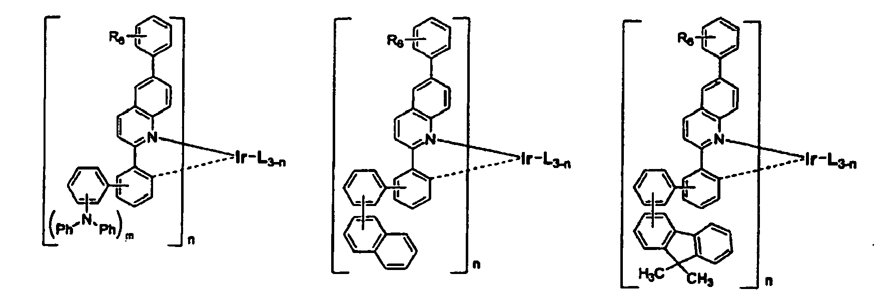 wherein, L and n are defined as in Chemical Formula (I) of claim 1;
R₆ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, fluoro, phenyl or naphthyl; and
m is an integer from 1 to 3.

7. The organic phosphorescent compound according to claim 1, wherein the ligand (L) has a structure represented by one of the following chemical formulas: 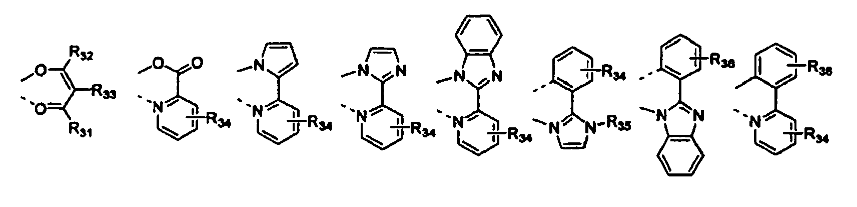 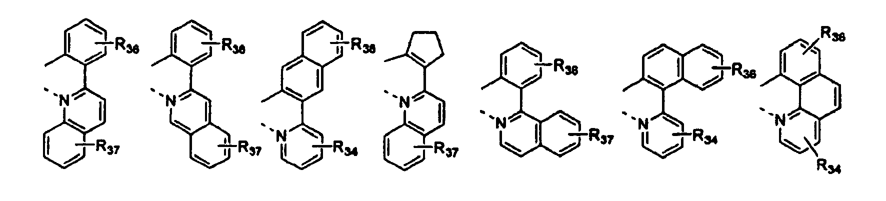 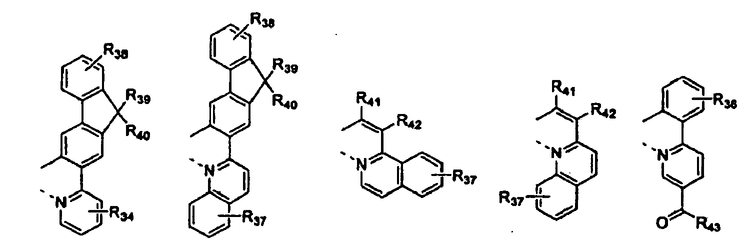 wherein, R₃₁ and R₃₂ independently represent hydrogen, (C₁-C₂₀)alkyl with or without halogen substituent(s), phenyl with or without (C₁-C₂₀)alkyl substituent(s), or halogen;
R₃₃ through R₃₈ independently represent hydrogen, (C₁-C₂₀)alkyl, phenyl with or without (C₁-C₂₀)alkyl substituent(s), tri(C₁-C₂₀)alkylsilyl or halogen;
R₃₉ through R₄₂ independently represent hydrogen, (C₁-C₂₀)alkyl or, phenyl with or without (C₁-C₂₀) alkyl substituent(s); and
R₄₃ represents (C₁-C₂₀)alkyl, phenyl with or without (C₁-C₂₀) alkyl, or halogen.

8. The organic phosphorescent compound according to claim 7, wherein the ligand (L) has a structure represented by one of the following chemical formulas.

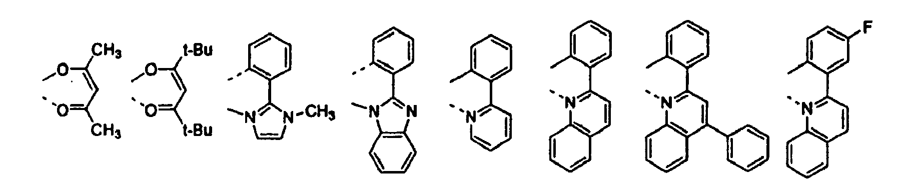

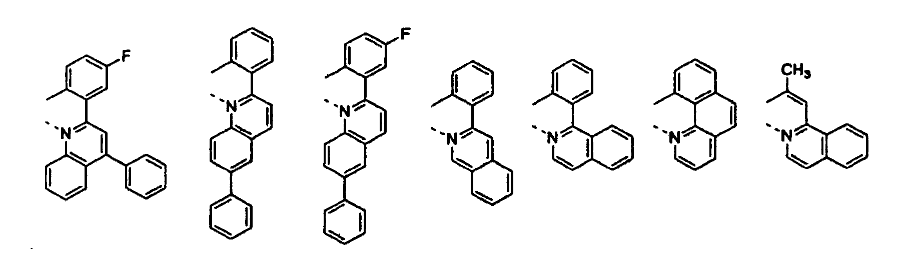

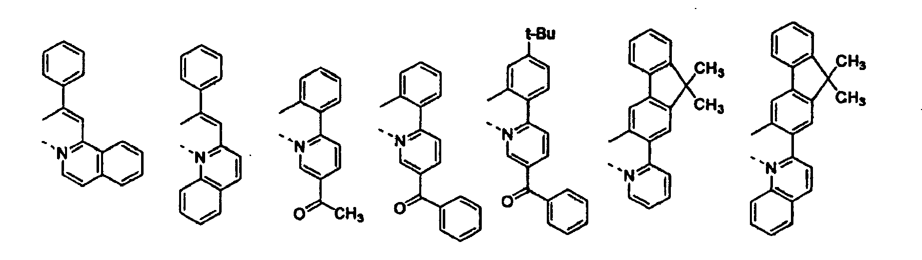

9. An organic electroluminescent device which is comprised of
a first electrode;
a second electrode; and
at least one organic layer(s) interposed between the first electrode and the second electrode;
wherein the organic layer comprises one or more compound(s) represented by Chemical Formula (I): 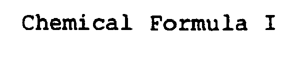 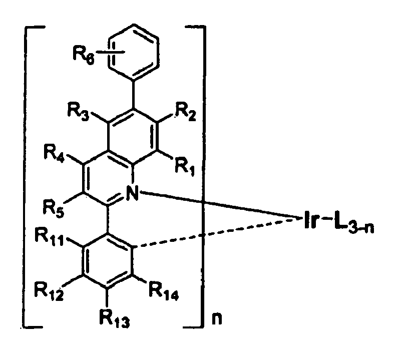 wherein, L is an organic ligand;
R₁ through R₂ independently represent hydrogen, (C₁-C₂₀)alkyl, (C₁-C₂₀)alkoxy, (C₃-C₁₂) cycloalkyl, halogen, tri(C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri (C₁-C₂₀)alkylsilyl, tri(C₆-C₂₀)arylsilyl, (C₁-C₂₀)alkoxy, (C₁-C₂₀) alkylcarbonyl, (C₆-C₂₀)arylcarbonyl, di (C₁-C₂₀) alkylamino, di (C₆-C₂₀) arylamino, phenyl, naphthyl, anthryl, fluorenyl, spirobifluorenyl or 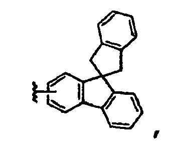 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂)alkylene or (C₃-C₁₂)alkenylene with or without a fused ring may be further substituted by one or more substituent(s) selected from (C₁-C₂₀)alkyl with or without halogen substituent(s), (C₁-C₂₀)alkoxy, halogen, tri(C₁-C₂₀)alkylsilyl, tri(C₆-C₂₀) arylsilyl, (C₁-C₂₀)alkylcarbonyl, (C₆-C₂₀) arylcarbonyl, di (C₁-C₂₀)alkylamino, di (C₆-C₂₀) arylamino and (C₆-C₂₀)aryl; and
n is an integer from 1 to 3.

10. The organic electroluminescent device according to claim 9. wherein the organic layer comprises an electroluminescent region which comprises one or more compound(s) represented by Chemical Formula (I) and one or more host(s).

11. The organic electroluminescent device according to claim 10, wherein the host is selected from the compounds represented by one of Chemical Formulas (VII) to (IX): 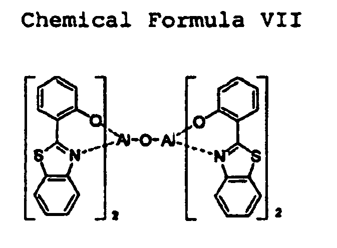 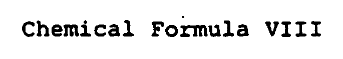 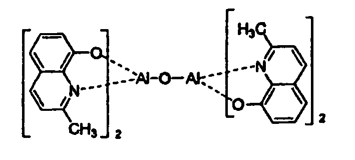
Chemical Formula IX L¹L²M(Q)_{y}
wherein, the ligands, L¹ and L² independently represent one of the following structures: 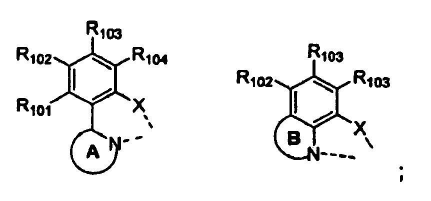 M is a bivalent or trivalent metal;
y is 0 when M is a bivalent metal, while y is 1 when M is a trivalent metal;
Q represents (C₆-C₂₀)aryloxy or tri(C₆-C₂₀)arylsilyl, and the aryloxy and triarylsilyl of Q may be further substituted by (C₁-C₅)alkyl or (C₆-C₂₀)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C₁-C₅)alkyl, or substituted or unsubstituted phenyl or naphthyl;
R₁₀₁ through R₁₀₄ independently represent hydrogen, (C₁-C₅)alkyl, halogen, tri(C₁-C₅)alkylsilyl, tri(C₆-C₂₀)arylsilyl or (C₆-C₂₀)aryl, or each of them may be linked to an adjacent substituent via alkylene or alkenylene to form a fused ring, and the pyridine or quinoline may form a chemical bond together with R₁₀₁ to form a fused ring; and
the ring A or aryl group of R₁₀₁ through R₁₀₄ may be further substituted by (C₁-C₅)alkyl, halogen, (C₁-C₅)alkyl with halogen substituent(s), phenyl, naphthyl, tri(C₁-C₅)alkylsilyl, tri(C₆-C₂₀)arylsilyl or amino group.

12. An organic electroluminescent device according to claim 11, wherein the ligands, L¹ and L² are independently selected from the following structures: 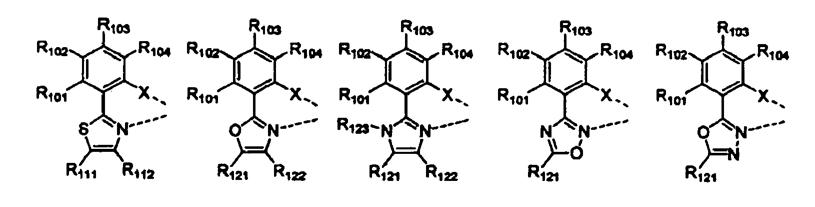 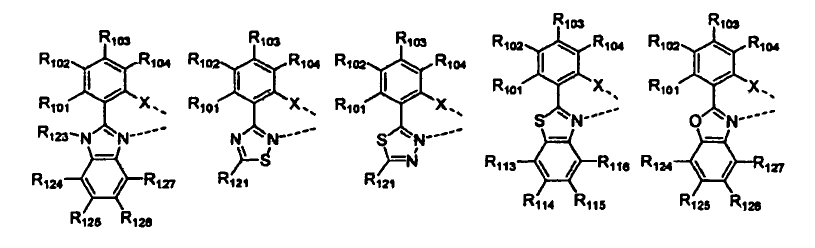 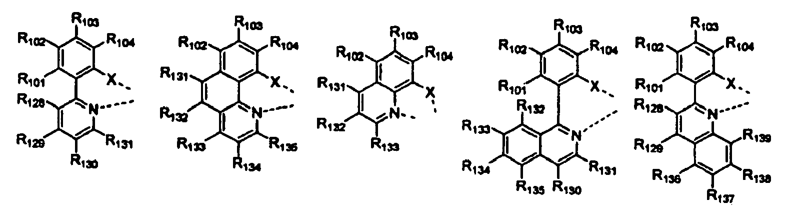 wherein, X represents O, S or Se; R₁₀₁ through R₁₀₄ independently represent hydrogen, (C₁-C₅)alkyl with or without halogen substituent (s), halogen, (C₆-C₂₀)aryl, (C₄-C₂₀) heteroaryl, tri (C₁-C₅)alkylsilyl, tri(C₆-C₂₀) arylsilyl, di(C₁-C₅)alkylamino, di(C₆-C₂₀)arylamino, thiophenyl or furanyl, or each of them may be linked to an adjacent substituent via alkylene or alkenylene to form a fused ring;
R₁₁₁ through R₁₁₆, R₁₂₁ and R₁₂₂ independently represent hydrogen, (C₁-C₅)alkyl, halogen, (C₁-C₅)alkyl with or without halogen substituent(s), phenyl, naphthyl, biphenyl, fluorenyl, tri(C₁-C₅)alkylsilyl, tri(C₆-C₂₀)arylsilyl, di(C₁-C₅)alkylamino, di(C₆-C₂₀)arylamino, thiophenyl or furanyl;
R₁₂₃ represents (C₁-C₂₀)alkyl, phenyl or naphthyl;
R₁₂₄ through R₁₃₉ independently represent hydrogen, (C₁-C₅)alkyl, halogen, (C₁-C₅)alkyl with halogen substituent(s), phenyl, naphthyl, biphenyl, fluorenyl, tri(C₁-C₅)alkylsilyl, tri (C₆-C₂₀)arylsilyl, di(C₁-C₅)alkylamino, di (C₆-C₂₀)arylamino, thiophenyl or furanyl; and
the phenyl, naphthyl, biphenyl, fluorenyl, thiophenyl or furanyl of R₁₁₁ through R₁₁₆ and R₁₂₁ through R₁₃₉ may be further substituted by one or more substituent(s) selected from (C₁-C₅)alkyl, halogen, naphthyl, fluorenyl, tri(C₁-C₅)alkylsilyl, tri(C₆-C₂₀)arylsilyl, di(C₁-C₅)alkylamino and di(C₆-C₂₀)arylamino.

13. An organic electroluminescent device according to claim 11, wherein M is a bivalent metal selected from Be, Zn, Mg, Cu and Ni, or a trivalent metal selected from Al, Ga, In and B.

14. An organic electroluminescent device according to claim 11, wherein Q is selected from the following structures.

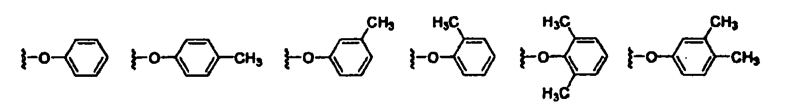

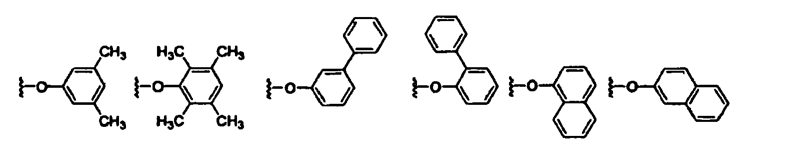

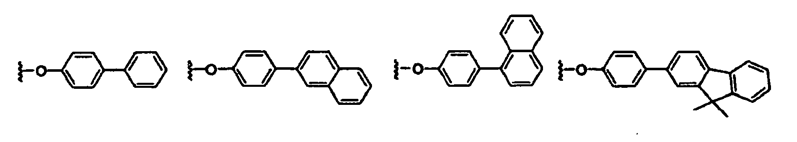

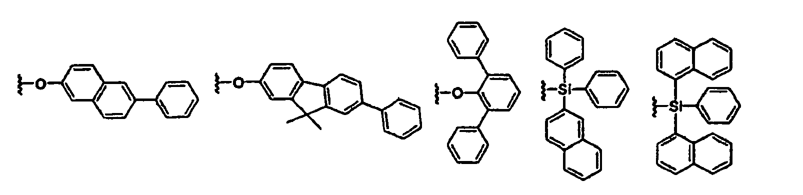

15. An organic electroluminescent device according to claim 11, wherein the host is selected from the compounds represented by the following structures.

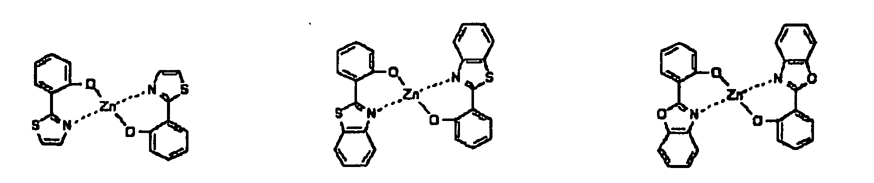

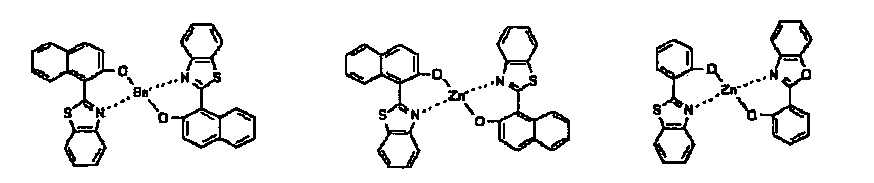

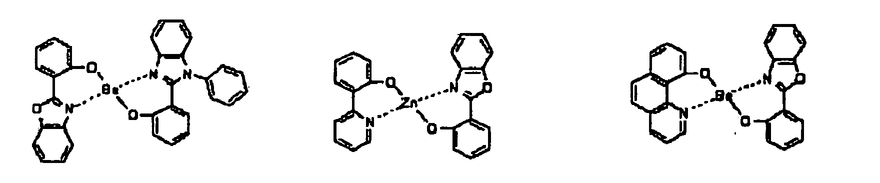

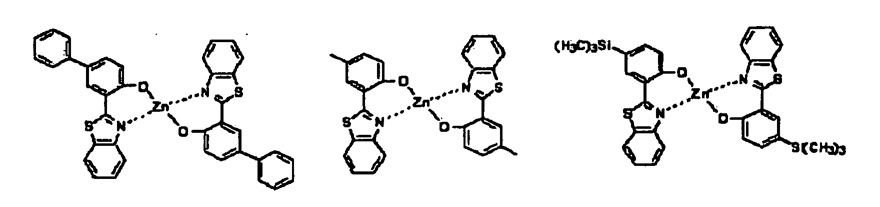

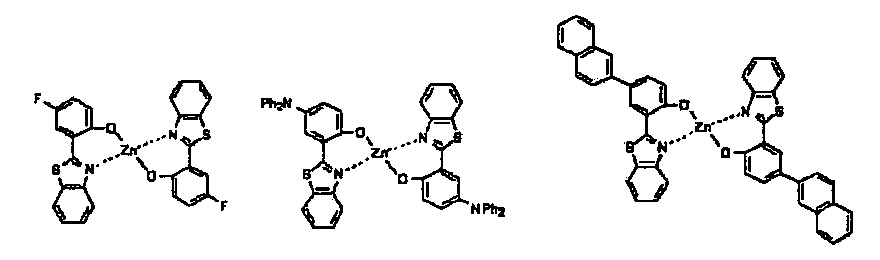

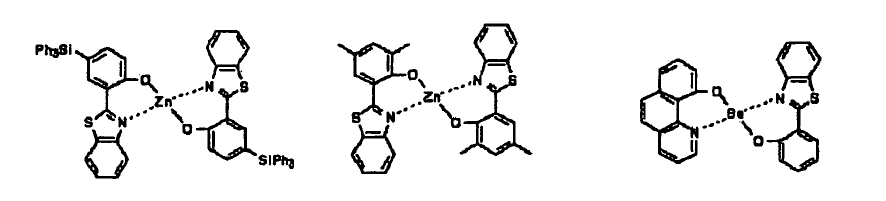

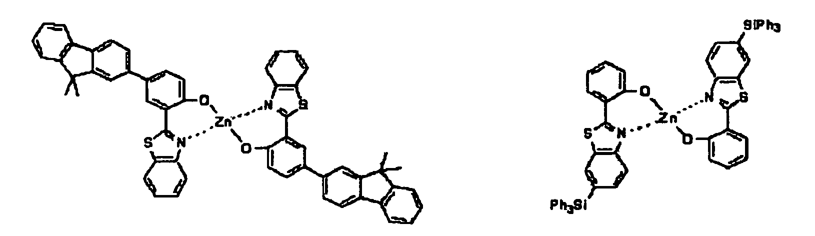

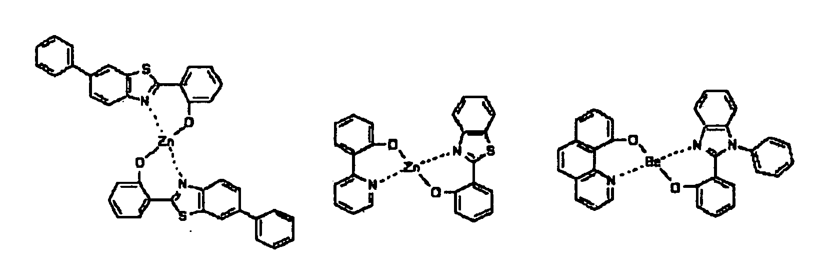

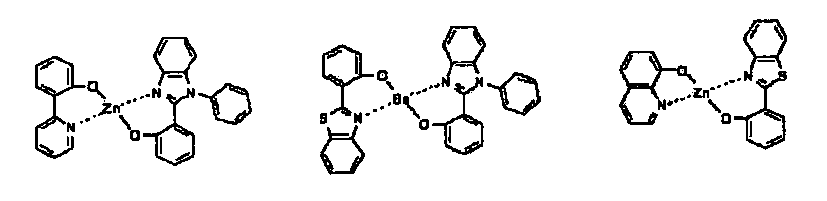

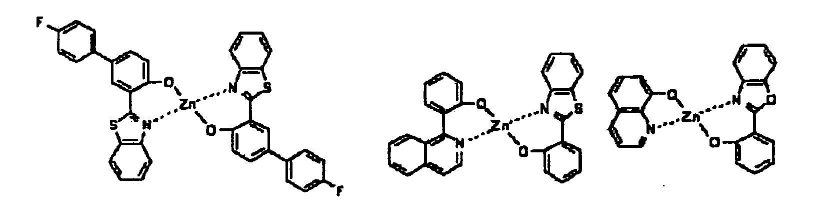

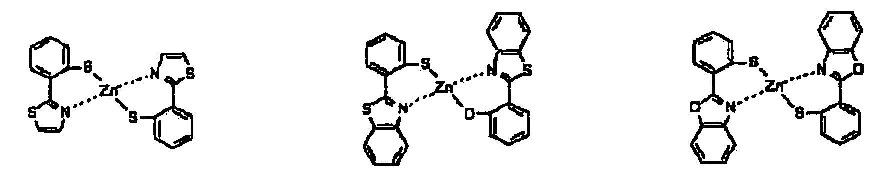

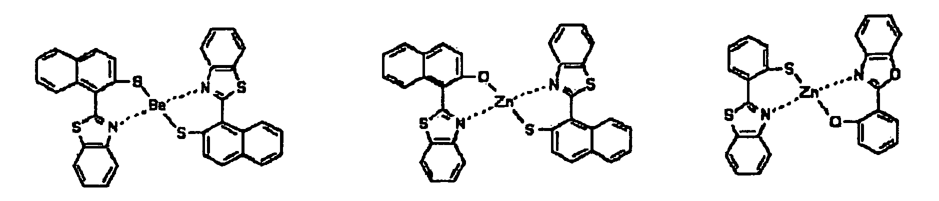

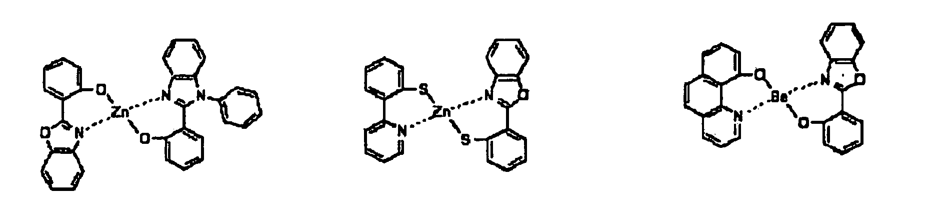

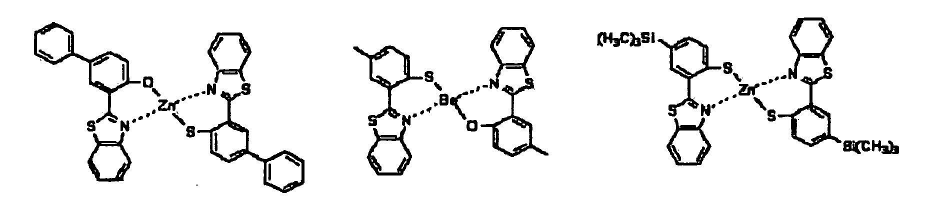

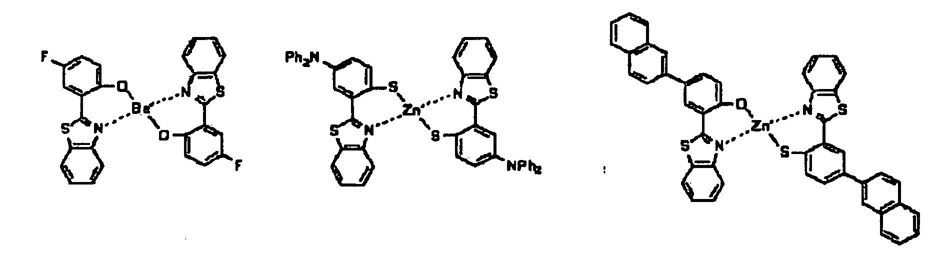

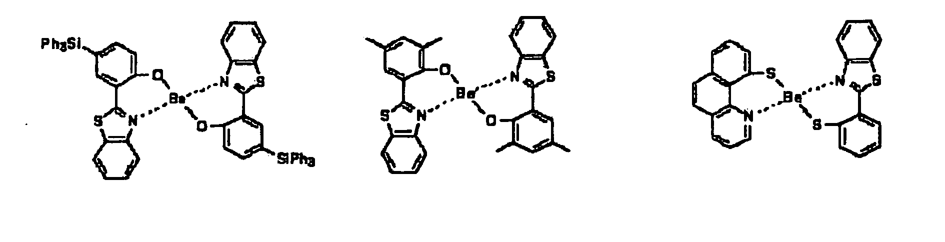

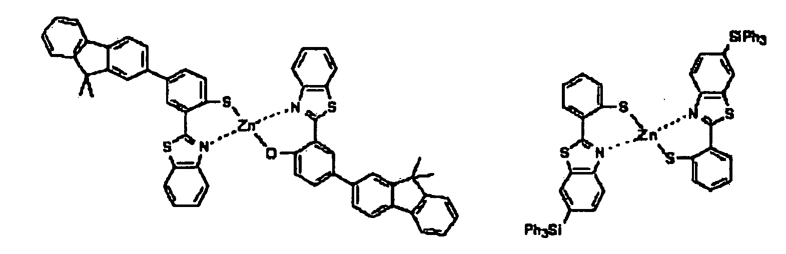

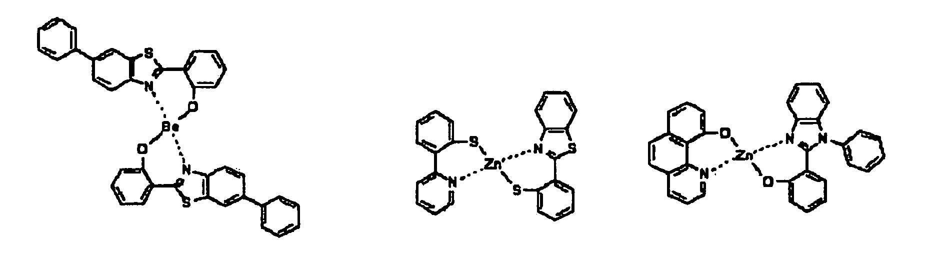

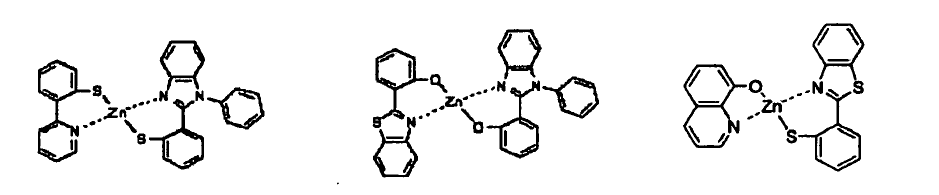

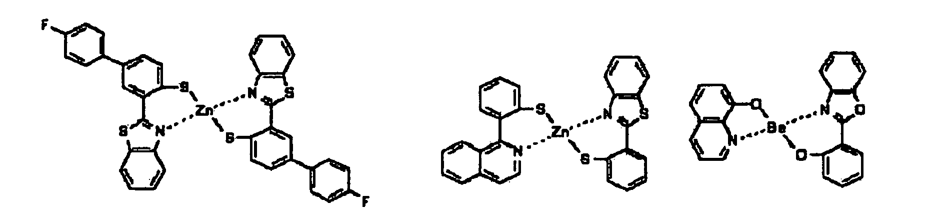

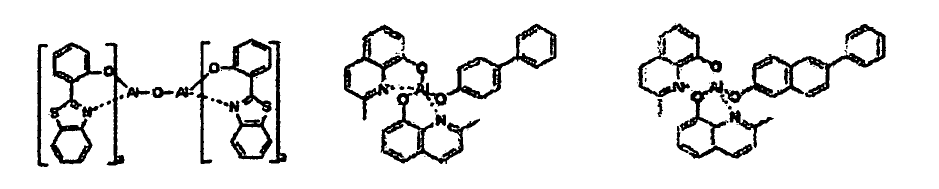

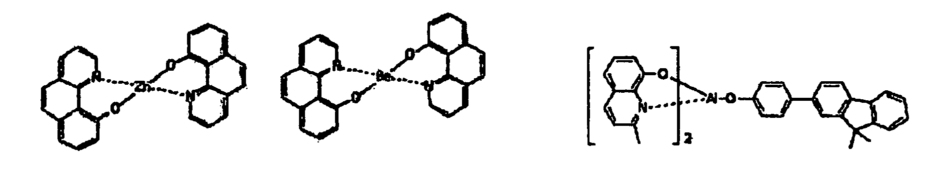

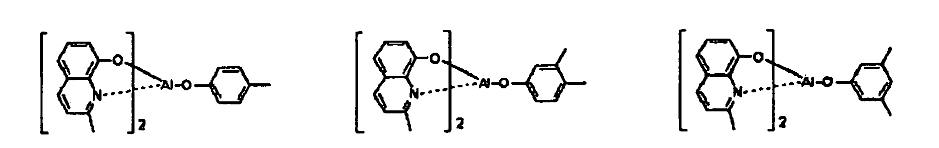

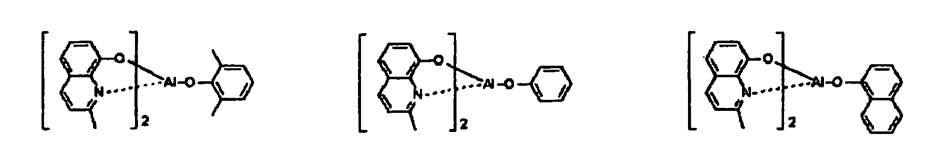

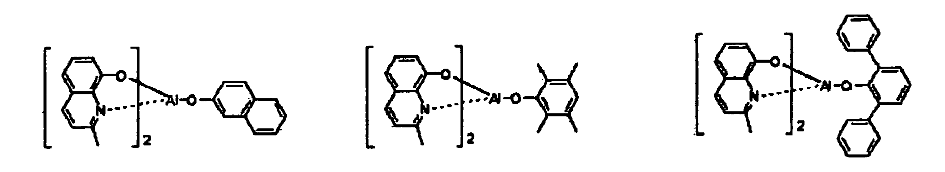

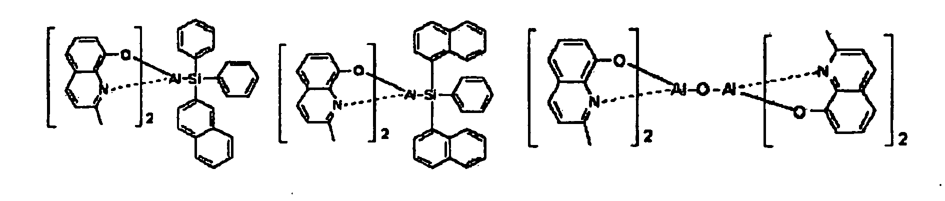

## Patentansprüche

1. Organische phosphoreszierende Verbindung, dargestellt durch die chemische Formel (I): 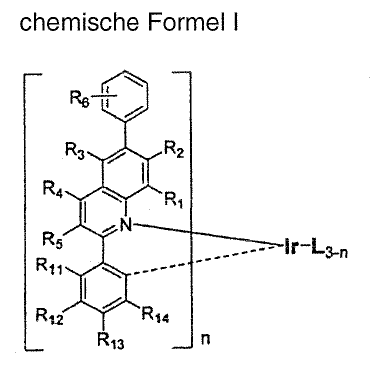 wobei L ein organischer Ligand ist;
R₁ bis R₅ stellen unabhängig Wasserstoff, (C₁-C₂₀)Alkyl, (C₁-C₂₀)Alkoxy, (C₃-C₁₂)Cycloalkyl, Halogen, Tri(C₁-C₂₀)alkylsilyl oder Tri(C₆-C₂₀)arylsilyl dar;
R₆ stellt Wasserstoff, (C₁-C₂₀)Alkyl, Halogen oder (C₆-C₂₀)Aryl dar;
R₁₁ bis R₁₄ stellen unabhängig Wasserstoff, (C₁-C₂₀)Alkyl, Halogen, Cyano, Tri(C₁-C₂₀)alkylsilyl, Tri(C₆-C₂₀)arylsilyl, (C₁-C₂₀)Alkoxy, (C₁-C₂₀)Alkylcarbonyl, (C₆-C₂₀)Arylcarbonyl, Di(C₁-C₂₀)alkylamino, Di(C₆-C₂₀)arylamino, Phenyl, Naphthyl, Anthryl, Fluorenyl, Spirobifluorenyl oder 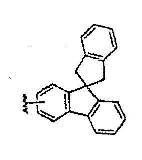 dar, oder jedes von R₁₁ bis R₁₄ kann mit einer anderen benachbarten Gruppe von R₁₁ bis R₁₄ über (C₃-C₁₂)Alkylen oder (C₃-C₁₂)Alkenylen mit oder ohne einem kondensierten Ring verbunden sein, um einen alicyclischen Ring oder einen monocyclischen oder polycyclischen aromatischen Ring zu bilden;
das Alkyl, Phenyl, Naphthyl, Anthryl, Fluorenyl von R₁₁ bis R₁₄, und der alicyclische Ring oder der monocyclische oder polycyclische aromatische Ring, der durch Bindung über (C₃-C₁₂)Alkylen oder (C₃-C₁₂)Alkenylen mit oder ohne einem kondensierten Ring davon gebildet ist, können weiter mit einem oder mehreren Substituenten substituiert sein, ausgewählt aus (C₁-C₂₀)Alkyl mit oder ohne Halogensubstituent(en), (C₁-C₂₀)Alkoxy, Halogen, Tri(C₁-C₂₀)alkylsilyl, Tri-(C₆-C₂₀)arylsilyl, (C₁-C₂₀)Alkylcarbonyl, (C₆-C₂₀)Arylcarbonyl, Di(C₁-C₂₀)alkylamino, Di(C₆-C₂₀)arylamino und (C₆-C₂₀)Aryl; und
n ist eine ganze Zahl von 1 bis 3.

2. Organische phosphoreszierende Verbindung nach Anspruch 1, wobei R₁₁ bis R₁₄ unabhängig Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, 2-Ethylhexyl, n-Nonyl, Trifluormethyl, Fluor, Cyano, Trimethylsilyl, Tripropylsilyl, Tri(t-butyl)silyl, t-Butyldimethylsilyl, Triphenylsilyl, Methoxy, Ethoxy, Butoxy, Methylcarbonyl, Ethylcarbonyl, t-Butylcarbonyl, Phenylcarbonyl, Dimethylamino, Diphenylamino, Phenyl, Naphthyl, Anthryl, Fluorenyl oder 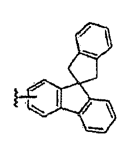 darstellen, und das Fluorenyl weiter mit ethyl, Ethyl, n-Propyl, i-Propyl, n-Butyl, i-Butyl, t-Butyl, n-Pentyl, i-Pentyl, n-Hexyl, n-Heptyl, n-Octyl, 2-Ethylhexyl, n-Nonyl, Phenyl, Naphthyl, Anthryl, Trimethylsilyl, Tripropylsilyl, Tri(t-butyl)silyl, t-Butyldimethylsilyl oder Triphenylsilyl substituiert sein kann.

3. Organische phosphoreszierende Verbindung nach Anspruch 1, welche aus den Verbindungen, dargestellt durch eine der chemischen Formeln (II) bis (VI), ausgewählt ist: 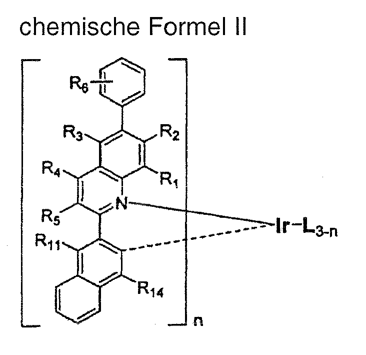 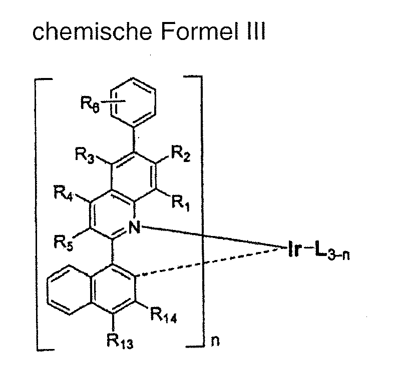 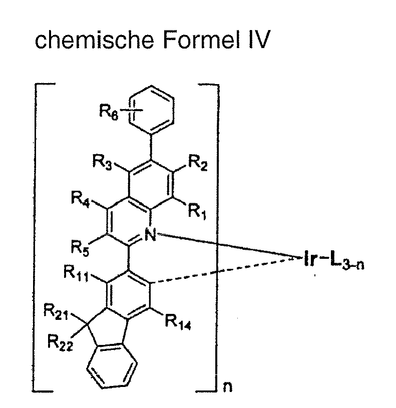 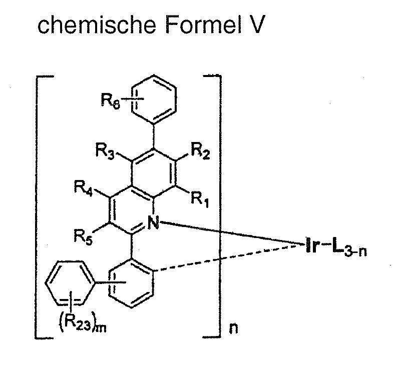 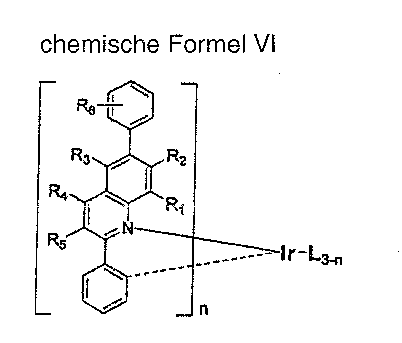 wobei L, R₁, R₂, R₃, R₄, R₅, R₆, R₁₁, R₁₃, R₁₄ und n wie in der chemischen Formel (I) von Anspruch 1 definiert sind;
R₂₁ und R₂₂ stellen unabhängig Wasserstoff, (C₁-C₂₀)Alkyl, (C₆-C₂₀)Aryl dar, oder R₂₁ und R₂₂ können über (C₃-C₁₂)Alkylen oder (C₃-C₁₂)Alkenylen mit oder ohne einem kondensierten Ring verbunden sein, um einen alicyclischen Ring oder einen monocyclischen oder polycyclischen aromatischen Ring zu bilden;
R₂₃ stellt (C₁-C₂₀)Alkyl, Halogen, Cyano, Tri(C₁-C₂₀)alkylsilyl, Tri(C₆-C₂₀)arylsilyl, (C₁-C₂₀)Alkoxy, (C₁-C₂₀)Alkylcarbonyl, (C₆-C₂₀)Arylcarbonyl, Phenyl, Di(C₁-C₂₀)-alkylamino, Di(C₆-C₂₀)arylamino, Naphthyl, 9,9-Di(C₁-C₂₀)alkylfluorenyl oder 9,9-Di(C₆-C₂₀)arylfluorenyl dar; und
m ist eine ganze Zahl von 1 bis 5.

4. Organische phosphoreszierende Verbindung nach Anspruch 1, wobei R₁ bis R₅ unabhängig Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Methoxy, Ethoxy, Butoxy, Cyclopropyl, Cyclohexyl, Cycloheptyl, Fluor, Trimethylsilyl, Tripropylsilyl, Tri(t-butyl)silyl, t-Butyldimethylsilyl oder Triphenylsilyl darstellen; und R₆ stellt Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Fluor, Phenyl, Naphthyl, Anthryi, Fluorenyl oder Spirobifluorenyl dar.

5. Organische phosphoreszierende Verbindung nach Anspruch 2, welche aus den Verbindungen, dargestellt durch eine der nachstehenden chemischen Formeln, ausgewählt ist: 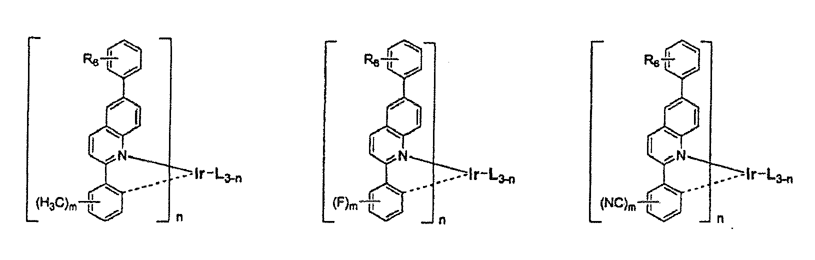 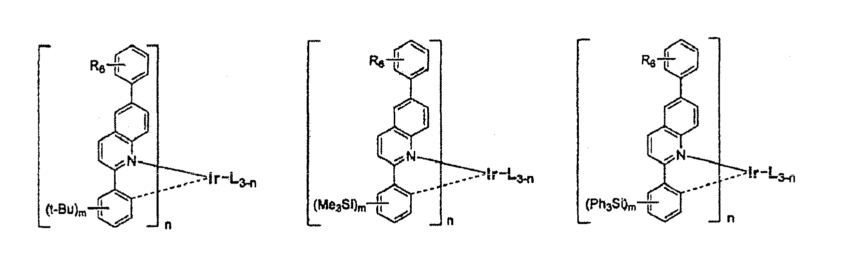 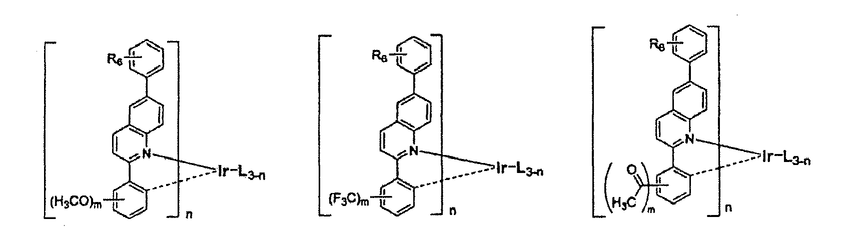 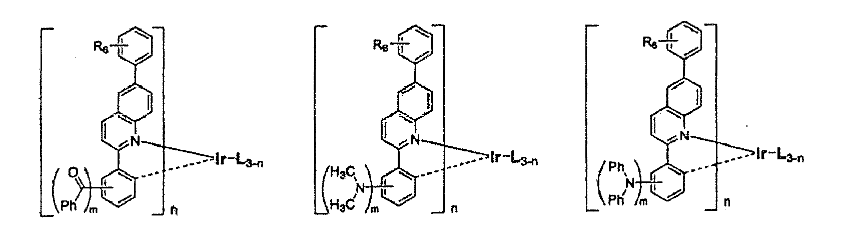 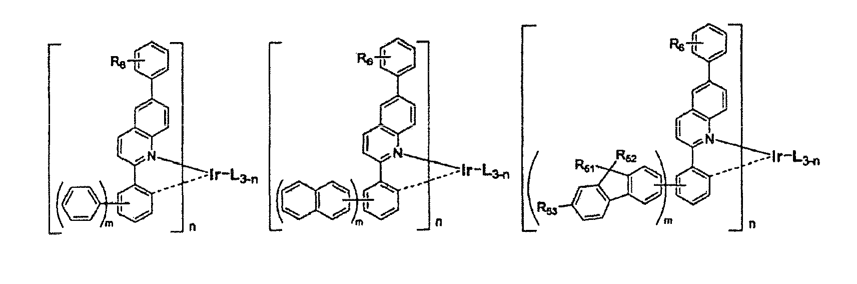 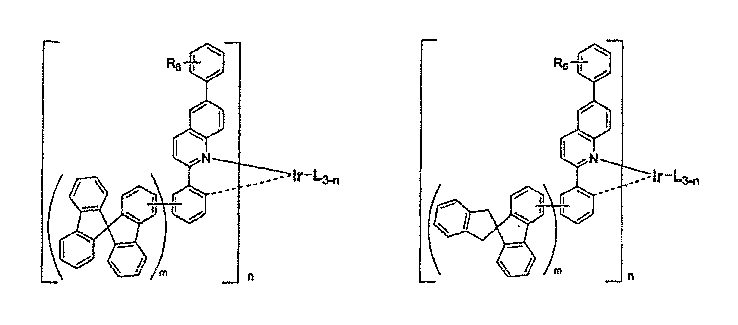 wobei L und n wie in der chemischen Formel (I) von Anspruch 1 definiert sind; R₆ stellt Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Fluor, Phenyl oder Naphthyl dar;
R₅₁ und R₅₂ stellen unabhängig Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Phenyl oder Naphthyl dar, oder R₅₁ und R₅₂ können miteinander über (C₃-C₁₂)Alkylen oder (C₃-C₁₂)Alkenylen mit oder ohne einem kondensierten Ring verbunden sein, um einen alicyclischen Ring oder einen monocyclischen oder polycyclischen aromatischen Ring zu bilden;
R₅₃ stellt Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Trimethylsilyl, Tripropylsilyl, Tri(t-butyl)silyl, t-Butyldimethylsilyl oder Triphenylsilyl dar; und
m ist eine ganze Zahl von 1 bis 3.

6. Organische phosphoreszierende Verbindung nach Anspruch 3, welche aus den nachstehenden Verbindungen ausgewählt ist: 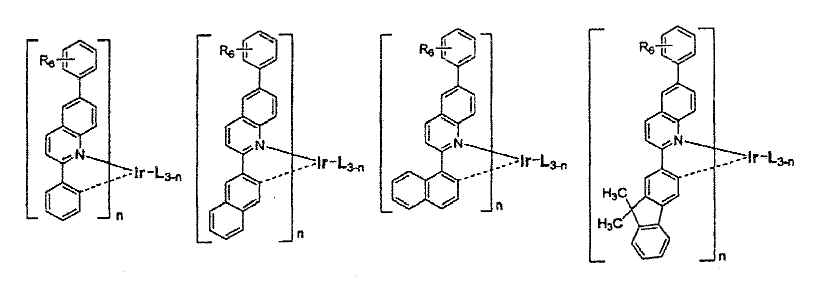 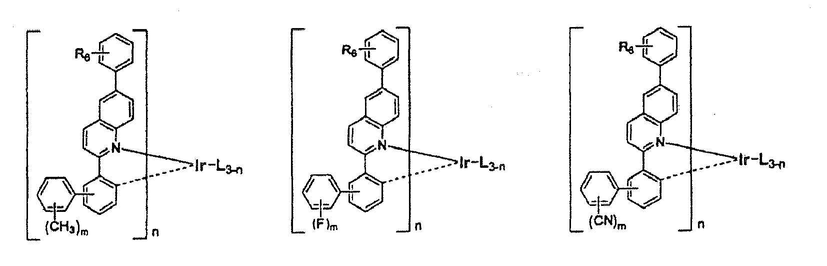 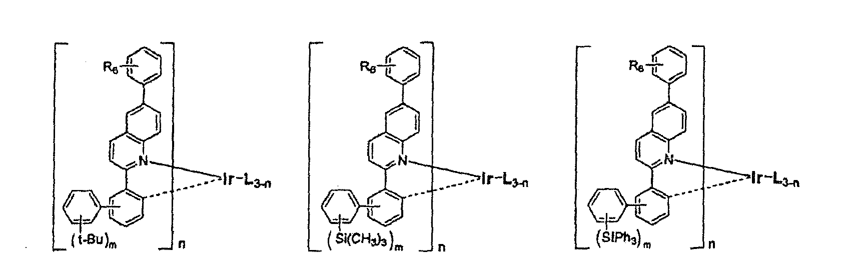 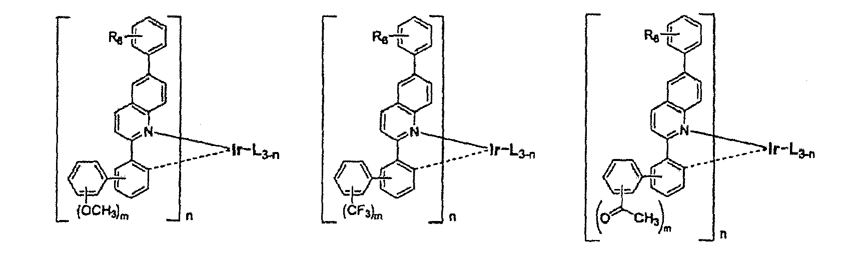 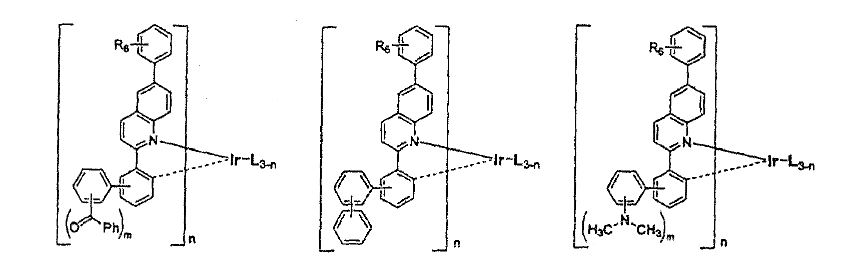 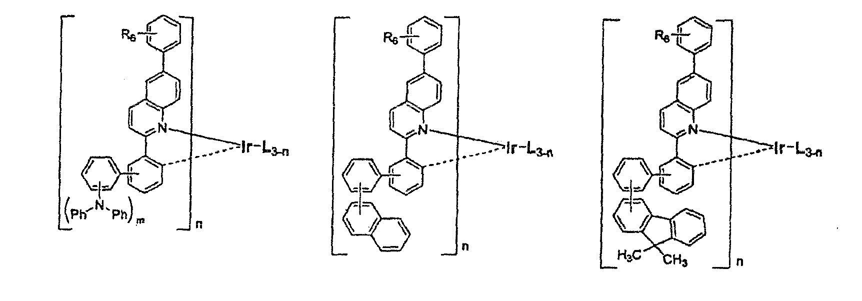 wobei L und n wie in der chemischen Formel (I) von Anspruch 1 definiert sind; R₆ stellt Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Fluor, Phenyl oder Naphthyl dar; und
m ist eine ganze Zahl von 1 bis 3.

7. Organische phosphoreszierende Verbindung nach Anspruch 1, wobei der Ligand (L) eine Struktur, dargestellt durch eine der nachstehenden chemischen Formeln, aufweist: 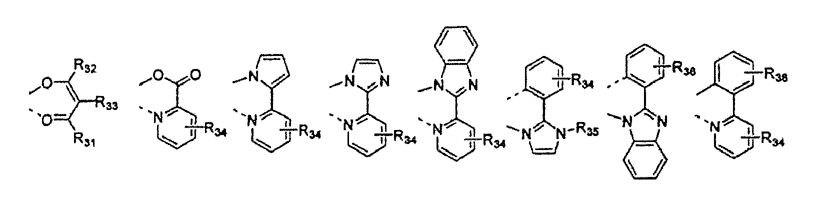 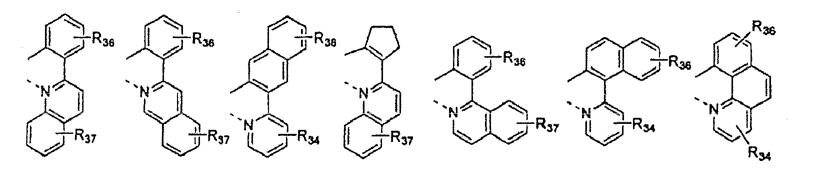 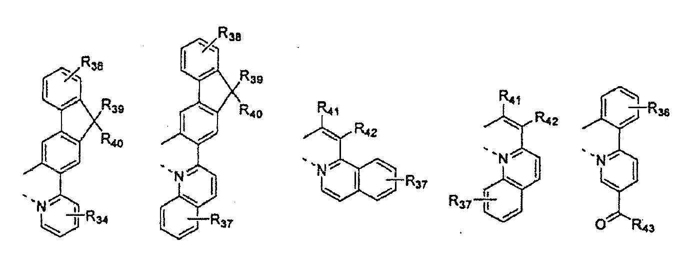 wobei R₃₁ und R₃₂ unabhängig Wasserstoff, (C₁-C₂₀)Alkyl mit oder ohne Halo-gensubstituent(en), Phenyl mit oder ohne (C₁-C₂₀)Alkylsubstituent(en) oder Halogen darstellen;
R₃₃ bis R₃₈ stellen unabhängig Wasserstoff, (C₁-C₂₀)Alkyl, Phenyl mit oder ohne (C₁-C₂₀)Alkylsubstituent(en), Tri(C₁-C₂₀)alkylsilyl oder Halogen dar;
R₃₉ bis R₄₂ stellen unabhängig Wasserstoff, (C₁-C₂₀)Alkyl oder Phenyl mit oder ohne (C₁-C₂₀)Alkylsubstituent(en) dar; und
R₄₃ stellt (C₁-C₂₀)Alkyl, Phenyl mit oder ohne (C₁-C₂₀)Alkyl oder Halogen dar.

8. Organische phosphoreszierende Verbindung nach Anspruch 7, wobei der Ligand (L) eine Struktur, dargestellt durch eine der nachstehenden chemischen Formeln, aufweist.

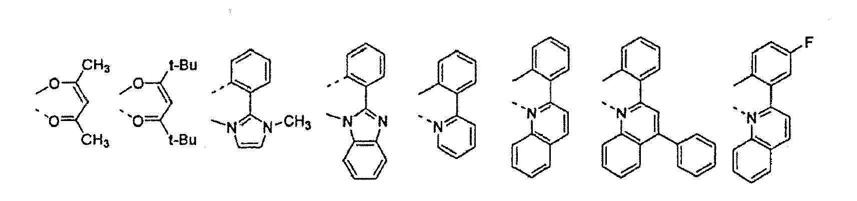

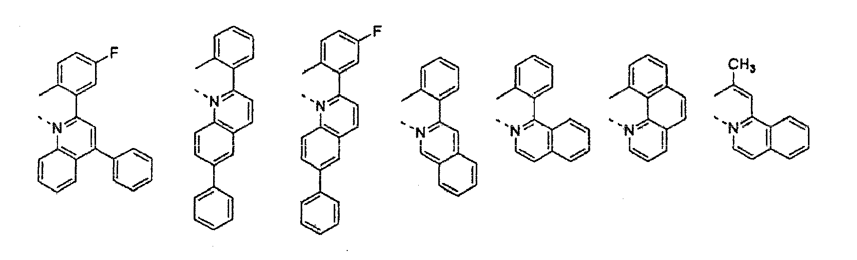

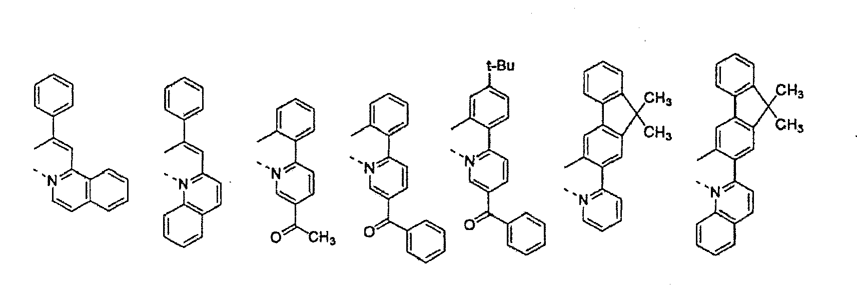

9. Organische Elektrolumineszenzvorrichtung, welche
eine erste Elektrode;
eine zweite Elektrode; und
mindestens eine organische Schicht(en), welche zwischen der ersten Elektrode und der zweiten Elektrode angeordnet ist (sind), umfasst,
wobei die organische Schicht eine oder mehrere Verbindung(en) umfasst, dargestellt durch die chemische Formel (I): 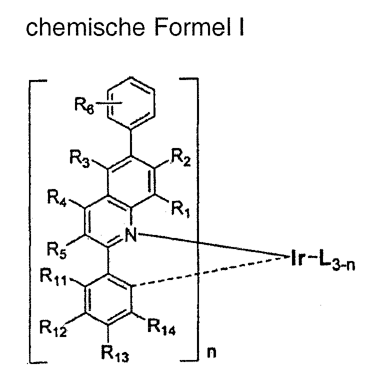 wobei L ein organischer Ligand ist;
R₁ bis R₅ stellen unabhängig Wasserstoff, (C₁-C₂₀)Alkyl, (C₁-C₂₀)Alkoxy, (C₃-C₁₂)Cycloalkyl, Halogen, Tri(C₁-C₂₀)alkylsilyl oder Tri(C₆-C₂₀)arylsilyl dar;
R₆ stellt Wasserstoff, (C₁-C₂₀)Alkyl, Halogen oder C₆-C₂₀)Aryl dar;
R₁₁ bis R₁₄ stellen unabhängig Wasserstoff, (C₁-C₂₀)Alkyl, Halogen, Cyano, Tri(C₁-C₂ₒ)alkylsilyl, Tri(C₆-C₂₀)arylsilyl, (C₁-C₂₀)Alkoxy, (C₁-C₂₀)Alkylcarbonyl, (C₆-C₂₀)Arylcarbonyl, Di(C₁-C₂₀)alkylamino, Di(C₆-C₂₀)arylamino, Phenyl, Naphthyl, Anthryl, Fluorenyl, Spirobifluorenyl oder 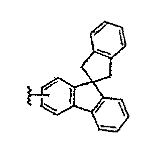 dar, oder jedes von R₁₁ bis R₁₄ kann mit einer anderen benachbarten Gruppe von R₁₁ bis R₁₄ über (C₃-C₁₂)Alkylen oder (C₃-C₁₂)Alkenylen mit oder ohne einem kondensierten Ring verbunden sein, um einen alicyclischen Ring oder einen monocyclischen oder polycyclischen aromatischen Ring zu bilden;
das Alkyl, Phenyl, Naphthyl, Anthryl, Fluorenyl von R₁₁ bis R₁₄, und der alicyclische Ring oder der monocyclische oder polycyclische aromatische Ring, der durch Bindung über (C₃-C₁₂)Alkylen oder (C₃-C₁₂)Alkenylen mit oder ohne einem kondensierten Ring davon gebildet ist, können weiter mit einem oder mehreren Substituenten substituiert sein, ausgewählt aus (C₁-C₂₀)Alkyl mit oder ohne Halogensubstituent(en), (C₁-C₂₀)Alkoxy, Halogen, Tri(C₁-C₂₀)alkylsilyl, Tri(C₆-C₂₀)arylsilyl, (C₁-C₂₀)Alkylcarbonyl, (C₆-C₂₀)Arylcarbonyl, Di(C₁-C₂₀)alkylamino, Di(C₆-C₂₀)arylamino und (C₆-C₂₀)Aryl; und
n ist eine ganze Zahl von 1 bis 3.

10. Organische Elektrolumineszenzvorrichtung nach Anspruch 9, wobei die organische Schicht einen Elektrolumineszenzbereich umfasst, welcher eine oder mehrere Verbindung(en), dargestellt durch die chemische Formel (I), und einen oder mehrere Host(s) umfasst.

11. Organische Elektrolumineszenzvorrichtung nach Anspruch 10, wobei der Host aus den Verbindungen, dargestellt durch eine der chemischen Formeln (VII) bis (IX), ausgewählt ist: 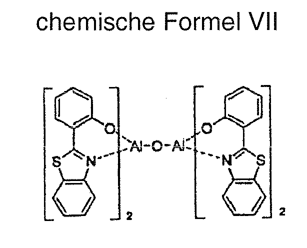 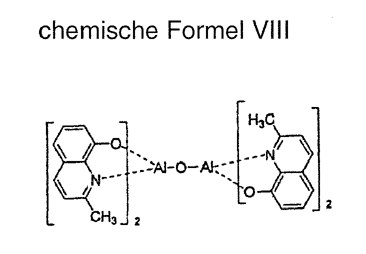
chemische Formel IX L¹L²M(Q)_{y}
wobei die Liganden L¹ und L² unabhängig eine der nachstehenden Strukturen darstellen: 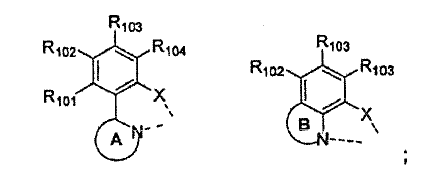 M ein zweiwertiges oder dreiwertiges Metall ist;
y 0 ist, wenn M ein zweiwertiges Metall ist, während y 1 ist, wenn M ein dreiwertiges Metall ist;
Q (C₆-C₂₀)Aryloxy oder Tri(C₆-C₂₀)arylsilyl darstellt, und das Aryloxy und Triarylsilyl von Q weiter mit (C₁-C₅)Alkyl oder (C₆-C₂₀)Aryl substituiert sein können;
X O, S oder Se darstellt;
Ring A stellt Oxazol, Thiazol, Imidazol, Oxadiazol, Thiadiazol, Benzoxazol, Benzothiazol, Benzimidazol, Pyridin oder Chinolin dar;
Ring B stellt Pyridin oder Chinolin dar, und Ring B kann weiter mit (C₁-C₅)Alkyl oder substituiertem oder unsubstituiertem Phenyl oder Naphthyl substituiert sein;
R₁₀₁ bis R₁₀₄ stellen unabhängig Wasserstoff, (C₁-C₅)Alkyl, Halogen, Tri(C₁-C₅)alkylsilyl, Tri(C₆-C₂₀)arylsilyl oder (C₆-C₂₀)Aryl dar, oder jedes von diesen kann mit einem benachbarten Substituenten über Alkylen oder Alkenylen verbunden sein, um einen kondensierten Ring zu bilden, und das Pyridin oder Chinolin kann zusammen mit R₁₀₁ eine chemische Bindung bilden, um einen kondensierten Ring zu bilden; und
der Ring A oder die Arylgruppe von R₁₀₁ bis R₁₀₄ kann weiter mit (C₁-C₅)Alkyl, Halogen, (C₁-C₅)Alkyl mit Halogensubstituent(en), Phenyl, Naphthyl, Tri(C₁-C₅)alkylsilyl, Tri(C₆-C₂₀)arylsilyl oder einer Aminogruppe substituiert sein.

12. Organische Elektrolumineszenzvorrichtung nach Anspruch 11, wobei die Liganden L¹ und L² unabhängig aus den nachstehenden Strukturen ausgewählt sind: 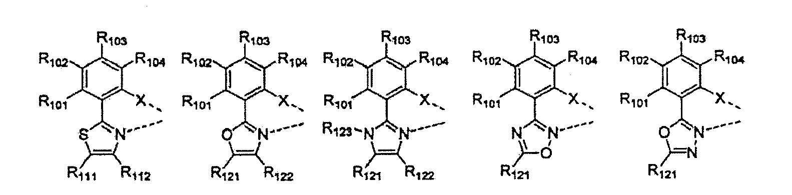 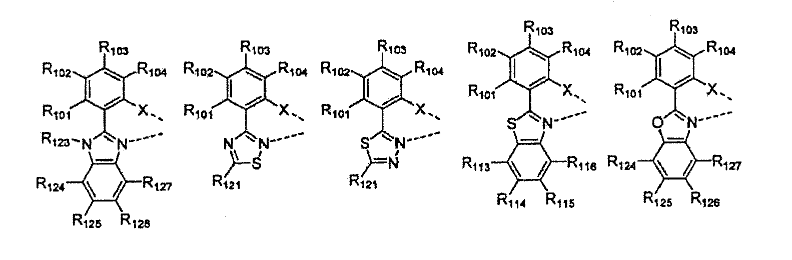 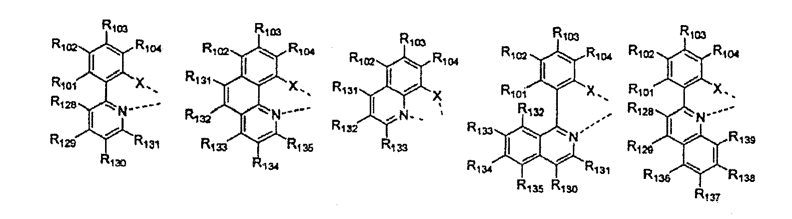 wobei X O, S oder Se darstellt;
R₁₀₁ bis R₁₀₄ stellen unabhängig Wasserstoff, (C₁-C₅)Alkyl mit oder ohne Halogensubstituent(en), Halogen, (C₆-C₂₀)Aryl, (C₄-C₂₀)Heteroaryl, Tri(C₁-C₅)alkylsilyl, Tri(C₆-C₂₀)arylsilyl, Di(C₁-C₅)alkylamino, Di(C₆-C₂₀)arylamino, Thiophenyl oder Furanyl dar, oder jedes von diesen kann mit einem benachbarten Substituenten über Alkylen oder Alkenylen verbunden sein, um einen kondensierten Ring zu bilden;
R₁₁₁ bis R₁₁₆, R₁₂₁ und R₁₂₂ stellen unabhängig Wasserstoff, (C₁-C₅)Alkyl, Halogen, (C₁-C₅)Alkyl mit oder ohne Halogensubstituent(en), Phenyl, Naphthyl, Biphenyl, Fluorenyl, Tri(C₁-C₅)alkylsilyl, Tri(C₆-C₂₀)arylsilyl, Di(C₁-C₅)alkylamino, Di(C₆-C₂₀)arylamino, Thiophenyl oder Furanyl dar;
R₁₂₃ stellt (C₁-C₂₀)Alkyl, Phenyl oder Naphthyl dar;
R₁₂₄ bis R₁₃₉ stellen unabhängig Wasserstoff, (C₁-C₅)Alkyl, Halogen, (C₁-C₅)Alkyl mit Halogensubstituent(en), Phenyl, Naphthyl, Biphenyl, Fluorenyl, Tri(C₁-C₅)alkylsilyl, Tri(C₆-C₂₀)arylsilyl, Di(C₁-C₅)alkylamino, Di(C₆-C₂₀)arylamino, Thiophenyl oder Furanyl dar; und
das Phenyl, Naphthyl, Biphenyl, Fluorenyl, Thiophenyl oder Furanyl von R₁₁₁ bis R₁₁₆ und R₁₂₁ bis R₁₃₉ können weiter mit einem oder mehreren Substituenten substituiert sein, ausgewählt aus (C₁-C₅)Alkyl, Halogen, Naphthyl, Fluorenyl, Tri(C₁-C₅)alkylsilyl, Tri(C₆-C₂₀)arylsilyl, Di(C₁-C₅)alkylamino und Di(C₆-C₂₀)arylamino.

13. Organische Elektrolumineszenzvorrichtung nach Anspruch 11, wobei M ein zweiwertiges Metall, ausgewählt aus Be, Zn, Mg, Cu und Ni, oder ein dreiwertiges Metall, ausgewählt aus Al, Ga, In und B, ist.

14. Organische Elektrolumineszenzvorrichtung nach Anspruch 11, wobei Q aus den nachstehenden Strukturen ausgewählt ist.

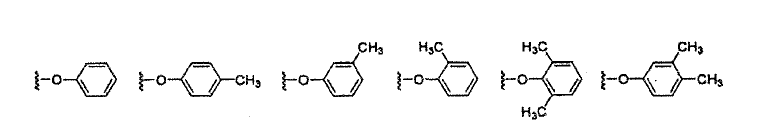

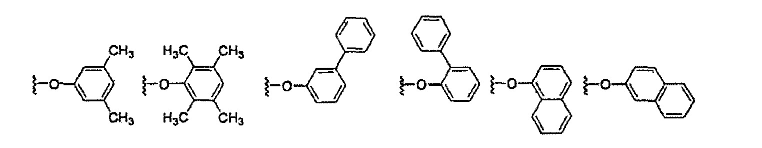

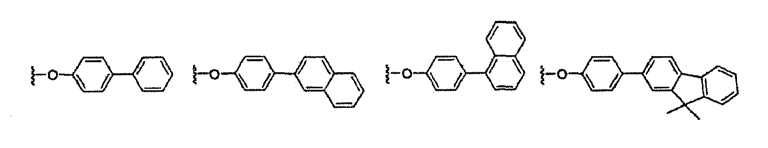

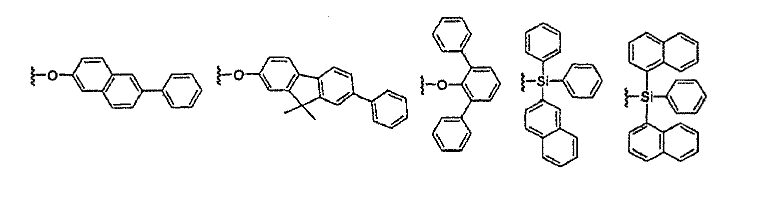

15. Organische Elektrolumineszenzvorrichtung nach Anspruch 11, wobei der Host aus den Verbindungen, dargestellt durch eine der nachstehenden Strukturen, ausgewählt ist.

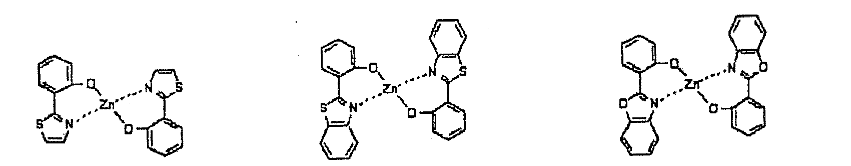

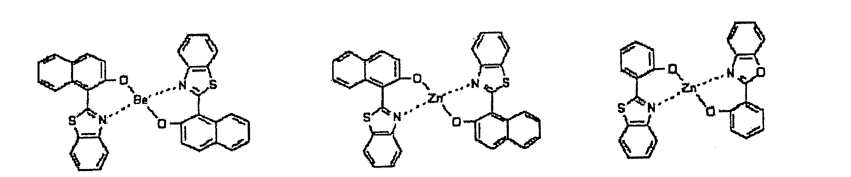

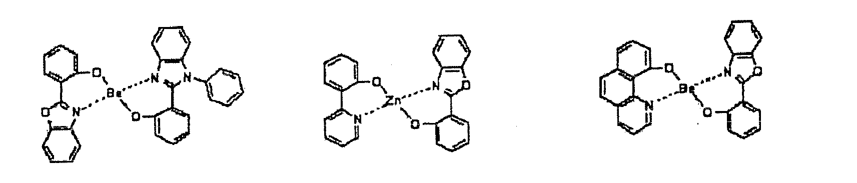

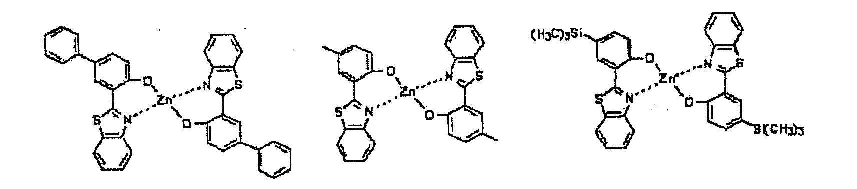

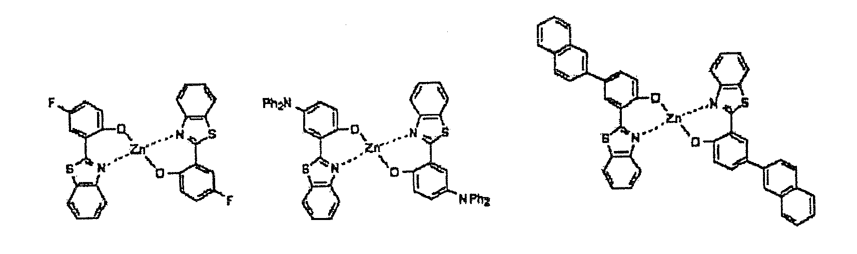

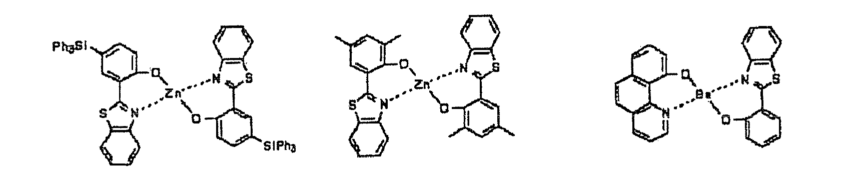

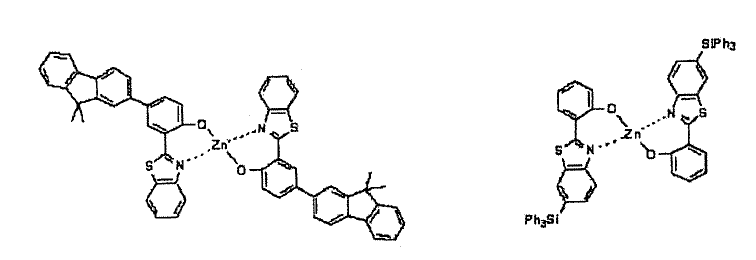

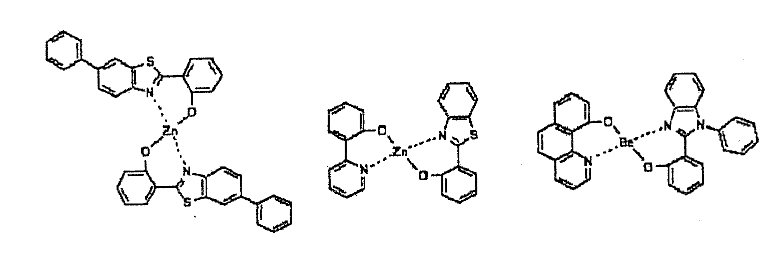

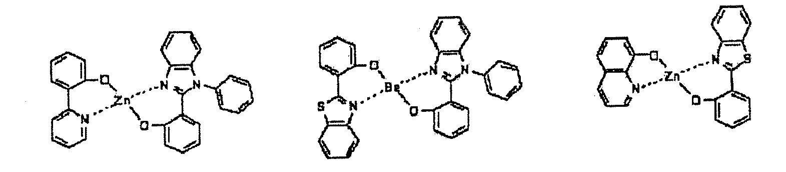

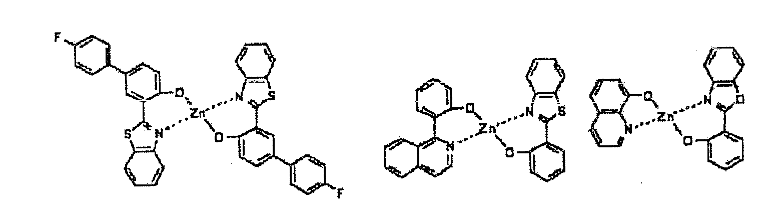

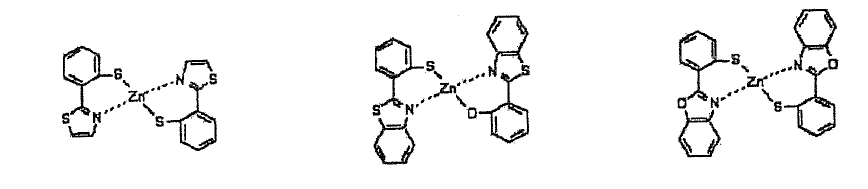

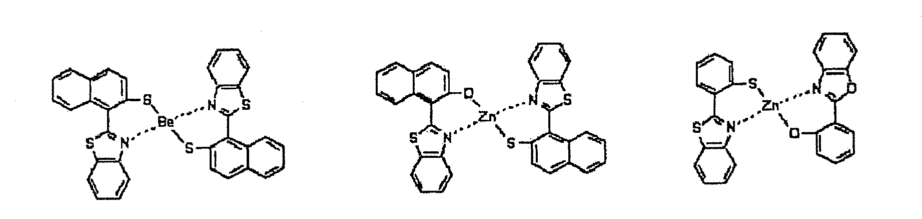

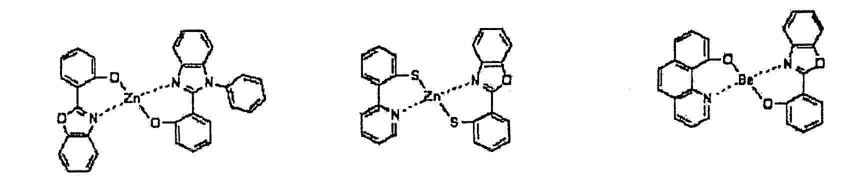

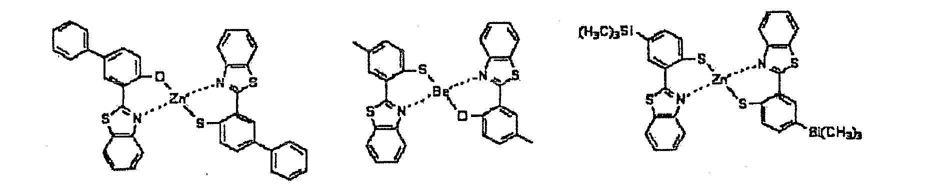

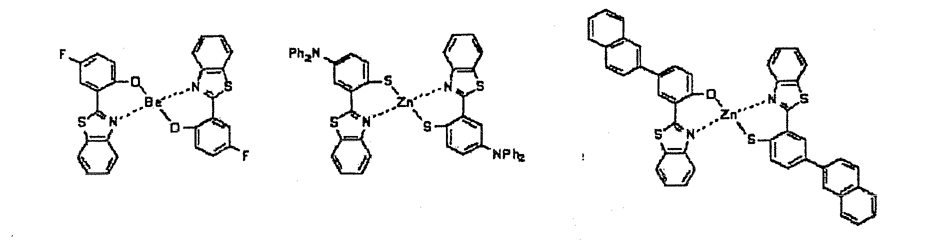

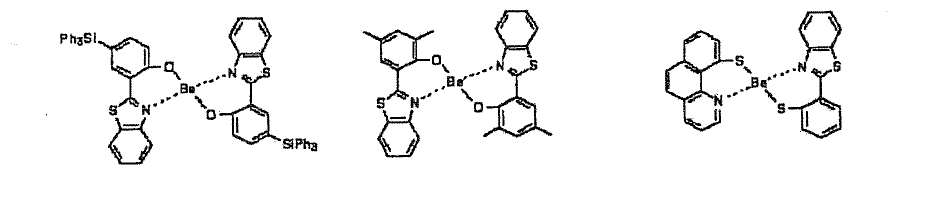

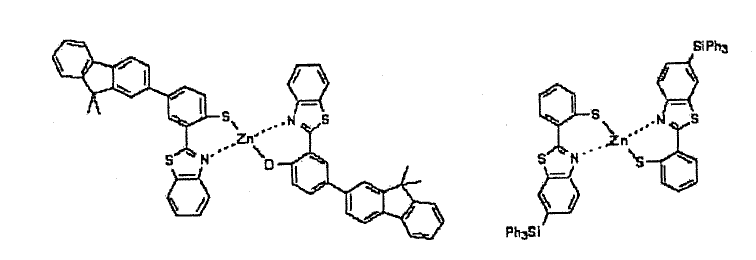

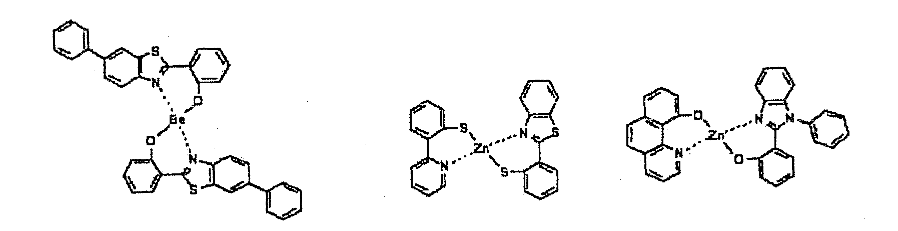

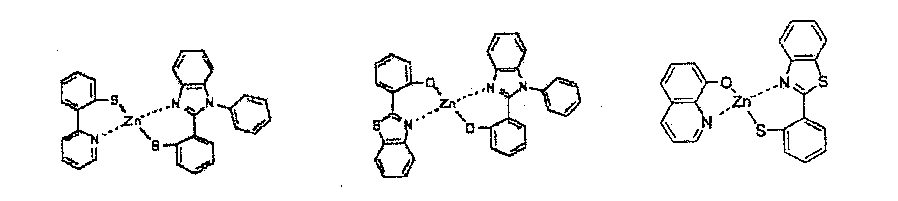

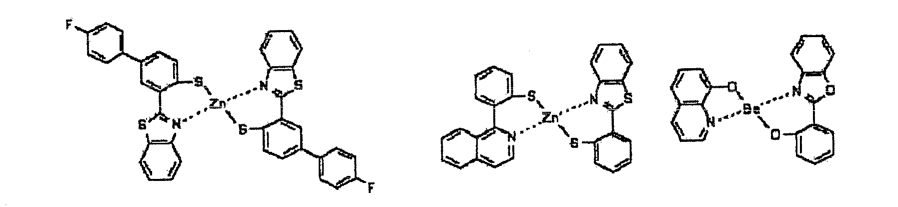

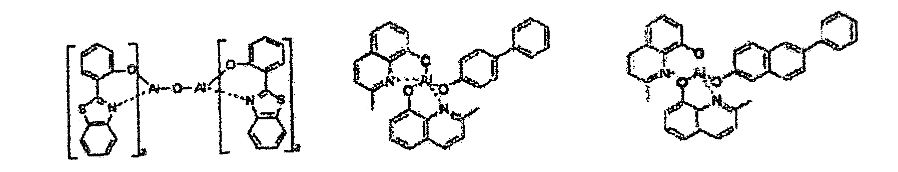

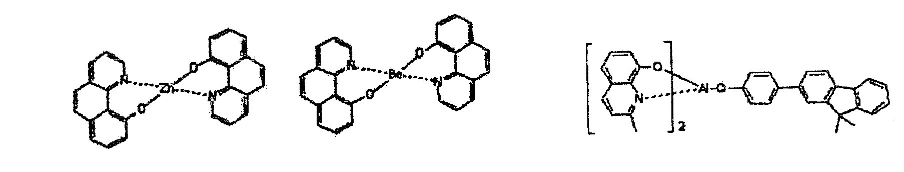

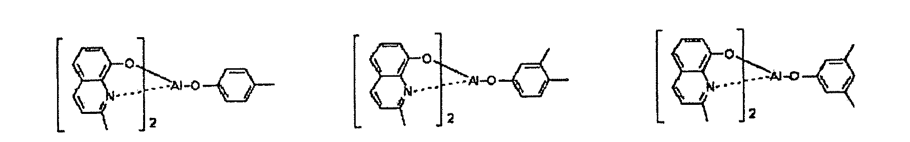

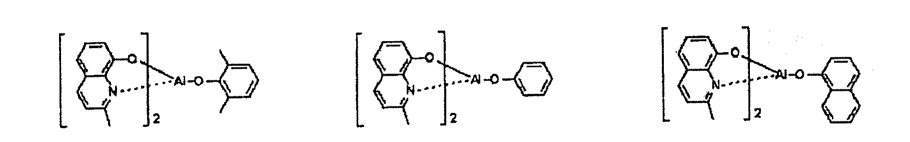

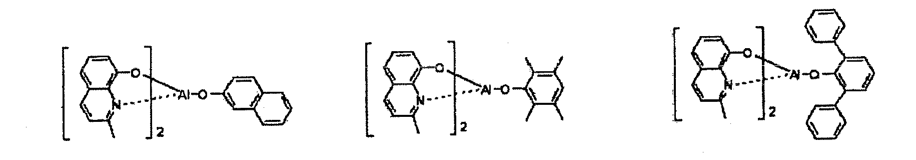

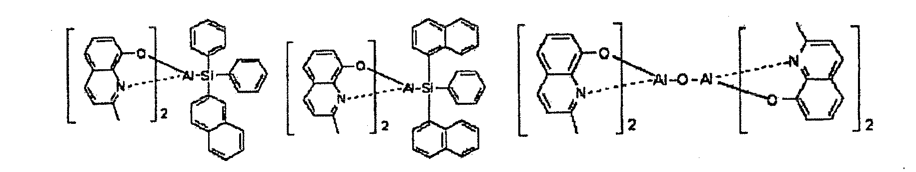

## Revendications

1. Composé phosphorescent organique représenté par la formule chimique (I) : 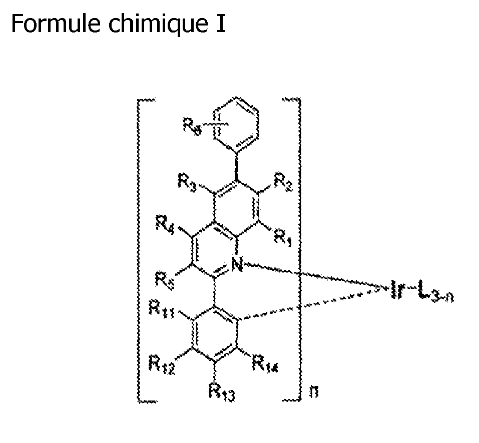 dans laquelle, L est un ligand organique ;
R₁ à R₅ représentent indépendamment l'hydrogène, un groupe alkyle en C₁-C₂₀, alcoxy en C₁-C₂₀, cycloalkyle en C₃-C₁₂, un halogène, un groupe tri(alkyle en C₁-C₂₀)silyle ou tri(aryle en C₆-C₂₀)silyle;
R₆ représente l'hydrogène, un groupe alkyle en C₁-C₂₀, un halogène ou un groupe aryle en C₆-C₂₀ ;
R₁₁ à R₁₄ représentent indépendamment l'hydrogène, un groupe alkyle en C₁-C₂₀, un halogène, un groupe cyano, tri(alkyle en C₁-C₂₀)silyle, tri(aryle en C₆-C₂₀)Silyle, alcoxy en C₁-C₂₀, alkylcarbonyle en C₁-C₂₀, arylcarbonyle en C₆-C₂₀, di(alkyle en C₁-C₂₀)amino, di(aryle en C₆-C₂₀)amino, phényle, naphtyle, anthryle, fluorényle, spirobifluorényle ou 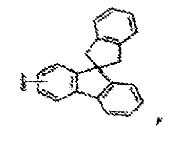 ou chacun de R₁₁ à R₁₄ peut être lié à un autre groupe adjacent de R₁₁ à R₁₄ via un groupe alkylène en C₃-C₁₂ ou alcénylène en C₃-C₁₂ avec ou sans cycle condensé pour former un cycle alicyclique, ou un cycle aromatique monocyclique ou polycyclique ;
les groupes alkyle, phényle, naphtyle, anthryle, fluorényle de R₁₁ à R₁₄, et le cycle alicyclique, ou le cycle aromatique monocyclique ou polycyclique formé à partir de ceux-ci par liaison via un groupe alkylène en C₃-C₁₂, ou alcénylène en C₃-C₁₂ avec ou sans cycle condensé peut de plus être substitué par un ou plusieurs substituants choisis parmi un groupe alkyle en C₁-C₂₀ avec ou sans substituant(s) d'halogène, alcoxy en C₁-C₂₀, un halogène, un groupe tri(alkyle en C₁-C₂₀)Silyle, tri(aryle en C₆-C₂₀)silyle, alkylcarbonyle en C₁-C₂₀, arylcarbonyle en C₆-C₂₀, di(alkyle en C₁-C₂₀)amino, di(aryle en C₆-C₂₀)amino et aryle en C₆-C₂₀; et
n est un nombre entier de 1 à 3.

2. Composé phosphorescent organique selon la revendication 1, dans lequel R₁₁ à R₁₄ représentent indépendamment l'hydrogène, un groupe méthyle, éthyle, n-propyle, i-propyle, n-butyle, i-butyle, t-butyle, n-pentyle, i-pentyle, n-hexyle, n-heptyle, n-octyle, 2-éthylhexyle, n-nonyle, trifluorométhyle, fluoro, cyano, triméthylsilyle, tripropylsilyle, tri(t-butyl)silyle, t-butyldiméthylsilyle, triphénylsilyle, méthoxy, éthoxy, butoxy, méthylcarbonyle, éthylcarbonyle, t-butylcarbonyle, phénylcarbonyle, diméthylamino, diphénylamino, phényle, naphtyle, anthryle, fluorényle ou 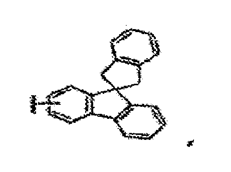 et le groupe fluorényle peut de plus être substitué par un groupe méthyle, éthyle, n-propyle, i-propyle, n-butyle, i-butyle, t-butyle, n-pentyle, i-pentyle, n-hexyle, n-heptyle, n-octyle, 2-éthylhexyle, n-nonyle, phényle, naphtyle, anthryle, triméthylsilyle, tripropylsilyle, tri(t-butyl)silyle, t-butyldiméthylsilyle ou triphénylsilyle.

3. Composé phosphorescent organique selon la revendication 1, lequel est choisi parmi les composés représentés par l'une des formules chimiques (II) à (VI) : 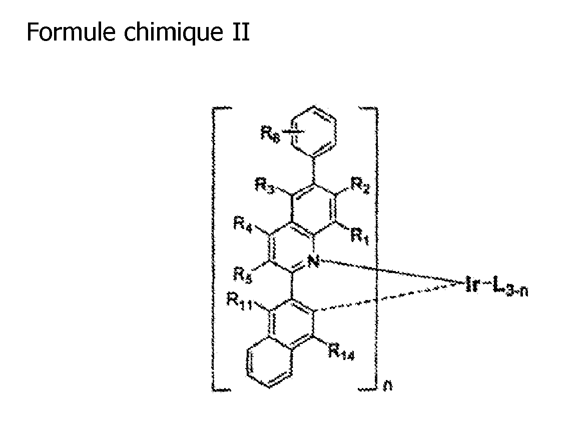 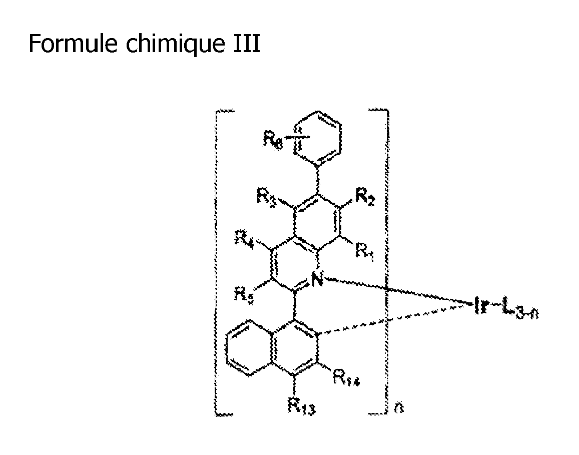 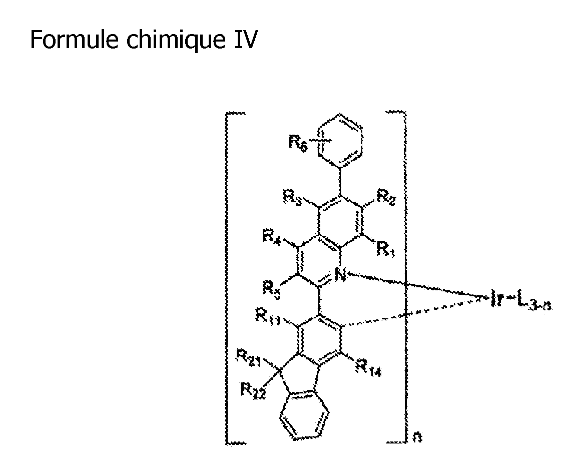 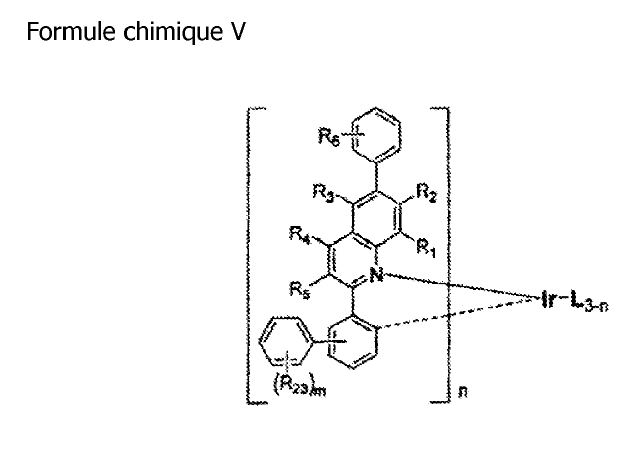 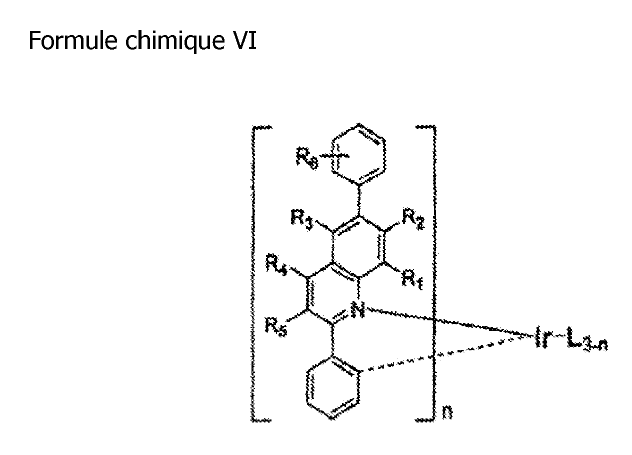 dans lesquelles, L, R₁, R₂, R₃, R₄, R₅, R₆, R₁₁, R₁₃, R₁₄ et n sont définis comme dans la formule chimique (I) de la revendication 1 ;
R₂₁ et R₂₂ représentent indépendamment l'hydrogène, un groupe alkyle en C₁-C₂₀, aryle en C₆-C₂₀, ou R₂₁ et R₂₂ peuvent être liés via un groupe alkylène en C₃-C₁₂ ou alcénylène en C₃-C₁₂ avec ou sans cycle condensé pour former un cycle alicyclique ou un cycle aromatique monocyclique ou polycyclique ;
R₂₃ représente un groupe alkyle en C₁-C₂₀, un halogène, un groupe cyano, tri(alkyle en C₁-C₂₀)Silyle, tri(aryle en C₆-C₂₀)silyle, alcoxy en C₁-C₂₀, alkylcarbonyle en C₁-C₂₀, arylcarbonyle en C₆-C₂₀, phényle, di(alkyle en C₁-C₂₀)amino, di(aryle en C₆-C₂₀)amino, naphtyle, 9,9-di(alkyle en C₁-C₂₀)fluorényle ou 9,9-di(aryle en C₆-C₂₀)fluorényle ; et
m est un nombre entier de 1 à 5.

4. Composé phosphorescent organique selon la revendication 1, dans lequel R₁ à R₅ représentent indépendamment l'hydrogène, un groupe méthyle, éthyle, n-propyle, i-propyle, n-butyle, i-butyle, t-butyle, n-pentyle, i-pentyle, n-hexyle, n-heptyle, n-octyle, éthylhexyle, méthoxy, éthoxy, butoxy, cyclopropyle, cyclohexyle, cycloheptyle, fluoro, triméthylsilyle, tripropylsilyle, tri(t-butyl)silyle, t-butyldiméthylsilyle ou triphénylsilyle ; et R₆ représente l'hydrogène, un groupe méthyle, éthyle, n-propyle, i-propyle, n-butyle, i-butyle, t-butyle, n-pentyle, i-pentyle, n-hexyle, n-heptyle, n-octyle, éthylhexyle, fluoro, phényle, naphtyle, anthryle, fluorényle ou spirobifluorényle.

5. Composé phosphorescent organique selon la revendication 2, lequel est choisi parmi les composés représentés par l'une des formules chimiques suivantes : 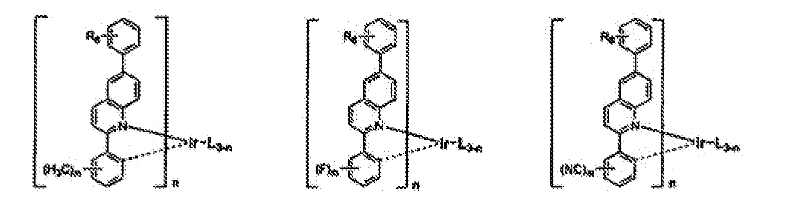 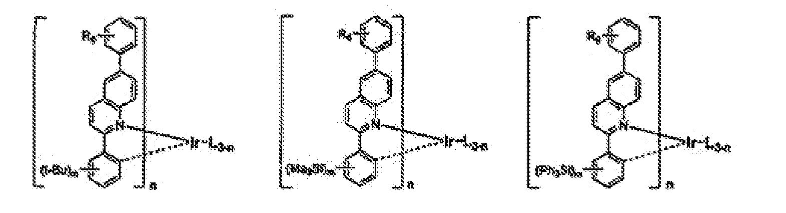 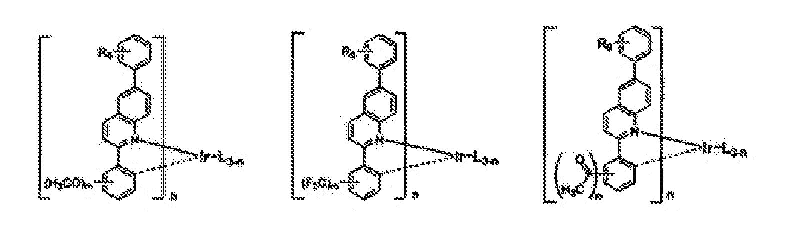 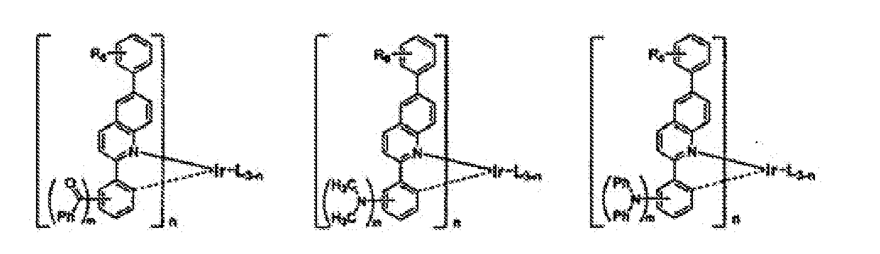 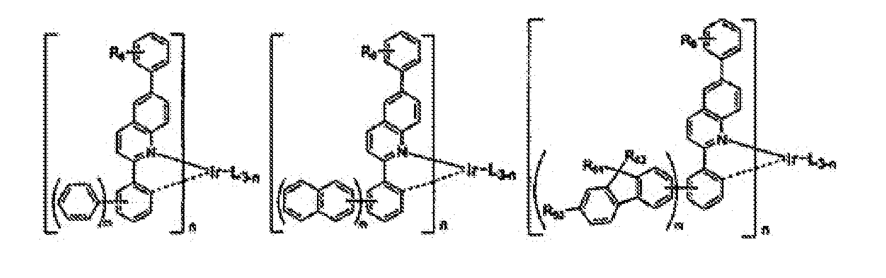 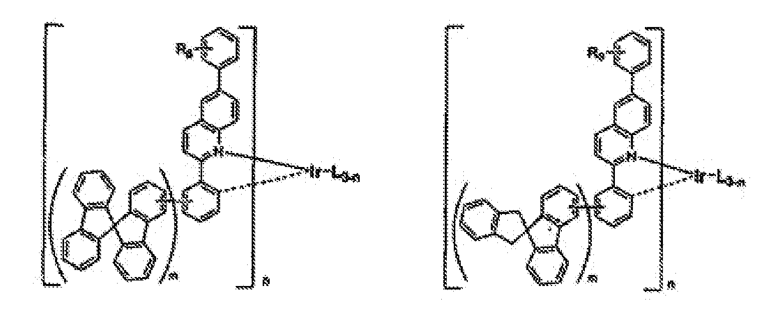 dans lesquelles, L et n sont comme définis dans la formule chimique (I) de la revendication 1 ;
R₆ représente l'hydrogène, un groupe méthyle, éthyle, n-propyle, i-propyle, n-butyle, i-butyle, t-butyle, n-pentyle, i-pentyle, n-hexyle, n-heptyle, n-octyle, éthylhexyle, fluoro, phényle ou naphtyle ;
R₅₁ et R₅₂ représentent indépendamment un groupe méthyle, éthyle, n-propyle, i-propyle, n-butyle, i-butyle, t-butyle, n-pentyle, i-pentyle, n-hexyle, n-heptyle, n-octyle, éthylhexyle, phényle ou naphtyle, ou R₅₁ et R₅₂ peuvent être liés l'un à l'autre via un groupe alkylène en C₃-C₁₂ ou alcénylène en C₃-C₁₂ avec ou sans cycle condensé pour former un cycle alicyclique, ou un cycle aromatique monocyclique ou polycyclique ;
R₅₃ représente l'hydrogène, un groupe méthyle, éthyle, n-propyle, i-propyle, n-butyle, i-butyle, t-butyle, n-pentyle, i-pentyle, n-hexyle, n-heptyle, n-octyle, éthylhexyle, triméthylsilyle, tripropylsilyle, tri(t-butyl)silyle, t-butyldiméthylsilyle ou triphénylsilyle ; et
m est un nombre entier de 1 à 3.

6. Composé phosphorescent organique selon la revendication 3, lequel est choisi parmi les composés suivants : 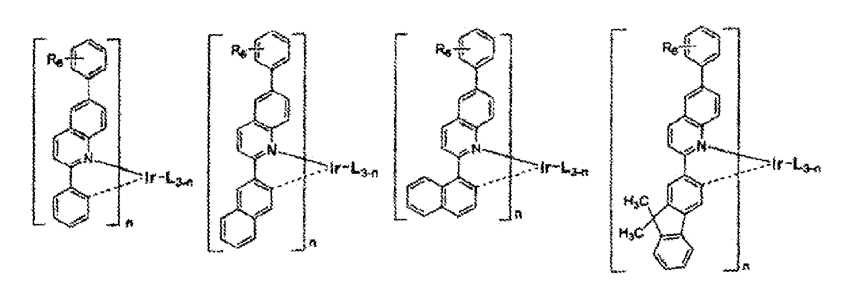 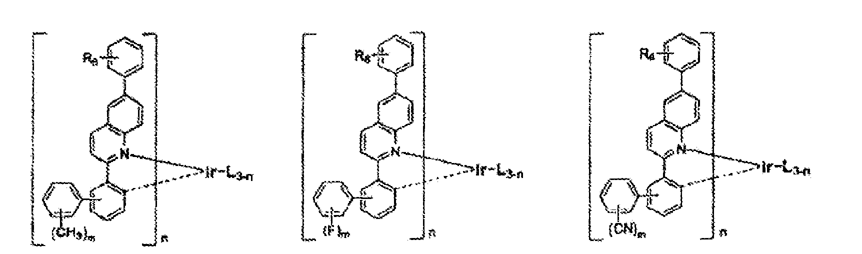 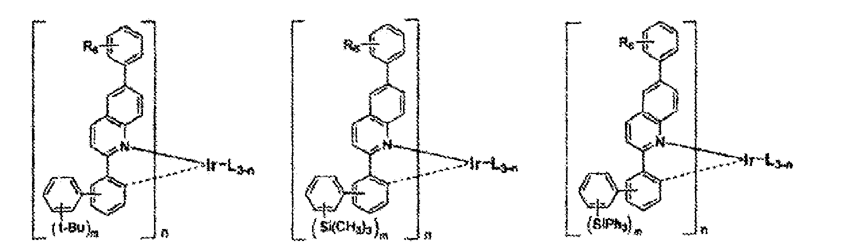 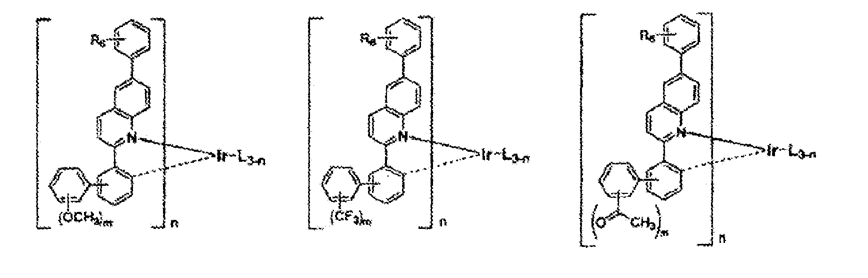 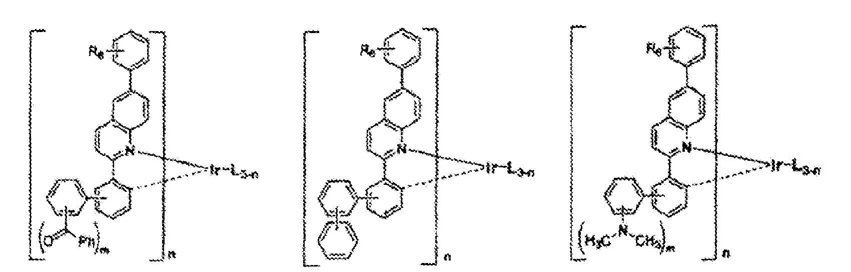 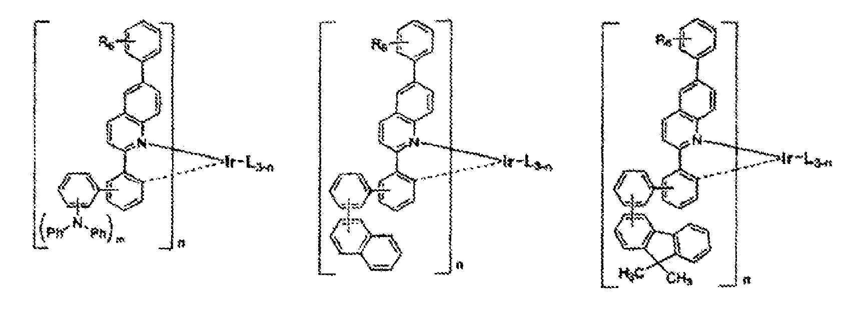 dans lesquels, L et n sont comme définis dans la formule chimique (I) de la revendication 1 ;
R₆ représente l'hydrogène, un groupe méthyle, éthyle, n-propyle, i-propyle, n-butyle, i-butyle, t-butyle, n-pentyle, i-pentyle, n-hexyle, n-heptyle, n-octyle, éthylhexyle, fluoro, phényle ou naphtyle ; et
m est un nombre entier de 1 à 3.

7. Composé phosphorescent organique selon la revendication 1, dans lequel le ligand (L) présente une structure représentée par l'une des formules chimiques suivantes : 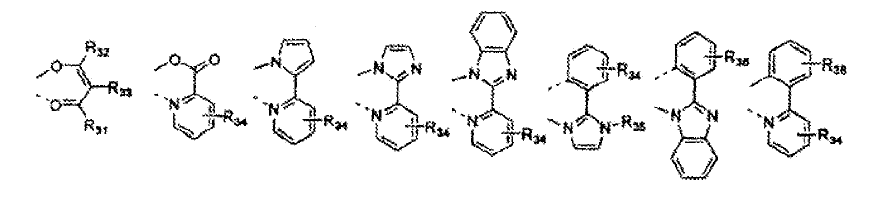 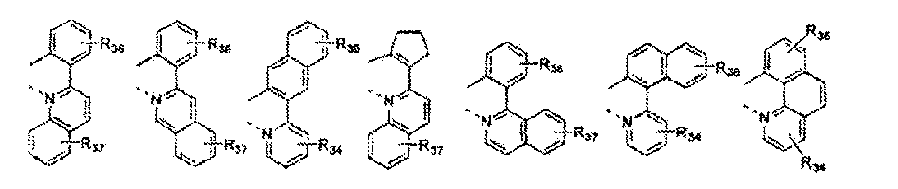 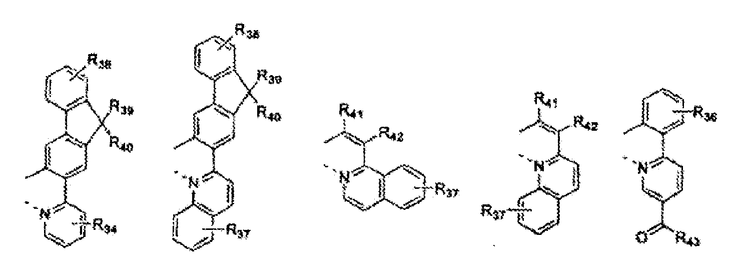 dans lesquelles R₃₁ et R₃₂ représentent indépendamment l'hydrogène, un groupe alkyle en C₁-C₂₀ avec ou sans substituant(s) d'halogène, phényle avec ou sans substituant(s) alkyle en C₁-C₂₀ ou un halogène ;
R₃₃ à R₃₈ représentent indépendamment l'hydrogène, un groupe alkyle en C₁-C₂₀, phényle avec ou sans substituant(s) alkyle en C₁-C₂₀, tri(alkyle en C₁-C₂₀)Silyle ou un halogène ;
R₃₉ à R₄₂ représentent indépendamment l'hydrogène, un groupe alkyle en C₁-C₂₀, ou phényle avec ou sans substituant(s) alkyle en C₁-C₂₀; et
R₄₃ représente un groupe alkyle en C₁-C₂₀, phényle avec ou sans groupe alkyle en C₁-C₂₀, ou un atome d'halogène.

8. Composé phosphorescent organique selon la revendication 7, dans lequel le ligand (L) présente une structure représentée par l'une des formules chimiques suivantes :

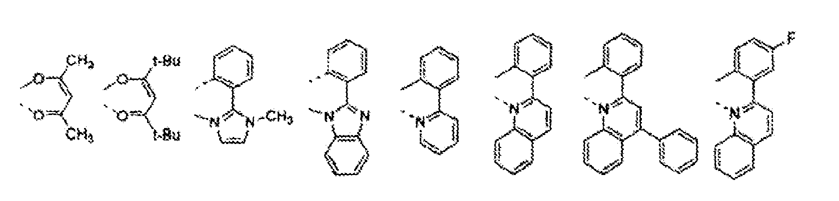

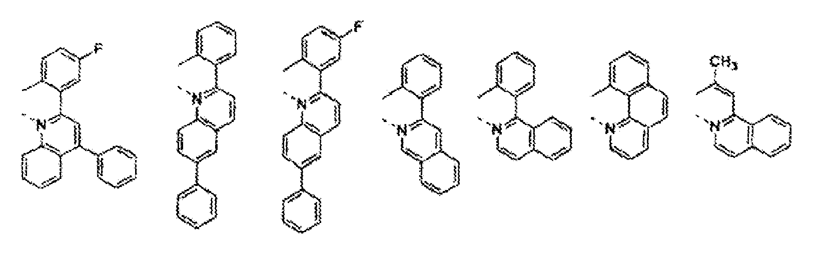

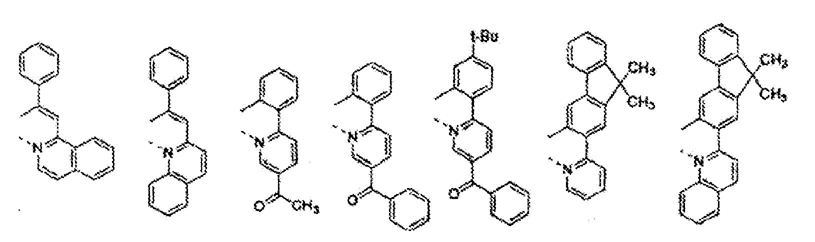

9. Dispositif électroluminescent organique qui est constitué
d'une première électrode ;
d'une seconde électrode ; et
d'au moins une couche organique intercalée entre la première électrode et la seconde électrode ;
dans lequel la couche organique comprend un ou plusieurs composé(s) représenté(s) par la formule chimique (I) : 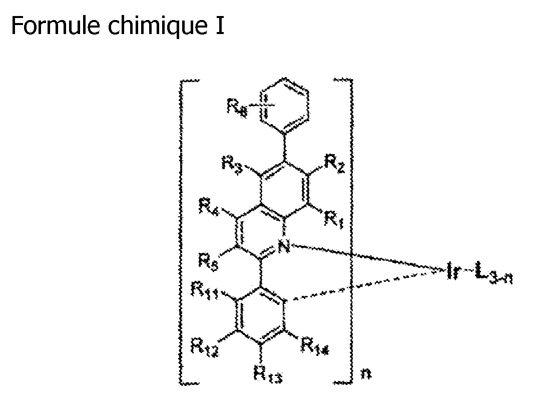 dans laquelle, L est un ligand organique ;
R₁ à R₅ représentent indépendamment l'hydrogène, un groupe alkyle en C₁-C₂₀, alcoxy en C₁-C₂₀, cycloalkyle en C₃-C₁₂, un halogène, un groupe tri(alkyle en C₁-C₂₀)silyle ou tri(aryle en C₆-C₂₀)silyle ;
R₆ représente l'hydrogène, un groupe alkyle en C₁-C₂₀, un halogène ou un groupe aryle en C₆-C₂₀;
R₁₁ à R₁₄ représentent indépendamment l'hydrogène, un groupe alkyle en C₁-C₂₀, un halogène, un groupe cyano, tri(alkyle en C₁-C₂₀)silyle, tri(aryle en C₆-C₂₀)silyle, alcoxy en C₁-C₂₀, alkylcarbonyle en C₁-C₂₀, arylcarbonyle en C₆-C₂₀, di(alkyle en C₁-C₂₀)amino, di(aryle en C₆-C₂₀)amino, phényle, naphtyle, anthryle, fluorényle, spirobifluorényle ou 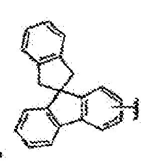 ou chacun de R₁₁ à R₁₄ peut être lié à un autre groupe adjacent de R₁₁ à R₁₄ via un groupe alkylène en C₃-C₁₂ ou alcénylène en C₃-C₁₂ avec ou sans cycle condensé pour former un cycle alicyclique, ou un cycle aromatique monocyclique ou polycyclique ;
les groupes alkyle, phényle, naphtyle, anthryle, fluorényle de R₁₁ à R₁₄, et le cycle alicyclique, ou le cycle aromatique monocyclique ou polycyclique formé à partir de ceux-ci par liaison via un groupe alkylène en C₃-C₁₂ ou alcénylène en C₃-C₁₂ avec ou sans cycle condensé peut de plus être substitué par un ou plusieurs substituants choisis parmi un groupe alkyle en C₁-C₂₀ avec ou sans substituant(s) d'halogène, alcoxy en C₁-C₂₀, un halogène, un groupe tri(alkyle en C₁-C₂₀)silyle, tri(aryle en C₆-C₂₀)silyle, alkylcarbonyle en C₁-C₂₀, arylcarbonyle en C₆-C₂₀, di(alkyle en C₁-C₂₀)amino, di(aryle en C₆-C₂₀)amino et aryle en C₆-C₂₀; et
n est un nombre entier de 1 à 3.

10. Dispositif électroluminescent organique selon la revendication 9, dans lequel la couche organique comprend une région électroluminescente qui comprend un ou plusieurs composé(s) représenté(s) par la formule chimique (I) et un ou plusieurs hôte(s).

11. Dispositif électroluminescent organique selon la revendication 10, dans lequel l'hôte est choisi parmi les composés représentés par l'une des formules chimiques (VII) à (IX) : 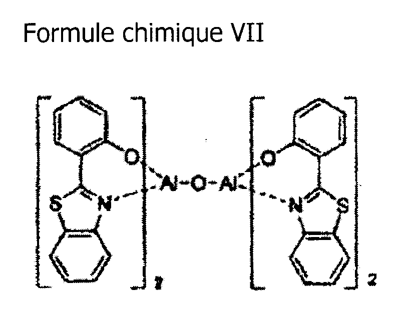 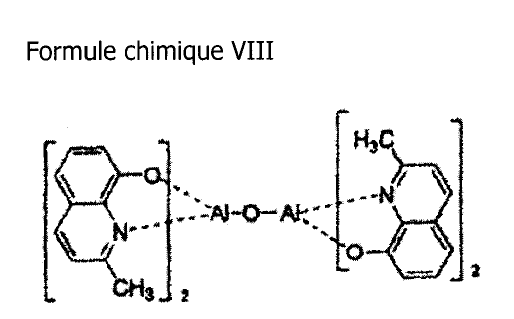
Formule chimique IX L¹L²M(Q)_{y}
dans laquelle, les ligands, L¹ et L² représentent indépendamment l'un de l'autre une des structures suivantes : 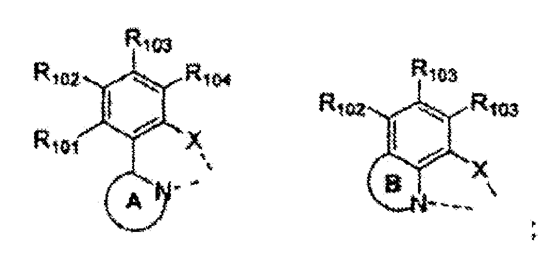 M est un métal bivalent ou trivalent ;
y est égal à 0 lorsque M est un métal bivalent alors que y est égal à 1 lorsque M est un métal trivalent ;
Q représente un groupe aryloxy en C₆-C₂₀ ou tri(aryle en C₆-C₂₀)silyle et le groupe aryloxy et triarylsilyle de Q peut encore être substitué par un groupe alkyle en C₁-C₅ ou aryle en C₆-C₂₀ ;
X représente O, S ou Se ;
le cycle A représente un cycle oxazole, thiazole, imidazole, oxadiazole, thiadiazole, benzoxazole, benzothiazole, benzimidazole, pyridine ou quinoléine ;
le cycle B représente un cycle pyridine ou quinoléine, et le cycle B peut de plus être substitué par un groupe alkyle en C₁-C₅ ou phényle ou naphtyle substitué ou non substitué ;
R₁₀₁ à R₁₀₄ représentent indépendamment l'hydrogène, un groupe alkyle en C₁-C₅, un halogène, un groupe tri(alkyle en C₁-C₅)silyle, tri(aryle en C₆-C₂₀)silyle ou aryle en C₆-C₂₀, ou chacun d'entre eux peut être lié à un substituant adjacent via un groupe alkylène ou alcénylène pour former un cycle condensé, et le cycle pyridine ou quinoléine peut former une liaison chimique avec R₁₀₁ pour former un cycle condensé ; et
le cycle A ou le groupe aryle de R₁₀₁ à R₁₀₄ peut de plus être substitué par un groupe alkyle en C₁-C₅, un halogène, un groupe alkyle en C₁-C₅ avec un(des) substituant(s) d'halogène, phényle, naphtyle, tri(alkyle en C₁-C₅)silyle, tri(aryle en C₆-C₂₀)silyle ou amino.

12. Dispositif électroluminescent organique selon la revendication 11, dans lequel les ligands, L¹ et L² sont indépendamment choisis parmi les structures suivantes : 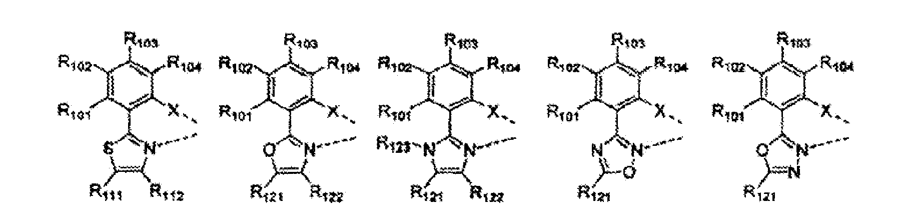 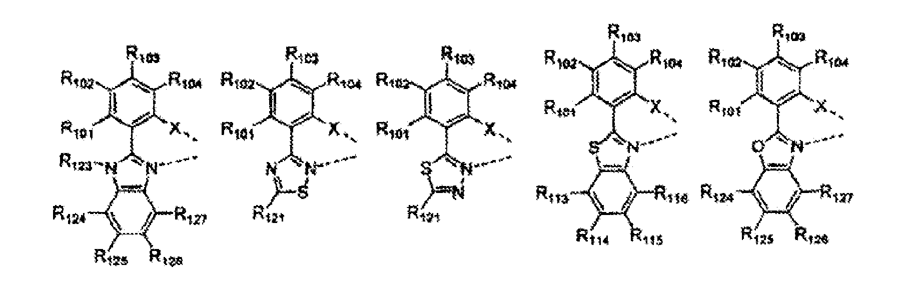 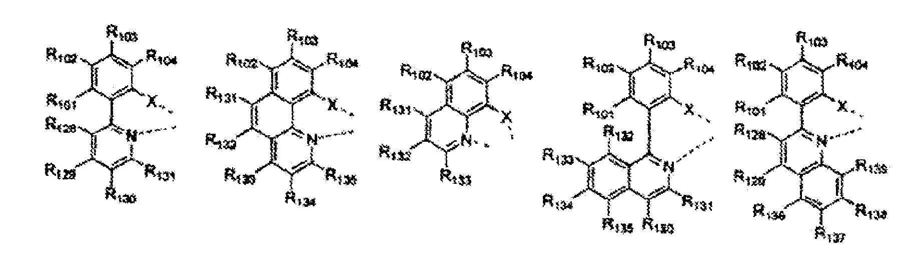 dans lesquelles X représente O, S ou Se ; R₁₀₁ à R₁₀₄ représentent indépendamment l'hydrogène, un groupe alkyle en C₁-C₅ avec ou sans substituant(s) d'halogène, un halogène, un groupe aryle en C₆-C₂₀, hétéroaryle en C₄-C₂₀, tri(alkyle en C₁-C₅)silyle, tri(aryle en C₆-C₂₀)silyle, di(alkyle en C₁-C₅)amino, di(aryle en C₆-C₂₀)amino, thiophényle ou furanyle, ou chacun d'entre eux peut être lié à un substituant adjacent via un groupe alkylène ou alcénylène pour former un cycle condensé ;
R₁₁₁ à R₁₁₆, R₁₂₁ et R₁₂₂ représentent indépendamment l'hydrogène, un groupe alkyle en C₁-C₅, un halogène, un groupe alkyle en C₁-C₅ avec ou sans substituant(s) d'halogène, un groupe phényle, naphtyle, biphényle, fluorényle, tri(alkyle en C₁-C₅)silyle, tri(aryle en C₆-C₂₀)silyle, di(alkyle en C₁-C₅)amino, di(aryle en C₆-C₂₀)amino, thiophényle ou furanyle ;
R₁₂₃ représente un groupe alkyle en C₁-C₂₀, phényle ou naphtyle ;
R₁₂₄ à R₁₃₉ représentent indépendamment l'hydrogène, un groupe alkyle en C₁-C₅, un halogène, un groupe alkyle en C₁-C₅ avec un(des) substituant(s) d'halogène, phényle, naphtyle, biphényle, fluorényle, tri(alkyle en C₁-C₅)silyle, tri(aryle en C₆-C₂₀)silyle, di(alkyle en C₁-C₅)amino, di(aryle en C₆-C₂₀)amino, thiophényle ou furanyle ; et
le groupe phényle, naphtyle, biphényle, fluorényle, thiophényle ou furanyle de R₁₁₁ à R₁₁₆ et R₁₂₁ à R₁₃₉ peut de plus être substitué par un ou plusieurs substituant(s) choisi(s) parmi un groupe alkyle en C₁-C₅, un halogène, un groupe naphtyle, fluorényle, tri(alkyle en C₁-C₅)silyle, tri(aryle en C₆-C₂₀)silyle, di(alkyle en C₁-C₅)amino et di(aryle en C₆-C₂₀)amino.

13. Dispositif électroluminescent organique selon la revendication 11, dans lequel M est un métal bivalent choisi parmi Be, Zn, Mg, Cu et Ni, ou un métal trivalent choisi parmi Al, Ga, In et B.

14. Dispositif électroluminescent organique selon la revendication 11, dans lequel Q est choisi parmi les structures suivantes.

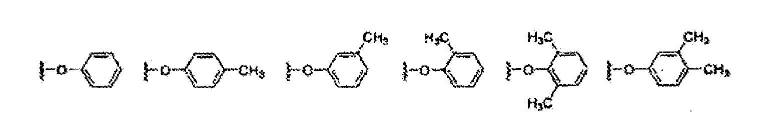

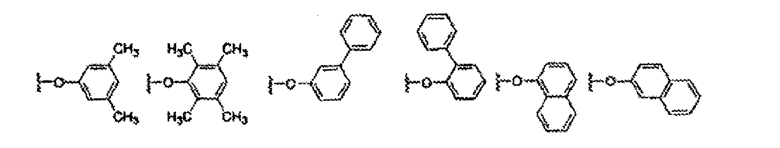

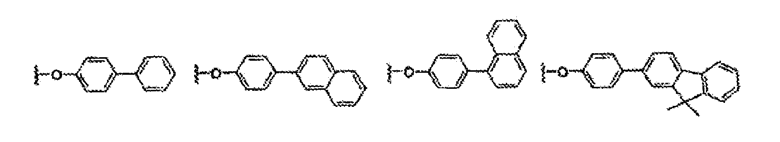

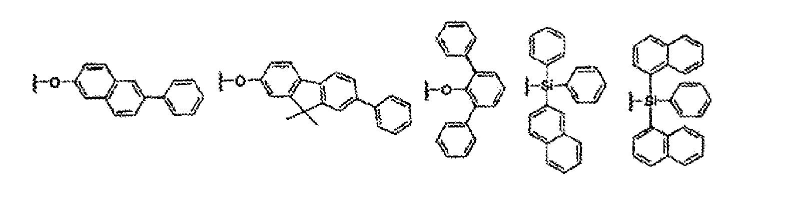

15. Dispositif électroluminescent organique selon la revendication 11, dans lequel l'hôte est choisi par les composés représentés par les formules suivantes.
